(19) Europäisches Patentamt
European Patent Office
Office européen des brevets

(11) **EP 3 043 392 A1**

(12) **EUROPEAN PATENT APPLICATION**

(43) Date of publication:
**13.07.2016 Bulletin 2016/28**

(51) Int Cl.:
***H01L 33/22*** *(2010.01)*

(21) Application number: **16157412.4**

(22) Date of filing: **25.09.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2012 JP 2012227299
17.10.2012 JP 2012230000
19.10.2012 JP 2012231861
21.12.2012 JP 2012280240
07.02.2013 JP 2013022576
27.05.2013 JP 2013111091**

(62) Document number(s) of the earlier application(s) in
accordance with Art. 76 EPC:
**13846095.1 / 2 908 353**

(71) Applicant: **Asahi Kasei E-materials Corporation
Tokyo 101-8101 (JP)**

(72) Inventors:
• **Koike, Jun
Tokyo, 101-8101 (JP)**

• **Yamaguchi, Fujito
Tokyo, 101-8101 (JP)**
• **Inoue, Naoki
Tokyo, 101-8101 (JP)**
• **Muroo, Hiroyuki
Tokyo, 101-8101 (JP)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

Remarks:
This application was filed on 25-02-2016 as a
divisional application to the application mentioned
under INID code 62.

(54) **OPTICAL SUBSTRATE, SEMICONDUCTOR LIGHT EMITTING DEVICE AND MANUFACTURING
METHOD OF THE SAME**

(57)     An optical substrate applied to a semiconductor light emitting device comprised of at least an n-type semiconductor layer, a light emitting semiconductor layer, and a p-type semiconductor layer, wherein a concavo-convex structure including dots comprised of a plurality of convex portions or concave portions is provided on a main surface of the optical substrate, the concavo-convex structure forms a two-dimensional photonic crystal controlled by at least one of a pitch between the dots, a dot diameter and a dot height, and a period of the two-dimensional photonic crystal is two or more times an emission center wavelength of the semiconductor light emitting device, so as to concurrently actualize increases in internal quantum efficiency IQE and improvements in light extraction efficiency LEE of a semiconductor light emitting device which have been mutually tradeoffs.

FIG.5

## Description

Technical Field

The present invention relates to optical substrates, semiconductor light emitting devices and manufacturing methods of the same.

Background Art

In recent years, in order to improve efficiency in semiconductor light emitting devices such as organic electroluminescence (OLED), fluorescent material and light emitting diode (LED), improvements have been studied in light extraction efficiency from the semiconductor light emitting device. Such a semiconductor light emitting device has a configuration that a high refractive index region including an emission part therein is sandwiched between low refractive index regions. Therefore, emitted light from the emission part of the semiconductor light emitting device becomes a waveguide mode that the light is guided inside the high refractive index region, while being enclosed inside the high refractive index region, and is absorbed in the waveguide process to attenuate as heat. Thus, in the semiconductor light emitting device, it is not possible to extract the emitted light to the outside of the semiconductor light emitting device, and there is a problem that the light extraction efficiency significantly decreases.

In the case of the LED device, as described below, it is possible to manufacture LED devices high in external quantum efficiency EQE by concurrently improving light extraction efficiency LEE and internal quantum efficiency IQE, or light extraction efficiency LEE and electron injection efficiency EIE.

A GaN-based semiconductor device typified by a blue LED is manufactured by layering an n-type semiconductor layer, light emitting semiconductor layer and p-type semiconductor layer on a single crystal substrate by epitaxial growth. As the single crystal substrate, a sapphire single crystal substrate and SiC single crystal substrate are generally used. However, for example, since lattice mismatch exists between a sapphire crystal and a GaN-based semiconductor crystal, dislocations occur inside the GaN-based semiconductor crystal (for example, see Non-patent Document 1). The dislocation density reaches $1 \times 10^9 / cm^2$. By the dislocations, the internal quantum efficiency of the LED i.e. efficiency that generated holes and electrons are bound to generate photons is decreased, and as a result, the external quantum efficiency EQE decreases.

Further, the refractive index of the GaN-based semiconductor layer is larger than that of the sapphire substrate. Therefore, light generated inside the light emitting semiconductor layer i.e. emitted light is not output at angles of the critical angle or more from an interface between the sapphire substrate and the GaN-based semiconductor crystal. That is, the emitted light forms a waveguide mode and attenuates as heat in the waveguide process. Therefore, the light extraction efficiency decreases, and as a result, the external quantum efficiency EQE decreases. Alternatively, in the case of using the SiC substrate such that the refractive index is larger as the single crystal substrate, a quantity of emitted light output from an interface between the SiC substrate and an air layer is smaller than that in the case of using the sapphire substrate. Therefore, as a substrate higher in the refractive index is used, the light extraction efficiency LEE is decreased.

That is, since the internal quantum efficiency IQE decreases due to dislocation defects inside the semiconductor crystal and the light extraction efficiency LEE decreases due to formation of the waveguide mode, the external quantum efficiency EQE of the LED significantly decreases.

Therefore, proposed is a technique for providing a concavo-convex structure on a single crystal substrate to change the waveguide direction of light in the semiconductor crystal layer, and enhancing the light extraction efficiency LEE (for example, see Patent Document 1).

Further, another technique is proposed in which the size of the concavo-convex structure provided on the single crystal substrate is made nanosize and an arrangement of the concavo-convex structure is a random arrangement (for example, see Patent Document 2). In addition, it is reported that when the size of the concave-convex structure provided on the single crystal substrate is nanosize, luminous efficiency of the LED is increased as compared with a substrate provided with a concavo-convex structure of microsize (for example, see Non-patent Document 2).

Moreover, a GaN-based semiconductor light emitting device is proposed in which a concavo-convex structure is provided on the top of a p-type semiconductor layer to improve the electron injection efficiency EIE i.e. generation rate of holes and electrons with respect to supplied electrical energy so as to reduce contact resistance with a transparent conductive film (see Patent Document 3).

Prior Art Document

Patent Document

[Patent Document 1] Japanese Unexamined Patent Publication No. 2003-318441
[Patent Document 2] Japanese Unexamined Patent Publication No. 2007-294972
[Patent Document 3] Japanese Unexamined Patent Publication No. 2005-259970

Non-patent Document

[Non-patent Document 1] IEEE photo. Tech. Lett., 20, 13 (2008)
[Non-patent Document 2] J. Appl. Phys., 103, 014314 (2008)

Disclosure of Invention

Problems to be Solved by the Invention

In addition, as factors to determine the external quantum efficiency EQE indicative of luminous efficiency of an LED, there are the electron injection efficiency EIE, internal quantum efficiency IQE, and light extraction efficiency LEE. Among the factors, the internal quantum efficiency IQE is dependent on the dislocation density caused by crystal mismatch of the GaN-based semiconductor crystal. The light extraction efficiency LEE is improved by disturbing the waveguide mode by light scattering due to the concavo-convex structure provided on the single crystal substrate. Further, the electron injection efficiency EIE is improved by reducing interface resistance between a p-type semiconductor layer and a transparent conductive film comprised of oxide such as ITO, ZnO, $In_2O_3$, and $SnO_2$. Particularly, since transparent conductive materials such as ITO are n-type conductive materials, the Schottky barrier tends to form in the interface with the p-type semiconductor layer, the ohmic property thereby decreases, and the contact resistance tends to increase. Therefore, the concavo-convex structure is formed in the interface with the p-type semiconductor layer to increase the contact area, and ohmic contact is enhanced to improve.

In other words, as the effects (roles) of the concavo-convex structure in a semiconductor light emitting device, there are three effects i.e. (1) improvements in internal quantum efficiency IQE by decreasing dislocations inside the semiconductor crystal, (2) improvements in light extraction efficiency LEE by resolving the waveguide mode, and (3) increases in electron injection efficiency EIE by enhancement of ohmic contact.

However, in the technique as described in Patent Document 1, improvements of light extraction efficiency LEE due to the effect of (2) are made, but the effect of improvements in internal quantum efficiency IQE due to the effect of (1) is a little. The reason why dislocation defects decrease by concavities and convexities on the single crystal substrate is that the growth mode of chemical vapor deposition (CVD) of the GaN-based semiconductor layer is disturbed by the concavities and convexities, and that the dislocation defects associated with layer growth collide and disappear. Therefore, when concavities and convexities corresponding to the density of defects exist, it is effective in decreasing defects, but in the concavo-convex density less than the density of defects, the effect of decreasing dislocations is limited. For example, in terms of nano-order, the dislocation density of $1 \times 10^9/cm^2$ corresponds to $10/\mu m^2$, and the dislocation density of $1 \times 10^8/cm^2$ corresponds to $1/\mu m^2$. When about two concavo-convex pieces are provided in 5 $\mu m$ x 5/$\mu m$ (□5 $\mu m$), the concavo-convex density is $0.08 \times 10^8/cm^2$, and when about two concavo-convex pieces are provided in 500 nm x 500 nm (□500 nm), the concavo-convex density is $8 \times 10^8/$. Thus, when the concavo-convex size is made a pitch of nano-order, there is a significant effect in decreasing the dislocation density, and it is thereby effective to improve the internal quantum efficiency IQE.

However, as the concavo-convex structure has a higher density i.e. when the size of the concavo-convex structure is nano-order, the scattering effect on light decreases. Therefore, the effect (2) of resolving the waveguide mode is reduced. The light emission wavelengths of LEDs are in the visible region, and the light emission wavelengths of GaN-based LEDs particularly used in white LEDs are 450 nm to 500 nm. In order to obtain a sufficient light scattering effect, the concavities and convexities are preferably about 2 to 20 times the wavelength, and the effect is a little in nano-order.

Further, in the technique as described in Patent Document 3, it is necessary to make the pitch (interval) and depth of the concavo-convex structure the nano-order, and improvements in light extraction efficiency LEE by the formed concavo-convex structure are not adequate. This is because it is necessary to set the thickness of the p-type semiconductor layer at about several hundreds of nanometers from the value of the absorption coefficient, and the size of the concavo-convex structure necessarily becomes the nano-order. On the other hand, the light emission wavelengths of an LED are in the visible light range (450 nm to 750 nm), and in the concavo-convex structure of the size equal to the wavelengths, there is a problem that the light extraction efficiency LEE thereof decreases.

Thus, in the conventional techniques, among three effects on LED luminous efficiency i.e. (1) improvements in internal quantum efficiency IQE, (2) improvements in light extraction efficiency LEE and (3) increases in electron injection efficiency EIE, as the effects (roles) of the concavo-convex structure in a semiconductor light emitting device, (1) and (2) and (2) and (3) are in the relationship of mutually tradeoffs, and it has always not been possible to actualize the optimal structure. That is, in the conventional techniques, there are problems that the effect of improving the light extraction efficiency LEE is less as the internal quantum efficiency IQE is increased, and that the effect of improving the light extraction efficiency LEE is less as the electron injection efficiency EIE is increased.

The present invention was made in view of the above-mentioned problems, and it is an object of the invention to provide an optical substrate, semiconductor light emitting device and manufacturing method of the same for enabling concurrent solution of increases in light extraction efficiency LEE and improvements in internal quantum efficiency IQE or increases in light extraction efficiency LEE and increases in electron injection efficiency EIE of a semiconductor light emitting device that have been mutually tradeoffs.

Means for Solving the Problem

As a result of carrying out earnest studies to attain the above-mentioned object, the inventors of the present invention found out that it is possible to concurrently actualize increases in internal quantum efficiency IQE and improvements in light extraction efficiency LEE or improvements in light extraction efficiency LEE and electron injection efficiency EIE of a semiconductor light emitting device that have been mutually tradeoffs by the fact that at least one pattern, observable with an optical microscope, drawn by a concavo-convex structure provided on a surface of an optical substrate is capable of being distinguished to a first region and a second region by a difference in light and dark and that the pattern and the concavo-convex structure exert respective different effects, and arrived at the present invention based on the findings. That is, the present invention is as described below.

An optical substrate of the present invention is an optical substrate provided with a substrate body, and a concavo-convex structure comprised of a plurality of convex portions or concave portions provided on a main surface of the substrate body, and is characterized in that at least one pattern observable at any magnification within a range of 10 times to 5,000 times with an optical microscope is drawn on the main surface, an interval of the pattern is larger than a pitch of the concavo-convex structure, and that in an optical microscope image of the pattern, the pattern is capable of being distinguished to a first region and a second region by a difference in light and dark, a plurality of first regions is arranged apart from one another at intervals, and the second region connects between the first regions.

The optical substrate of the invention is an optical substrate provided with a concavo-convex structure on a surface thereof, and is characterized in that an average pitch of the concavo-convex structure ranges from 50 nm to 1,500 nm, the concavo-convex structure includes disturbances, and that a standard deviation and arithmetic mean of elements of the concavo-convex structure that is at least one factor of the disturbances meet a relationship of the following equation (1).

$$0.025 \leq (\text{standard deviation/arithmetic mean}) \leq 0.5 \quad (1)$$

An optical substrate of the invention is an optical substrate applied to a semiconductor light emitting device comprised of at least an n-type semiconductor layer, a light emitting semiconductor layer, and a p-type semiconductor layer, and is characterized in that a concavo-convex structure including dots comprised of a plurality of convex portions or concave portions is provided on a main surface of the optical substrate, the concavo-convex structure forms a two-dimensional photonic crystal controlled by at least one of a pitch between the dots, a dot diameter and a dot height, and that a period of the two-dimensional photonic crystal is two or more times an emission center wavelength of the semiconductor light emitting device.

A semiconductor light emitting device of the invention is characterized in that at least a first semiconductor layer, a light emitting semiconductor layer and a second semiconductor layer are layered on the main surface of the above-mentioned optical substrate.

A method of manufacturing the semiconductor light emitting device of the invention is characterized by being provided with a step of performing an optical inspection on the above-mentioned optical substrate, and a step of manufacturing the semiconductor light emitting device using the optical substrate subjected to the optical inspection.

The semiconductor light emitting device of the invention is characterized by being obtained by separating the above-mentioned optical substrate from an intermediate product provided with the optical substrate, a first semiconductor layer, light emitting semiconductor layer and second semiconductor layer sequentially layered on the surface having the concavo-convex structure, and a support product joined to the second semiconductor layer.

A method of manufacturing the semiconductor light emitting device of the invention is characterized by being provided with a step of layering a first semiconductor layer, a light emitting semiconductor layer and a second semiconductor layer in this order on the surface having the concavo-convex structure of the above-mentioned optical substrate, a step of bonding a support product to a surface of the second semiconductor layer to obtain an intermediate product, and a step of separating the optical substrate from the intermediate product to obtain the semiconductor light emitting device comprised of the first semiconductor layer, the light emitting semiconductor layer, the second semiconductor layer and the support product.

Advantageous Effect of the Invention

According to the present invention, it is possible to concurrently solve increases in internal quantum efficiency IQE and improvements in light extraction efficiency LEE or increases in electron injection efficiency EIE and improvements in light extraction efficiency LEE of a semiconductor light emitting device that have been mutually tradeoffs.

Brief Description of Drawings

FIG. 1 is an explanatory diagram illustrating a pattern drawn on a main surface of an optical substrate PP according to this Embodiment;

FIG. 2 is a cross-sectional schematic diagram showing an example of a semiconductor light emitting device to which is applied the optical substrate PP according to this Embodiment;

FIG. 3 is a cross-sectional schematic diagram showing another example of the semiconductor light emitting device to which is applied the optical substrate PP according to this Embodiment;

FIG. 4 is a cross-sectional schematic diagram showing still another example of the semiconductor light emitting device to which is applied the optical substrate PP according to this Embodiment;

FIG. 5 is a cross-sectional schematic diagram showing still another example of the semiconductor light emitting device to which is applied the optical substrate PP according to this Embodiment;

FIG. 6 is a cross-sectional schematic diagram showing still another example of the semiconductor light emitting device to which is applied the optical substrate PP according to this Embodiment;

FIG. 7 contains cross-sectional schematic diagrams of the optical substrate PP according to this Embodiment;

FIG. 8 contains explanatory diagrams illustrating patterns in the case of observing, from the concavo-convex structure surface side, the optical substrate PP according to this Embodiment;

FIG. 9 is an explanatory diagram illustrating a pattern in the case of observing, from the concavo-convex structure surface side, the optical substrate PP according to this Embodiment;

FIG. 10 is an explanatory diagram illustrating another pattern in the case of observing, from the concavo-convex structure surface side, the optical substrate PP according to this Embodiment;

FIG. 11 contains cross-sectional schematic diagrams illustrating the optical substrate PP according to this Embodiment;

FIG. 12 is a plan schematic diagram illustrating a pattern X in the case of viewing, from the concavo-convex structure surface side, the optical substrate PP according to this Embodiment;

FIG. 13 is a graph in which the horizontal axis represents a line segment YY', and the vertical axis represents light and dark of the pattern X in the case of observing, from the concavo-convex structure surface side, the optical substrate PP as shown in FIG. 12;

FIG. 14 is another graph in which the horizontal axis represents the line segment YY', and the vertical axis represents light and dark of the pattern X in the case of observing, from the concavo-convex structure surface side, the optical substrate PP as shown in FIG. 12;

FIG. 15 is still another graph in which the horizontal axis represents the line segment YY', and the vertical axis represents light and dark of the pattern X in the case of observing, from the concavo-convex structure surface side, the optical substrate PP as shown in FIG. 12;

FIG. 16 is still another graph in which the horizontal axis represents the line segment YY', and the vertical axis represents light and dark of the pattern X in the case of observing, from the concavo-convex structure surface side, the optical substrate PP as shown in FIG. 12;

FIG. 17 is a plan schematic diagram illustrating the pattern X observed in the case of viewing, from the concavo-convex structure side, the optical substrate PP according to this Embodiment;

FIG. 18 is a plan schematic diagram illustrating the concavo-convex structure in the case of viewing, from the concavo-convex structure side, the optical substrate PP according to this Embodiment;

FIG. 19 is a top diagram in the case where the concavo-convex structure PP constituting the concavo-convex structure surface is a dot structure in the optical substrate PP according to this Embodiment;

FIG. 20 contains cross-sectional schematic diagrams of the concavo-convex structure PP in a line segment position that corresponds to a pitch P' shown in FIG. 19;

FIG. 21 is a top diagram in the case where the concavo-convex structure PP constituting the concavo-convex structure surface is a hole structure in the optical substrate PP according to this Embodiment;

FIG. 22 contains cross-sectional schematic diagrams of the concavo-convex structure PP in a line segment position that corresponds to a pitch P' shown in FIG. 21;

FIG. 23 contains explanatory diagrams illustrating top images in the case of observing, from the concavo-convex structure surface side, the optical substrate PP according to this Embodiment;

FIG. 24 is a cross-sectional schematic diagram of a semiconductor light emitting device to which is applied an optical substrate D according to this Embodiment;

FIG. 25 is a cross-sectional schematic diagram of another example of the semiconductor light emitting device to which is applied the optical substrate D according to this Embodiment;

FIG. 26 is a cross-sectional schematic diagram of still another example of the semiconductor light emitting device to which is applied the optical substrate D according to this Embodiment;

FIG. 27 is a schematic diagram illustrating a relationship between a cross-sectional schematic diagram showing an example of the optical substrate D according to this Embodiment and a graph showing a distribution of effective refractive index Nema;

FIG. 28 is another schematic diagram illustrating the relationship between a cross-sectional schematic diagram showing an example of the optical substrate D according to this Embodiment and a graph showing a distribution of effective refractive index Nema;

FIG. 29 is still another schematic diagram illustrating the relationship between a cross-sectional schematic diagram showing an example of the optical substrate D according to this Embodiment and a graph showing a distribution of effective refractive index Nema;

FIG. 30 contains cross-sectional schematic diagrams illustrating the optical substrate D according to this Embodiment;

FIG. 31 contains cross-sectional schematic diagrams illustrating the optical substrate D according to this Embodiment;

FIG. 32 contains a top diagram, viewed from the concavo-convex structure surface side, showing an example of the optical substrate D according to this Embodiment and a graph showing a distribution of effective refractive index Nema;

FIG. 33 contains a cross-sectional schematic diagram showing an example of the optical substrate D according to this Embodiment and a graph showing a distribution of effective refractive index Nema; FIG. 34 contains another cross-sectional schematic diagram showing an example of the optical substrate D according to this Embodiment and a graph showing a distribution of effective refractive index Nema; FIG. 35 is a perspective schematic diagram showing an example of an optical substrate PC according to this Embodiment;

FIG. 36 is a perspective schematic diagram showing another example of the optical substrate PC according to this Embodiment;

FIG. 37 is a plan schematic diagram illustrating the optical substrate PC according to this Embodiment;

FIG. 38 is a schematic diagram showing an arrangement example of dot lines in a second direction D2 of the optical substrate PC according to this Embodiment;

FIG. 39 is a plan schematic diagram showing another example of the optical substrate PC according to this Embodiment;

FIG. 40 is a plan schematic diagram showing still another example of the optical substrate PC according to this Embodiment;

FIG. 41 is a plan schematic diagram showing still another example of the optical substrate PC according to this Embodiment;

FIG. 42 is a plan schematic diagram showing still another example of the optical substrate PC according to this Embodiment;

FIG. 43 is a plan schematic diagram showing still another example of the optical substrate PC according to this Embodiment;

FIG. 44 is a schematic diagram showing an arrangement example of dot lines in the second direction D2 of the optical substrate according to this Embodiment;

FIG. 45 is a schematic diagram showing another arrangement example of dot lines in the second direction D2 of the optical substrate according to this Embodiment;

FIG. 46 contains cross-sectional schematic diagrams illustrating each step of a manufacturing method of a semiconductor light emitting device according to this Embodiment;

FIG. 47 is a schematic explanatory diagram showing an example of a manufacturing method of the optical substrate PC according to this Embodiment;

FIG. 48 contains explanatory diagrams to explain an example of setting a reference pulse signal and modulated pulse signal using a Z-phase signal of a spindle motor as a reference signal in an exposure apparatus for forming the optical substrate PC according to this Embodiment;

FIG. 49 is an explanatory diagram to explain an example of setting a phase-modulated pulse signal from a reference pulse signal and modulated pulse signal in the exposure apparatus for forming the optical substrate PC according to this Embodiment;

FIG. 50 is an explanatory diagram to explain an example of a shift velocity of a processing head portion that applies laser light in the exposure apparatus for forming the optical substrate PC according to this Embodiment;

FIG. 51 contains scanning electron microscope photographs showing the concavo-convex structure of the optical substrate D prepared in an Example of the present invention;

FIG. 52 contains scanning electron microscope photographs showing the concavo-convex structure of the optical substrate D prepared in another Example of the present invention;

FIG. 53 is a scanning microscope photograph showing the concavo-convex structure D of a sapphire substrate prepared in an Example of the present application;

FIG. 54 contains scanning microscope photographs showing the concavo-convex structure D of a sapphire substrate prepared in another Example of the present application;

FIG. 55 contains scanning microscope photographs showing the concavo-convex structure D of a sapphire substrate prepared in still another Example of the present application; and

FIG. 56 contains scanning microscope photographs showing the concavo-convex structure D of a sapphire substrate prepared in still another Example of the present application.

Best Mode for Carrying Out the Invention

It is a feature of an optical substrate according to the present invention that there is at least one pattern which is larger than a concavo-convex structure and which is capable of being recognized by emitted light of a semiconductor light emitting device, in addition to the concavo-convex structure existing as an entity, in an interface position of the semiconductor light emitting device in noting the semiconductor light emitting device manufactured by applying the optical substrate. By this means, effects are exerted in manufacturing the semiconductor light emitting device and using the manufactured semiconductor light emitting device. First, in manufacturing the semiconductor light emitting device, the internal quantum efficiency IQE is improved in association with decreases in the dislocation of the semiconductor crystal layer, or a contact area between the p-type semiconductor layer and the n-type conductive layer is increased to improve the electron injection efficiency EIE. Then, in using the semiconductor light emitting device, it is possible to maintain a state in which the internal quantum efficiency IQE or electron injection efficiency EIE is improved, and enhance optical light scattering properties with respect to the emitted light of the semiconductor light emitting device, and therefore, the light extraction efficiency LEE is concurrently increased. That is, it is possible to actualize the semiconductor light emitting device with the internal quantum efficiency IQE and light extraction efficiency LEE or electron injection efficiency EIE and light extraction efficiency LEE concurrently improved. Further, it is possible to provide the semiconductor light emitting device with the internal quantum efficiency IQE, electron injection efficiency EIE and light extraction efficiency LEE concurrently improved.

In order to concurrently increase the internal quantum efficiency IQE or electron injection efficiency EIE and light extraction efficiency LEE By the above-mentioned technical idea i.e. the concavo-convex structure existing as an entity and the pattern that is larger than the concavo-convex structure and that is capable of being recognized by emitted light of a semiconductor light emitting device, three optical substrates are proposed in the present description. These optical substrates will be described as an optical substrate PP, optical substrate D and optical substrate PC, and each substrate will be described individually. Further, concavo-convex structures provided on the optical substrate PP, optical substrate D and optical substrate PC will be described as a concavo-convex structure PP, concavo-convex structure D and concavo-convex structure PC, respectively. Furthermore, in the following description, the description will be started with the optical substrate PP, and when overlapping portions exist in the content of the optical substrate PP and optical substrate D or optical substrate PC, in describing the optical substrate D or optical substrate PC, the content of the optical substrate PP will be cited.

«Optical substrate PP»

The general outline of the optical substrate PP of the present invention will be described first. Generally, the external quantum efficiency EQE of a semiconductor light emitting device is determined by the internal quantum efficiency IQE, light extraction efficiency LEE and electron injection efficiency EIE. Particularly, since the internal quantum efficiency IQE affects the efficiency at which the semiconductor light emitting device emits light, the effect by improvements is significantly high. Further, even when the internal quantum efficiency IQE is improved, in the case where the light extraction efficiency LEE is low, the emitted light is absorbed inside the semiconductor layer and is transformed to heat. Therefore, it is an effective method to concurrently actualize increases in internal quantum efficiency IQE and improvements in light extraction efficiency LEE in the relationship of mutually tradeoffs, in order to actualize high external quantum efficiency EQE. Then, differences in the principle were noted in increases in internal quantum efficiency IQE and improvements in light extraction efficiency LEE in the relationship of mutually tradeoffs.

In a semiconductor light emitting device, it is possible to increase the internal quantum efficiency IQE by a concavo-convex structure of a high density, and on the other hand, it is possible to increase the light extraction efficiency LEE by a concavo-convex structure with a large change in the volume exhibiting strong optical scattering properties. That is, in the case of providing the concavo-convex structure of a high density so as to increase the internal quantum efficiency IQE, the change in the volume of the concavo-convex structure is small, and since the optical scattering properties decrease, the degree of increases in light extraction efficiency LEE is limited. This can be explained by an optical phenomenon recognizable by the emitted light of the semiconductor light emitting device. In the concavo-convex structure having a sufficient density to increase the internal quantum efficiency IQE, a pitch of the concavo-convex structure is of an order equal to or less than the order of wavelengths of the emitted light. Then, as the wavelength of the emitted light increases relative to the pitch of the concavo-convex structure, the effective medium approximation acts as an optical phenomenon, and this is because the optical scattering properties decrease. On the other hand, in the case of increasing the change in the volume of the concavo-convex structure to enhance the light extraction efficiency LEE, since the density of the concavo-convex structure existing as an entity decreases, the effect of dispersing dislocations is weakened, and the degree of improvements in internal quantum efficiency IQE is limited.

Therefore, in the case of increasing the change in the volume of the concavo-convex structure existing as an entity for the purpose of increasing the optical scattering properties, the internal quantum efficiency IQE decrease as described above, and further, since the volume change rate of the concavo-convex structure existing as an entity is increased, there are problems associated with cracks in the semiconductor crystal layer, used amount of the semiconductor crystal layer, deposition time of the semiconductor crystal layer or the like i.e. issues of manufacturing the semiconductor light emitting device and environmental suitability.

From the foregoing, in order to concurrently improve the internal quantum efficiency IQE and light extraction efficiency LEE, while achieving the environmental suitability without interfering with manufacturing of the semiconductor light emitting device, we thought that it is important to develop the optical scattering properties by a concavo-convex structure capable of improving the internal quantum efficiency IQE, and arrived at completion of the present invention.

That is, by actualizing a concavo-convex structure for enabling the optical scattering properties to be strengthened that is even the concavo-convex structure of a high density, it is thought that it is possible to concurrently increase the internal quantum efficiency IQE and light extraction efficiency LEE in the relationship of mutually tradeoffs.

Further, the n-type semiconductor layer, light emitting semiconductor layer, p-type semiconductor layer and n-type conductive layer have large absorption in the semiconductor light emitting device. That is, from the viewpoint of effectively extracting the emitted light to the outside of the semiconductor light emitting device, it is naturally necessary to thin these layers to nano-order. In other words, in the case of providing a concavo-convex structure in any of interfaces of the semiconductor light emitting device to increase the light extraction efficiency LEE, the concavo-convex structure is necessarily the concavo-convex structure of nano-order. As described already, the optical scattering properties of the concavo-convex structure of a high density are small. That is, the degree of increases in light extraction efficiency LEE is limited.

In consideration of this viewpoint, by actualizing a concavo-convex structure for enabling the optical scattering properties to be strengthened that is even the concavo-convex structure of a high density, it can be thought that it is possible to more increase the light extraction efficiency LEE of the semiconductor light emitting device.

For example, in the case of providing a concavo-convex structure with a simply large specific surface area in between the p-type semiconductor layer and the n-type conductive layer, since it is possible to increase ohmic contact with increases in the interface contact area, the electron injection efficiency EIE is increased. However, as described already, since these concavo-convex structures are high-density concavo-convex structures and the optical scattering properties are small, the degree of increases in light extraction efficiency LEE is limited.

Further, for example, in the case of attempting to more increase the light extraction efficiency LEE by providing a concavo-convex structure on the surface of the n-type conductive layer, since the thickness of the n-type conductive layer itself is limited to nano-order, the concavo-convex structure is also a high-density concavo-convex structure of nano-order, and the optical scattering properties are not increased. In other words, the degree of increases in light extraction efficiency LEE is limited.

That is, it is the gist of the present invention to provide a concavo-convex structure with large optical scattering properties that is even a concavo-convex structure of a high density. By this means, it is possible to concurrently improve the internal quantum efficiency IQE or electron injection efficiency EIE, and the light extraction efficiency LEE. Further, also in the case of providing the concavo-convex structure in each of thin layers of nano-order constituting the semiconductor light emitting device, it is possible to increase the light extraction efficiency LEE without impairing physical properties of these layers.

In addition, in the following description, the description will be given by focusing on concurrently increasing the internal quantum efficiency IQE and light extraction efficiency LEE, but the essence is to strongly develop the optical scattering properties even in the high-density concavo-convex structure, and therefore, it is possible to replace with the effect of concurrently increasing the electron injection efficiency EIE and light extraction efficiency LEE. That is, the internal quantum efficiency IQE is increased by dispersed and reduced dislocations by the high-density concavo-convex structure, and the electron injection efficiency EIE is more improved by ohmic contact properties improved by the high-density concavo-convex structure. At this point, since the high-density concavo-convex develops optical scattering properties, the light extraction efficiency LEE is concurrently improved. From the same technical idea, with the effect of concurrently increasing the internal quantum efficiency IQE and light extraction efficiency LEE typified to describe, it is possible to replace with the effect in the case of improving the concavo-convex structure in each of thin layers of nano-order constituting the semiconductor light emitting device i.e. improvements in light extraction efficiency LEE without impairing physical properties of these layers. For example, the film thickness of the transparent conductive layer of the semiconductor light emitting device is several hundreds of nanometers. Also in the case of providing the concavo-convex structure on the surface of the transparent conductive layer i.e. the interface between the transparent conductive layer and sealant, between the transparent conductive layer and the electrode pad, or between the transparent conductive layer and the p-type semiconductor layer in the semiconductor light emitting device, it is possible to maintain electrical properties of the transparent conductive layer and more increase the light extraction efficiency LEE.

That is, the optical substrate PP according to this Embodiment is the optical substrate PP provided with a substrate body, and the concavo-convex structure PP comprised of a plurality of convex portions or concave portions provided on the main surface of the substrate body, and is characterized in that at least one pattern observable at any magnification within a range of 10 times to 5,000 times with an optical microscope is drawn on the main surface, an interval of the pattern is larger than a pitch of the concavo-convex structure, and that in an optical microscope image of the pattern, the pattern is capable of being distinguished to a first region and a second region by a difference in light and dark, a plurality of first regions is arranged apart from one another at intervals, and the second region connects between the first regions.

In the optical substrate PP according to this Embodiment, an average pitch of the concavo-convex structure PP preferably ranges from 50 nm to 1,500 nm,

According to this configuration, first, by the concavo-convex structure PP comprised of a plurality of convex portions or concave portions, i.e. by the concavo-convex structure existing as an entity, since the growth mode of the semiconductor crystal layer is disturbed, dislocations inside the semiconductor crystal layer are dispersed microscopically, while being reduced, and the internal quantum efficiency IQE is improved.

On the other hand, the pitch of the concavo-convex structure PP is smaller than the interval of the pattern. In other words, a plurality of concavo-convex structure groups comprised of sets of a plurality of convex portions or concave portions is arranged on the main surface. That is, it is presumed that the plurality of convex portions or concave portions constituting the concavo-convex structure PP draws the pattern observable at any magnification within the range of 10 times to 5,000 times with an optical microscope on the main surface, by a difference in the element (for example, density, height, or shape) constituting the portions. The reason why the pattern is drawn is presumed that a change in effective refractive index Nema (Refractive Index under Effective Medium Approximation) with respect to the concavo-convex structure PP occurs by the difference in the element. That is, the optical pattern recognizable by light exists, in addition to the plurality of convex portions or concave portions existing as an entity. In other words, the optical pattern of the concavo-convex structure PP first appears in applying light to the concavo-convex structure. This pattern is capable of being distinguished to the first region and second region by a difference in light and dark in an optical microscope image, a plurality of first regions is arranged apart from one another at intervals, and the second region connects between the first regions. That is, the pattern comprised of the first region and second region is optically observed, and this pattern is expressed by sets of a plurality of convex portions or concave portions of the concavo-convex structure PP. In other words, inside the main surface of the optical substrate PP, the density of the plurality of first regions is smaller than the density of the concavo-convex structure PP constituting the pattern. By such a configuration, the following three effects are exhibited. First, dispersion properties of dislocations by the concavo-convex structure PP are held also macroscopically. That is, it is possible to lower the dislocation density of the semiconductor crystal layer provided on the optical substrate PP inside the surface. Second, it is possible to suppress cracks occurring in growth of the semiconductor crystal layer, while reducing the used amount of the semiconductor crystal layer, and it is also possible to reduce the deposition time of the semiconductor crystal layer. Finally, since the emitted light guided inside the semiconductor crystal layer is disturbed in its travel direction, the waveguide mode is disturbed. From the foregoing, it is possible to concurrently improve the internal quantum efficiency IQE and light extraction efficiency LEE, while achieving the environmental suitability without interfering with manufacturing of the semiconductor light emitting device.

Further, in the optical substrate PP according to the present invention, the average pitch of the concavo-convex structure PP preferably ranges from 10 nm to 900 nm, and the height of the concavo-convex structure PP preferably ranges from 10 nm to 500 nm.

According to this configuration, as the density of the concavo-convex structure PP increases, the effects of dispersion and reduction of dislocations are larger. Further, since the height is within a predetermined range, it is possible to suppress the occurrence of cracks with more excellence in depositing the semiconductor crystal layer, and in association therewith, it is possible to reduce the defect rate of the semiconductor light emitting device. Furthermore, the effects are more remarkable in decreases of the used amount of the semiconductor crystal layer and reductions of the deposition time. Moreover, by the height meeting the predetermined range, also when the thickness of the layer to provide the concavo-convex structure PP is nano-order and is extremely thin, it is possible to excellently maintain physical properties of the layer. By this means, it is possible to suppress decreases of factors except the light extraction efficiency LEE, in providing the concavo-convex structure PP in the interface position of the semiconductor light emitting device to increase the light extraction efficiency LEE. For example, in the case of providing the concavo-convex structure PP in the interface between the p-type semiconductor layer and n-type conductive layer (for example, transparent conductive layer. The same in the following description), in a state in which semiconductor characteristics of the p-type semiconductor layer and electrical characteristics of the n-type conductive layer are maintained, it is possible to improve ohmic contact properties, increase the electron injection efficiency EIE, and to improve the light extraction efficiency LEE. Further, for example, in the case of providing the concavo-convex structure PP on the surface of the n-type conductive layer or in the interface between the n-type conductive layer and the sealant, it is also possible to increase the light extraction efficiency LEE, while maintaining electrical characteristics of the n-type conductive layer.

Further, in the optical substrate PP of the invention, when each of three types of laser beams respectively with wavelengths of 640 nm to 660 nm, 525 nm to 535 nm and 460 nm to 480 nm is applied perpendicularly to the main surface of the optical substrate PP from the first surface side on which the concavo-convex structure PP exists of the optical substrate PP, with respect to at least one laser beam or more, it is preferable that the laser beam output from the second surface on the side opposite to the first surface splits in two or more.

According to this configuration, it is possible to increase the intensity of the optical pattern from the viewpoint of the semiconductor light emitting device. That is, it is possible to more increase the light extraction efficiency LEE.

Further, in the optical substrate PP of the invention, it is preferable that the average pitch of the concavo-convex structure PP ranges from 50 nm to 1,500 nm, the concavo-convex structure PP includes disturbances, and that a standard deviation and arithmetic mean of the element of the concavo-convex structure that is at least one factor of the disturbances meet the relationship of the following equation (1).

$$0.025 \leq (\text{standard deviation/arithmetic mean}) \leq 0.5 \ (1)$$

According to this configuration, among the above-mentioned effects, particularly the following two effects are more remarkable. First, the light extraction efficiency LEE is more increased. This is because by meeting the above-mentioned equation (1), the distribution of effective refractive index Nema is moderate from the viewpoint of the emitted light of the semiconductor light emitting device, and the optical scattering properties are more strengthened. Next, the effect is increased in suppressing cracks occurring in the semiconductor crystal layer. This is because the disturbances of the concavo-convex structure PP is kept in a predetermined range in observing the concavo-convex structure microscopically, and it is thereby possible to suppress concentration of stress applied to the semiconductor crystal layer by the concavo-convex structure PP.

Further, in the optical substrate PP of the invention, the optical substrate PP is applied to a semiconductor light emitting device comprised of at least an n-type semiconductor layer, a light emitting semiconductor layer, and a p-type semiconductor layer, and it is preferable that the concavo-convex structure PP includes dots comprised of the plurality of convex portions or concave portions, and forms a two-dimensional photonic crystal controlled by at least one of a pitch between dots, a dot diameter and a dot height, and that a period of the two-dimensional photonic crystal is two or more times an emission center wavelength of the semiconductor light emitting device.

According to this configuration, the difference in light and dark of the optical pattern observed in the optical substrate PP is more strengthened. That is, it is possible to more strongly develop the optical scattering properties, while ensuring the effect by providing the high-density concavo-convex structure. Particularly, since the period of the two-dimensional photonic crystal formed by a predetermined element of the concavo-convex structure PP is two or more times the emission center wavelength of the semiconductor light emitting device, the interaction between the emitted light and the optical pattern is strengthened, and in association therewith, the optical scattering properties are more strengthened. Accordingly, the light extraction efficiency LEE is more increased.

Further, the present invention includes semiconductor light emitting devices characterized in that at least a first semiconductor layer, light emitting semiconductor layer and second semiconductor layer are layered on the main surface of the above-mentioned optical PP of the invention.

Furthermore, the present invention includes manufacturing methods of semiconductor light emitting devices using the above-mentioned optical PP of the invention.

Hereinafter, one Embodiment (hereinafter, abbreviated as "Embodiment") of the present invention will specifically be described with reference to drawings. In addition, the present invention is not limited to the following Embodiment, and is capable of being carried into practice with various modifications thereof within the subject matter thereof.

The concavo-convex structure existing as an entity in the present description means as it is written, and means that the concavo-convex structure exists on the surface of the substrate as a physical structure body. Particularly, in the present description, the concavo-convex structure observed by observation using a scanning electron microscope is referred to as the concavo-convex structure existing as an entity. On the other hand, the pattern recognizable by light is the word indicating what concavo-convex structure exists from the viewpoint of the light. Generally, irrespective of differences in resolution, the order of the observed concavo-convex structure is equal both in the case of optically detecting and in the case of detecting with an electron beam. However, according to findings found out by the present description, when the concavo-convex structure existing as an entity i.e. the concavo-convex structure physically existing is viewed from light, there is the case where the pattern of a different order from the order of the concavo-convex structure existing as an entity is observed based on optical viewpoint. That is, there is the case where the order of the concavo-convex structure existing as an entity is different from the order of an optically effective image of the concavo-convex structure obtained in observing the concavo-convex structure existing as an entity by an optical technique. In considering the concavo-convex structure existing as an entity through such an optical phenomenon, in order to express that the pattern of the order different from that of the concavo-convex structure existing as an entity exists, the words of recognizable by light are used. From such a viewpoint, it is possible to translate the pattern recognizable by light to a pattern detectable by light, a pattern capable of being felt by light, or an optically drawn pattern. Further, it is also possible to translate to a state in which light behaves as if the pattern different from the material substance optically exists, or a state in which as if a medium corresponding to the distribution of refractive index exists in the case of being viewed from light. In addition, in the present description, such a pattern is defined by optical microscope observation. This is because the fact that the pattern of the order different from that of the material substance is observed by optical microscope observation is synonymous with the state in which light behaves as if the pattern different from the material substance optically exists. That is, it is possible to link the information capable of being obtained by optical microscope observation to optical scattering properties with respect to the semiconductor light emitting device.

First, the effects in using the optical substrate PP according to this Embodiment will be described generally. In manufacturing a semiconductor light emitting device, due to the high-density concavo-convex structure PP existing as an entity, developed are effects of improving the internal quantum efficiency IQE, reducing the occurrence of cracks in the semiconductor crystal layer and reducing the used amount of the semiconductor crystal layer. Then, in using the semiconductor light emitting device, due to the optical pattern recognizable by light, the light extraction efficiency LEE is improved. Here again, in the case of using the concavo-convex structure that does not draw the optical pattern i.e. of a simply high density, the above-mentioned effects in manufacturing the semiconductor light emitting device are developed, but the degree of development of the effect in using is limited. Conversely, in the case of using the concavo-convex structure with a large change in the volume with large optical scattering properties, the above-mentioned effect in using the semiconductor light emitting device is developed, but the degree of the effects in manufacturing is limited. Similarly, in the case where the order of the optical pattern is the order of the concavo-convex structure PP or less, the effect in using the semiconductor light emitting device is developed, but the degree of the effects in manufacturing is limited. In other words, in the optical substrate PP according to this Embodiment, functions are divided into the function developing in manufacturing the semiconductor light emitting device and the function developing in using the semiconductor light emitting device by the concavo-convex structure existing as an entity and the pattern recognizable by emitted light. By this means, it is possible to develop strong optical scattering properties by the high-density concavo-convex structure which have conventionally been difficult to actualize, and concurrently improve the internal quantum efficiency IQE and the light extraction efficiency LEE.

Described first is the substrate body of the optical substrate PP. The substrate body of the optical substrate PP according to this Embodiment is a substrate for a semiconductor light emitting device in contact with at least one of the n-type semiconductor layer comprised of one or more layers, the light emitting semiconductor layer comprised of one or more layers, the p-type semiconductor layer comprised of one or more layers and the n-type conductive layer comprised of one or more layers constituting the semiconductor light emitting device. That is, the substrata body may be a single-layer substrate comprised of only one kind of material or a multi-layer substrate comprised of a plurality of materials. For example, with respect to a semiconductor light emitting device including a laminate structure comprised of sapphire/n-GaN/MQW/p-GaN/ITO, it is possible to regard, as the substrate body, sapphire, a laminate comprised of sapphire/n-GaN/MQW/p-GaN, a laminate comprised of sapphire/n-GaN/MQW/p-GaN/ITO or the like. In other words, it is possible to modify the configuration of the substrate body as appropriate to provide the concavo-convex structure PP on the surface or interface of the semiconductor light emitting device.

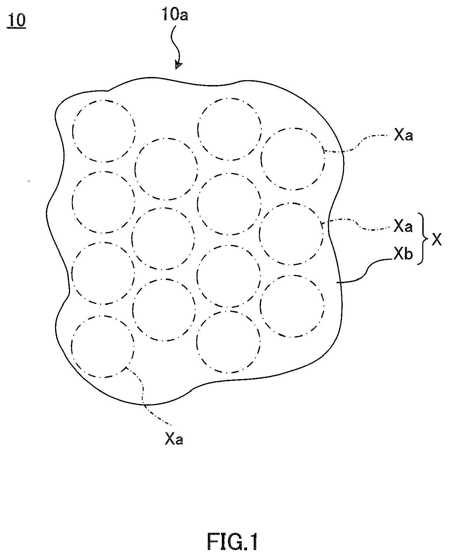

The semiconductor light emitting device will be described below with reference to drawings. FIG. 1 is an explanatory illustrating the pattern drawn on the main surface of the optical substrate PP according to this Embodiment. On a main surface 10a of an optical substrate PP 10 is provided the concavo-convex structure PP (not shown in the figure) comprised of a plurality of convex portions and concave portions. In other words, the main surface 10a of the optical substrate PP 10 is covered with a plurality of convex portions or concave portions (not shown in the figure). In the case of observing the main surface 10a with an optical microscope, a pattern X is drawn by the convex portions or concave portions constituting the concavo-convex structure PP, and is capable of being distinguished to a first region Xa and a second region Xb by a difference in light and dark. A plurality of first regions Xa exists, and is arranged apart from one another at intervals. The second region Xb connects between the first regions Xa.

The pattern X is dependent on the pitch, height or diameter of convex portions or concave portions constituting the concavo-convex structure PP, and is capable of being observed at any magnification within a range of 10 times to 5,000 times using an optical microscope. In addition, it is not possible to observe the pattern by the naked eye, but it is possible to observe light diffraction and light scattering that is the optical phenomenon occurring due to the pattern.

Herein, being observable at any magnification within a range of 10 times to 5,000 times means that the pattern X is first recognizable at a magnification A ($10 \leq A \leq 5,000$) in observing the main surface of the optical substrate PP 10 while increasing the observation magnification gradually using the optical microscope, and that there is a state in which the observation image is too large or sharpness of the interface between the region Xa and the region Xb extremely decreases not to recognize the pattern X in further increasing to a magnification B that is a higher magnification than the magnification A. That is, in observation using the optical microscope, it is essential only that the pattern X is observed at any magnification within the range of 10 times to 5,000 times. In addition, in the pattern X, images may be different corresponding to the magnification of the optical microscope. That is, for example, an optical pattern in the shape of mutually approximately parallel lines having irregular intervals may be observed in observing at a magnification H ($10 \leq H \leq 5,000$), a circular optical pattern may be observed in the pattern in the shape of the lines in further increasing the magnification to a magnification I ($10 \leq H < I \leq 5,000$), and only the circular pattern may be observed in further increasing the magnification to a magnification J ($10 \leq H < I < J \leq 5,000$). Also at such low magnifications and high magnifications, by the optical patterns X being observed, while being different from one another, the effect of optical scattering properties as described below is more strengthened, and the degree of improvements in light extraction efficiency LEE is increased. By the fact that the pattern X is observed at any magnification within the range of 10 times to 5,000 times, it is possible to develop optical scattering properties as described below, and it is thereby possible to improve the light extraction efficiency LEE with increases in internal quantum efficiency IQE maintained.

It is presumed that the pattern X is drawn by a change occurring in the effective refractive index Nema with respect to the concavo-convex structure PP due to a difference in the element constituting a plurality of convex portions or concave portions forming the concavo-convex structure PP. That is, it is presumed that the effective refractive index Nema has a distribution by a difference in the element of the concavo-convex structure PP. It is conceivable that reflection, diffraction, scattering or the like of light occurs corresponding to this distribution of effective refractive index Nema to draw the optical pattern X. Then, since the pattern X is able to change the travel direction of light, with respect to the semiconductor light emitting device, the light extraction efficiency LEE is improved. The element constituting a plurality of convex portions or concave portions may be an element generating a change in the effective refractive index Nema with respect to the concavo-convex structure PP, and for example, is a height of the convex portion or concave portion, pitch, diameter of the concave-portion bottom portion, or an opening diameter of the concave portion. The element will be described later. In addition, the effective refractive index Nema is not an actually measured value, and is a value obtained by calculation based on the optical phenomenon as a premise. Herein, the premise as the optical phenomenon is effective medium approximation. It is possible to express this effective medium approximation readily with a volume fraction of the distribution of dielectric constant. That is, the difference in the element of the concavo-convex structure PP is calculated as the volume fraction of the distribution of dielectric constant, and the resultant is transformed into the refractive index to calculate. In addition, the dielectric constant is the square of the refractive index.

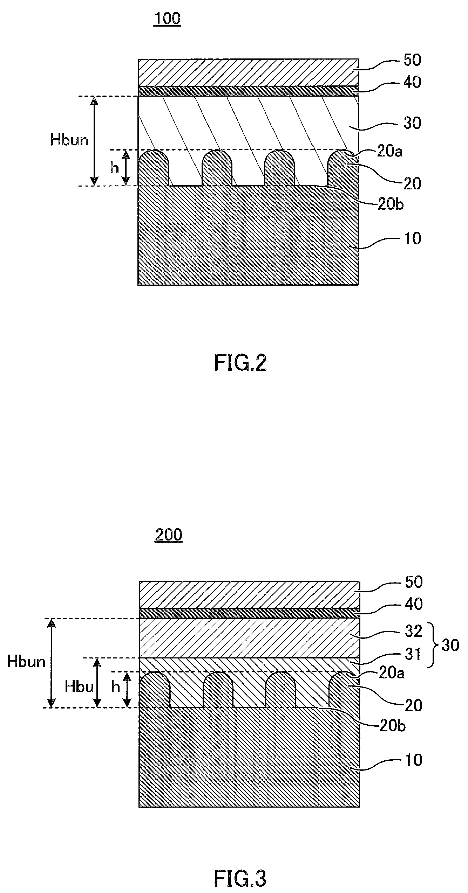

FIG. 2 is a cross-sectional schematic diagram showing an example of the semiconductor light emitting device to which is applied the optical substrate PP according to this Embodiment. As shown in FIG. 2, in a semiconductor light emitting device 100, the optical substrate PP 10 is provided with a concavo-convex structure 20 on its surface. In FIGs. 2 to 23, this concavo-convex structure 20 is the concavo-convex structure PP forming the pattern X. The concavo-convex structure 20 is comprised of a plurality of convex portions 20a and concave portion 20b connecting the portions, and as described previously, the pattern X (not shown in the figure) is optically expressed by sets of the concavo-convex structure 20. A first semiconductor layer 30, light emitting semiconductor layer 40 and second semiconductor layer 50 are sequentially layered on the surface including the concavo-convex structure 20 i.e. the main surface of the optical substrate PP 10. Herein, emitted light (hereinafter, also simply referred to as emitted light) generated in the light emitting semiconductor layer 40 is extracted from the second semiconductor layer 50 side or the optical substrate side 10 side. Further, the first semiconductor layer 30 and the second semiconductor layer 50 are mutually different semiconductor layers. Herein, it is preferable that the first semiconductor layer 30 flattens the concavo-convex structure 20. This is because it is possible to reflect performance of the first semiconductor layer 30 as a semiconductor in the light emitting semiconductor layer 40 and the second semiconductor layer 50 and the internal quantum efficiency IQE is increased. In addition, in the semiconductor light emitting device 100, it is possible to replace the optical substrate PP with the optical substrate D or optical substrate PC as described later.

Further, as shown in FIG. 3, the first semiconductor layer 30 may be comprised of an undoped first semiconductor layer 31 and doped first semiconductor layer 32. Each of FIGs. 3 to 6 is a cross-sectional schematic diagram showing another example of the semiconductor light emitting device to which is applied the optical substrate PP according to this Embodiment. In addition, in semiconductor light emitting devices 200, 300, 400 and 500, it is possible to replace the optical substrate PP with the optical substrate D or optical substrate PC as described later. In this case, as shown in FIG. 3, in the semiconductor light emitting device 200, when the optical substrate PP 10, undoped first semiconductor layer 31 and doped first semiconductor layer 32 are layered in this order, in addition to improvements in internal quantum efficiency IQE, it is possible to reduce warpage, and shorten the manufacturing time of the semiconductor light emitting device 200. Herein, when the undoped first semiconductor layer 31 is provided so as to flatten the concavo-convex structure 20, it is possible to reflect performance of the undoped first semiconductor layer 31 as a semiconductor in the doped first semiconductor layer 32, light emitting semiconductor layer 40 and second semiconductor layer 50, and therefore, the internal quantum efficiency IQE is increased.

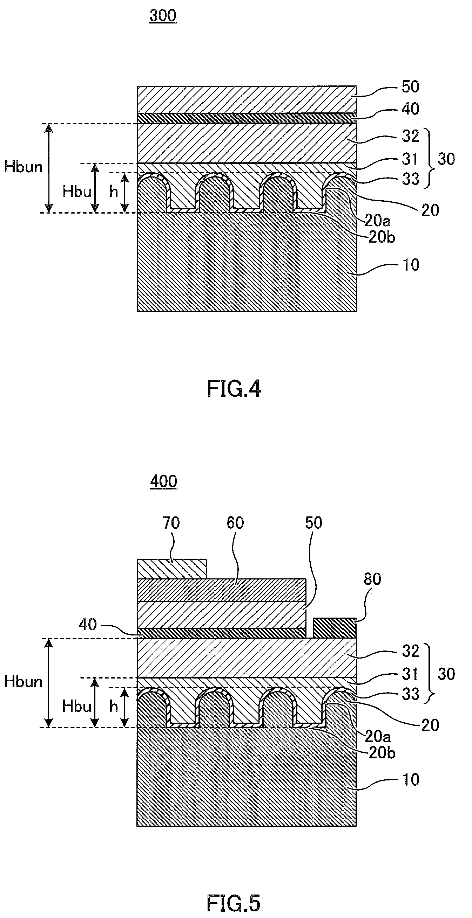

Further, as shown in FIG. 4, the undoped first semiconductor layer 31 preferably includes a buffer layer 33. As shown in FIG. 4, in the semiconductor light emitting device 300, the buffer layer 33 is provided on the concavo-convex structure 20, subsequently the undoped first semiconductor layer 31 and doped first semiconductor layer 32 are sequentially layered, nucleation and nucleus growth, which is the initial conditions of crystal growth of the first semiconductor layer 30, is thereby made excellent, the performance of the first semiconductor layer 30 as a semiconductor is enhanced, and the degree of improvements in internal quantum efficiency IQE is increased. Herein, the buffer layer 33 may be disposed to flatten the concavo-convex structure 20, but since a growth rate of the buffer layer 33 is slow, from the viewpoint of shortening the manufacturing time of the semiconductor light emitting device 300, it is preferable that the concavo-convex structure 20 is flattened by the undoped first semiconductor layer 31 provided on the buffer layer 33. When the undoped first semiconductor layer 31 is provided so as to flatten the concavo-convex structure 20, it is possible to reflect the performance of the undoped first semiconductor layer 31 as a semiconductor in the doped first semiconductor layer 32, light emitting semiconductor layer 40 and the second semiconductor layer 50, and therefore, the internal quantum efficiency IQE is increased. In addition, as shown in FIG. 4, the buffer layer 33 is disposed to cover the surface of the concavo-convex structure 20, and may also be provided partially on the surface of the concavo-convex structure 20. Particularly, it is possible to provide the buffer layer 33 preferentially in the concave-portion bottom portion of the concavo-convex structure 20 or in the side surface portion of the convex portion 20a of the concavo-convex structure 20.

The semiconductor light emitting devices 100, 200 and 300 respectively shown in FIGs. 2 to 4 are of an example of applying to the semiconductor light emitting device of double-hetero structure, and the layered structure of the first semiconductor layer 30, light emitting semiconductor layer 40 and second semiconductor layer 50 is not limited thereto.

As shown in FIG. 5, in the semiconductor light emitting device 400, it is possible to provide a transparent conductive layer 60 on the second semiconductor layer 50, an anode electrode 70 on the surface of the transparent conductive layer 60, and a cathode electrode 80 on the surface of the first semiconductor layer 30. The arrangement of the transparent conductive layer 60, anode electrode 70 and cathode electrode 80 can be optimized as appropriate corresponding to the semiconductor light emitting device, is thereby not limited, and generally, is provided as exemplified in FIG. 5.

The optical substrates PP 10 used in the semiconductor light emitting devices 100, 200, 300 and 400 respectively shown in FIGs. 2 to 5 are provided with the concavo-convex structure 20 comprised of convex portions 20a and concave portion 20b, and the convex portions 20a and concave portion 20b constituting the concavo-convex structure 20 draw the pattern X as described with reference to FIG. 1.

By manufacturing the semiconductor light emitting device using the optical substrate PP 10, it is possible to obtain three effects as described below.

(1) Increases in internal quantum efficiency IQE

By the concavo-convex structure 20, it is possible to disturb the growth mode of the first semiconductor layer 30. By this means, it is possible to cause dislocations occurring by lattice mismatch between the first semiconductor layer 30 and the optical substrate PP 10 to disappear in the vicinity of the concavo-convex structure 20 existing as an entity. Particularly, the pattern X is drawn by sets of the concavo-convex structure 20, and does not exist as an entity, and therefore, it is possible to disperse dislocations inside the surface of the optical substrate PP 10 to decrease the dislocation density. Further, since the pattern X does not exist as an entity, it is possible to suppress the occurrence of cracks in association with growth of the first semiconductor layer 30. From the foregoing, it is conceivable that the internal quantum efficiency IQE is increased.

(2) Increases in light extraction efficiency LEE

The fact that the pattern X is optically observable means that the emitted light behaves as if a unevenness corresponding to the pattern X exists without the pattern X existing as an entity. Therefore, the emitted light exhibits optical scattering properties (light diffraction or light scattering). In the semiconductor light emitting device, particularly in the LED device, for the purpose of increasing the light extraction efficiency LEE, a sapphire substrate (PSS: Patterned Sapphire Substrate) provided with a concavo-convex structure of micro-order has already been used, and when the first semiconductor layer 30 is deposited on the concavo-convex structure of micro-order, there is a problem that cracks tend to occur in the first semiconductor layer 30 in the vicinity of the convex-portion vertex portion of the concavo-convex structure. In this Embodiment, the light extraction efficiency LEE is improved by the pattern X. Herein, the pattern X is drawn by sets of the concavo-convex structure 20, and does not have material substance. That is, even when the size and interval of the first regions Xa constituting the observed pattern X are of micro-order, there is no structure of micro-order in the three-dimensional direction. Therefore, it is possible to suppress cracks occurring inside the first semiconductor layer 30. In other words, it is possible overcome the waveguide mode of the emitted light generated inside the semiconductor crystal layers (first semiconductor layer 30, light emitting semiconductor layer 40 and second semiconductor layer 50) by the pattern X, while suppressing cracks occurring inside the first semiconductor layer 30. This means that the travel direction of the emitted light, which should travel in only a predetermined travel direction due to the waveguide mode, is changed. That is, the emitted light is extracted to the outside of the semiconductor light emitting device by the pattern X.

As described above, the effects of (1) and (2) are concurrently satisfied. That is, it is possible to increase the efficiency of light emission itself, and to effectively extract the emitted light to the outside of the semiconductor light emitting device. Therefore, in the semiconductor light emitting devices 100, 200, 300 and 400 manufactured using the optical substrate PP 10 according to this Embodiment, the heating value is small. The fact that the heating value is small means that it is possible to not only improve long-term stability of the semiconductor light emitting device, and also reduce loads (for example, provision of excessive heat radiation member) according to heat radiation measures.

(3) Shortening of optical substrate PP manufacturing time and reduction of semiconductor crystal amount

Further, it means to enable the time (cost) taken to manufacture the optical substrate PP 10 to be reduced that the mechanism for increasing the light extraction efficiency LEE is optical scattering properties (light diffraction or light scattering) due to the pattern X drawn by sets of the concavo-convex structure 20. In the semiconductor light emitting device, particularly, in the LED device, for the purpose of increasing the light extraction efficiency LEE, the PSS has already been used, and there is the problem that it takes an extremely long time to manufacture the concavo-convex structure of micro-order. In the optical substrate PP 10 of the present invention, the pattern X is drawn by sets of the concavo-convex structure 20 and is observed. That is, even when the pattern X has the interval and size of micro-order, the size (structure) of the same order does not exist in the three-dimensional direction. Therefore, it is possible to reduce the cost taken to manufacture the optical substrate PP 10. Further, it also means that it is possible to reduce the semiconductor crystal amount to deposit. In LED manufacturing, the (MO)CVD process that is semiconductor crystal layer deposition process is rate determination, decreases throughput, and increases the material cost. The fact that it is possible to reduce the semiconductor crystal amount increases throughput properties of the (MO)CVD process, also means that the used material is reduced, and is thereby an important factor in manufacturing.

In addition, in the description using FIGs. 2 to 5 as described above, the description is given with the optical substrate PP as the substrate body, and as described previously, it is possible to select the substrate body as appropriate so as to provide the concavo-convex structure 20 (the interface) between the first semiconductor layer 30 and the light emitting semiconductor layer 40, the light emitting semiconductor layer 40 and the second semiconductor layer 50, the second semiconductor layer 50 and the transparent conductive layer 60, the transparent conductive layer 60 and the anode electrode 70, or the first semiconductor layer 30 and the cathode electrode 80. Further, as well as the substrates exemplified in FIGs. 2 to 5 as described above, it is possible to adopt substrates as described in the following «Optical substrate D», «Optical substrate PC», or «Semiconductor light emitting device».

That is, as the substrate body of the optical substrate PP 10 according to this Embodiment, since it is possible to apply the concavo-convex structure 20 to the interface position of the semiconductor light emitting device as described above, the substrate body is not limited particularly, as long as it is possible to use the substrate body as a substrate for a semiconductor light emitting device. For example, it is possible to use substrates of sapphire, silicon carbide, silicon nitride, gallium nitride, copper-tungsten alloy (W-Cu), silicon, zinc oxide, magnesium oxide, manganese oxide, zirconium oxide, manganese oxide-galvanized iron, magnesium aluminum oxide, zirconium boride, gallium oxide, indium oxide, lithium gallium oxide, lithium aluminum oxide, neodymium gallium oxide, lanthanum strontium aluminum tantalum oxide, strontium titanium oxide, titanium oxide, hafnium, tungsten, molybdenum, gallium phosphide, gallium arsenide and the like. Among the substrates, from the viewpoint of lattice matching with the semiconductor crystal layer, it is preferable to apply substrates of sapphire, gallium nitride, gallium phosphide, gallium arsenide, silicon carbide substrate, spinel substrate and the like. Further, the substrate may be used alone, or a substrate of a hetero structure may be used in which another substrate is provided on the substrate body using the substrates.

The first semiconductor layer 30 or n-type semiconductor layer is not limited particularly, as long it is possible to use as the n-type semiconductor layer suitable for an LED. For example, it is possible to apply materials obtained by doping various elements to element semiconductors such as silicon and germanium, chemical semiconductors of group III-V, group II-VI, group VI-VI and the like and others as appropriate. Further, it is possible to provide the n-type semiconductor layer and p-type semiconductor layer respectively with an n-type clad layer and p-type clad layer, not shown, as appropriate.

The light emitting semiconductor layer 40 is not limited particularly, as long as the layer has the light emitting property as an LED. For example, as the light emitting semiconductor layer 40, it is possible to apply semiconductor layers of AsP, GaP, AlGaAs, AlGaAsInGaN, GaN, AlGaN, ZnSe, AlHaInP, ZnO and the like. Further, the light emitting semiconductor layer 40 may be doped with various elements as appropriate corresponding to characteristics.

Further, materials of the second semiconductor layer 50 or p-type semiconductor layer are not limited particularly, as long as it is possible to use the materials as the p-type semiconductor layer suitable for an LED. For example, it is possible to apply materials obtained by doping various elements to element semiconductors such as silicon and germanium, chemical semiconductors of group III-V, group II-VI, group VI-VI, and the like and others as appropriate.

It is possible to deposit these layered semiconductor layers (n-type semiconductor layer, light emitting semiconductor layer 40, and p-type semiconductor layer) by publicly-known techniques. For example, as the deposition method, it is possible to apply Metal Organic Chemical Vapor Deposition (MOCVD), Hydride Vapor Phase Epitaxy (HVPE), Molecular Beam Epitaxy (MBE) and the like.

Materials of the transparent conductive layer are not limited particularly, as long as it is possible to use the materials as the transparent conducive layer suitable for an LED. For example, it is possible to apply metal thin films of a Ni/Au electrode and the like, conductive oxide films of ITO, ZnO, $In_2O_3$, $SnO_3$, IZO, IGZO and the like, etc. Particularly, from the viewpoints of transparency and electrical conductivity, ITO is preferable.

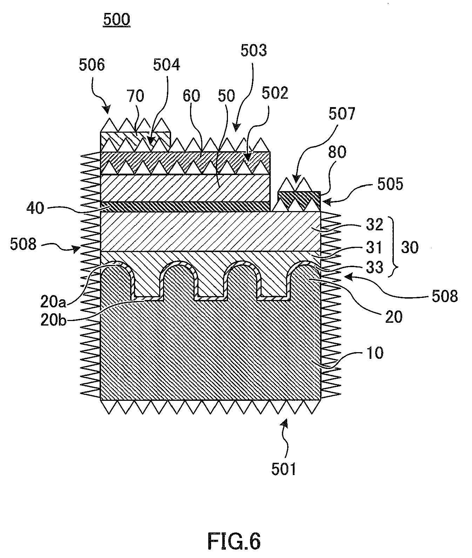

Further, in the semiconductor light emitting device 400 as shown in FIG. 5, the concavo-convex structure 20 is provided between the optical substrate PP 10 and the first semiconductor layer 30, and as shown in FIG. 6, it is also possible to further provide other concavo-convex structures. As shown in FIG. 6, as the concavo-convex structures to separately provide, there are the following structures.

- Concavo-convex structure 501 provided on the surface on the side opposite to the light emitting semiconductor layer 40 of the optical substrate PP 10
- Concavo-convex structure 502 provided between the second semiconductor layer 50 and the transparent conductive layer 60
- Concavo-convex structure 503 provided on the surface of the transparent conductive layer 60
- Concavo-convex structure 504 provided between the transparent conductive layer 60 and the anode electrode 70
- Concavo-convex structure 505 provided between the first semiconductor layer 30 and the cathode electrode 80
- Concavo-convex structure 506 provided on the surface of the anode electrode 70
- Concavo-convex structure 507 provided on the surface of the cathode electrode 80
- Concavo-convex structure 508 provided on side surfaces of the first semiconductor layer 30, light emitting semiconductor layer 40, second semiconductor layer 50 and optical substrate PP 10

By further providing at least one concavo-convex structure among the concavo-convex structures 501 to 508 as well as the concavo-convex structure 20 of the optical substrate PP 10, it is possible to develop effects corresponding to each of the concavo-convex structure 501 to 508 as described below.

By providing the concavo-convex structure 501, since it is possible to suppress total reflection on the backside (surface on the side opposite to the concavo-convex structure 20) of the optical substrate PP 10, the light extraction efficiency LEE is further increased. That is, it is possible to more effectively extract the emitted light, which is emitted effectively by increasing the internal quantum efficiency IQE by the concavo-convex structure 20 of the optical substrate PP 10, to the outside of a semiconductor light emitting device 500. Further, it is also possible to reduce warpage of the semiconductor light emitting device 500. Accordingly, in the semiconductor light emitting device 500 using the optical substrate PP 10 according to this Embodiment, it is preferable to further provide the concavo-convex structure 501. The interval among a plurality of convex portions of the concavo-convex structure 501 preferably ranges from 1 $\mu$m to 500 $\mu$m. By this means are developed the effects of light extraction efficiency LEE and reductions in warpage. From the same effects, particularly, the range of 5 μm to 100 μm is more preferable, and the range of 5 μm to 50 μm is the most preferable.

By providing the concavo-convex structure 502, it is possible to enhance ohmic contact properties and also to increase the light extraction efficiency LEE, and therefore, the external quantum efficiency EQE is significantly improved. Further, since diffusion properties of electrons in the transparent conductive layer 60 are enhanced, it is possible to increase the size of the semiconductor light emitting device chip. This concavo-convex structure 502 is naturally a high-density concavo-convex structure of nano-order. From this viewpoint, in order to more increase the light extraction efficiency LEE, the concavo-convex structure 502 is preferably one of the concavo-convex structure PP, concavo-convex structure D and concavo-convex structure PC as described below.

By providing the concavo-convex structure 503, it is possible to suppress total reflection in the transparent conductive layer 60, and therefore, the light extraction efficiency LEE is more increased. Particularly, there is a strong tendency that the refractive index is different between the transparent conductive layer 60 and its outside (mainly, sealant), and therefore, by disturbing the waveguide mode due to the concavo-convex structure 503, the external quantum efficiency EQE is effectively improved. Accordingly, in the semiconductor light emitting device 500 using the optical substrate PP 10 according to this Embodiment, it is preferable to further provide the concavo-convex structure 503. This concavo-convex structure 503 is naturally a high-density concavo-convex structure of nano-order. From this viewpoint, in order to more increase the light extraction efficiency LEE, the concavo-convex structure 503 is preferably one of the concavo-convex structure PP, concavo-convex structure D and concavo-convex structure PC as described below.

By providing the concavo-convex structure 504, since it is possible to reduce ohmic resistance and to enhance ohmic contact properties, it is possible to improve the electron injection efficiency EIE, and it is possible to increase the external quantum efficiency EQE. The external quantum efficiency EQE is determined by the product of the electron injection efficiency EIE, internal quantum efficiency IQE, and light extraction efficiency LEE. By using the optical substrate PP 10 of the present invention, both the internal quantum efficiency IQE and the light extraction efficiency LEE are increased. Accordingly, in the semiconductor light emitting device 500 using the optical substrate PP 10 according to this Embodiment, it is preferable to further provide the concavo-convex structure 504. This concavo-convex structure 504 is naturally a high-density concavo-convex structure of nano-order. From this viewpoint, in order to more increase the light extraction efficiency LEE, the concavo-convex structure 504 is preferably one of the concavo-convex structure PP, concavo-convex structure D and concavo-convex structure PC as described below.

By providing the concavo-convex structure 505, since the contact area between the first semiconductor layer 30 and the cathode electrode 80 is increased, it is possible to suppress peeling of the cathode electrode 80.

By providing the concavo-convex structure 506, since the fix strength of wiring connected to the anode electrode 70 is increased, it is possible to suppress peeling.

By providing the concavo-convex structure 507, since the fix strength of wiring provided on the surface of the cathode electrode 80 is increased, it is possible to suppress peeling.

By providing the concavo-convex structure 508, since it is possible to increase emission light quantities output from the side surfaces of the first semiconductor layer 30, light emitting semiconductor layer 40, second semiconductor layer 50 and optical substrate PP 10, it is possible to reduce the rate of emitted light which attenuates and disappears in the waveguide mode. Therefore, the light extraction efficiency LEE is increased, and it is possible to enhance the external quantum efficiency EQE.

As described above, by using the optical substrate PP 10 according to this Embodiment, it is possible to increase the internal quantum efficiency IQE and light extraction efficiency LEE of the semiconductor light emitting device 500. Moreover, by further providing at least one concavo-convex structure of the concavo-convex structures 501 to 508 as described above, it is possible to develop the effects due to the concavo-convex structures 501 to 508. Particularly, from the viewpoint of more increasing the light extraction efficiency LEE, it is preferable to provide at least one of the concavo-convex structure 501, concavo-convex structure 503 and concavo-convex structure 504. Further, from the viewpoint of increasing the electron injection efficiency EIE, it is preferable to provide the concavo-convex structure 504. The most preferable case is that semiconductor light emitting device 500 is provided with the concavo-convex structures 503 and 504, and that the concavo-convex structures 503 and 504 are the concavo-convex structure PP, the concavo-convex structure D as described below or the concavo-convex structure PC as described below. By this means, since it is possible to more increase the light extraction efficiency LEE in a state in which the film thickness of the transparent conductive layer 60 is thin and its electrical characteristics are kept excellent, it is possible to actualize high external quantum efficiency EQE. Further, more preferable states of the semiconductor light emitting device will be described in the following «Semiconductor light emitting device ».

Moreover, the optical substrate PP 10 may be removed from an intermediate product in which an electrode is formed on the surface on which the second semiconductor layer 50 is exposed in the semiconductor light emitting devices 100, 200, 300 exemplified in FIG. 2 to 4 as described above and a support substrate is disposed on the surface with the electrode exposed. It is possible to attain removal of the optical substrate PP 10 by laser lift off, and chemical lift off typified by complete dissolution of partial dissolution of the optical substrate PP 10. Particularly, in the case of adopting a silicon (Si) substrate as the optical substrate PP 10, removal by dissolution is preferable, from the viewpoints of accuracy of the concavo-convex structure 20 and performance deterioration of the first semiconductor layer 30. On the other hand, in the case of laser lift off, when the concavo-convex structure is in the optical substrate PP 10, there is a problem that peeling properties decrease in removing the optical substrate PP 10. By the decrease in peeling properties, there is a problem that the accuracy reduces in the concavo-convex structure 20 to be provided on the exposed surface of the first semiconductor layer 30 and that a large distribution occurs. However, in the case of using the optical substrate PP 10, since the concavo-convex structure 20 existing as an entity is a high-density concavo-convex structure, peeling properties of laser lift off are enhanced. By thus removing the optical substrate PP 10, it is possible to further increase the light extraction efficiency LEE more in a state in which improvements in internal quantum efficiency IQE are maintained. This is because differences in the refractive index are large between the optical substrate PP 10 and the first semiconductor layer 30, and between the light emitting semiconductor layer 40 and the second semiconductor layer 50. By removing the optical substrate PP 10, it is possible to assemble a semiconductor light emitting device with the first semiconductor layer as a light output surface. In this case, the emitted light is output via the concavo-convex structure 20 and pattern X of the present invention. Particularly, since the pattern X is of configuration drawn by the concavo-convex structure 20, a gradient of the refractive index between the first semiconductor layer 30 and peripheral environment (for example, sealant) is gentle and it is possible to develop optical scattering properties due to the pattern X, it is possible to more increase the light extraction efficiency LEE.

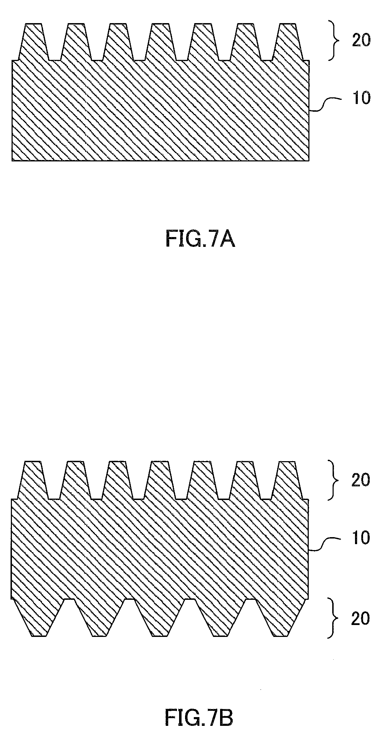

The pattern X and concavo-convex structure 20 of the optical substrate PP 10 according to this Embodiment will be described with reference to drawings. FIG. 7 contains cross-sectional schematic diagrams of the optical substrate PP according to this Embodiment, FIG. 7A shows the case where one surface of the optical substrate PP is provided with the concavo-convex structure 20, and FIG. 7B shows the case where both surfaces of the optical substrate PP 10 are provided with the concavo-convex structure 20. That is, as shown in FIG. 7A, the concavo-convex structure 20 may be provided on at least one of the optical substrate PP 10, and the pattern X is drawn by the concavo-convex structure 20 and is observed. Further, as shown in FIG. 7B, the concavo-convex structure 20 may be provided on both surfaces of the optical substrate PP 10. In this case, it is essential only that the pattern X is drawn by at least one of the concavo-convex structures 20 and is observed.

<Pattern X>

It is presumed that the pattern X is drawn by a difference in the element constituting the concavo-convex structure 20. Herein, the element is a height of the convex portion 20a or concave portion 20b forming the concavo-convex structure 20, interval, diameter of the convex-portion bottom portion, diameter of the concave-portion opening portion or the like, and will specifically be described later. The concavo-convex structure 20 exhibits the effect of reducing dislocations inside the first semiconductor layer 30 as described above, and therefore, is a high-density structure of nano-order. When light is input to the concavo-convex structure, as the wavelength of the light is larger than the concavo-convex structure, the concavo-convex structure viewed from the light is averaged. In addition, the nano-order refers to the structure in which the average pitch of the concavo-convex structure ranges from 10 nm to 1,500 nm. Herein, a medium with respective to the light is defined by a refractive index of a substance. That is, the phenomenon that the concavo-convex structure is averaged from the viewpoint of the light means that the effective refractive index Nema is formed by the refractive index of a substance constituting the concavo-convex structure and the refractive index of environments (for example, first semiconductor layer 30 and air) surrounding the periphery of the concavo-convex structure. Herein, when the element constituting the convex portion 20a or concave portion 20b of the concavo-convex structure 20 is equal without any difference, uniform effective refractive index Nema is formed inside the surface parallel with the main surface of the optical substrate PP 10. In other words, since there is no distribution of effective refractive index Nema inside the surface of the optical substrate PP 10, the light behaves as if there is a single-layer film having the effective refractive index Nema. That is, the pattern X is not drawn, and in other words, the main surface of the optical substrate PP 10 is observed in a single color. On other hand, when there is a difference in the element constituting the convex portion 20a or concave portion 20b of the concavo-convex structure 20, the effective refractive index Nema as described previously forms the distribution of effective refractive index Nema inside the surface parallel with the main surface of the optical substrate PP 10. In other words, since there is the distribution of effective refractive index Nema inside the surface of the optical substrate PP 10, the light behaves as if there is the unevenness (pattern) corresponding to the distribution of effective refractive index Nema, and thereby exhibits optical scattering properties (light diffraction or light scattering). That is, the pattern X is drawn.

The pattern X is an pattern observable at any magnification within the range of 10 times to 5,000 times in observing using an optical microscope, and particularly, is capable being identified as a difference in light and dark. Since there is a state in which the pattern X is first recognizable at a magnification A ($10 \leq A \leq 5,000$) in increasing the observation magnification gradually on the main surface of the optical substrate PP 10 using the optical microscope, and the observation image is too large or sharpness of the interface between the region Xa and the region Xb extremely decreases not to recognize the pattern X in further increasing to a magnification B that is a higher than the magnification A, in observation using the optical microscope, it is essential only that the pattern X is observed at any magnification within the range of 10 times to 5,000 times. By the fact that pattern X is thus observed at any magnification within the range of 10 times to 5,000 times, it is possible to develop the optical scattering properties as described above, and to improve the light extraction efficiency LEE with increases in internal quantum efficiency IQE maintained.

In addition, in the pattern X, images may be different corresponding to the magnification of the optical microscope. That is, for example, an optical pattern in the shape of approximately parallel lines mutually having irregular intervals may be observed in observing at a magnification H ($10 \leq H \leq 5,000$), a circular optical pattern may be observed in the pattern in the shape of the lines in further increasing the magnification to a magnification I ($10 \leq H < I \leq 5,000$), and only the circular pattern may be observed in further increasing the magnification to a magnification J ($10 \leq H < I < J \leq 5,000$). Also at such low magnifications and high magnifications, by the optical patterns X being observed, while being different from one another, the effect of optical scattering properties is more strengthened, and more specifically, since the number of modes corresponding to optical scattering is increased, the degree of improvements in light extraction efficiency LEE is increased.

Herein, considered is the observation magnification in using the optical microscope. Determining the observation magnification by the optical microscope means to limit the size of the observable pattern X. Herein, the pattern X is a pattern that has an order larger than that of the concavo-convex structure existing as an entity and that is recognized by light. That is, action on the light, specifically one factor to determine the degree of optical scattering properties (light diffraction or light scattering) is the size of the pattern X. Accordingly, it is presumed that the observation magnification of the optical microscope has a suitable range.

First, a suitable range of magnifications of the optical microscope was thought by optical calculation. That is, the size of the pattern X was calculated to effectively develop optical scattering properties with respect to emitted light from a semiconductor light emitting device, and calculated was a magnification of the optical microscope for enabling the size of the pattern X at this time to be observed. In addition, the calculation was carried out by using the effective refractive index Nema and preparing a simulated state in which the distribution of refractive index is present inside a predetermined plane. As a result, it was understood that when the range of magnifications is 10 times to 1,500 times, the size of the observable optical pattern is limited to a predetermined range, and effectively exhibits optical scattering properties. From the forgoing, it is preferable that the pattern X is observed at any magnification of 10 times to 1,500 times.

More detailed studies were performed on the optical scattering properties developed by the pattern X observed with the optical microscope. As the studies, the magnification of the optical microscope was gradually increased from 10 times, and the magnification at which the pattern X was observed was recorded. On the other hand, optical scattering properties were measured by haze. As a result, a difference in the haze value between the case with the pattern X and the case without the pattern X was observed at the magnification of 10 times at which the pattern X was first observed as the boundary, and it is was confirmed that the haze value substantially coincides with the above-mentioned calculation result. It was further understood that the haze value remarkably increases from 500 times as the boundary. This means that the optical scattering properties (light diffraction or light scattering) due to the pattern X viewed from the light becomes large. From the fact, in observation using the optical microscope, it is more preferable that the pattern X is observed at any magnification of 500 times to 1,500 times.

On the other hand, studies on the upper limit value were also carried out. For the studies on the upper limit value, inversely to the studies on the lower limit value, the observation magnification of the optical microscope was gradually increased, and the magnification was recorded at the time the pattern X was too enlarged or sharpness of the interface between the region Xa and the region Xb extremely decreased not to recognize the pattern X. Further, correspondence with the haze was measured as in the lower limit value. As a result, it was shown that the haze decreases at the maximum magnification of 5,000 times as the boundary. This means that the size of the pattern X is too large. More specifically, in the case where the pattern X viewed from light is too large, the light feels the pattern X that is sufficiently larger than its wavelength and that is recognizable as a plane. That is, the optical scattering properties due to patterns of the pattern X degrade, and reflection in each pattern (Xa, Xb) occurs. From the foregoing, it is the most preferable that the pattern X is observed at any magnification of 500 times to 5,000 times.

In addition, in a more preferable range of the observation magnification, as described above, it is more preferable that different patterns X are observed corresponding to the magnifications.

The pattern X is observed by a difference in light and dark in the optical microscope image, and it is possible to distinguish one (for example, light) of portions with a difference in light and dark as the first region Xa, and the other portion (for example, dark) as the second region Xb. In addition, in the following description, described is the case where the concavo-convex structure 20 is comprised of a plurality of convex portions 20a and concave portion 20b for connecting between the portions 20a, as an example.

Herein, the "difference in light and dark" is a difference in the visual characteristic for enabling a target portion and another portion to be distinguished, and particularly, in an image, refers to a difference in luminance between the darkest portion and the lightest portion. In visual sensation in the real world, the difference refers to a difference in color or luminance in the same visual field. For example, the light first region Xa may be observed as blue, while the dark second region Xb may be observed as dark blue, and the light first region Xa may be observed as light pink, while the dark second region Xb may be observed as dark pink.

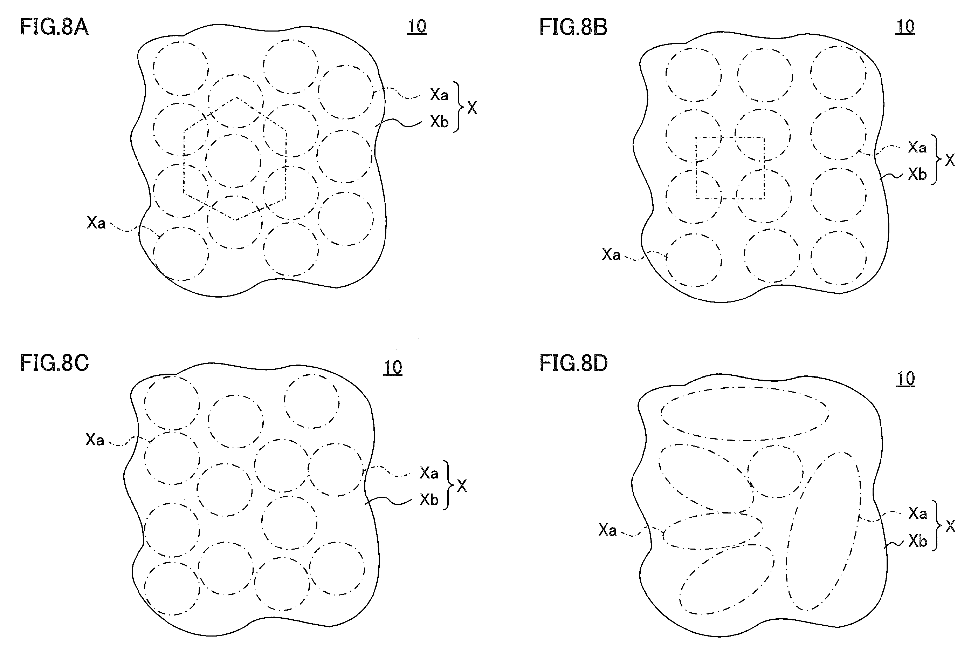

FIGs. 8 to 10 are explanatory diagrams illustrating patterns in the case of observing the optical substrate PP according to this Embodiment from the concavo-convex structure surface side. FIGs. 8A to 8D are explanatory diagrams illustrating patterns X in the case of observing the optical substrate PP according to this Embodiment from the concavo-convex structure surface side using the optical microscope. As shown in FIGs. 8A to 8D, the pattern X is observed in observing the optical substrate PP 10 from the concavo-convex structure 20 surface side using the optical microscope. The pattern X may be observed so that the substantially same plane-shaped first regions Xa are arranged periodically as shown in FIGs. 8A and 8B, may be observed so that the substantially same plane-shaped first regions Xa are arranged with low regularity as shown in FIG. 8C, or may be observed so that the first regions Xa with significantly different plane shapes are arranged as shown in FIG. 8D.

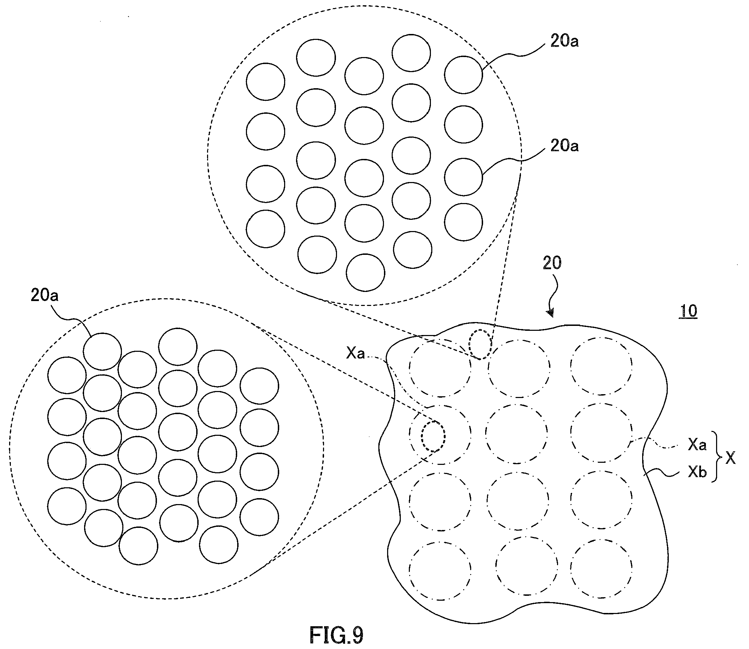

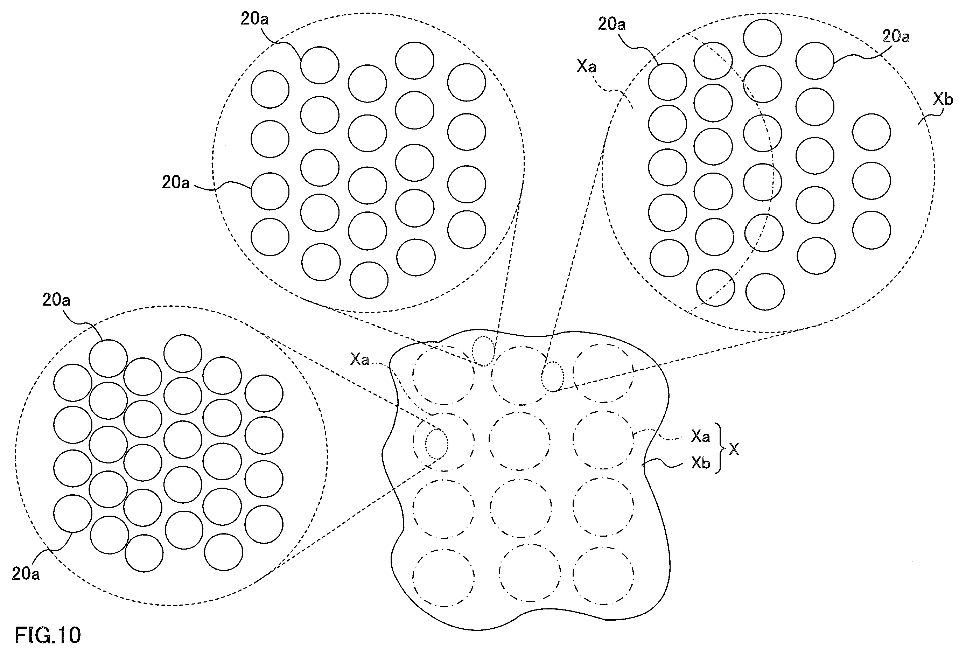

On the main surface 10a of the optical substrate PP 10, in observing using a scanning electron microscope, it is preferable that a plurality of convex portions 20a or concave portions 20b is formed over the entire surface, and that, accordingly, a plurality of convex portions 20a or concave portions 20b is formed continuously in between the first region Xa and the second region Xb. FIGs. 9 and 10 are explanatory diagrams showing the relationship between the pattern in observing the optical substrate PP according to this Embodiment from the concavo-convex structure surface side using the optical microscope and the concavo-convex structure in observing using the scanning electron microscope. As shown in FIG. 9, in the pattern X, a plurality of convex portions 20a is formed both inside the region of the first region Xa and inside the region of the second region Xb. Further, as shown in FIG. 10, the interface does actually not exist between the first region Xa and the second region Xb, and convex portions 20a constituting the concavo-convex structure 20 are arranged.

In addition, the above-mentioned description indicates that the pattern X is observed by a difference in light and dark, and is expressed with the first region Xa that is a light portion and the second region Xb that is a dark portion, and the pattern X may be observed as a pattern formed of three or more portions different in lightness i.e. color or luminance.

Further, the interface between the first region Xa and the second region Xb may be observed clearly as a change in color or luminance, or the color or luminance may change continuously. Particularly, from the viewpoints of suppressing cracks occurring inside the first semiconductor layer 30, while increasing the internal quantum efficiency IQE, it is preferable that the interface between the first region Xa and the second region Xb is observed while changing the color or luminance continuously.

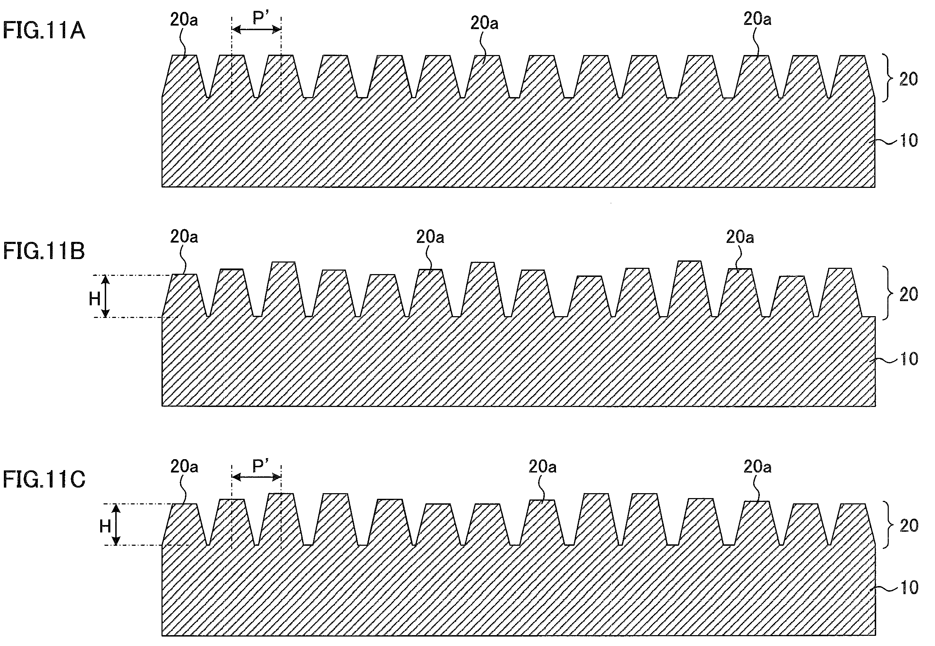

FIG. 11 contains cross-sectional schematic diagrams illustrating the optical substrate PP according to this Embodiment. The relationship between the pattern X and the concavo-convex structure 20 will more specifically be described next with reference to FIGs. 11A to 11C. FIGs. 11A to 11C are cross-sectional schematic diagrams in observing the optical substrate PP according to this Embodiment from the cross section using the scanning electron microscope. In addition, the pattern X is observed from the concavo-convex structure surface side of the optical substrate PP 10, and in the case of performing optical microscope observation on the cross section of the optical substrate PP 10, a clear pattern X may not be observed. FIG. 11A illustrates a state in which mutually adjacent distances P' (hereinafter, referred to as pitches P') gradually change among a plurality of convex portions 20a constituting the concavo-convex structure 20. In this case, in the case of observing the optical substrate PP 10 from the concavo-convex structure surface side using the optical microscope, it is possible to observe the pattern X corresponding to a period of the change in the pitch P'.

FIG. 11B illustrates a state in which a height H of each of a plurality of convex portions 20a constituting the concavo-convex structure 20 gradually changes. In this case, in the case of observing the optical substrate PP 10 from the concavo-convex structure surface side using the optical microscope, it is possible to observe the pattern X corresponding to a period of the change in the height H.

FIG. 11C illustrates a state in which the pitch P' and height H gradually change among a plurality of convex portions 20a constituting the concavo-convex structure 20. In this case, in the case of observing the optical substrate PP 10 from the concavo-convex structure surface side using the optical microscope, it is possible to observe the pattern X corresponding to periods of the changes in the pitch P' and height H.

As described above, it is presumed that the pattern X is not a structure existing as an entity, and is drawn on the main surface 10a of the optical substrate PP 10 by a change occurring in the effective refractive index Nema of the concavo-convex structure 20 by the difference in the element such as the pitch P' and height H of the convex portion 20a or concave portion 20b in the concavo-convex structure 20. In other words, in the region Xa, elements constituting the convex portions 20a or concave portions 20b are the same or close, and the elements different from elements constituting the second region Xb are grouped. This group is called the "concavo-convex structure group" or "a set of the concavo-convex structure". The concavo-convex structure group (set of the concavo-convex structure) is observed as the pattern X in a plane manner.

In addition, the concavo-convex structure group (set of the concavo-convex structure) is the case where two or more convex portions 20a separated by the concave portion 20b exist. Further, the first regions Xa and second region Xb are capable being drawn when one or more convex portions 20a of the concavo-convex structure 20 exist in between the convex portion 20a that is the center portion of one of the adjacent first regions Xa and the convex portion 20a that is the center portion of the other one of the adjacent first regions Xa. In other words, when three or more convex portions 20a exist, and the element constituting at least one convex portion 20a is different from the element of the other convex portion 20a, it is possible to draw the first regions Xa and second region Xb. As described above, since the pattern X is a pattern observed in optical microscope observation corresponding to the change in the effective refractive index Nema of the concavo-convex structure 20, the interval between the first regions Xa of the pattern X is larger than the pitch P' of the concavo-convex structure 20.

Further, the element constituting the convex portion 20a may change continuously from the first region Xa to the second region Xb and to the first region Xa, and the same or close elements of convex portions 20a forming the first region Xa may be discretely different from the same or close elements of convex portions 20a forming the second region Xb. It is possible to determine whether to adopt a continuous change or discrete change of elements constituting convex portions 20a as appropriate from performance required of a semiconductor light emitting device. For example, in the case of particularly placing importance on increases in internal quantum efficiency IQE and adding the light extraction efficiency LEE as a complementary factor for increases in external quantum efficiency EQE, the element constituting the convex portion 20a preferably changes continuously. This is because of suppressing application of excessive stress to growth of the semiconductor crystal layer of the semiconductor light emitting device. On the other hand, in the case of particularly placing importance on increases in light extraction efficiency LEE and adding the internal quantum efficiency IQE as a complementary factor for increases in external quantum efficiency EQE, the element constituting the convex portion 20a preferably changes discretely. This is because it is possible to increase sharpness of the interface of the pattern X recognizable by emitted light i.e. the interface between the region Xa and the region Xb to strengthen optical scattering properties.

As described above, the pattern X is presumed to be drawn by a difference in the element constituting the concavo-convex structure 20, and is observed in observing the optical substrate PP 10 from the concavo-convex structure surface side. The reasons are as described below why both the internal quantum efficiency IQE and the light extraction efficiency LEE of the semiconductor light emitting device are increased by using such an optical substrate PP 10. First, by the concavo-convex structure 20 being comprised of a plurality of convex portions 20a, it is possible to disturb the growth mode of the semiconductor crystal layer. By this means, dislocations inside the first semiconductor layer 30 are dispersed microscopically (in a minute order such as one by one of convex portions 20a constituting the concavo-convex structure 20). Further, the pattern X is not a structure existing as an entity i.e. the size and interval of the first regions Xa constituting the observed pattern X are not reflected in the three-dimensional direction (thickness direction) of the optical substrate PP 10, and therefore, three effects are exhibited.

(1) Dispersion properties of dislocations inside the first semiconductor layer 30 due to the concavo-convex structure 20 are also maintained macroscopically. That is, it is possible to decrease the dislocation density, inside the surface, of the first semiconductor layer 30 provided on the optical substrate PP 10. Therefore, light emission characteristics are enhanced in the light emitting semiconductor layer 40 provided on the first semiconductor layer 30, and the internal quantum efficiency IQE is increased. This is because the pattern X is not a structure existing as an entity, and is observed as if to exist in the case of being viewed from the light by sets of the above-mentioned concavo-convex structure 20. More specifically, in the case where the size and interval of the pattern X exist also in the film thickness direction of the optical substrate PP 10 i.e. in the case where the pattern X exists as an entity, growth of the first semiconductor layer 30 occurs preferentially from the first region Xa or second region Xb in the pattern X. In this case, as compared with the density of dislocations generated inside the first semiconductor layer 30, the density of the pattern X is low inside the main surface of the optical substrate PP 10. That is, the effect of dislocation dispersion properties in the first semiconductor layer 30 decreases inside the surface of the optical substrate PP 10. In other words, in the case of noting the inside of the surface of the optical substrate PP 10, a region with a dislocation density of the semiconductor layer 30 being high and another region with such a density being low coexist. On the other hand, in the present invention, the pattern X does not exist as an entity, and is a two-dimensional plane image optically observed by sets of the above-mentioned concavo-convex structure 20. In this case, growth of the first semiconductor layer 30 occurs substantially equally inside the pattern X. Accordingly, the first semiconductor layer 30 is capable of growing while sensing the density of the concavo-convex structure 20 existing as an entity, and therefore, the dislocation dispersion properties of the first semiconductor layer 30 are enhanced inside the surface of the optical substrate PP 10. In other words, in the case of noting the inside of the surface of the optical substrate PP 10, the dislocation density of the semiconductor crystal layer is decreased approximately equally. That is, it is possible to effectively improve the internal quantum efficiency IQE.

(2) Since the pattern X is a two-dimensional plane image optically observed by sets of the concavo-convex structure 20, it is possible to suppress cracks occurring in growth of the first semiconductor layer 30, decrease the used amount of the first semiconductor layer, and to shorten the deposition time of the first semiconductor layer 30. More specifically, in the case of a three-dimensional structure body such that the size and interval of the first regions Xa constituting the observed pattern X exist in the film thickness direction of the optical substrate PP 10 i.e. in the case where the pattern X exists as an entity, it is necessary to flatten the pattern X with the first semiconductor layer 30. Herein, in flattening the pattern X with the first semiconductor layer 30, the crystal growth direction of the first semiconductor layer 30 abruptly changes near the vertex portion of the pattern X. Therefore, this is because stress concentration occurs in the first semiconductor layer 30 near the vertex portion of the pattern X. That is, by the fact that the concavo-convex structure 20 is the structure existing as an entity and that the pattern X is a plane-like pattern recognizable by light, it is possible to suppress macro defects such as cracks inside the first semiconductor layer 30, and to obtain the effect of internal quantum efficiency IQE due to dislocation dispersion by the concavo-convex structure 20.

(3) Finally, the pattern X is a pattern that is optically observed. In other words, the emitted light of the semiconductor light emitting device behaves as if a unevenness corresponding to the pattern X exists. Accordingly, the travel direction of the emitted light guided inside the first semiconductor layer 30, light emitting semiconductor layer 40 and second semiconductor layer 50 is disturbed, the waveguide mode is thereby disturbed, and the light extraction efficiency LEE is increased. More specifically, the refractive index viewed from the emitted light of the semiconductor light emitting device is different between the first region Xa and the second region Xb of the observed pattern X. Then, the first regions Xa are arranged while being spaced by the second region Xb. That is, although the pattern X is not the structure existing as an entity, in the case of being viewed from the emitted light of the semiconductor light emitting device, it is possible to recognize the pattern X with different refractive indexes, and it is thereby possible to disturb the waveguide mode. From the foregoing, it is possible to concurrently improve the internal quantum efficiency IQE and light extraction efficiency LEE, while achieving the environmental suitability without interfering with manufacturing of the semiconductor light emitting device.

That is, in manufacturing a semiconductor light emitting device, due to the high-density concavo-convex structure 20 existing as an entity, developed are effects of improving the internal quantum efficiency IQE, reducing the occurrence of cracks in the semiconductor crystal layer and reducing the used amount of the semiconductor crystal layer. Then, in using the semiconductor light emitting device, due to the pattern X recognizable by light, i.e. the pattern X that does not exist as an entity, the light extraction efficiency LEE is improved. Here again, in the case of using a high-density concavo-convex structure that does not draw the optical pattern, the above-mentioned effects in manufacturing the semiconductor light emitting device are developed, but the degree of development of the effect in using is limited. Conversely, in the case of using a concavo-convex structure with a large change in the volume with large optical scattering properties, the above-mentioned effect in using the semiconductor light emitting device is developed, but the degree of the effects in manufacturing is limited, In other words, in the optical substrate PP according to this Embodiment, functions are divided into the function developing in manufacturing the semiconductor light emitting device and the function developing in using the semiconductor light emitting device by the concavo-convex structure existing as an entity and the pattern X of an order larger than that of the concavo-convex structure existing as an entity recognizable by emitted light. By this means, it is possible to actualize strong optical scattering properties by the high-density concavo-convex structure which have conventionally been difficult to actualize, and concurrently improve the internal quantum efficiency IQE and the light extraction efficiency LEE.

As described above, the pattern X observed with the optical microscope is observed in observing the optical substrate PP 10 from the concavo-convex structure surface side, due to a plurality of sets of concavo-convex structure 20 observed with the scanning electron microscope i.e. the difference in the element constituting a plurality of convex portions 20a. Herein, according to the above-mentioned principles, from the viewpoints of increasing the internal quantum efficiency IQE and also increasing the light extraction efficiency LEE, it is preferable that the pattern X is observable by optical observation using visible light. This is because the fact that the pattern X is optically observable means existence of different media from the viewpoint of light even when the pattern X is not the structure existing as an entity. This is because the substance for light is defined by the refractive index, and particularly, is explained by averaging action of refractive indexes (effective medium approximation action). It is possible to perform optical observation with an optical microscope. For example, it is possible to perform optical observation on the optical substrate PP 10 of the present invention with the following apparatuses and conditions.

(Optical observation)

Apparatus A: Ultra-depth color 3D profile measuring microscope VK-9500 made by Keyence Corporation
Microscope lens: Made by Nikon Corporation

Conditions:

10X/0.30 (WD. 16.5)
20X/0.46 (WD. 3.1)
50X/0.95 (WD. 0.35)
150X/0.95 (WD. 0.2)


Apparatus B: KH-3000VD made by HILOX Co., Ltd.
Objective lens: OL-700
Observation magnification: ~5,000 times

In addition, for optical observation, it is more preferable to use the apparatus B. This is because of the large effect of suppressing decreases in sharpness of the observed pattern X due to noise by light diffraction and light scattering occurring due to the concavo-convex structure 20. That is, an image observed using the apparatus B is sometimes high in sharpness, as compared with an image observed using the apparatus A.

Described next are the arrangement (pattern), sharpness, shape of the contour, size and interval inside the surface of the pattern X observed in observing the optical substrate PP 10 from the concavo-convex structure surface side.


· Arrangement (Pattern)


As the arrangement (pattern) of the pattern X observed in the case of viewing the optical substrate PP 10 from the concavo-convex structure side using the optical microscope, the arrangement is not limited particularly, as long as the arrangement develops optical scattering properties, from the viewpoint of increasing the light extraction efficiency LEE. Therefore, the first regions Xa are arranged while being spaced by the second region Xb, and the interval of the pattern X is larger than the pitch P' of the concavo-convex structure 20. That is, the fact that the first regions Xa are arranged apart from each other at a longer interval than the pitch P' of the concavo-convex structure 20 by the second region Xb is synonymous with that media with different refractive indexes are arranged discretely in the case of being viewed from light. Herein, the refractive index in light is synonymous with a substancethat is able to change a travel direction of the light. Accordingly, in the optically observed pattern X, by the first regions Xa arranged while being spaced by the second region Xb, optical scattering properties are developed. Herein, the optical scattering properties are light diffraction or light scattering. More specifically, as the arrangement of the first regions (or second region), for example, it is possible to adopt an arrangement in which a plurality of line-shaped patterns is arranged i.e. line-and-space arrangement, hexagonal arrangement, quasi-hexagonal arrangement, quasi-tetragonal arrangement, tetragonal arrangement, arrangement obtained by combing these arrangements, arrangement with low regularity and the like. In addition, the quasi-hexagonal arrangement is defined as an arrangement in which a distortion amount of lattice interval (distance between mutually adjacent first regions Xa) of a hexagonal arrangement is 30% or less, and the quasi-tetragonal arrangement is defined as an arrangement in which a distortion amount of lattice interval (distance between mutually adjacent first regions Xa) of a tetragonal arrangement is 30% or less. Further, as the case of including a hexagonal arrangement and tetragonal arrangement, examples thereof are a state in which portions observed as the tetragonal arrangement and portions observed as the hexagonal arrangement are scattered, and an arrangement including tetragonal arrangements and hexagonal arrangement where the tetragonal arrangement gradually changes to the hexagonal arrangement and the hexagonal arrangement gradually returns to the tetragonal arrangement.

For example, the above-mentioned line-and-space arrangement includes an arrangement in which a plurality of line-shaped patterns is aligned parallel with one another, an arrangement in which a plurality of line-shaped patterns is aligned substantially parallel with one another (degree of parallelism≤10%), an arrangement in which a plurality of line-shaped patterns is aligned parallel with one another while distances between respective line-shaped patterns are constant, an arrangement in which a plurality of line-shaped patterns is aligned parallel with one another while distances between respective line-shaped patterns are irregular, an arrangement in which a plurality of line-shaped patterns is aligned substantially parallel with one another (degree of parallelism≤10%) while distances between respective line-shaped patterns are constant, and an arrangement in which a plurality of line-shaped patterns is aligned substantially parallel with one another (degree of parallelism≤10%) while distances between respective line-shaped patterns are irregular.

Herein, as described already, by observed patterns X being different corresponding to the observation magnification in observing using the optical microscope, the optical scattering properties are more strengthened, and the light extraction efficiency LEE is more increased. For example, in the case where two kinds of patterns X are observed corresponding to the magnification, in the case of describing as (pattern X observed at a low magnification/pattern X observed at a high magnification), among the combinations are (line-and-space arrangement/hexagonal arrangement), (line-and-space arrangement/tetragonal arrangement), (hexagonal arrangement/tetragonal arrangement), (tetragonal arrangement/hexagonal arrangement), (random patchy pattern/hexagonal arrangement), (random patchy pattern/tetragonal arrangement), (random patchy pattern/line-and-space arrangement) and the like. Among the arrangements, in combinations of (line-and-space arrangement or random patchy pattern/hexagonal arrangement or tetragonal arrangement), the effect is enhanced to increase the internal quantum efficiency IQE due to the concavo-convex structure 20 forming the pattern X observed at a high magnification, further the effect is more enhanced to increase the light extraction efficiency LEE due to the pattern X observed at a low magnification, and therefore, such combinations are preferable. Particularly, as the regularity of the pattern X observed at a low magnification is lower and more random, the optical scattering properties are increased, and therefore, such a pattern is preferable. Further, as the regularity of the pattern X observed at a high magnification is higher, the regularity of the difference in the element of the concavo-convex structure 20 is enhanced, the internal quantum efficiency IQE is increased, and therefore, such a pattern is preferable. In addition, at magnifications between the low magnification and the high magnification, it is the most preferable that the pattern X observed at the low magnification and the pattern X observed at the high magnification are observed at the same time. In addition, the above-mentioned example exemplifies the case where different images are observed at the low magnification and at the high magnification i.e. the case where two kinds of images are observed, and three or more kinds of different images may be observed for each magnification. Further, it is possible to decrease emission angle dependence by the observed patterns being different corresponding to the magnification. Therefore, emission characteristics get closer to Lambertian emission characteristics easy to apply to industrial uses.

For example, there are arrangements as shown in FIGs. 8A to 8D. In FIGs. 8A to 8C, the contour shape of the first region Xa that is a light portion in the pattern X observed with the optical microscope is schematically drawn in the shape of a circle sharply, but the contour shape of the first region Xa and sharpness of the interface is not limited thereto, and is intended to include the contour shape and sharpness of the interface as described below. Further, in FIGs. 8A to 8C, the first region Xa is indicated as a single contour shape, and further, it is possible to include first regions Xa of a plurality of contour shapes as shown in FIG. 8D. Furthermore, in FIGs. 8A to 8D, the interface sharpness between the first region Xa and the second region Xb is also drawn in a single manner, and it is also possible to include a plurality of kinds of sharpness.

FIG. 8A shows a state in which the first regions Xa are observed as a pattern of hexagonal arrangement, FIG. 8B shows the case where the first regions Xa are observed as a pattern of tetragonal arrangement, and FIG. 8C shows the case where the first regions Xa are observed as a pattern with low regularity. Further, FIG. 8D shows the case where patterns that the first regions Xa have a plurality of contour shapes are arranged with low regularity. In addition, in FIGs. 8A to 8D, a dark portion except the first regions Xa is described as the second region Xb, and in contrast thereto, it is also possible to describe a light portion as the second region Xb and a dark portion as the first region Xa. Each of these first regions Xa and second region Xb is comprised of an aggregation of the concavo-convex structure 20.

Among the arrangements, from the viewpoint of more increasing the light extraction efficiency LEE, it is preferable that the pattern X is observed as the hexagonal arrangement, tetragonal arrangement, line-and-space arrangement, or lattice arrangement in the in-plane direction of the optical substrate PP 10. In addition, the line-and-space arrangement is a state in which the first region Xa that is a light portion and the second region Xb that is a dark portion are alternatively arranged in parallel with one another. The parallel in the line-and-space arrangement refers to a range in which parallelism ranges from 0% to 10%. In addition, as the parallelism in the present description, the case of 0% is defined as the case of completely parallel geometrically.

· Sharpness

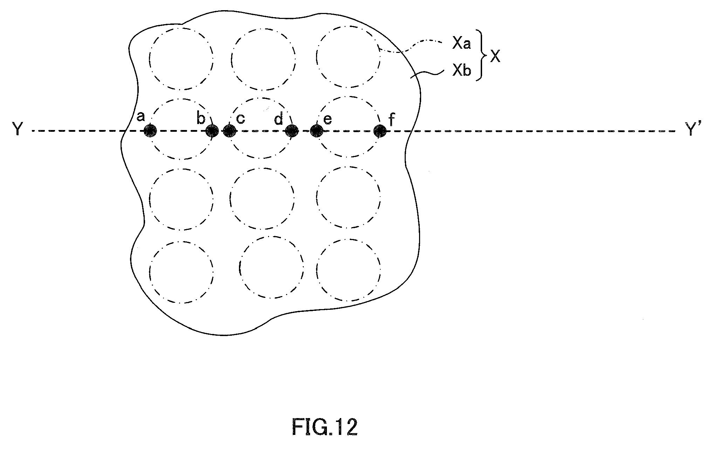

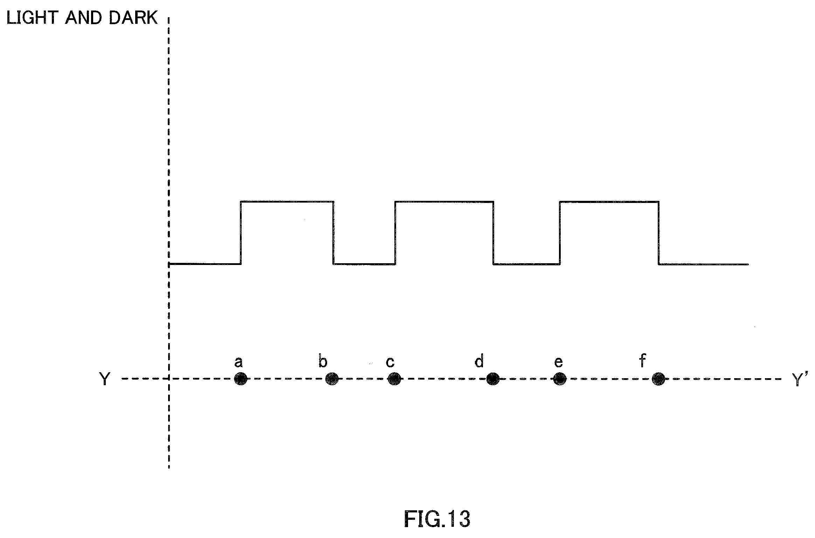

Sharpness of the contour of the pattern X observed in the optical substrate PP according to this Embodiment will be described with reference to FIGs. 12 to 16. FIG. 12 is a plan schematic diagram illustrating the pattern X in the case of viewing the optical substrate PP according to this Embodiment from the concavo-convex structure surface side using the optical microscope. Intersection points of the line segment YY' and first regions Xa in FIG. 12 are assumed to be a, b, c, d, e, and f. FIGs. 13 to 16 are graphs in which the horizontal axis represents the line segment YY', and the vertical axis represents light and dark of the pattern X in the case of observing the optical substrate PP as shown in FIG. 12 from the concavo-convex structure surface side using the optical microscope.

As shown in FIG. 13, in the case of viewing the optical substrate PP 10 from the concavo-convex structure surface side using the optical microscope, the first regions Xa and second region Xb constituting the observed pattern X have substantially certain color tones, and the pattern X may be observed by an abrupt change in light and dark in the interface between the first region Xa and the second region Xb. That is, the interface between the first region Xa and the second region Xb constituting the observed pattern may be observed sharply. In this case, the same or close elements of convex portions 20a forming the first region Xa and the same or close elements of the convex portions 20a forming the second region Xb are discretely different. In this case, since the interface between the first region Xa and the second region Xb viewed from the emitted light is sharp, intensity of optical scattering properties is increased, and particularly, the light extraction efficiency LEE is increased.

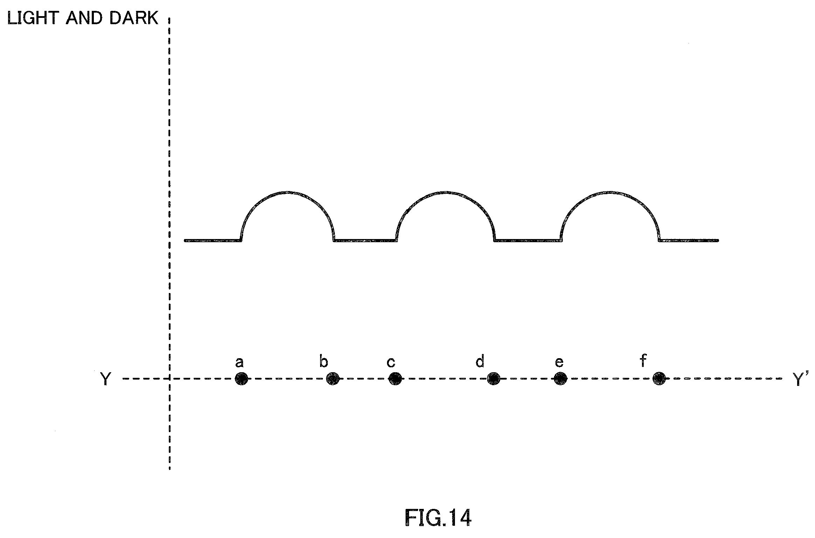

As shown in FIG. 14, in the case of viewing the optical substrate PP 10 from the concavo-convex structure surface side using the optical microscope, the second region Xb constituting the observed pattern X has a substantially certain color tone, and the pattern X may be observed so that light and dark changes from the second region Xb to the first region Xa gradually. In this case, the elements of convex portions 20a forming the second region Xb are the same or close. On the other hand, the elements of the convex portions 20a forming the first region Xa continuously change. In this case, it is possible to change the color tone of the pattern X continuously from the first region Xa toward the second region Xb, while enhancing the sharpness of the interface between the first region Xa and the second region Xb viewed from the emitted light. By this means, the number of modes of optical scattering properties is increased, and the light extraction efficiency LEE is particularly increased. Further, it is possible to suppress the fact that the growth rate of the semiconductor crystal layer is specifically increased or decreased from the interface between the first region Xa and the second region Xb to the second region Xb, and it is possible to suppress the generation of cracks in the semiconductor crystal layer. Furthermore, by the pattern being observed so that light and dark gradually changes from the second region Xb to the first region Xa, it is possible to decrease the emission angle dependence. Therefore, emission characteristics get closer to Lambertian emission characteristics easy to apply to industrial uses.

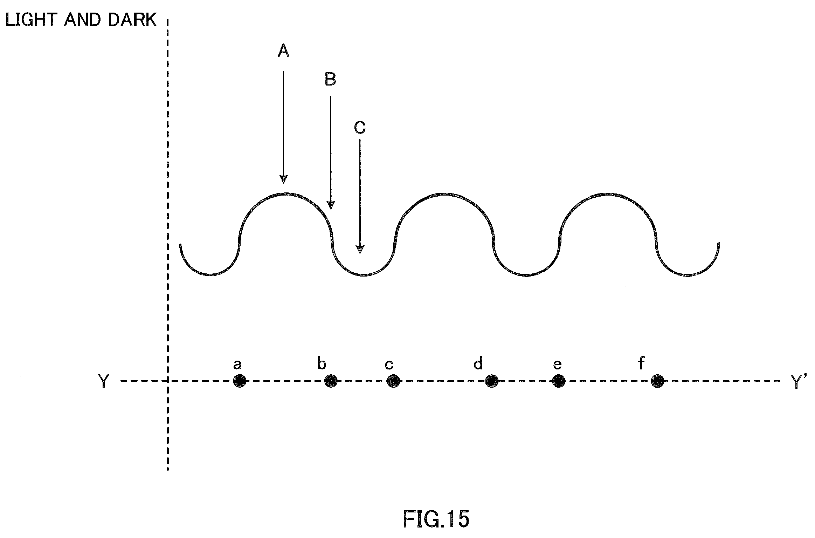

As shown in FIG. 15, in the case of viewing the optical substrate PP 10 from the concavo-convex structure surface side using the optical microscope, both the second region Xb and the first regions Xa constituting the observed pattern X have gradations, and it may be observed that the color tone gradually changes from the second region Xb to the first region Xa. In this case, inside the first region Xa and inside the second region Xb, the elements of convex portions 20a constituting respective regions continuously change, while the elements of convex portions 20a constituting the pattern X continuously change from the first region Xa to the second region Xb and from the second region Xb to the first region Xa. In this case, the emitted light is capable of changing its travel direction by optical scattering intensity corresponding to a different in the color tone between the first region Xa and the second region Xb, and therefore, the light extraction efficiency LEE is increased. Further, it is possible to suppress the fact that the growth rate of the semiconductor crystal layer is specifically increased or decreased over inside the surface of the optical substrate PP 10, and it is possible to suppress the generation of cracks in the semiconductor crystal layer. Therefore, the internal quantum efficiency IQE is particularly increased. Furthermore, by the pattern being observed so that light and dark gradually changes from the first region Xa to the second region Xb and from the second region Xb to the first region Xa, it is possible to more decrease the emission angle dependence. Therefore, emission characteristics get closer to Lambertian emission characteristics easy to apply to industrial uses.

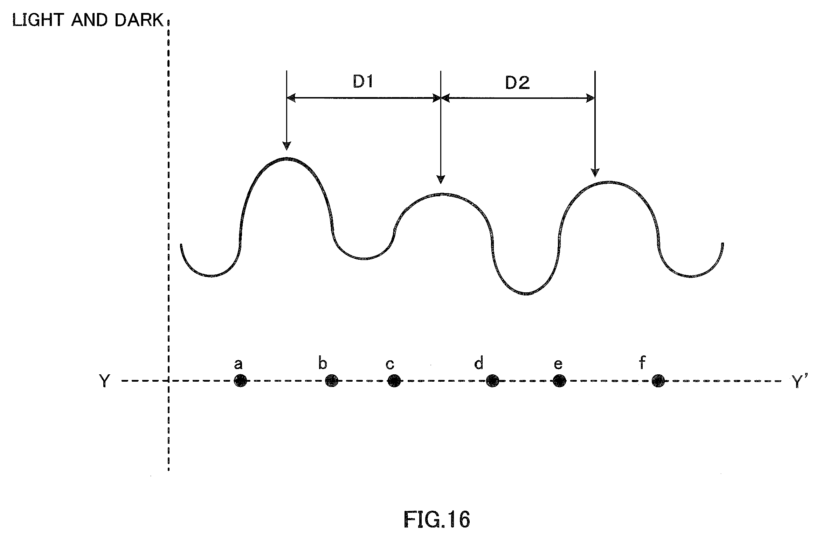

Further, as shown in FIG. 16, in the first regions Xa constituting the pattern X observed in the case of viewing the optical substrate PP 10 from the concavo-convex structure surface side using the optical microscope, some first region Xa and another first region Xa may have different lightness. Similarly, some second region Xb and another second region Xb may have different lightness. In this case, the elements of convex portions 20a constituting some first region Xa are different from the elements of convex portions 20a constituting another first region Xa. Further, the elements of convex portions 20a constituting some second region Xb are different from the elements of convex portions 20a constituting another second region Xb. Furthermore, inside the first region Xa and inside the second region Xb, the elements of convex portions 20a constituting respective regions continuously change, while the elements of convex portions 20a constituting the pattern X continuously change from mutually adjacent first region Xa to second region Xb and from mutually adjacent second region Xb to first region Xa. In this case, in the emitted light, since a distribution occurs in the difference in the color tone between the first region Xa and the second region Xb, the number of modes of optical scattering properties is increased, and the light extraction efficiency LEE is increased. Further, it is possible to suppress the fact that the growth rate of the semiconductor crystal layer is specifically increased or decreased over inside the surface of the optical substrate PP 10, and it is possible to suppress the generation of cracks in the semiconductor crystal layer. Therefore, the internal quantum efficiency IQE is particularly increased. Furthermore, it is possible to more decrease the emission angle dependence. Therefore, emission characteristics get closer to Lambertian emission characteristics easy to apply to industrial uses.

In addition, it is possible to combine the change in light and dark of the pattern X described with reference to FIGs. 13 to 16 with the change in light and dark exemplified in FIG. 13, FIG. 14, FIG. 15 or FIG. 16.

In addition, in FIGs. 13 to 16, a light portion is described as the first region Xa, and a dark portion except the first region Xa is described as the second region Xb, and it is also possible to mention a light portion as the second region Xb and a dark portion as the first region Xa.

As described above, the pattern X is a pattern observed in the case of viewing the optical substrate PP 10 from the concavo-convex structure surface side using the optical microscope, and light and dark defining the pattern X may change continuously or may change abruptly. Herein, from the viewpoint of more significantly increasing the internal quantum efficiency IQE, light and dark preferably changes continuously. From the viewpoint of more significantly increasing the light extraction efficiency LEE, light and dark preferably changes abruptly. It is possible to select which change in dark and light to adopt as appropriate corresponding to conditions (for example, type of the optical substrate PP 10, deposition conditions of the first semiconductor layer 30, layer configurations of the first semiconductor layer 30, light emitting semiconductor layer 40 and second semiconductor layer 50 and the like) in manufacturing the semiconductor light emitting device or characteristics of the semiconductor light emitting device to manufacture. Particularly, the deposition conditions are extremely severe in an (MO)CVD apparatus to deposit the first semiconductor layer 30, light emitting semiconductor layer 40 and second semiconductor layer 50, and on the other hand, film thickness control of the first semiconductor layer 30, light emitting semiconductor layer 40 and second semiconductor layer 50 is relatively easy. In view thereof, in increases in internal quantum efficiency IQE and increases in light extraction efficiency LEE which are performance exerted by the optical substrate PP 10, it is conceivable that importance is preferably placed on increases in internal quantum efficiency IQE. Accordingly, it is more preferable that light and dark of the pattern X observed on the main surface side of the optical substrate PP 10 continuously changes.

· Shape of contour

As described above, the pattern X is a pattern observed in the case of viewing the optical substrate PP 10 from the concavo-convex structure surface side using the optical microscope, and light and dark defining the pattern X may change continuously or may change abruptly. Herein, in the case where light and dark continuously changes, since the contour of the first region Xa i.e. the interface between the first region Xa and the second region Xb is unclear, although it is difficult to explicitly define the contour shape of the first region Xa, there are substantially a circular shape, concentric circular shape, n(n≥3)-gon, n(n≥3)-gon with the corner rounded, shape of a line, shape containing one or more inflection points, and the like. Particularly, from the viewpoint of suppressing cracks in depositing the semiconductor crystal layer, from the viewpoint of increasing the internal quantum efficiency IQE over inside the surface of the optical substrate PP 10, and from the viewpoint of increasing the light extraction efficiency LEE over inside the surface of the optical substrate PP 10, it is more preferable that the contour shape of the first region Xa is substantially a circular shape or the shape of a line.

In the pattern X observed in the case of viewing the optical substrate PP 10 from the concavo-convex structure surface side, as light and dark changes continuously, the shape of the contour of the first region Xa is blurred. In other words, a difference in light and dark is small between the first region Xa and the second region Xb, and the interface between the first region Xa and the second region Xb is unclear.

The fact that the contour shape of the first region Xa is blurred means that the elements of convex portions 20a constituting the first region Xa continuously change from the first region Xa to the second region Xb and from the second region Xb to the first region Xa. In the case of providing the first semiconductor layer 30 on the main surface of the optical substrate PP 10, it is necessary to decrease the growth rate distribution inside the main surface of the optical substrate PP 10 of the first semiconductor layer 30. The reason is that in the case where the growth rate of the first semiconductor layer 30 has the distribution inside the main surface of the optical substrate PP 10, bulges and depressions caused by a difference in the growth rate occur in the interface portions between a portion with a high growth rate and a portion with a low growth rate, and that in the case where such bulges and depressions exist, luminous efficiency of the semiconductor light emitting device significantly reduces to increase the defect rate of the semiconductor light emitting device. By the contour shape of the first region Xa being blurred, it is possible to continuously change the growth rate distribution of the first semiconductor layer 30 inside the main surface of the optical substrate PP 10, and it is possible to suppress the bulges and depressions as described previously. That is, by the fact that the contour shape of the first region Xa is blurred, in other words, light and dark continuously changes from the first region Xa to the second region Xb, it is possible to suppress the occurrence of cracks in the semiconductor crystal layer in depositing the semiconductor crystal layer with improvements in light extraction efficiency LEE ensured by the optically drawn pattern X, while it is possible to suppress specific growth of the semiconductor crystal layer, and the degree of increases in internal quantum efficiency IQE is thereby increased.

· Size

The size of the pattern X observed in the case of viewing the optical substrate PP 10 from the concavo-convex structure surface side is defined as the size of the first region Xa, but is not limited thereto. This is because as described above, since the pattern X is a pattern capable of being observed within a particular magnification range using an optical microscope, it is possible to develop optical scattering properties (light diffraction or light scattering) corresponding to the pattern X with respect to light. Further, the contour of the first region Xa is often unclear, and that is, there are many cases that it is difficult to explicitly grasp the shape of the first region Xa. Accordingly, it is assumed that the size of the pattern X i.e. the size of the first region Xa is defined by the interval as described below.

· Interval

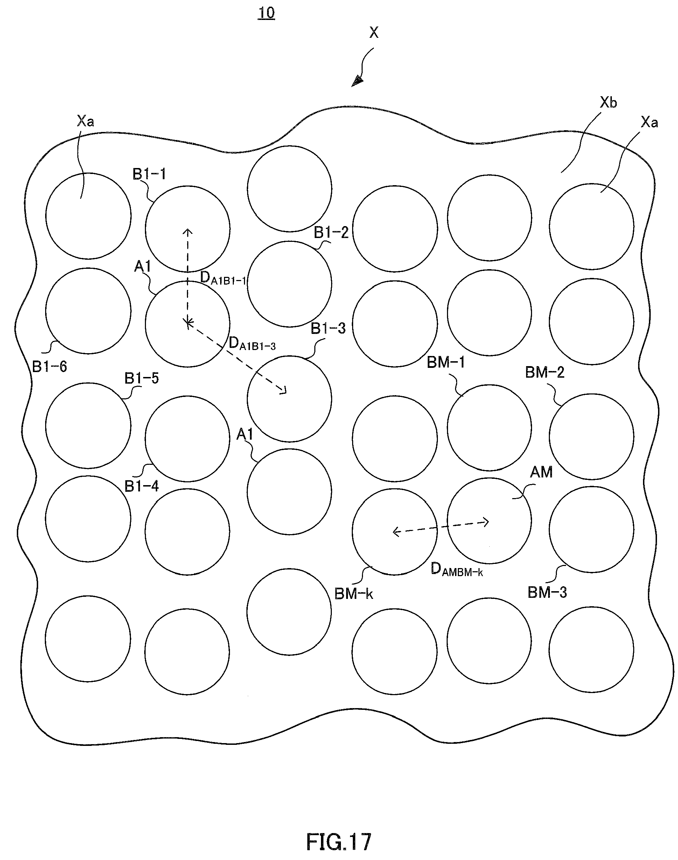

As described above, the pattern X observed in the case of viewing the optical substrate PP 10 from the concavo-convex structure surface side using the optical microscope is defined by light and dark. The interval between patterns X is defined as a distance D between the first region Xa that is lighter (or darker) than the periphery and another first region Xa, which is lighter (or darker) than the periphery, adjacent to the first region Xa. FIG. 17 is a plan schematic diagram of the pattern X observed in the case of viewing the optical substrate PP according to this Embodiment from the concavo-convex structure side using the optical microscope, and is a diagram to explain the interval between patterns X. As shown in FIG. 17, when a plurality of first regions Xa is drawn, distance $D_{A1B1-1}$ to distance $D_{A1B1-6}$ that are distances between the center of some first region A1 and the centers of first region B1-1 to first region B1-6 adjacent to the portion A1 are defined as the interval D. However, as shown in FIG. 17, when the interval D varies with the adjacent first region Xa, average interval Dave is determined according to the following procedure. (1) A plurality of arbitrary first regions A1, A2···AN is selected. (2) Intervals $D_{AMBM-1}$ to $D_{AMBM-k}$ between a first region AM and first regions (BM-1 to BM-k) adjacent to the first region AM ($1 \leq M \leq N$) are measured. (3) For the first region A1 to the first region AN, the intervals D are measured as in (2). (4) An arithmetic mean value of intervals $D_{A1B1-1}$ to $D_{ANBN-k}$ is defined as an average interval Dave. In addition, it is determined that N ranges from 5 to 10, and that k ranges from 4 to 6. In addition, as the center of the first region, for example, when the case of FIG. 16 is used as an example, the center is a portion shown by the arrow in FIG. 16, and the distance between adjacent arrows is the above-mentioned interval (shown by D1 and D2 in FIG. 16).

From the viewpoint of increasing the light extraction efficiency LEE, it is preferable that the average interval Dave of the pattern X observed in the case of viewing the optical substrate PP 10 from the concavo-convex structure surface side using the optical microscope is 800 nm or more in a range larger than the average pitch P'ave of the concavo-convex structure 20. Particularly, from the viewpoints of strengthening optical scattering properties (light diffraction or light scattering) and effectively disturbing the waveguide mode, the interval is preferably 1,000 nm or more, more preferably 1,100 nm or more, and most preferably 1,200 nm or more. On the other hand, from the viewpoint of increasing the number of optical scattering points, the upper limit value is preferably 100 $\mu$m or less, more preferably 50 $\mu$m or less, and most preferably 10 $\mu$m or less. Particularly, by the interval being 5 $\mu$m or less, since light diffraction properties are strongly developed, the effect of disturbing the waveguide mode is more increased due to the pattern X which is drawn by an aggregation of a plurality of convex portions 20a constituting the concavo-convex structure 20, is first observed with the optical microscope, and which does not exist as an entity, and therefore, such a range is preferable.

As described above, the pattern X is drawn by the concavo-convex structure 20, and is defined by a difference in light and dark of the pattern X observed with the optical microscope. Further, the pattern X is characterized by sharpness, arrangement, contour shape, size, interval or the like. By combining these factors, the degree of provision of new optical scattering properties which is the function as the pattern X is changed. Herein, the reason why the light extraction efficiency LEE is increased by the pattern X is optical scattering properties developed by the pattern X. That is, it is conceivable that the degree of increases in light extraction efficiency LEE is changed by making the pattern X a predetermined pattern (arrangement, contour shape, sharpness or the like). Further, the pattern X is a plane-like pattern recognized by light, and does not exist as an entity. However, since it is presumed that the pattern X is drawn by a change in the element forming the concavo-convex structure 20, the semiconductor crystal layer in manufacturing the semiconductor light emitting device senses a change in the element of the concavo-convex structure 20. That is, from the viewpoint of manufacturing the semiconductor light emitting device, it is conceivable that the manner of changing the element of the concavo-convex structure 20 has also a more suitable range.

With respect to the pattern X viewed from light and the light extraction efficiency LEE due to optical scattering properties developed by the pattern X, when calculation was performed by applying optical simulations (FDTD method and RCWA method), in terms of the viewpoint of the distribution of effective refractive index Nema, it was understood that by containing the pattern X with high regularity in the shape closer to a general diffraction grating, the emitted light is more extracted to the outside of the semiconductor light emitting device. On the other hand, in regard to deposition (growth) of the semiconductor crystal layer, when nuclei of the semiconductor crystal layer were accumulated by assuming random walk, it was understood that deposition properties of the semiconductor crystal layer are stabilized by a change in the element of the concavo-convex structure 20 with high regularity.

From the foregoing, as the pattern X observed with the optical microscope, it was understood that it is more preferable to contain the pattern with high regularity. Herein, with attention directed toward regularity viewed from light, it is possible to think that the function as a diffraction grating with respect to predetermined light is important. That is, in applying a laser beam having a predetermined wavelength to the optical substrate PP 10, it is preferable that the laser beam, which passes through the optical substrate PP 10 and is output, splits. This respect will be descried more specifically.

First, as a system, the following conditions are adopted.

· Laser beam

Each of three kinds of laser beams with wavelengths of 640 nm to 660 nm, 525 nm to 535 nm and 460 nm to 480 nm is used. Herein, the fact that the wavelength has a range such as λ1 to λ2 is not intended to use laser light having such a wavelength distribution, and means using a laser beam meeting the relationship of λ1~λc~λ2 when the center wavelength is assumed to be λc. For example, each of laser beams with respective wavelengths of 650 nm, 532 nm and 473 nm may be used. In addition, in a simple manner, it is possible to use laser pointers of red, green and blue as the laser beams.

· Irradiation method of laser beam

The laser beam is perpendicularly input to the surface with the concavo-convex structure 20 of the optical substrate PP 10. Herein, a distance between the input surface and an output portion of the laser beam is determined as 50 mm.

· Output laser beam

The laser beam output from the surface on the side opposite to the input surface of the laser beam of the optical substrate PP 10 is the output laser beam (hereinafter, also referred to as output light). Herein, a screen is provided in a position that is parallel with the output surface of the optical substrate PP 10 and that is spaced 150 mm apart from the output surface. A pattern of the output light projected on the screen is observed. In addition, in order to make observation easy, the above-mentioned observation is performed in a dark room.

In observing the output light projected on the screen on the above-mentioned conditions, it is preferable that the output laser beam splits at least two or more. The case where the output light does not split is a state in which only one light point is projected on the screen. On the other hand, the output light splitting in X ways (X≥2) means that the number of light points projected on the screen is X (X≥2). That is, it is assumed to include a light point of the output light existing on the axis of the input laser beam. Further, the case of splitting in X ways is one case of following 1 to 3.

1. A state in which X light points are aligned in some straight line A on the screen
2. A state in which light points are respectively aligned in some straight line A on the screen and a straight line B on the screen perpendicular to the straight line A
3. A state in which light points are respectively aligned in some straight line A on the screen, a straight line B on the screen obtained by rotating the straight line A 60 degrees rightward, and a straight line C on the screen obtained by rotating the straight line B further 60 degrees rightward

Herein, the state of splitting in two or more means that the laser light is diffracted by the pattern X of the optical substrate PP 10. That is, the state means large capability to change the travel direction of the light i.e. large capability to increase the light extraction efficiency LEE. From the same viewpoint, the light preferably splits in at least 3 or more, more preferably in 5 or more, and most preferably in 9 or more.

In addition, it is essential only that the above-mentioned observation is observed with respect to at least one or more laser beams in testing with three kinds of laser beams with wavelengths of 640 nm to 660 nm, 525 nm to 535 nm and 460 nm to 480 nm. This is because the refractive index and emission main wavelength of the semiconductor light emitting device are varied with the semiconductor light emitting device.

The relationship between the concavo-convex structure 20 and the pattern X will be described next. The pattern X is observed with an optical microscope, and the concavo-convex structure 20 is observed with a scanning electron microscope. Since the pattern X is drawn by an aggregation of the concavo-convex structure 20, in sequentially enlarging the image in which the pattern X is observed, it is possible to observe the concavo-convex structure 20 later. For example, it is possible to observe the concavo-convex structure 20 by observing the pattern X with an optical microscope, and observing a position corresponding to the observe pattern X at a high magnification using a scanning electron microscope. By the fact that a plurality of convex portions 20a constituting the concavo-convex structure 20 forms the above-mentioned concavo-convex structure group i.e. the concavo-convex structure 20 is aggregated, when the pattern X is capable of being observed in observing the optical substrate PP 10 from the concavo-convex structure surface side using the optical microscope, the internal quantum efficiency IQE is increased, while enabling the light extraction efficiency KEE to be improved, and therefore, the shape and arrangement of the convex portions 20a constituting the concavo-convex structure 20 are not limited particularly. In addition, a more preferable form of the concavo-convex structure 20 will be described later.

In order to enable the pattern X to be observed using the optical microscope due to the concavo-convex structure group observed using the scanning electron microscope, it is necessary that concavo-convex structures 20 of portions with different in light and dark in the pattern X are mutually different. Herein, the fact that concavo-convex structures 20 are mutually different means that the elements (for example, pitch, height, convex-portion bottom portion width or the like) of convex portions 20a forming the concavo-convex structures 20 as described below are different. For example, the description will be given using FIG. 15 as an example. FIG. 15 is the case where gradations are exerted on both the second region Xb and first region Xa constituting the pattern X observed in the case of viewing the optical substrate PP 10 from the concavo-convex structure surface side using the optical microscope, and light and dark gradually changes from the second region Xb to the first region Xa. Herein, portions shown by the arrows A, B and C in FIG. 15 are portions with different light and dark contrasts of the pattern X observed in the case of viewing the optical substrate PP 10 from the concavo-convex structure surface side. Such a difference in light and dark is actualized by a difference in the element constituting the concavo-convex structure 20 observed with the scanning electron microscope. For example, in the case of describing a pitch of the concavo-convex structure 20 of the portion shown by the arrow A in FIG. 15 as P'a, a pitch of the concavo-convex structure 20 of the portion shown by the arrow B as P'b, and a pitch of the concavo-convex structure 20 of the portion shown by the arrow C as P'c, it is possible to make the pattern X by a difference in the concavo-convex structure 20 such as P'a>P'b>P'c or P'a<P'b<P'c as shown in Table 1. That is, the pattern X is observed in the case of viewing the optical substrate PP 10 from the concavo-convex structure surface side with the optical microscope, due to the difference in the element of the concavo-convex structure 20 observed with the scanning electron microscope. In addition, the case where the pitches P' are different includes the case where arrangements of the concavo-convex structure 20 are different. Similarly, in the case of describing heights (depths, the same in the following description) of concavo-convex structures 20 in portions shown by the arrows A, B and C in FIG. 15 respectively as Ha, Hb and Hc, it is possible to make the pattern X by a difference in the concavo-convex structure 20 such as Ha>Hb>Hc or Ha<Hb<Hc as shown in Table 1. Further, in the case of describing convex-portion bottom portion circumscribed circle diameters of the concavo-convex structures 20 in portions shown by the arrows A, B and C in FIG. 15 respectively as $\Phi$out_a, $\Phi$out_b and $\Phi$out_c, it is possible to make the pattern X by a difference in the concavo-convex structure 20 such as$\Phi$out_a>$\Phi$out_b>$\Phi$out_c or $\Phi$out_a<$\Phi$out_b<$\Phi$out_c as shown in Table 1. In addition, the above-mentioned description describes the case of enabling the pattern X to be observed by the element constituting the concavo-convex structure 20 changing alone, and a plurality of elements constituting the concavo-convex structure 20 may change at the same time. In the case where a plurality of elements changes at the same time, since the volume change in the concavo-convex structure 20 is increased, sharpness of the pattern X and a difference in the color tone between the first region Xa and the second region Xb is increased, and it is possible to more improve the light extraction efficiency LEE. For example, there are the pitch P' and height (depth) H of the concavo-convex structure 20, the pitch P' and convex-portion bottom portion circumscribed circle diameter $\Phi$out of the concavo-convex structure 20, the pitch P', height H and convex-portion bottom portion circumscribed circle diameter $\Phi$out of the concavo-convex structure 20, and the like. Further, when a plurality of elements changes at the same time, a correlation coefficient with respect to changes in the elements may be positive or negative. For example, in the case where the pitch P' and height H change at the same time, as the pitch P' increases, the height H may decrease, or conversely, may increase.

[Table 1]

| ELEMENT | CASE | A | | B | | C |
|---|---|---|---|---|---|---|
| PITCH | 1 | P' a | > | P' b | > | P' c |
| | 2 | P' a | < | P' b | < | P' c |
| HEIGHT | 1 | Ha | > | Hb | > | Hc |
| | 2 | Ha | < | Hb | < | Hc |
| CONVEX-PORTION BOTTOM PORTION CIRCUMSCRIBED CIRCLE DIAMETER | 1 | $\phi$ out_a | > | $\phi$ out_b | > | $\phi$ out_c |
| | 2 | $\phi$ out_a | < | $\phi$ out_b | < | $\phi$ out_c |

Described herein are results of studying differences in elements of the concavo-convex structure 20. As typical examples of the elements of the concavo-convex structure 20, three kinds of the pitch P', height H and convex-portion bottom portion circumscribed circle diameter $\Phi$out were selected. With respect to each of these three elements, a difference in the element was quantified from scanning electron microscope observation, the pattern X was observed from optical microscope observation, and the light and dark was observed. As a result, in the case of selecting any of the elements, it was understood that the pattern X is observed when the difference is 5 nm or more. More specifically, in assuming a pitch as P'(Xa), height as H(Xa) and convex-portion bottom portion circumscribed circle diameter as $\Phi$out(Xa) in the concavo-convex structure 20, forming the first region Xa in the pattern X observed with the optical microscope, observed with the scanning electron microscope, and further assuming a pitch as P'(Xb), height as H(Xb) and convex-portion bottom portion circumscribed circle diameter as $\Phi$out(Xb) in the concavo-convex structure 20 forming the second region Xb, observed with the scanning electron scope, it was confirmed that it is possible to observe the pattern X and the effect of optical scattering properties are developed by meeting |P'(Xa)-P'(Xb)|≥5nm, |H(Xa)-H(Xb)|≧5nm, or |Φout(Xa) - Φout(Xb)|≧5nm. Particularly, in the case where only one element is varied, it is preferable that the difference in the element is 10 nm or more. On the other hand, in the case where two or more elements are varied, for example, in the pitch P' and height H, the height H and convex-portion bottom portion circumscribed circle diameter Φout, and the pitch P', height H and convex-portion bottom portion circumscribed circle diameter Φout, when differences in respective elements are 5 nm or more, it is possible to observe the pattern X sharply, and the effect of optical scattering properties are also developed. It is conceivable that this result is the same in the other elements as described below.

Further, as a result of checking correlation coefficients of a plurality of elements in the case where the elements change at the same time, it was understood that by containing elements meeting the relationship that the correlation coefficient is negative, the effect of suppressing cracks is particularly enhanced in depositing the semiconductor crystal layer. More specifically, it was understood that when the pitch P' and height H (or convex-portion bottom portion circumscribed circle diameter Φout) change at the same time, it is preferable that the height H (or convex-portion bottom portion circumscribed circle diameter Φout) decreases, as the pitch P' increases, from the viewpoint of cracks, and that when the pitch P', height H and convex-portion bottom portion circumscribed circle diameter Φout change at the same time, it is preferable that the height H and convex-portion bottom portion circumscribed circle diameter Φout decrease, as the pitch P' increases, from the viewpoint of cracks.

On the other hand, from the viewpoint of increasing the light extraction efficiency LEE, it is preferable that at least the relationship between the pitch P' and the height H or the pitch P' and the convex-portion bottom portion circumscribed circle diameter Φout is positive correlation. This is because by meeting such a relationship, the degree of volume change of the elements of the concavo-convex structure 20 is increased, in association therewith a difference in the refractive index in the distribution of effective refractive index Nema is increased, and intensity of optical scattering properties is strengthened. Particularly, it is the most preferable that the height H and convex-portion bottom portion circumscribed circle diameter Φout increase, as the pitch P' increases.

From the foregoing, in order to draw the pattern X due to the difference in the element of the concavo-convex structure 20 and thereby develop the effect of optical scattering properties, the difference in the element of the concavo-convex structure 20 is preferably 5 nm or more. Further, in the case of only a single element, the difference thereof is preferably 10 nm or more. In addition, the most preferable case is that the number of elements is 2 or more and that both of the differences in these elements are 10 nm or more.

As the difference in the element of the concavo-convex structure 20, when names of elements of the concavo-convex structure 20 as described below are used, it is preferable that the difference includes particularly a change in the pitch P', height H or convex-portion bottom portion circumscribed circle diameter Φout. This is because the difference in these elements has a large value in terms of volume, and makes a large contribution to optical scattering properties. Further, by containing at least a change in the pitch P', a difference in light and dark of the pattern X observed with the optical microscope is increased, the effect of suppressing cracks occurring in growth of the semiconductor crystal layer is enhanced, and therefore, such a change is preferable. Further, by containing at least changes in the pitch P' and height H or convex-portion bottom portion circumscribed circle diameter Φout, more increased are the effect of decreasing the dislocation density and the effect of suppressing cracks in the semiconductor crystal layer, and increases in the light extraction efficiency LEE, and therefore, such changes are preferable. In addition, the most preferable is the case of containing changes in the pitch P', the height H and the convex-portion bottom portion circumscribed circle diameter Φout. This case concurrently improves the effects of dispersion of dislocation and reduction of dislocation density, the crack suppressing effect, and the effect of strong optical scattering properties. In addition, in this case, when correlation coefficients between the pitch P' and the height H and between the pitch P' and the convex-portion bottom portion circumscribed circle diameter Φout are negative, the crack suppressing effect is enhanced. On the other hand, when correlation coefficients between the pitch P' and the height H and between the pitch P' and the convex-portion bottom portion circumscribed circle diameter Φout are positive, the degree of increases in light extraction efficiency LEE is more increased. By this means, it is possible to more increase the light extraction efficiency LEE with improvements in internal quantum efficiency IQE maintained.

Further, from the viewpoints of improving the internal quantum efficiency IQE by the concavo-convex structure 20, and increasing the light extraction efficiency LEE by the pattern X while maintaining the improved internal quantum efficiency IQE, the average pitch P'ave of the concavo-convex structure 20 and the average interval Dave of the pattern X meet average interval Dave>average pitch P'ave. That is, the order of the pattern observed using the optical microscope is larger than the order of the physical structure existing as an entity observed with the scanning electron microscope. Particularly, from the viewpoint of increasing the light extraction efficiency LEE also in the case of improving the degree of improvements in internal quantum efficiency IQE, it is preferable to meet average interval Dave≧2P'ave, it is more preferable to meet average interval Dave≧3P'ave, and it is the most preferable to meet average interval Dave≧4P'ave. In addition, the upper limit value is determined by the degree of increases in light extraction efficiency LEE, and an extent of improvement maintenance of the internal quantum efficiency IQE, and it is preferable to meet average interval Dave≦500P'ave. Among the values, from the viewpoint of increasing the density of optical scattering points, it is preferable to meet average interval Dave≤100P'ave, it is more preferable to meet average interval Dave≤50P'ave, and it is the most preferable to meet average interval Dave≤20P'ave.

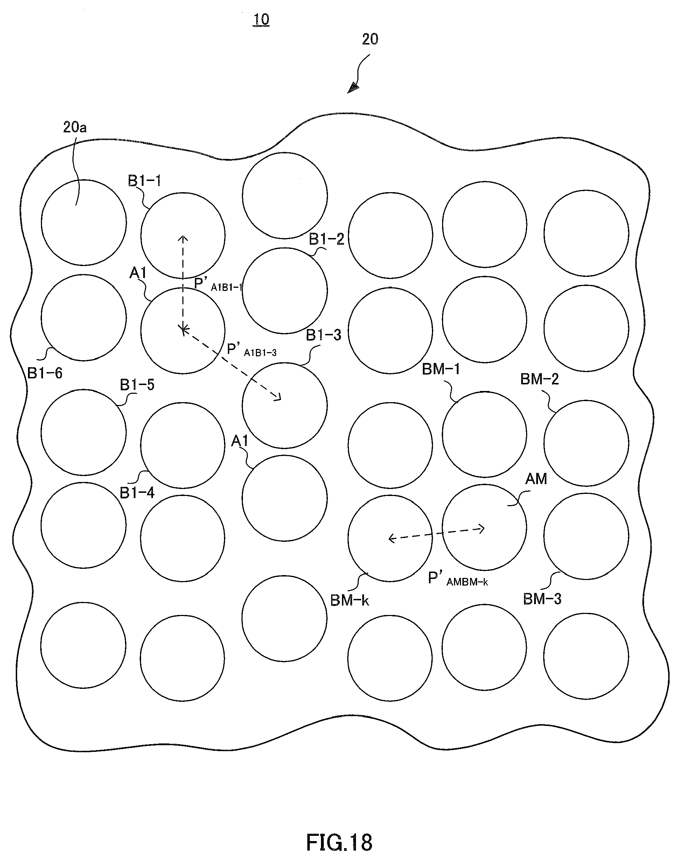

In addition, it is assumed that the pitch P' and average pitch P'ave of the concavo-convex structure 20 are defined as described below. FIG. 18 is a plan schematic diagram illustrating the concavo-convex structure in the case of viewing the optical substrate PP according to this Embodiment from the concavo-convex structure surface side using the scanning electron microscope. As shown in FIG. 18, in the case where the concavo-convex structure 20 is a dot structure with a plurality of convex portions 20a arranged, distance $P'_{A1B1-1}$ to distance $P'_{A1B1-6}$ that are distances between the center of some convex portion A1 and the centers of convex portion B1-1 to convex portion B1-6 adj acent to the convex portion A1 are defined as the pitch P'. However, as shown in FIG. 18, when the pitch P' varies with the adjacent convex portion, the average pitch P'ave is determined according to the following procedure. (1) A plurality of arbitrary convex portions A1, A2···AN is selected. (2) Pitches $P'_{AMBM-1}$ to $P'_{AMBM-k}$ between a convex portion AM and convex portions (BM-1 to BM-k) adjacent to the convex portion AM (1≤M≤N) are measured. (3) For the convex portion A1 to the convex portion AN, the pitches P' are measured as in (2). (4) An arithmetic mean value of pitches $P'_{A1B1-1}$ to $P'_{ANSN-k}$ is defined as an average pitch P'ave. In addition, it is determined that N ranges from 5 to 10, and that k ranges from 4 to 6. In addition, in the case of a hole structure, it is possible to define the average pitch P'ave by replacing the convex portion described in the above-mentioned dot structure with a concave-portion opening portion to read.

When the average pitch P'ave ranges from 10 nm to 1,500 nm in the range of meeting the above-mentioned relationships between the average pitch P'ave and the average interval Dave, it is possible to increase both the internal quantum efficiency IQE and the light extraction efficiency LEE. Particularly, when the average pitch P'ave is 10 nm or more, the change is increased in light and dark of the pattern X observed in the case of viewing the optical substrate PP 10 from the concavo-convex structure surface side, and it is thereby possible to increase the light extraction efficiency LEE. From the viewpoint of more exerting the above-mentioned effect, the average pitch P'ave is preferably 150 nm or more, more preferably 200 nm or more, and most preferably 250 nm or more. On the other hand, by the average pitch P'ave being 1,500 nm or less, the density of the concavo-convex structure 20 is increased. In association therewith, it is possible to disperse dislocations inside the first semiconductor layer 30, it is thereby possible to reduce local and macroscopic dislocation densities, and therefore, it is possible to increase the internal quantum efficiency IQE. From the viewpoint of more exerting the above-mentioned effect, the average pitch P'ave is preferably 1,000 nm or less. Particularly, by the average pitch P'ave being 900 nm or less, the density of the concavo-convex structure 20 is effectively increased relative to the dislocation density of the semiconductor crystal layer, the effects of dispersion of dislocations and dislocation density reduction are more remarkable, and therefore, such a range is preferable. From the same effect, the average pitch P'ave is most preferably 800 nm or less. Particularly, in the case of concurrently meeting a suitable range of the height H as described later and the suitable range of the average pitch P'ave as described already, all effects are excellent in the effect of suppressing cracks in the semiconductor crystal layer, the effect of reducing a used amount of the semiconductor crystal layer and the effect of improving the internal quantum efficiency IQE, and therefore, such a case is preferable.

(Concavo-convex structure)

A more preferable form of the concavo-convex structure 20 will be described below. It is essential only that the concavo-convex structure 20 has the convex portion and concave portion. Particularly, it is preferable that the structure 20 is a concavo-convex structure D as described in the following «Optical substrate D» or concavo-convex structure PC described in the following «Optical substrate PC». By this means, since optical scattering properties are strengthened, a difference in light and dark of the pattern X is increased, and increases in light extraction efficiency LEE are enhanced.

As the concavo-convex structure 20, for example, it is possible to adopt the line-and-space structure with a plurality of bar-shaped bodies arranged, lattice structure with a plurality of bar-shaped bodies crossing, dot structure with a plurality of dot(convex portion, protrusion)-shaped structures arranged, hole structure with a plurality of hole(concave portion)-shaped structures arranged, and the like. As the dot structure and hole structure, examples thereof are a cone, cylinder, quadrangular pyramid, quadrangular prism, hexagonal pyramid, hexagonal prism, polygonal pyramid, polygonal prism, the shape of a double ring, and the shape of a multi-ring. In addition, these shapes include shapes that the outside diameter of the bottom is distorted, and shapes that the side surface is curved.

In addition, the dot structure is a structure where a plurality of convex portions is arranged independently of one another. That is, each convex portion is separated by a continuous concave portion. In addition, convex portions may be smoothly connected by a continuous concave portion. On the other hand, the hole structure is a structure where a plurality of concave portions is arranged independently of one another. That is, each concave portion is separated by a continuous convex portion. In addition, concave portions may be smoothly connected by a continuous convex portion. In the structures, from the viewpoint of more increasing the internal quantum efficiency IQE, the concavo-convex structure 20 is preferably the dot structure. This is because it is necessary to promote dislocation dispersion by the density of the concavo-convex structure 20, in order to increase the internal quantum efficiency IQE by the concavo-convex structure 20.

In order to suppress the occurrence of cracks in the first semiconductor layer 30 provided on the concavo-convex structure 20, the convex portion of the concavo-convex structure 20 is preferably a structure that the size of the convex-portion vertex portion is smaller than the size of the convex-portion bottom portion.

Particularly, in order to increase the internal quantum efficiency IQE, among dot structures, the concavo-convex structure 20 is preferably a structure that the convex-portion vertex portion does not have a flat surface. Further, in order to more increase the internal quantum efficiency, it is more preferable that the concave-portion bottom portion of the concavo-convex structure 20 has a flat surface. In addition, the structure that the convex-portion vertex portion does not have a flat surface is defined as that the diameter of the flat surface of the vertex portion of the convex portion 20a is 10 nm or less in observing the convex portion 20a with the scanning electron microscope.

Further, from the viewpoints of the occurrence of cracks in the semiconductor crystal layer and more development of the effect of improving the internal quantum efficiency IQE, such a structure is preferable that the inclination angle changes in two or more stages from the convex-portion vertex portion to the convex-portion bottom portion. In addition, it is the most preferable that the change in the inclination angle of the convex-portion side surface portion is a gentle change from the convex-portion bottom portion to the convex-portion vertex portion.

In the case where the flat surface that the concave-portion bottom portion of the concavo-convex structure 20 has is parallel to a surface (hereinafter, referred to as "parallel stable growth surface") almost parallel to a stable growth surface of the first semiconductor layer 30 provided on the concavo-convex structure 20, the disturbances of the growth mode of the first semiconductor layer 39 is large near the concave portion of the concavo-convex structure 20, it is possible to effectively reduce dislocations inside the first semiconductor layer 30 by the concavo-convex structure 20, and the internal quantum efficiency IQE is thereby increased. The stable growth surface refers to a surface with the lowest growth rate in a material to grow. Generally, it is known that the stable growth surface appears as a facet surface during the growth. For example, in the case of gallium nitride-based compound semiconductor, a plane parallel to the A-axis typified by the M-surface is the stable growth surface. The stable growth surface of the GaN-based semiconductor layer is the M-surface (1-100), (01-10), (-10101) of a hexagonal crystal, and is one of surfaces parallel to the A-axis. In addition, depending on the growth conditions, there is the case where the stable growth surface is another surface including the A-axis that is a plane except the M-surface of the GaN-based semiconductor.

Described next are elements constituting the concavo-convex structure 20 and more preferable ranges of the elements. As the elements of the concavo-convex structure 20, examples thereof are the pitch P', duty, aspect ratio, convex-portion vertex portion width lcvt, convex-portion bottom portion width lcvb, concave-portion opening width lcct, concave-portion bottom portion width lccb, inclination angle of the convex-portion side surface, the number of changes in the inclination angle of the convex-portion side surface, convex-portion bottom portion inscribed circle diameter $\Phi in$, convex-portion bottom portion circumscribed circle diameter $\Phi out$, convex-portion height H, area of the convex-portion vertex portion, the number (density) of minute protrusions on the surface of the convex portion, ratio thereof, and information (for example, shape of the concave portion or the like) by analogy from the arrangement of the concavo-convex structure.

<Height H>

The height of the concavo-convex structure 20 is defined as the shortest distance between the average position of the concave-portion bottom portion of the concavo-convex structure 20 and the position of the convex-portion vertex of the concavo-convex structure 20. The number of samples in calculating the average position is preferably 10 or more.

The height H of the concavo-convex structure 20 preferably ranges from 10 nm to 1,000 nm. By the height H being 10 nm or more, since it is possible to disturb the growth mode of the first semiconductor layer 30, the dislocation density is thereby decreased, and it is possible to increase the internal quantum efficiency IQE. Particularly, from the viewpoints of increasing the difference in light and dark of the pattern X and increasing the light extraction efficiency LEE, the height H is preferably 30 nm or more, more preferably 50 nm or more, and most preferably 100 nm or more. On the other hand, by the height H being 1,000 nm or less, it is possible to reduce the deposition amount of the first semiconductor layer 30, and to shorten the deposition time. Particularly, by the height H being 500 nm or less, it is possible to suppress the occurrence of cracks in association with growth of the first semiconductor layer 30, and therefore, such a range is preferable. From the same effects, the height H is more preferably 350 nm or less, and most preferably 300 nm or less.

<Convex-portion vertex portion width lcvt, concave-portion opening width lcct, convex-portion bottom portion width lcvb, concave-portion bottom portion width 1 ccb>

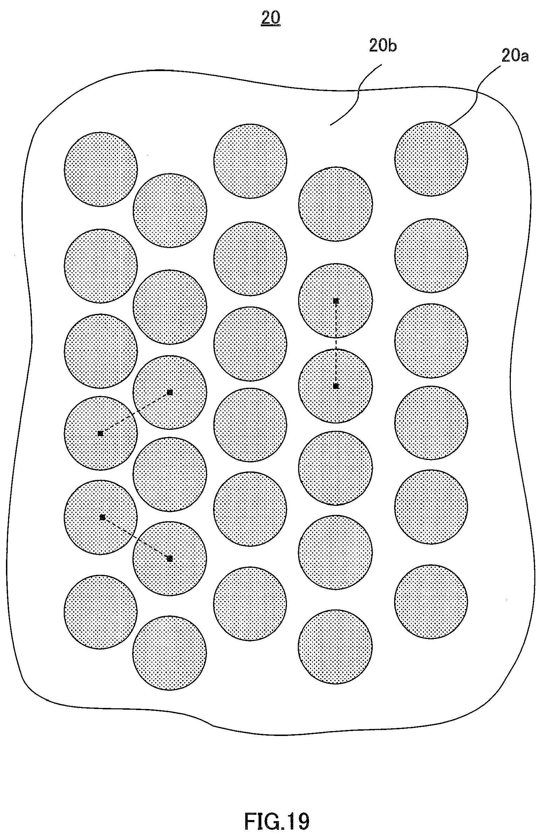

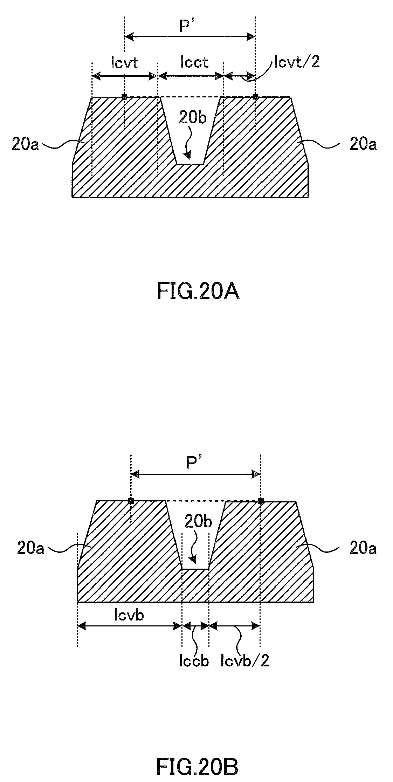

FIG. 19 is a top diagram in the case where the concavo-convex structure PP constituting the concavo-convex structure surface of the optical substrate PP according to this Embodiment is the dot structure. FIG. 19 shows the top diagram in the case where the concavo-convex structure 20 is the dot structure. Each of line segments shown by dashed lines in FIG. 19 is a distance between the center of some convex portion 20a and the center of a convex portion closest to the convex portion 20a, and means the pitch P' as described above. FIGs. 20A and 20B show cross-sectional schematic diagrams of the concavo-convex structure PP in the position of the line segment that corresponds to the pitch P' as shown in FIG. 19.

As shown in FIG. 20A, the convex-portion vertex portion width lcvt is defined as a width of the top surface of the convex portion 20a, and the concave-portion opening width lcct is defined as a difference value (P'-lcvt) between the pitch P' and the convex-portion vertex portion width lcvt. As shown in FIG. 20B, the convex-portion bottom portion width lcvb is defined as a width of the bottom portion of the convex portion 20a, and the concave-portion bottom portion width lccb is defined as a difference value (P'-lcvb) between the pitch P' and the convex-portion bottom portion width lcvb.

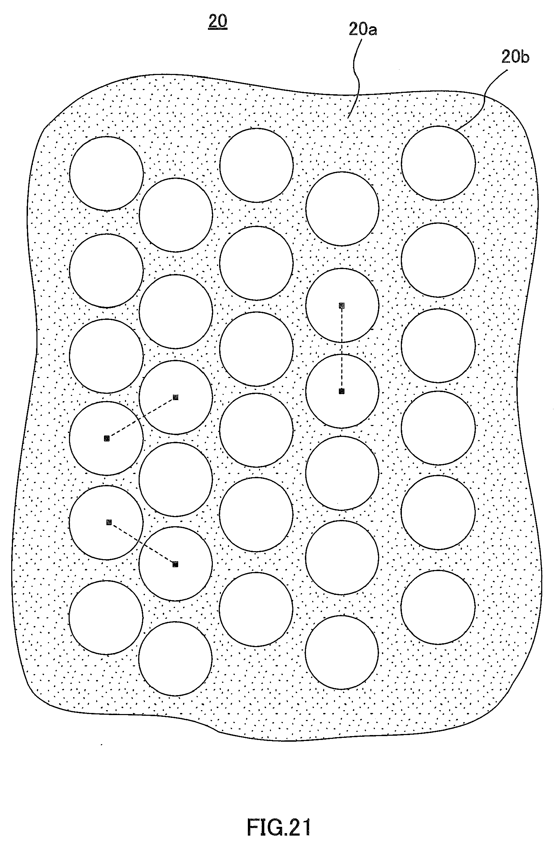

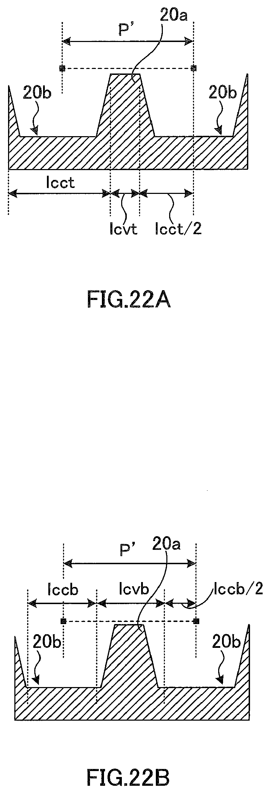

FIG. 21 is a top diagram in the case where the concavo-convex structure PP constituting the concavo-convex structure surface of the optical substrate PP according to this Embodiment is the hole structure. Each of line segments shown by dashed lines in FIG. 21 is a distance between the center of some concave portion 20b and the center of a concave portion closest to the convex portion 20b, and means the pitch P' as described above. FIGs. 22A and 22B show cross-sectional schematic diagrams of the concavo-convex structure 20 in the position of the line segment that corresponds to the pitch P' as shown in FIG. 21.

FIG. 22 is a cross-sectional schematic diagram of the concavo-convex structure PP in the position of the line segment that corresponds to the pitch P' as shown in FIG. 21. As shown in FIG. 22A, the concave-portion opening width lcct is defined as an opening diameter of the concave portion 20b, and the convex-portion vertex portion width lcvt is defined as a difference value (P'-lcct) between the pitch P' and the concave-portion opening width lcct. As shown in FIG. 22B, the convex-portion bottom portion width lcvb is defined as a width of the bottom portion of the convex portion 20a, and the concave-portion bottom portion width lccb is defined as a difference value (P'-lcvb) between the pitch P' and the convex-portion bottom portion width lcvb.

It is preferable that the ratio (lcvt/lcct) of the convex-portion vertex portion width lcvt to the concave-portion opening width lcct of the concavo-convex structure 20 is smaller, and it is the most preferable that the ratio is substantially 0. In addition, lcvt/lcct=0 means that lcvt=0 nm. However, for example, even when the lcvt is measured with the scanning electron microscope, it is not possible to measure 0 nm accurately. According, the lcvt herein is assumed to include all the cases of the measurement resolution or less. When the ratio (lcvt/lcct) is 3 or less, it is possible to effectively increase the internal quantum efficiency IQE. This is because dislocations occurring on the vertex portion of the convex portion are suppressed, dispersion properties of the dislocations are improved, and microscopic and macroscopic dislocation densities are decreased. Further, by the (lcvt/lcct) being 1 or less, it is possible to increase the light extraction efficiency LEE. This is because the distribution of refractive index made by the optical substrate PP 10 and the first semiconductor layer 30 is appropriate viewed from the emitted light. From the viewpoints of significantly increasing both the internal quantum efficiency IQE and the light extraction efficiency LEE as described above, (lcvt/lcct) is preferably 0.4 or less, more preferably 0.2 or less, and further preferably 0.15 or less.

In the case where the bottom portion of the concave portion 20b of the concavo-convex structure 20 has a flat surface, it is possible to increase the internal quantum efficiency IQE and also to decrease a difference between semiconductor crystal deposition apparatuses, and therefore, such a case is preferable. In a semiconductor light emitting device, in order to increase the internal quantum efficiency IQE, it is necessary to disperse dislocations inside the semiconductor crystal layer and to decrease local and macroscopic dislocation densities. Herein, initial conditions of these physical phenomena are nucleation and nucleus growth in depositing the semiconductor crystal layer by chemical deposition (CVD). By the fact that the bottom portion of the concave portion 20b of the concavo-convex structure 20 has a flat surface, it is possible to cause nucleation suitably, and it is thereby possible to more develop the effect of reducing dislocations inside the semiconductor crystal layer due to the density of the concavo-convex structure 20. As a result, it is possible to more increase the internal quantum efficiency IQE. From the above-mentioned viewpoints, it is preferable that the ratio (lcvb/lccb) of the convex-portion bottom portion width lcvb to the concave-portion bottom portion width lccb of the concavo-convex structure 20 is preferably 5 or less. Particularly, from the viewpoint of more promoting growth of the semiconductor crystal layer with the concave-portion bottom portion of the concavo-convex structure 20 as a reference surface, (lcvb/lccb) is more preferably 2 or less, and most preferably 1 or less.

Further, when the convex-portion vertex portion width lcvt is a smaller shape than that of the convex-portion bottom portion width lcvb, it is easy to concurrently meet the above-mentioned ratio (lcvt/lcct) and ratio (lcvb/lccb), and therefore, from the already described mechanism, it is possible to concurrently increase the internal quantum efficiency IQE and the light extraction efficiency LEE.

Further, when the concavo-convex structure 20 is the dot structure, control of the convex-portion vertex portion width lcvt and the convex-portion bottom portion width lcvb is made easy, it is easy to concurrently meet the ratio (lcvt/lcct) and the ratio (lcvb/lccb), and therefore, from the already described mechanism, it is possible to concurrently increase the internal quantum efficiency IQE and the light extraction efficiency LEE.

<Duty>

The duty is expressed by a ratio (lcvb/P') of the convex-portion bottom portion width lcvb to the pitch P'. From the viewpoint of the light extraction efficiency LEE, it is preferable that the duty is larger i.e. approaches 1, and from the viewpoint of the internal quantum efficiency IQE, it is preferable that the duty is a predetermined value or less. Herein, the duty is preferably 0.95 or less. This is because by meeting 0.95 or less, it is possible to maintain nucleation and growth properties of the semiconductor crystal layer. Further, from the viewpoints of making nucleation excellent in semiconductor crystal layer deposition and increasing the internal quantum efficiency IQE, the ratio preferably ranges from 0.03 to 0.83. By the ratio being 0.03 or more, the effect of disturbing the crystal mode of the semiconductor crystal layer is increased, it is possible to improve the internal quantum efficiency IQE, while the volume of the convex portion is increased, the effect of disturbing the waveguide mode is thereby increased, and it is possible to increase the light extraction efficiency LEE. From the same effects, the ratio (lcvb/P') is more preferably 0.17 or more, and is most preferably 0.33 or more. On the other hand, by the ratio being 0.83 or less, it is possible to perform nucleation and nucleus growth excellently in chemical deposition of the semiconductor crystal layer, and it is possible to increase the internal quantum efficiency IQE. From the same effect, the ratio (lcvb/P') is more preferably 0.73 or less, and is most preferably 0.6 or less.

<Aspect ratio>

When the concavo-convex structure 20 is the dot structure, using the above-mentioned lcvb, the aspect ratio is defined as height H/lcvb of the concavo-convex structure 20. On the other hand, when the concavo-convex structure 20 is the hole structure, using the above-mentioned lcct, the aspect ratio is defined as depth H/lcct of the concavo-convex structure 20. An average aspect ratio is defined as a value of an average (arithmetic mean) of 10 or more aspect ratios. The average aspect ratio preferably ranges from 0.1 to 3. By the average aspect ratio being 0.1 or more, since it is possible to disturb the growth mode of the first semiconductor layer 30, the dislocation density is decreased, and it is possible to increase the internal quantum efficiency IQE. Particularly, from the viewpoints of increasing a difference in light and dark of the pattern X and increasing the light extraction efficiency LEE, the average aspect ratio is preferably 0.3 or more, more preferably 0.5 or more, and most preferably 0.6 or more. On the other hand, by the ratio being 3 or less, it is possible to decrease the deposition amount of the first semiconductor layer 30 and shorten the deposition time. Particularly, the ratio of 2 or less enables the occurrence of cracks in association with growth of the first semiconductor layer 31 to be suppressed, and is thereby preferable. From the same effect, the ratio is more preferably 1.5 or less, and most preferably 1.2 or less.

<Convex-portion bottom portion circumscribed circle diameter Φout, convex-portion bottom portion inscribed circle diameter Φin>

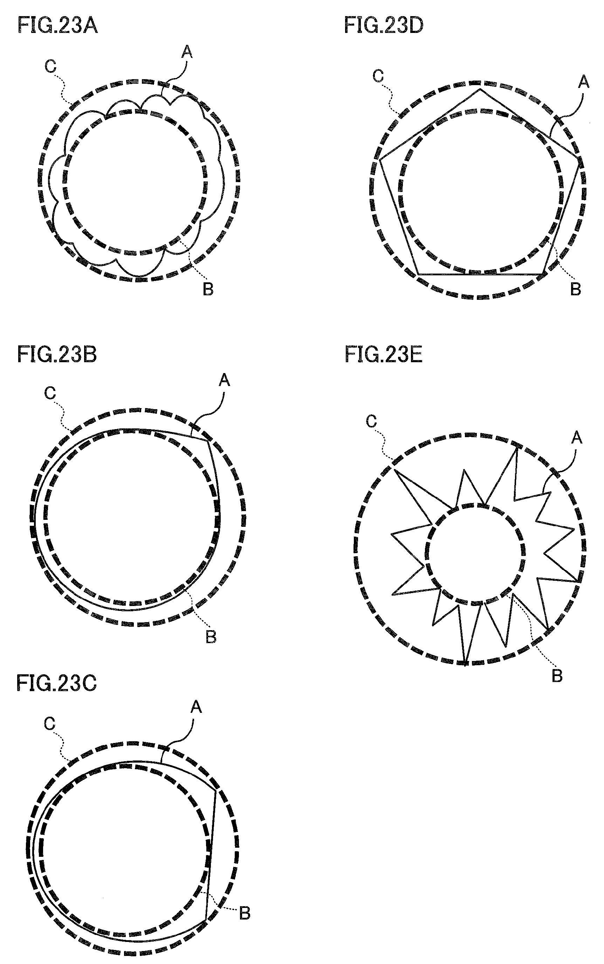

FIG. 23 contains explanatory diagrams illustrating top images in the case of observing the optical substrate PP according to this Embodiment from the concavo-convex structure surface side using the scanning electron microscope. FIGs. 23A to 23E illustrate top images of the concavo-convex structure in the case of observing the optical substrate PP 10 from the concavo-convex structure surface side using the scanning electron microscope. The convex portion of the concavo-convex structure 20 of the optical substrate PP 10 according to this Embodiment may be a distorted shape. The contour (hereinafter, referred to as convex-portion bottom portion contour) of the concavo-convex structure 20 in the case of observing the concavo-convex structure 20 from the concavo-convex structure side is shown by "A" in FIGs. 23a to 23E. Herein, when the convex-portion bottom portion contour A is not a perfect circle, the inscribed circle and circumscribed circle with respect to the convex-portion bottom portion contour A are not matched. In FIGs. 23A to 23E, the inscribed circle is shown by "B", and the circumscribed circle is shown by "C". In addition, the diameter of the inscribed circle B with respect to the convex-portion bottom portion contour A is defined as the convex-portion bottom portion inscribed circle diameter Φin. In addition, Φin is assumed to be the diameter of the inscribed circle B when the size of the inscribed circle B is a maximum. In addition, the inscribed circle B is a circle disposed inside the convex-portion bottom portion contour A, and is a circle that contacts a part of the convex-portion bottom portion contour A and that does not extend from the convex-portion bottom portion contour A to the outside. On the other hand, the diameter of the circumscribed circle C with respect to the convex-portion bottom portion contour A is defined as the convex-portion bottom portion circumscribed circle diameter Φout. In addition, Φout is assumed to be the diameter of the circumscribed circle C when the size of the circumscribed circle C is a minimum. In addition, the circumscribed circle C is a circle disposed outside the convex-portion bottom portion contour A, and us a circle that contacts a part of the convex-portion bottom portion contour A and that does not enter the inside of the convex-portion bottom portion contour A.

The ratio (Φout/Φin) of the convex-portion bottom portion circumscribed circle diameter Φout to the convex-portion bottom portion inscribed circle diameter Φin is a measure indicative of distortion of the convex-portion bottom portion contour A. When the ratio (Φout/Φin) ranges from 1 to 3, it is possible to concurrently actualize increases in internal quantum efficiency IQE and increases in light extraction efficiency LEE, and therefore, such a range is preferable. When the ratio (Φout/Φin) is 1, the convex-portion bottom portion contour A is a perfect circle. In this case, it is possible to cause optical simulations to act suitably in designing the concavo-convex structure 20, and design of the semiconductor light emitting device is thereby made easy. Further, since uniformity of the growth rate of the semiconductor crystal layer is enhanced, the internal quantum efficiency IQE is more increased, and the defect rate of the semiconductor light emitting device decreases. From the viewpoint of increasing the light extraction efficiency LEE, the ratio (Φout/Φin) preferably exceeds 1. On the other hand, when the ratio (Φout/Φin) is 3 or less, it is possible to increase the internal quantum efficiency IQE. The fact that ratio (Φout/Φin) is large means that the diameter of the convex-portion bottom portion is significantly distorted from a perfect circle. That is, the fact means that the convex-portion bottom portion width lcvb and concave-portion bottom portion width lccb change according to the direction to measure. Particular, since the concave-portion bottom portion width lccb is important as a reference surface of growth of the semiconductor crystal layer, it is necessary to meet the above-mentioned range. From this viewpoint, the ratio (Φout/Φin) is preferably 3 or less, more preferably 2 or less, and most preferably 1.5 or less.

<Convex-portion side surface inclination angle Θ>

The inclination angle Θ of the convex-portion side surface is determined by the shape parameter of the concavo-convex structure 20 as described above. Particularly, it is preferable that the inclination angle changes in a multi-stage from the convex-portion vertex portion toward the convex-portion bottom portion. For example, when the inflection point that the convex-portion side surface is bulged upward draws a single curve, the number of inclination angles is 2. By having such multi-stage inclination angles, it is possible to suppress cracks occurring inside the first semiconductor layer 30. Further, corresponding to materials of the optical substrate PP 10 and semiconductor crystal layer, it is also possible to select the inclination angle of the convex-portion side surface from the crystal surface appearing on the convex-portion side surface. In this case, it is conceivable that growth properties of the semiconductor crystal layer are made excellent, and that the internal quantum efficiency IQE is thereby increased.

In addition, in the case where the concavo-convex structure 20 is comprised of a plurality of concave portions 20a, it is possible to replace the words of "convex-portion bottom portion" as described above with "concave-portion opening portion" to read.

As described above, it is presumed that the pattern X observed with the optical microscope is drawn due to the distribution of effective refractive index Nema formed by a difference in the element of the concavo-convex structure 20, and it has been verified that the pattern X is actually drawn by taking the element of the concavo-convex structure 20 as a parameter to change. Herein, since it can be thought that the occurrence of the change of effective refractive index Nema is the essence to draw the pattern X, it is conceivable that it is possible to actualize the method of drawing the pattern X by types of materials constituting the concavo-convex structure 20, as well as the difference in the shape and arrangement of the concavo-convex structure 20 existing as an entity. That is, it is conceivable that it is possible to draw the pattern X by regarding the difference in the concavo-convex structure 20 as described above as a difference in materials forming the concavo-convex structure 20, particularly, a difference in the refractive index or extinction coefficient of materials forming the concavo-convex structure 20. Particularly, in considering that the optical substrate PP 10 is applied to a semiconductor light emitting device, it is conceivable that it is preferable to draw the pattern by a difference in the refractive index of materials forming the concavo-convex structure 20, from the viewpoint of increasing the light extraction efficiency LEE. Further, it is not hard to conceive that a difference of the extent of behavior of light due to the refractive index is important in drawing the difference X by a difference in the refractive index of materials forming the concavo-convex structure 20. In calculating from this viewpoint, in order to draw the pattern X by a difference in the refractive index of materials forming the concavo-convex structure 20, the difference in the refractive index is preferably 0.07 or more, and more preferably 0.1 or more. This is because it is thereby possible to increase the reflectance of light. Particularly, from the viewpoints of more increasing the reflectance and strengthening a difference in light and dark of the pattern X, it is presumed that the difference in the refractive index is more preferably 0.5 or more. In addition, the difference in the refractive index is preferably larger, and most preferably 1.0 or more.

Described next is a method of manufacturing the optical substrate PP 10 according to this Embodiment. As long as the optical substrate PP 10 according to this Embodiment is provided with the concavo-convex structure 20 meeting the above-mentioned conditions, the manufacturing method thereof is not limited, and it is possible to manufacture the substrate by a transfer method, photolithography method, thermal lithography method, electron beam lithography method, interference exposure method, lithography method using nanoparticles as a mask, lithography method using a self-organizing structure as a mask and the like. Particularly, from the viewpoints of processing accuracy and processing speed of the concavo-convex structure 20 of the optical substrate PP 10, it is preferable to adopt the transfer method.

Herein, the transfer method is defined as a method including a step of transferring a fine structure of a mold with the fine structure observed on its surface to a target product (optical substrate PP 10 without the concave-convex structure 20 being prepared yet). Herein, the arrangement of the fine structure of the mold is the same as the arrangements of the concavo-convex structure 20 and pattern X as described above. Further, for example, it is possible to manufacture the mold by manufacturing a cylindrical master mold by techniques described in «Optical substrate PC» as described later, and transferring a pattern of the cylindrical mold. That is, the method is a method including at least a step of bonding the fine structure of the mold to the target product via a transfer material, and a step of peeling off the mold. More specifically, it is possible to classify the transfer method into two.

First, there is the case of using a transfer material that is transfer-added to the target product as a permanent material. For example, it is possible to add a permanent material having $SiO_2$, ITO, ZnO, $TiO_2$, SnO or the like as a main component to the main surface of the substrate body with the main surface being sapphire, silicon, silicon carbide, gallium nitride, or transparent conductive layer (ITO or the like). In this case, the main body of the optical substrate PP 10 is different from materials constituting the concavo-convex structure 20. Further, it is a feature that the concavo-convex structure 20 remains as the permanent material and is used as a semiconductor light emitting device. Since the semiconductor light emitting device is used over a long term such as several tens of thousands of hours, in the case of using the transfer material as the permanent material, it is preferable that materials constituting the transfer material contain the metal element. Particularly, by containing metal alkoxide causing hydrolysis and polycondensation reaction, or condensation compound of metal alkoxide in raw materials, performance as the permanent material is increased, and therefore, such materials are preferable. In addition, by using a transfer material obtained by mixing two or more materials, designing a difference in the refractive index between the materials, and using phase separation, it is conceivable that it is possible to draw the pattern X due to the difference in the refractive index between materials forming the concavo-convex structure 20 as described above.

Second, there is a nanoimprint lithography method. The nanoimprint lithography method is a method including a step of transferring an arrangement of a fine structure of a mold onto a target product, a step of providing a mask to process the target product by etching, and a step of etching the target product. For example, in the case of using one kind of transfer material, first, the target product and mold are bonded via the transfer material. Next, the transfer material is cured by heat or light (UV), and the mold is peeled off. Etching typified by oxygen ashing is performed on the concavo-convex structure comprised of the transfer material to partially expose the target product. As the processing method at this point, it is possible to adopt dry etching and wet etching. In the case of intending to increase the height of the concavo-convex structure 20, dry etching is useful. Further, for example, in the case of using two kinds of transfer materials, a first transfer material layer is first formed on the target product. Next, the first transfer material layer and mold are bonded via a second transfer material. Subsequently, the transfer material is cured by heat or light (UV) to peel off the mold. Etching typified by oxygen ashing is performed on the concavo-convex structure comprised of the second transfer material to partially expose the first transfer material. Next, using the second transfer material layer as a mask, the first transfer material layer is etched by dry etching. Subsequently, using the transfer material as a mask, the target product is processed by etching. As the processing method at this point, it is possible to adopt dry etching and wet etching. In the case of intending to increase the height of the concavo-convex structure 20, dry etching is useful.

Further, as the transfer method, it is possible to adopt a method of manufacturing a sheet for nano-processing that is a member for nano-processing beforehand provided with a mask layer and a resist layer, and using the sheet. Herein, the sheet for nano-processing is a sheet obtained by filling and providing a mask layer inside the concave portion of the fine structure of the mold, and forming a resist layer on the fine structure surface of the mold filled with the mask layer to flatten the fine structure. By including at least a step of bonding the sheet for nano-processing to a target product, and a step of peeling off the mold in this order, it is possible to obtain a layered product comprised of target product/resist layer/mask layer. First dry etching processing is performed from the mask layer surface side of the obtained layered product to partially expose the target product. Herein, as the first dry etching processing, it is possible to adopt oxygen ashing using oxygen. Next, it is possible to perform nano-processing on the target product by dry etching or wet etching. Particularly, by adopting dry etching, it is possible to add a nanostructure with a high aspect ratio onto the target product. For example, when the target product is a sapphire substrate, as a gas to use in dry etching, it is possible to use $Cl_2$ gas, $BCl_3$ gas, or a mixed gas of $Cl_2$ gas and $BCl_3$ gas. Further, Ar may be added to such a gas. By using such a sheet for nano-processing, in-plane processing uniformity is enhanced in the target product. As a mask layer constituting the sheet for nano-processing, it is possible to contain the metal element such as Ti, Si and Zr, and to select metal alkoxide and silane coupling agent. Further, as the resist layer, it is possible to adopt thermosetting resin and thermoplastic resin.

As described above, by adopting the transfer method, since it is possible to reflect the fine structure arrangement of the mold in the target product, it is possible to obtain the optical substrate PP 10 with excellence.

That is, an imprint mold according to this Embodiment is a mold which is provided with a mold body, and a fine structure provided on a main surface of the mold body, and which is used to prepare the optical substrate PP 10 with an arrangement of the fine structure transferred to the surface, and is characterized in that a pattern observable at any magnification within a range of 10 times to 5,000 times with an optical microscope is drawn on the main surface, an interval of the pattern is larger than a pitch of the concavo-convex structure, and that in an optical microscope image of the pattern, the pattern is capable of being distinguished to a first region and a second region by a difference in light and dark, a plurality of first regions is arranged apart from one another at intervals, and the second region connects between the first regions.

Herein, as the arrangement of the fine structure, it is possible to adopt the arrangement obtained by replacing the above-mentioned concavo-convex structure 20 with a fine structure to read. Particularly, the hole-shaped structure in the above-mentioned concavo-convex structure 20 is preferable. Further, it is possible to define the definition of the pattern observed in the mold by replacing the concavo-convex structure 20 and the optical mold PP 10 respectively with the fine structure and the mold to read. Furthermore, as in the optical substrate PP 10, in performing observation using a laser beam, it is preferable that the laser beam splits in two or more.

Materials of the imprint mold are not limited particularly, and it is possible to use glass, quartz, sapphire, nickel, diamond and flexible resins. Among the materials, by using flexible molds, transfer accuracy of the fine structure of the mold is enhanced, concavo-convex structure accuracy of the optical substrate PP 10 is enhanced, and therefore, such molds are preferable. Particularly, from the viewpoint of more enhancing the transfer accuracy, it is the most preferable that the mold is comprised of one of a fluorine resin, silicone resin, resin containing fluorine, and resin containing methyl groups.

In the case of manufacturing a semiconductor light emitting device, it is preferable to include a step of preparing the optical substrate PP 10 according to this Embodiment, a step of performing an optical inspection on the optical substrate PP 10, and a step of manufacturing a semiconductor light emitting device using the optical substrate PP 10 in this order.

As described already, in the optical substrate PP 10 according to this Embodiment, it is possible to observe the pattern X made by the concavo-convex structure 20. Therefore, by performing an optical inspection after preparing the optical substrate PP 10, it is possible to beforehand grasp the accuracy of the concavo-convex structure 20 and the pattern X. In other words, without performing analysis of a high degree using an electron beam, by general optical microscope observation, it is possible to judge the accuracy of the concavo-convex structure 20. For example, in the case of adding the concavo-convex structure 20 (pattern X) to a sapphire substrate so as to concurrently increase the internal quantum efficiency IQE and the light extraction efficiency LEE, by performing the optical inspection on the sapphire substrate, and evaluating a scattering component of the optical inspection, it is possible to grasp the accuracy of the concavo-convex structure 20 (pattern X). By this means, it is possible to beforehand estimate the performance rank of an LED device to manufacture. Further, since it is also possible to screen out optical substrates that cannot be used, the yield is enhanced.

Herein, it is possible to measure the optical inspection using either of transmission measurement and reflection measurement, as well as optical microscope observation used in the definition of the pattern X of the optical substrate PP 10. In the case of transmission measurement, a scattering component of transmitted light may be detected. Therefore, the scattering component may be evaluated directly, or haze may be used. Particularly, the case of haze enables a publicly-known commercially available apparatus to be used, and is preferable. The haze is obtained from total transmittance T of light which is applied from a light source and passes through a sample and transmittance D of light which is diffused and scattered on the sample surface, and is defined as haze value H=D/T x 100. These items are specified by JIS K 7105, and it is possible to easily measure by using a commercially available haze meter (for example, NDH-10.025DP, made by NIPPON DENSHOKU INDUSTRIES Co., LTD. and the like). Since the essence of the haze is the scattering component of transmitted light, by using equipment that enables the scattering component of transmitted light to be detected in applying the light to the optical substrate PP 10, it is possible to quantify the relationship between the concavo-convex structure 20 and the pattern X as the optical inspection. Particularly, it is preferable to apply incident light at a predetermined angle, instead of perpendicular incidence.

On the other hand, in the case of reflection measurement, either of a regular reflection component or a diffuse reflection component may be used. By using the regular reflection component, it is possible to evaluate accuracy of the contour shape of the concavo-convex structure 20, and by using the diffuse reflection component, it is possible to evaluate volume distribution accuracy of the concavo-convex structure 20. It is possible to select which component to adopt as appropriate according to the used concavo-convex structure 20 and the purpose. Further, it is also possible to use a ratio between the diffuse reflection component and the regular reflection component, (diffuse reflection component-regular reflection component), (diffuse reflection component-regular reflection component)/regular reflection component, (diffuse reflection component-regular reflection component)/diffuse reflection component and the like.

In the above-mentioned optical inspection, by making the wavelength of the light source larger than the average pitch P'ave of the concavo-convex structure 20, it is possible to extract the effect of the pattern X. This is because of meaning that the effect of the pattern X is purely evaluated, and that it is possible to control with higher accuracy. Further, also in reflection measurement, in order to increase output, it is preferable to measure in oblique incidence.

«Optical substrate D»

The general outline of the optical substrate D of this Embodiment will be described. As described above, increases in internal quantum efficiency IQE and light extraction efficiency LEE, and increases in electron injection efficiency EIE and light extraction efficiency LEE are in mutually tradeoff relationships. Herein, it is noted that any of these tradeoff relationships is caused by a difference in the order such as "structure of nano-order" and "structure of micro-order".

In a semiconductor light emitting device, it is possible to increase the internal quantum efficiency IQE or the electron injection efficiency EIE due to the structure of nano-order, and on the other hand, by using optical scattering properties (light scattering or light diffraction) due to the structure of micro-order, it is possible to increase the light extraction efficiency LEE. Herein, the concavo-convex structure sufficiently smaller than wavelengths of light is averaged (effective medium approximated) viewed from the light, and functions as a thin film having the effective refractive index Nema. Therefore, even when the concavo-convex structure of nano-order is provided, the optical scattering properties are extremely small, and the degree of increases in light extraction efficiency LEE is limited.

Herein, in the case where the concavo-convex structure having a predetermined size and arrangement includes disturbances, we found out and noted that optical scattering properties are detected also in the case of performing the optical inspection under effective medium approximation where a wavelength of a light source is sufficiently larger than the size of the concavo-convex structure. The reason is conceivable that a thin film having the effective refractive index Nema has a distribution of the refractive index corresponding to the disturbances of the concavo-convex structure, and therefore, in the case of viewing from light, is shown so that as if a medium corresponding to the distribution of the refractive index exists. Using terms as described already, by adding a disturbance to the concavo-convex structure existing as an entity, an optical pattern, which is recognizable by light and has an order lager than that of the concavo-convex structure existing as an entity, is generated, and therefore, even the concavo-convex structure of nano-order develops optical scattering properties.

Further, in the case of the concavo-convex structure that is not under effective medium approximation, where the wavelength of light is equal to or less than the size of the concavo-convex structure, by adding a disturbance to the concavo-convex structure, it is conceivable that it is possible to add a plurality of modes to light diffraction occurring in a microscopic order such as one by one of the concavo-convex structure. Therefore, in a macroscopic order such as several tens of micrometers, it was found out that an average optical behavior of light diffraction is observed due to a plurality of modes, and that optical scattering properties are thereby exhibited. That is, by adding a disturbance to the concavo-convex structure, since it is possible to use optical scattering properties with a large effect of disturbing the waveguide mode, it is possible to more increase the light extraction efficiency LEE.

That is, also in the case where the concavo-convex structure is sufficiently small viewed from light, or in the case of the concavo-convex structure of about the same to several tens of times, by including a disturbance, it is possible to exhibit optical scattering properties. Therefore, it is possible to concurrently develop the function (increases in internal quantum efficiency IQE or electron injection efficiency EIE due to the concavo-convex structure) corresponding to the concavo-convex structure with a small disturbance, and the function (increases in light extraction efficiency LEE using optical scattering properties due to the disturbances) that is newly added due to the disturbances. Particularly, in order to increase the light extraction efficiency LEE with increases in internal quantum efficiency IQE or light extraction efficiency LEE due to the concavo-convex structure maintained, it is considered that it is important to set a predetermined range on the distribution as the effective refractive index Nema in the optical inspection, and consequently, we found out that adding a disturbance to the concavo-convex structure is effective and arrived at completion of the optical substrate D that is this Embodiment.

In this Embodiment, two aspects are considered as "the concavo-convex structure including a disturbance".

The first aspect is the case where at least one of elements of the concavo-convex structure has regularity or uniformity, while at least one of the other elements of the concavo-convex structure has irregularity or non-uniformity.

The second aspect is the case where the concavo-convex structure includes a portion (hereinafter, referred to as specific portion) where an element of the concavo-convex structure is different from that of a main portion, as well as the main portion where at least one of elements of the concavo-convex structure has regularity or uniformity.

In other words, in the present invention, "the concavo-convex structure including a disturbance" refers to having the function corresponding to the original concavo-convex structure or the structure or arrangement (hereinafter, referred to as a basis structure) of convex portions or concave portions that exert an optical phenomenon, while having a portion (hereinafter, referred to as the specific portion) that is a structure or arrangement of convex portions or concave portions deviating from the basic structure and that exerts an optical phenomenon different from that in the basic structure.

In the above-mentioned first aspect, the element of the concavo-convex structure having regularity or uniformity corresponds to the basic structure, and the element of the concavo-convex structure having irregularity corresponds to the specific structure.

Further, in the above-mentioned second aspect, the main portion corresponds to the basic structure, and the specific portion corresponds to the specific portion

Herein, the elements of the concavo-convex structure are conditions to determine the structure (dimensions, shape and the like) of the convex portion or concave portion of the concavo-convex structure, arrangement of convex portions or concave portions, and the like.

For example, the elements of the concavo-convex structure are preferably elements listed below, and may be one, or two or more. In addition, the following terms are in accordance with the definitions as already described in «Optical substrate PP».

Height H of the convex portion of the concavo-convex structure;
Outside diameter of the convex-portion bottom portion of the concavo-convex structure;
Aspect ratio of the concavo-convex structure;
Convex-portion bottom portion circumscribed circle diameter $\Phi$out of the concavo-convex structure;
Convex-portion bottom portion inscribed circle diameter $\Phi$in of the concavo-convex structure;
Ratio between the convex-portion bottom portion circumscribed circle diameter $\Phi$out and the convex-portion bottom portion inscribed circle diameter $\Phi$in of the concavo-convex structure;
Pitch P' of the concavo-convex structure;
Duty of the concavo-convex structure;
Inclination angle of the side surface of the convex portion of the concavo-convex structure;
Area of a flat surface of the vertex portion of the convex portion of the concavo-convex structure; and
Refractive index of the substance making the concavo-convex structure.

That is, the optical substrate D of the present invention is an optical substrate provided with a concavo-convex structure D on its surface, where an average pitch of the concavo-convex structure D ranges from 50 nm to 1,500 nm, the concavo-convex structure D includes disturbances, and a standard deviation and arithmetic mean of a distribution of an element of the concavo-convex structure D that is at least one factor of the disturbances meet a relationship of the following equation (1).

$$0.025 \leq (\text{standard deviation/arithmetic mean}) \leq 0.5 \quad (1)$$

That is, the concavo-convex structure D of the optical substrate D is characterized in that at least one or more elements selected from the group of elements of the concavo-convex structure D as illustrated above meet the above-mentioned equation (1), and that the average pitch of the concavo-convex structure D is in a predetermined range.

By this means, first, since the average pitch of the concavo-convex structure D is in a predetermined range, it is possible to increase the density of the concavo-convex structure. Accordingly, from the same principles as described in <<Optical substrate PP>>, the internal quantum efficiency IQE is increased. Alternatively, even in the case of providing the concavo-convex structure D in the interface position of the semiconductor light emitting device, since the concavo-convex structure D has a high density, it is possible to increase the contact area of the interface, without impairing physical properties of each layer of the semiconductor light emitting device. By this means, for example, ohmic contact properties are made excellent, and the electron injection efficiency EIE is increased. Herein, by including the disturbances expressed by the above-mentioned equation (1), in spite of the high-density concavo-convex structure, it is possible to exhibit optical scattering properties on the emitted light of the semiconductor light emitting device. Accordingly, it is possible to concurrently improve the internal quantum efficiency IQE or the electron injection efficiency EIE, and the light extraction efficiency LEE.

First, the effect in using the optical substrate D according to this Embodiment will be briefly described. In manufacturing the semiconductor light emitting device, due to the concavo-convex structure D that is the high-density basic structure, developed are the effect of improving the internal quantum efficiency IQE, reducing the occurrence of cracks in the semiconductor crystal layer, and reducing the used amount of the semiconductor crystal layer. Then, in using the semiconductor light emitting device, due to the specific structure, the distribution of effective refractive index Nema recognizable by the emitted light is formed to develop optical scattering properties, and the light extraction efficiency LEE is improved. Here again, in the case of using the high-density concavo-convex structure that does not include the disturbances i.e. the specific structure, the effects in manufacturing the semiconductor light emitting device as described previously are developed, but the degree of development of the effect in using is limited. Conversely, in the case of using the concavo-convex structure with a large change in the volume with large optical scattering properties, the above-mentioned effect in using the semiconductor light emitting device is developed, but the degree of the effects in manufacturing is limited. In other words, in the optical substrate D according to this Embodiment, functions are divided into the function developing in manufacturing the semiconductor light emitting device and the function developing in using the semiconductor light emitting device by the basic structure and the specific structure. By this means, it is possible to concurrently improve the internal quantum efficiency IQE and the light extraction efficiency LEE, which has conventionally been difficult to actualize concurrently.

By using the optical substrate D of the invention in the semiconductor light emitting device, the internal quantum efficiency IQE or the electron injection efficiency EIE, and the light extraction efficiency LEE are concurrently improved.

The reason is as described below.

The internal quantum efficiency IQE is decreased by dislocations occurring due to mismatch (lattice mismatch) of the lattice constant of the optical substrate D and the lattice constant of the semiconductor crystal layer. Herein, in the case of providing a high-density concavo-convex structure having the density equal to or more than the dislocation density on the surface of the optical substrate D, it is possible to disturb the crystal growth mode of the semiconductor crystal layer, and it is possible to disperse dislocations inside the semiconductor crystal layer corresponding to the concavo-convex structure D. That is, it is possible to decrease the dislocation density both microscopically and macroscopically. Therefore, it is possible to increase the internal quantum efficiency IQE.

The electron injection efficiency EIE is decreased by increases in contact resistance due to a Schottky barrier. By the optical substrate D being provided on the uppermost surface of the semiconductor light emitting device having a layered semiconductor layer configured by layering a semiconductor crystal layer comprised of at least two layers or more and a light emitting semiconductor layer, the contact area with a transparent conductive film or electro pad formed on the surface increases corresponding to the specific surface area of the concavo-convex structure D, and it is possible to decrease the contact resistance. Therefore, ohmic contact is increased, and it is possible to enhance the electron injection efficiency EIE.

However, in order to increase the internal quantum efficiency IQE and to increase the electron injection efficiency EIE, a minute concave-convex structure of nano-order is required. As the density and specific surface area of the concavo-convex structure are increased, the size of the concavo-convex structure from the viewpoint of the wavelength of the emitted light is decreased, and therefore, the optical scattering effect is decreased. That is, since the effect of disturbing the waveguide mode is weakened, the degree of increases in light extraction efficiency LEE is decreased.

Herein, the inventors of the present invention found out that by adding a disturbance to the concavo-convex structure that is the base i.e. using the concavo-convex structure D that concurrently includes the basic structure and the specific structure, it is possible to add a new optical phenomenon (light diffraction and light scattering) corresponding to the disturbances of the concavo-convex structure i.e. the specific structure to the function (increases in internal quantum efficiency IQE or increases in electron injection efficiency EIE due to the high-density concavo-convex structure) developed by the original concavo-convex structure i.e. the basic structure. That is, since it is possible to increase the internal quantum efficiency IQE or electron injection efficiency EIE due to the high-density concavo-convex structure (original function), and to apply the new optical phenomenon (light diffraction and light scattering) corresponding to the disturbances of the concavo-convex structure, it is possible to increase the light extraction efficiency LEE with increases in internal quantum efficiency IQE or electron injection efficiency EIE maintained. The principles will be described specifically with actual studies included.

When the wavelength of light is equal to or less than the size of the concavo-convex structure, as an optical phenomenon, light diffraction occurs. On the other hand, when the wavelength of light is sufficiently large, the effective medium approximation action works.

In the former case, light diffraction occurs in a microscopic order such as one by one of the concavo-convex structure, and in the case of only the concavo-convex structure without a substantial disturbance i.e. only the basis structure, the number of modes of light diffraction is limited. That is, the number of diffraction points to disturb the waveguide mode is limited. On the other hand, in the case where the concavo-convex structure has a disturbance i.e. the case of including the specific structure in the basic structure, it is conceivable that the number of modes of light diffraction increases corresponding to the disturbances. That is, in the case of observing in a macroscopic order such as several tens of micrometers or more, since average light of output light is observed due to a plurality of light diffraction modes, the concavo-convex structure including the disturbances exhibits light scattering properties. Since such light scattering properties are high in the effect of disturbing the waveguide mode, it is possible to significantly increase the light extraction efficiency LEE.

For example, from the viewpoint of light with a wavelength of 550 nm, the concavo-convex structure comprised of a plurality of convex portions and concave portions arranged in a hexagonal lattice shape with the average pitch P'ave of 460 nm causes light diffraction corresponding to the average pitch P'ave. Therefore, as a result of performing visual inspection observation, it was possible to observe rainbow-colored glare corresponding to the diffracted light due to the concavo-convex structure that was the base (hereinafter, also referred to as "original optical phenomenon"). Next, a predetermined disturbance was added to the concavo-convex structure. In this case, it was confirmed to further include the disturbances of the concavo-convex structure i.e. scattering component (hereinafter, also referred to as "new optical phenomenon") corresponding to the specific structure, in addition to the original optical phenomenon (light diffraction phenomenon) due to the concavo-convex structure that is the base. Herein, as a result of performing the optical inspection using light with a wavelength (for example, 550 nm) that was almost equal to the average pitch P'ave and that causes light diffraction, it was confirmed that scattering properties (haze and diffusion reflection intensity) in the case of targeting the concavo-convex structure including the specific structure were more strengthened, as compared with the case of targeting the concavo-convex structure that did substantially not include the specific structure. For the reason, from the viewpoint of the light with a wavelength of 550 nm, the convex portion of the concavo-convex structure functions as a diffraction point, but since the basic structure is high in the arrangement regularity of the convex portion or uniformity of the contour shape of the convex portion, the number of diffraction modes is limited by the arrangement. On the other hand, in the case where the concavo-convex structure includes the disturbances, it is considered that the number of diffraction modes increases corresponding to the specific structure, and that diffusion is included. For example, the haze with respect to a sapphire substrate (basic structure) on which a plurality of convex portions with the average pitch P'ave of 300 nm was arranged in an orthohexagonal lattice shape was 0.5 time the haze of a sapphire substrate including a plurality of convex portions with the average pitch P'ave of 300 nm arranged in an orthohexagonal lattice shape and convex portions (specific portion) with a height of 0 nm dispersed at a ratio of 1%.

Further, in the case of adding modulation of ±10% to the average pitch P'ave of 460 nm in a period of 4,600 nm, i.e. in the case of including a specific structure where the pitch P' varied stepwise between 414 nm and 506 nm and the period was 4,600 nm, it was confirmed that the scattering component that is the new optical phenomenon was dependent on the diffraction lattice. That is, in performing visual inspection observation, it was possible to further observe the new optical phenomenon (light diffraction due to the diffraction lattice) due to the diffraction lattice made by the distribution of the pitch P', in addition to the rainbow-colored glare due to the original optical phenomenon (light diffraction due to the diffraction point) corresponding to the average pitch P'ave. Therefore, in the case of observing through a white fluorescent lamp, it was possible to newly observe a light split phenomenon due to the diffraction lattice in the glare corresponding to the average pitch P'ave. Further, it was also possible to observe the split phenomenon of the laser beam as described in the above-mentioned <<Optical substrate PP>>. Particularly, it was confirmed that when modulation of the above-mentioned pitch P' was generated only in a one-dimensional direction, splits of the output laser beam were aligned on some axis, and that when modulation of the above-mentioned pitch P' was generated in two-dimensional directions, splits were aligned on three axes forming a rotation angle of 60 degrees.

Furthermore, in preparing a concavo-convex structure (specific portion) with convex portions of the concavo-convex structure lost at a rate of 1% relative to the hexagonal arrangement-shaped pattern (basic structure) with the average pitch P'ave of 460 nm, it is considered that the convex portions (specific portion) function as scattering points, and scattering properties were observed as the new optical phenomenon. That is, in performing visual inspection observation, it was possible to observe the new optical phenomenon (light scattering) corresponding to the scattering points, in addition to the glare due to the original optical phenomenon (light diffraction) corresponding to the average pitch P'ave. Therefore, the glare due to light diffraction that is the original optical phenomenon was eased by scattering that is the new optical phenomenon, and was accompanied with turbidity.

In the case of the concavo-convex structure substantially without the disturbances i.e. only the basic structure, since equal effective refractive index Nema is formed, optical scattering properties decrease without limit. On the other hand, in the case where the concavo-convex structure has the disturbances i.e. the specific structure is included in the basic structure, it is conceivable that it is possible to add the distribution corresponding to the disturbances of the concavo-convex structure to the effective refractive index Nema. Therefore, since the light behaves as if a medium with the effective refractive index Nema having an outside shape corresponding to the distribution exists, it is possible to newly develop the optical phenomenon (light diffraction or light scattering) corresponding to the distribution, and it is possible to increase the light extraction efficiency LEE. In other words, it is meant that the disturbances of the concavo-convex structure appears as an optical scattering component.

For example, from the viewpoint of light with a wavelength of 550 nm, the basic structure comprised of a plurality of convex portions and concave portions arranged in a hexagonal lattice shape with the average pitch P'ave of 200 nm is averaged. In providing the concavo-convex structure on a transparent substrate and performing visual inspection observation, it was possible to observe the transparent substrate with extremely little reflected light. This is generally called the non-reflective film, or the moth-eye structure. This is because the concavo-convex structure that is sufficiently smaller than the wavelength of light is averaged by the effective medium approximation action from the viewpoint of the light. Herein, in the case where the concavo-convex structure included the disturbances, it was confirmed to further include the scattering component as the new optical phenomenon, in addition to the optical phenomenon (antireflection effect). That is, as a result of performing the optical inspection using light with a wavelength (for example, 550 nm) that was sufficiently larger than the average pitch P'ave, it was confirmed that the scattering component was extremely small. The reason is conceivable that the effective medium approximation action works, and that the inspection is equal to the optical inspection on a thin film with the effective diffractive index Nema. On the other hand, by making the concavo-convex structure including the specific structure a measurement target, it was confirmed that the scattering component increased. The reason is conceivable that the distribution corresponding to the specific structure is added to the effective diffractive index Nema, and that the light used in the optical inspection thereby behaves as if a medium with the effective refractive index Nema having an outside shape corresponding to the distribution of the concavo-convex structure is measured. For example, the haze with respect to convex portions (basic structure) with the average pitch P'ave of 200 nm arranged in an orthohexagonal lattice shape was 0.89 time the haze with respect to convex portions (concavo-convex structure including the specific structure) with the average pitch P'ave of 220 nm including randomly arrangements between a hexagonal lattice and a tetragonal lattice.

Further, the regular reflection intensity relative to measurement light with a wavelength of 750 nm in the case of convex portions (basic structure) arranged in an orthohexagonal lattice shape with the average pitch P'ave of 200 nm was 0.31 time that in the case of convex portions (concavo-convex structure including the specific structure) with the average pitch P'ave of 200 nm including randomly the hexagonal lattice and tetragonal lattice.

Furthermore, in the case of adding modulation of ±10% to the average pitch P'ave of 200 nm in a period of 1,600 nm, i.e. in the case of the concavo-convex structure including a specific structure where the pitch P' varied stepwise between 180 nm and 220 nm and the period was 1,600 nm, it was confirmed that the scattering component that is the new optical phenomenon was dependent on the diffraction lattice. That is, in performing visual inspection observation, it was possible to further observe the new optical phenomenon (light diffraction due to the diffraction lattice) due to the diffraction lattice considered being made by the effective refractive index Nema in the transparent substrate due to the original optical phenomenon (antireflection) corresponding to the average pitch P'ave. Therefore, it was possible to observe the split phenomenon of light due to the diffraction lattice made by the effective refractive index Nema in the transparent body corresponding to the average pitch P'ave. Further, it was possible to observe the split phenomenon of the laser beam as described in the above-mentioned <<Optical substrate PP>>. Particularly, it was confirmed that when modulation of the above-mentioned pitch P' was generated only in a one-dimensional direction, splits of the output laser beam were aligned on some axis, and that when modulation of the above-mentioned pitch P' was generated in two-dimensional directions, splits were arranged on three axes forming a rotation angle of 60 degrees.

Still furthermore, in preparing a concavo-convex structure including a specific structure with the convex-portion diameter having an irregular distribution in a range of 100 nm to 125 nm with respect to the concavo-convex structure with the average pitch P'ave that was the base, scattering components due to the new optical phenomenon were observed as scattering points. That is, in performing visual inspection observation, it was possible to observe the new optical phenomenon (scattering) corresponding to scattering points presumed to being made by the effective refractive index Nema in the transparent substrate due to the original optical phenomenon (antireflection) corresponding to the average pitch P'ave. Therefore, it was possible to observe the turbidity due to scattering that is the new optical phenomenon in the transparent body due to antireflection that is the original optical phenomenon.

As described above, by adding a disturbance to the shape or arrangement of the concavo-convex structure i.e. including the specific structure in the concavo-convex structure, it was found out that it is possible to add the optical phenomenon corresponding to the distribution of the concavo-convex structure. That is, even in the high-density concavo-convex structure that is not able to sufficiently disturb the waveguide mode originally, by including a disturbance, it is possible to develop the new optical phenomenon (light diffraction and light scattering) corresponding to the disturbances, and it is thereby possible to increase the light extraction efficiency LEE with the internal quantum efficiency IQE or the light extraction efficiency LEE maintained. In other words, even in the high-density concavo-convex structure that is not able to sufficiently disturb the waveguide mode originally, since strong optical scattering properties are developed by the disturbances, the internal quantum efficiency IQE or the electron light efficiency EIE is improved due to the high-density concavo-convex structure, and concurrently, it is possible to improve the light extraction efficiency LEE due to newly added strong optical scattering properties.

As described above, in the semiconductor light emitting device, in order to increase the internal quantum efficiency IQE or the electron light efficiency EIE due to the high-density concavo-convex structure, and to concurrently increase the light extraction efficiency LEE, it is the essence to newly add optical scattering components to the basic structure of the concavo-convex structure high in regularity or uniformity. That is, by performing an optical inspection on an optical substrate provided with a concavo-convex structure, and detecting the scattering component such as the haze and scattering reflection intensity, it is possible to determine the disturbances of the concavo-convex structure suitable for increases in light extraction efficiency LEE of the semiconductor light emitting device. Herein, in the case of fixing the average pitch P'ave of the concavo-convex structure to apply to the semiconductor light emitting device, it is possible to judge the effect of the disturbances of the concavo-convex structure by optical transmission measurement or optical reflection measurement. Particularly, in optical transmission measurement, it is possible to suitably use a scattering component of the transmitted light or Haze, and in optical reflection measurement, it is possible to suitably use a regular reflection component, diffuse reflection component, and a difference value and ratio thereof. In addition, in the case of extracting only the effect due to the disturbances of the concavo-convex structure, it is necessary to subject the concavo-convex structure to effective medium approximation to perform the optical inspection. That is, it is necessary to determine an optical measurement wavelength λ as a value larger than the average pitch of the concavo-convex structure. In this way, by performing the optical inspection in a state subjected to the effective medium approximation, it is possible to quantify the scattering component caused by the disturbances of the concavo-convex structure.

The inventors of the present invention carried out studies from the viewpoints as described above, and as a result of measuring the degree of increases in light extraction efficiency LEE with increases in internal quantum efficiency IQE or electron light efficiency EIE maintained and performing simulations by the FDTD method, found out that the type of disturbance of the concavo-convex structure is not limited particularly, and that the size of the optical scattering component corresponding to the disturbances of the concavo-convex structure is important. That is, it is possible to determine the concavo-convex structure D of the optical substrate D according to this Embodiment by the optical scattering component with respect to the concavo-convex structure, particularly, the scattering component in performing the optical inspection using an optical measurement wavelength λ for enabling the concavo-convex structure to be subjected to effective medium approximation. That is, it was found out that the element of the concavo-convex structure to develop the disturbances is not important, and that the intensity of the scattering component indicative of the degree of the disturbances is important. Further, it was discovered that the intensity of this scattering component shows positive correlation in a coefficient of variation with respect to the element of the concavo-convex structure. Furthermore, it was found out that by using the disturbances with respect to a predetermined element of the concavo-convex structure, more remarkable effects are exerted on concurrently increasing the internal quantum efficiency IQE or the electron light efficiency EIE and the light extraction efficiency LEE.

A substrate body of the optical substrate D will be described first. As the substrate body of the optical substrate D according to this Embodiment, it is possible to use the main body of the optical substrate as described in <<Optical substrate PP>>. Therefore, it is possible to modify the configuration of the substrate body as appropriate so as to provide the concavo-convex structure D on the surface or interface of the semiconductor light emitting device.

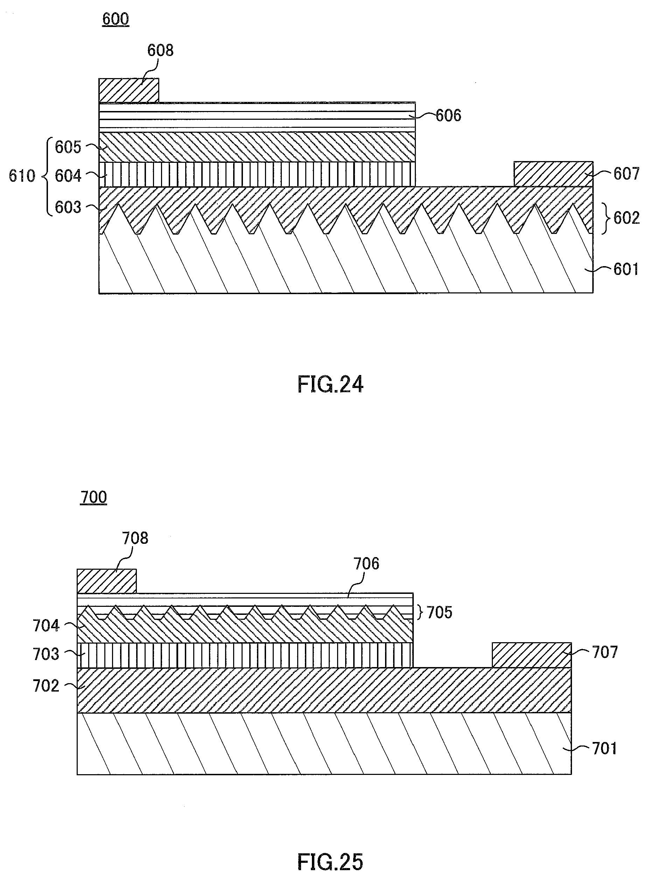

As the configuration of the semiconductor light emitting device using the optical substrate D according to this Embodiment, it is possible to adopt the device as described in <<Optical substrate PP>>. The semiconductor light emitting device as described in << Optical substrate PP>> will be described more specifically. FIG. 24 is a cross-sectional schematic diagram of the semiconductor light emitting device to which is applied the optical substrate D according to this Embodiment. As shown in FIG. 24, in a semiconductor light emitting device 600, an n-type semiconductor layer 603, light emitting semiconductor layer 604 and p-type semiconductor layer 605 are sequentially layered on a concavo-convex structure 602 provided on one main surface of an optical substrate D601. Further, a transparent conductive film 606 is formed on the p-type semiconductor layer 605. Furthermore, a cathode electrode 607 is formed on the n-type semiconductor layer 603 surface, and an anode electrode 608 is formed on the transparent conductive film 606 surface. In addition, the n-type semiconductor layer 603, light emitting semiconductor layer 604 and p-type semiconductor layer 605 sequentially layered on the optical substrate D601 are referred to as a layered semiconductor layer 610.

In FIG. 24, the diagram is drawn while assuming that the optical substrate D601 is sapphire, silicon carbide (SiC), silicon (Si), gallium nitride (GaN) or the like, for example, and as described in <<Optical substrate PP>>, for example, it is possible to provide the concavo-convex structure D also on the surface of the transparent conductive film 606, interface between the transparent conductive film 606 and the p-type semiconductor layer 605, and the like. The effects are as described in <<Optical substrate PP>> with reference to FIG. 6.

In addition, in FIG. 24, the semiconductor layers 603, 604, 605 are sequentially layered on the concavo-convex structure layer 602 provided on one main surface of the optical substrate D601, and the semiconductor layers may be sequentially layered on the other main surface opposite to the surface on which the concavo-convex structure layer 602 is provided of the optical substrate D601.

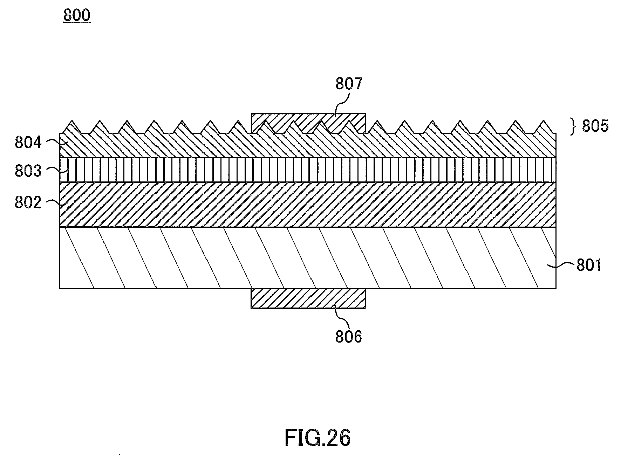

FIGs. 25 and 26 are cross-sectional schematic diagrams of other examples of the semiconductor light emitting device to which is applied the optical substrate D according to this Embodiment. As shown in FIG. 25, in a semiconductor light emitting device 700, an n-type semiconductor layer 702, light emitting semiconductor layer 703 and p-type semiconductor layer 704 are sequentially layered on a substrate 701. Further, the p-type semiconductor layer 704 has a concavo-convex structure layer 705 on one main surface in contact with the p-type semiconductor layer 704. Furthermore, a cathode electrode 707 is formed on the n-type semiconductor layer 702 surface, and an anode electrode 708 is formed on the transparent conductive film 706 surface. In addition, in the semiconductor light emitting device 700, the transparent conductive film 706 or a layered product comprised of substrate 701/n-type semiconductor layer 702/light emitting semiconductor layer 703/p-type semiconductor layer 704 is capable being set as the optical substrate D according to this Embodiment.

In FIG. 25, the main surface with the concavo-convex structure 705 provided of the transparent conductive film 706 is adjacent to the p-type semiconductor layer 704, and the layer may be provided on the surface opposite to the p-type semiconductor layer 704.

As shown in FIG. 26, in a semiconductor light emitting device 800, on a substrate 801 are sequentially layered an n-type semiconductor layer 802, light emitting semiconductor layer 803 and p-type semiconductor layer 804 provided with a concavo-convex layer 805 on the main surface opposite to the light emitting semiconductor layer 803. A cathode electrode 806 is formed on the main surface on the side opposite to the main surface in contact with the n-type semiconductor layer 802 of the substrate 801, and an anode electrode 807 is formed on the p-type semiconductor layer 804 surface. In addition, in the semiconductor light emitting device 800, for example, the p-type semiconductor layer 804 or a layered product comprised of substrate 801/n-type semiconductor layer 802/light emitting semiconductor layer 803/p-type semiconductor layer 804 is capable being set as the optical substrate D according to this Embodiment.

The semiconductor light emitting devices 600, 700 and 800 as shown in FIGs. 24 to 26 are of the example of applying the optical substrate D according to this Embodiment to the semiconductor light emitting device of double-hetero structure, but the layered structure of the layered semiconductor layer is not limited thereto. Further, a buffer layer, not shown, may be provided between the substrate 601, 701 or 801 and the n-type semiconductor layer 603, 702 or 802, respectively.

The configuration of the optical substrate D according to this Embodiment is as described in <<Optical substrate PP>> with reference to FIG. 7. That is, as shown in FIG. 7A, it is essential only that the concavo-convex structure 20 (D) is provided on at least one of the optical substrate 10 (D), the average pitch of the concavo-convex structure 20(D) is in the range as described above, and that the concavo-convex structure 20(D) includes the disturbances as described above.

Described next is the disturbances of the concavo-convex structure D of the optical substrate D according to this Embodiment.

The distribution of the element that is a factor of the disturbances of the concavo-convex structure D has (standard deviation/arithmetic mean) as shown in the above-mentioned equation (1) as described already. In the equation (1), (standard deviation/arithmetic mean) i.e. coefficient of variation of the concavo-convex structure D is a value with respect to the element constituting the concavo-convex structure D. For example, when the concavo-convex structure D is comprised three elements A, B, C, such a value is defined as a ratio of the standard deviation to the arithmetic means with respect to the same element, such as a coefficient of variation obtained by dividing the standard deviation with respect to the element A by the arithmetic mean with respect to the element A. Each element will be described below. In the following description, the value obtained by dividing the standard deviation by the arithmetic mean is also called the coefficient of variation.

(Arithmetic mean)

The arithmetic mean value is defined by the following equation in the case of assuming that N measurement values of the distribution of some element (variable) are x1, x2···, xn.

[Math 1]

$$\overline{x} = \frac{\sum_{i=1}^{N} x_i}{N}$$

(Standard deviation)

In the case of assuming that N measurement values of the distribution of some element (variable) are x1, x2···, xn, the standard deviation is defined by the following equation, using the arithmetic mean value defined as described above.

[Math 2]

$$\sigma = \sqrt{\frac{1}{N} \sum_{i=1}^{N} (x_i - \overline{x})^2}$$

The number N of samples in calculating the arithmetic mean is 10 or more to define. Further, the number of samples in calculating the standard deviation is determined to be the same as the number N of samples in arithmetic mean calculation.

Further, the coefficient of variation is defined as a value with respect to a local portion of the optical substrate D, instead of a value inside the surface of the optical substrate D. In other words, instead of measuring N points over the inside of the surface of the optical substrate D to calculate the coefficient of deviation, local observation of the optical substrate D is performed, and the coefficient of variation in the observation range is calculated. Herein, the local range to use in observation is defined as a range about 5 times to 50 times the average pitch P'ave of the concavo-convex structure D. For example, when the average pitch P'ave is 300 nm, observation is performed in the observation range of 1,500 nm to 15,000 nm. Therefore, for example, a field image of 2,500 nm is taken, the standard deviation and arithmetic mean are obtained using the picked image, and the coefficient of variation is calculated.

As described above, by adding the disturbances to the concavo-convex structure, it is possible to induce the new optical phenomenon, and it is possible to increase the light extraction efficiency LEE with increases in internal quantum efficiency IQE or electron injection efficiency EIE maintained. The above-mentioned equation (1) represents normalized variations with respect to some element of the concavo-convex structure D. That is, the disturbances is represented such that the scattering component obtained by the optical inspection as described above is a suitable value. Therefore, by meeting the range of the above-mentioned equation (1), it is possible to disturb the waveguide mode by the new optical phenomenon (light diffraction or light scattering) corresponding to the disturbances, and it is possible to increase the light extraction efficiency LEE.

As the coefficient of variation, an optimal value exists for each of elements constituting the concavo-convex structure D, and by meeting the equation (1) irrespective of the elements that are at least one factor of the disturbances of the concavo-convex structure D, it is possible to increase the light extraction efficiency LEE. Herein, the lower limit value was determined by the degree of increases in light extraction efficiency LEE, and the upper limit value was determined by the degree of maintenance of increases in internal quantum efficiency IQE or electron injection efficiency EIE. From the viewpoint of more decreasing the effects on manufacturing conditions of the semiconductor light emitting device and the type of optical substrate D, and increasing both increases in internal quantum efficiency IQE or electron injection efficiency EIE and the light extraction efficiency LEE, the lower limit value is more preferably 0.03 or more. On the other hand, the upper limit value is preferably 0.35 or less, more preferably 0.25 or less, and most preferably 0.15 or less.

In addition, by one or more elements selected from the group of the pitch P', convex-portion bottom portion circumscribed circle diameter Φout, convex-portion bottom portion circumscribed circle diameter Φout/convex-portion bottom portion inscribed circle diameter Φin, and height H as described below meeting the above-mentioned equation (1), it is possible to increase the degree of development of the new optical phenomenon (light diffraction or light scattering) based on the disturbances of the concavo-convex structure D, and therefore, such an element is preferable. That is, it is possible to increase the light extraction efficiency LEE with increases in internal quantum efficiency IQE or electron injection efficiency EIE maintained. This is because the volume change of the concavo-convex structure D is important so as to strengthen optical scattering properties due to the disturbances of the concavo-convex structure D. By the element as described above having the disturbances, it is possible to increase the change in the volume of the concavo-convex structure D, and to increase the number of light diffraction modes or increase the contrast in a portion corresponding to the disturbances of effective refractive index Nema. That is, the optical scattering properties are increased, and it is made possible to increase the light extraction efficiency LEE. Particularly, for the pitch P' and height H, it is also possible to add a regular disturbance. In this case, by the disturbances with regularity, it is possible to use light diffraction as the new optical phenomenon.

As the disturbances with respect to the concavo-convex structure D, particularly, it is preferable to include the disturbances of the pitch P', height H or convex-portion bottom portion circumscribed circle diameter Φout. This is because the disturbances of these elements has a large value in converting to the volume, and makes a large contribution to the optical scattering properties. Further, by including at least a change in the pitch P', the effect of suppressing cracks occurring in growth of the semiconductor crystal layer is increased, while the optical scattering properties are strengthened, and therefore, such a change is preferable. Furthermore, by including at least changes in the pitch P' and the height H or convex-portion bottom portion circumscribed circle diameter Φout, the dislocation density reducing effect and crack suppressing effect on the semiconductor crystal layer and increases in light extraction efficiency are more increased, and therefore, such changes are preferable. In addition, the most preferable case is the case of including changes in the pitch P', height H and convex-portion bottom portion circumscribed circle diameter Φout. This case concurrently improves the effects of dispersion of dislocation and reduction of dislocation density, the crack suppressing effect, and the effect of strong optical scattering properties.

In addition, in this case, when correlation coefficients between the pitch P' and the height H and between the pitch P' and the convex-portion bottom portion circumscribed circle diameter Φout are negative, the crack suppressing effect is enhanced. On the other hand, when correlation coefficients between the pitch P' and the height H and between the pitch P' and the convex-portion bottom portion circumscribed circle diameter Φout are positive, the degree of increases in light extraction efficiency LEE is more increased. By this means, it is possible to more increase the light extraction efficiency LEE with improvements in internal quantum efficiency IQE maintained.

From the viewpoint of increasing the light extraction efficiency LEE, it is preferable that the relationship at least between the pitch P' and the height H or between the pitch P' and the convex-portion bottom portion circumscribed circle diameter Φout is positive correlation. This is because by meeting such a relationship, the degree of the volume change of the element of the concavo-convex structure D is increased, in association therewith the difference in the refractive index is increased in the distribution of effective refractive index Nema, and intensity of optical scattering properties is strengthened. Particularly, it is the most preferable that the height H and convex-portion bottom portion circumscribed circle diameter Φout increase, as the pitch P' increases.

In addition, for which numeric value in the range meeting the above-mentioned equation (1) is adopted, it is possible to select various values corresponding to the surface state of the optical substrate D and the purpose, and to select an optimal structure. For example, in selection of concurrently increasing the internal quantum efficiency IQE and light extraction efficiency LEE, in the case where it is possible to apply the optical substrate D, CVD apparatus or CVD conditions such that dislocation defects are relatively hard to occur, in order to increase the light scattering effect, a large coefficient of variation may be adopted in the range meeting the above-mentioned equation (1). Further, in the case of the optical substrate D, CVD apparatus or CVD apparatus conditions such that many dislocation defects relatively occur, in order to decrease dislocation defects and more increase the internal quantum efficiency IQE, a small coefficient of variation may be adopted in the range meeting the above-mentioned equation (1).

Further, in selection of concurrently increasing the electron injection efficiency EIE and light extraction efficiency LEE, it is possible to select various values corresponding to generation conditions and types of the transparent conductive film or the electrode pad and the uppermost semiconductor layer, and to select an optimal structure. For example, in the case of a combination of the p-type semiconductor layer and the transparent conductive layer with relatively good ohmic properties, in order to enhance the light scattering effect and increase the light extraction efficiency LEE, a large coefficient of variation may be adopted in the range meeting the above-mentioned equation (1). Conversely, in the case where ohmic properties are not good, in order to actualize increases in electron injection efficiency EIE due to decreases in contact resistance by increasing the contact area, a small coefficient of variation may be adopted in the range meeting the above-mentioned equation (1).

Described next is the concavo-convex structure D of the optical substrate D according to this Embodiment. The concavo-convex structure D is not limited in the shape and arrangement, as long as the structure has convex portions or concave portions, and it is possible to adopt the shape and arrangement as described in «Optical substrate PP». This is because by meeting the above-mentioned equation (1), it is possible to increase the light extraction efficiency LEE with increases in internal quantum efficiency IQE or electron injection efficiency EIE maintained.

In addition, convex portions in the dot structure may be smoothly connected by the continuous concave portion. On the other hand, concave portions in the hole structure may be smoothly connected by the continuous convex portion. In the structures, from the viewpoint of more increasing the internal quantum efficiency IQE or the electron injection efficiency EIE, the dot structure is preferable. This is because it is necessary to promote dislocation dispersion by the density of the concavo-convex structure D, in order to increase the internal quantum efficiency IQE. On the other hand, in order to increase the electron injection efficiency EIE, this is because it is necessary to increase the specific surface area of the concavo-convex structure D, while increasing the contact area using the increased specific surface area, and to reduce the contact resistance. Particularly, in order to increase the internal quantum efficiency IQE, to promote dispersion of dislocations, among the dot structures, such a structure is the most preferable that the convex-portion vertex portion does not have a flat surface. Further, it is preferable that the concave-portion bottom portion of the concavo-convex structure D has a flat surface. This is because it is possible to promote nucleation and nucleus growth of the semiconductor crystal layer to increase the internal quantum efficiency IQE.

Terms used in the description of the concavo-convex structure D will be defined next.

<Average pitch P'ave>

The definition of the average pitch P'ave is as described in «Concavo-convex structure PP» with reference to FIG. 18. In addition, when the concavo-convex structure 20(D) is the line-and-space structure, the pitch P' is defined as an interval between center lines of mutually adjacent convex-portion bodies.

When the average pitch P'ave ranges from 50 nm to 1,500 nm, it is possible to increase both the internal quantum efficiency IQE or the electron injection efficiency and the light extraction efficiency LEE. Particularly, by the average pitch P'ave being 50 nm or more, it is possible to strengthen the development intensity of the new optical phenomenon (light diffraction or light scattering) based on the disturbances of the concavo-convex structure D as described above, and the effect of disturbing the waveguide mode is enhanced. Therefore, it is possible to increase the light extraction efficiency LEE. From the viewpoint of more exerting the above-mentioned effect, the average pitch P'ave is preferably 150 nm or more, more preferably 200 nm or more, and most preferably 250 nm or more. On the other hand, by the average pitch P'ave being 1,500 nm or less, the density and specific surface area of the concavo-convex structure D are increased. In association therewith, it is possible to disperse dislocations inside the semiconductor crystal layer, it is thereby possible to reduce local and macroscopic dislocation densities, and therefore, it is possible to increase the internal quantum efficiency IQE. From the viewpoint of more exerting the above-mentioned effect, the average pitch P'ave is preferably 1,000 nm or less, and more preferably 900 nm or less. Particularly, in the case where the average pitch P'ave is 900 nm or less, since the density of the concavo-convex structure is moderately increased relative to the dislocation density, the effects of dislocation reduction dispersion are enhanced. In the range, the pitch P'ave is more preferable 550 nm or less, and most preferably 400 nm or less. Further, since the contact area is increased by the large specific surface area, it is possible to reduce the contact resistance and increase the electron injection efficiency EIE.

From the viewpoint of more exerting the above-mentioned effects, the average pitch P'ave is preferably 1,000 nm or less, more preferably 800 nm or less, and most preferably 550 nm or less.

Further, from the viewpoint of applying the disturbances of the pitch as the disturbances of the concavo-convex structure D to increases in light extraction efficiency LEE with increases in internal quantum efficiency IQE or electron injection efficiency EIE maintained by the above-mentioned mechanism, in the above-mentioned widest range (of 0.025 to 0.5), the coefficient of variation on the pitch P' that is the element of the concavo-convex structure D which is the factor of the disturbances preferably ranges from 0.03 to 0.4. Particularly, by being 0.03 or more, a contribution to the light extraction efficiency LEE is excellent, and by being 0.4 or less, a contribution to maintenance of increases in internal quantum efficiency IQE or electron injection efficiency EIE is excellent. From the same viewpoints, the coefficient is preferably 0.035 or more, and more preferably 0.04 or more. Further, the ratio is preferably 0.35 or less, more preferably 0.25 or less, and most preferably 0.15 or less.

In the case where the pitch P' meets the above-mentioned range, it is possible to increase the development intensity of the new optical phenomenon (light diffraction or light scattering) based on the disturbances of the concavo-convex structure D, and therefore, such a case is preferable. That is, it is possible to increase the light extraction efficiency LEE with increases in internal quantum efficiency IQE or electron injection efficiency EIE maintained. This is because the volume change of the concavo-convex structure D is important so as to strengthen optical scattering properties due to the disturbances of the concavo-convex structure D. By the element as described above having the disturbances, it is possible to increase the change in the volume of the concavo-convex structure D, and to increase the number of light diffraction modes or increase the contrast in a portion corresponding to the disturbances of effective refractive index Nema. That is, the optical scattering properties are increased, and it is made possible to increase the light extraction efficiency LEE. Particularly, by the pitch P', height H or convex-portion bottom portion circumscribed circle diameter Φout meeting the range of the above-mentioned equation (1), the effect of the volume change as described above is enhanced, and the optical scattering properties are strengthened. That is, since the new optical phenomenon (light diffraction or light scattering) intensity based on the disturbances of the concavo-convex structure D is increased, the light extraction efficiency LEE is increased. Further, in the case where the pitch P', height H and convex-portion bottom portion circumscribed circle diameter Φout meet the range of the above-mentioned equation (1), the above-mentioned effects are further enhanced, and therefore, such a case is preferable.

In addition, the disturbances of the pitch P' of the concavo-convex structure D may have high regularity or may be low in regularity. For example, in the case of the concavo-convex structure D including the specific structure that irregularly contains an orthohexagonal arrangement, hexagonal arrangement, quasi-hexagonal arrangement, quasi-tetragonal arrangement, tetragonal arrangement, and orthotetragonal arrangement, regularity of the disturbances of the pitch P' of the concavo-convex structure D is decreased, and it is possible to develop light scattering as the new optical phenomenon. On the other hand, in the orthohexagonal arrangement, in the case of the concavo-convex structure D including the specific structure such that the increase and decrease of the pitch P' occur periodically, the disturbances of the pitch P' has high regularity, and it is possible to develop light diffraction as the new optical phenomenon. Further, for example, in the case where quasi-orthohexagonal arrangement (for example, tetragonal arrangement) portions that are the specific structure are locally arranged in the orthohexagonal arrangement that is the basic structure and the specific structures are scattered irregularly, regularity of the disturbances of the pitch P' of the concavo-convex structure D is decreased, and it is possible to develop light scattering as the new optical phenomenon. On the other hand, in the case where quasi-orthohexagonal arrangement (for example, tetragonal arrangement) portions that are the specific structure are locally arranged in the orthohexagonal arrangement that is the basic structure and the specific structures are provided regularly, the disturbances of the pitch P' has high regularity, and it is possible to develop light diffraction as the new optical phenomenon.

<Convex-portion vertex portion width lcvt, concave-portion opening width lcct, convex-portion bottom portion width lcvb, concave-portion bottom portion width lccb>

The definitions of the convex-portion vertex portion width lcvt, concave-portion opening width lcct, convex-portion bottom portion width lcvb and concave-portion bottom portion width lccb are as described in <<Optical substrate PP>> with reference to FIGs. 19 to 22.

It is preferable that the ratio (lcvt/lcct) meets the same range as the suitable range described in <<Optical substrate PP>>. By this means, this is because it is possible to develop the optical scattering properties that are the effect of the disturbances due to the above-mentioned equation (1), and to actualize increases in internal quantum efficiency IQE due to decreases in microscopic and macroscopic dislocation densities.

Further, it is preferable that the bottom portion of the concave portion 20b of the concavo-convex structure 20(D) has a flat surface, from the same effect as described in <<Optical substrate PP>>. Further, from the same principles as described in <<Optical substrate PP>>, it is preferable that the ratio (lcvb/lccb) meets the suitable range as described in <<Optical substrate PP>>. By meeting such a range, it is possible to more promote growth of the semiconductor crystal layer with the concave-portion bottom portion of the concavo-convex structure D as a reference surface, improve the internal quantum efficiency IQE excellently, and to decrease a difference between semiconductor crystal deposition apparatuses.

On the other hand, in order to concurrently meet increases in electron injection efficiency EIE and light extraction efficiency LEE, it is the most preferable that the flat surface of the concave-portion bottom portion of the concavo-convex structure 20(D) does substantially not exist. That is, as the ratio (lcvb/lccb), it is preferable that the ratio increases, and it is the most preferable that the ratio is infinitely asymptotic. In order to increase the electron injection efficiency EIE in the semiconductor light emitting device, it is necessary to effectively increase the specific surface area of the thin p-type semiconductor layer and to decrease the contact resistance. Further, for example, in the case of providing the concavo-convex structure D on the surface of the transparent conductive film, increase in the volume of the concavo-convex structure leads to increase in the optical scattering properties. On the other hand, in order to increase the light extraction efficiency LEE, it is necessary to develop optical scattering properties due to the disturbances of the concavo-convex structure D as described above and to effectively disturb the waveguide mode. From the above-mentioned viewpoints, the ratio (lcvb/lccb) of the convex-portion bottom portion width lcvb to the concave-portion bottom portion width lccb of the concavo-convex structure 20 (D) is preferably 0.33 or more. Particularly, from the viewpoint of increasing the specific surface area and increasing optical scattering properties, (lcvb/lccb) is more preferably 0.6 or more, and most preferably 3 or more.

Further, in the shape that the convex-portion vertex portion width lcvt is smaller than the convex-portion bottom portion width lcvb, it is made easy to concurrently meet the ratio (lcvt/lcct) and ratio (lcvb/lccb) as described above, and therefore, from the already described mechanism, it is possible to concurrently increase the internal quantum efficiency IQE or the electron injection efficiency EIE and the light extraction efficiency LEE.

Furthermore, when the concavo-convex structure 20(D) is the dot structure, it is easy to control the convex-portion vertex portion width lcvt and convex-portion bottom portion width lcvb, it is easy to concurrently meet the ratio (lcvt/lcct) and ratio (lcvb/lccb), and therefore, from the already described mechanism, it is possible to concurrently increase the internal quantum efficiency IQE or the electron injection efficiency EIE and the light extraction efficiency LEE.

<Duty>

The definition of the duty is as described in «Optical substrate PP». Further, a preferable range in the case of the viewpoint of concurrently increasing the internal quantum efficiency IQE and the light extraction efficiency LEE is as described in «Optical substrate PP» from the same reason.

On the other hand, from the viewpoint of increasing the electron injection efficiency EIE, the duty preferably ranges from 0.25 to 1. By being 0.25 or more, it is possible to effectively increase the specific surface area and to improve the electron injection efficiency EIE, while the volume of the convex portion is increased, the effect of disturbing the waveguide mode is thereby enhanced, and it is possible to increase the light extraction efficiency LEE. From the same effect, the ratio (lcvb/P) is preferably 0.38 or more, more preferably 0.5 or more, and most preferably 0.75 or more.

In addition, in the case where the convex-portion bottom portion circumscribed circle diameter $\Phi$out and convex-portion bottom portion circumscribed circle diameter $\Phi$out/convex-portion bottom portion inscribed circle diameter $\Phi$in as described below meet the above-mentioned equation (1), it is possible to effectively develop optical scattering properties, and therefore, such a case is preferable. The convex-portion bottom portion circumscribed circle diameter $\Phi$out having the disturbances means that the duty has the disturbances.

<Aspect ratio>

When the concavo-convex structure D is the dot structure, using the above-mentioned lcvb, the aspect ratio is defined as height H/lcvb of the concavo-convex structure D. On the other hand, when the concavo-convex structure D is the hole structure, using the above-mentioned lcct, the aspect ratio is defined as depth/lcct of the concavo-convex structure D.

By the aspect ratio being 0.1 or more, it is possible to increase the light extraction efficiency LEE due to scattering properties by the disturbances of the concavo-convex structure D. Particularly, the ratio is preferably 0.3 or more, more preferably 0.5 or more, and most preferably 0.8 or more. On the other hand, by the aspect ratio being 5 or less, as well as decreasing the dislocation density, it is possible to shorten the time to prepare the concavo-convex structure D, and to reduce the semiconductor crystal amount, and therefore, such a ratio is preferable. Further, by the aspect ratio of being 5 or less, it is possible to suppress the contact failure, and it is possible to excellently develop the effect of increasing the electron injection efficiency EIE due to the decrease in the contact resistance. From the same effect, the ratio is more preferably 2 or less, and most preferably 1.5 or less.

In addition, in the case where the height H as described below has the disturbances meeting the above-mentioned equation (1), the optical scattering properties are effectively enhanced, and therefore, such a case is preferable. In this case, the aspect ratio has the disturbances at the same time. In addition, the disturbances of the height H of the concavo-convex structure D may have high regularity, or may be low in regularity. That is, the disturbances of the aspect ratio may have high regularity, or may be low in regularity. For example, when there is the concavo-convex structure D with center height H0, minimum height H1 and maximum height H2, in the case of the concavo-convex structure D including the specific structure in which the height H has the disturbances with low regularity in the above-mentioned range, regularity of the disturbances of the height H of the concavo-convex structure D is decreased, and it is possible to develop light scattering as the new optical phenomenon. On the other hand, in the case of the concavo-convex structure D including the specific structure in which the increase and decrease of the height H occur periodically, the disturbances of the height H has high regularity, and it is possible to develop light diffraction as the new optical phenomenon. Further, for example, in the case where the specific portions of the height H2 are locally arranged in the basic structure of an aggregation of the height H1, and the specific portions are scattered irregularly, regularity of the disturbances of the height H of the concavo-convex structure D is decreased, and it is possible to develop light scattering as the new optical phenomenon. On the other hand, the specific portions of the height H2 are locally arranged in the basic structure of an aggregation of the height H1, and the specific portions are arranged regularly, the disturbances of the height H has high regularity, and it is possible to develop light diffraction as the new optical phenomenon.

<Convex-portion bottom portion circumscribed circle diameter Φout, convex-portion bottom portion inscribed circle diameter Φin>

The definitions of the convex-portion bottom portion circumscribed circle diameter Φout and convex-portion bottom portion inscribed circle diameter Φin are as described in «Optical substrate PP» with reference to FIG. 23. Further, their preferable ranges preferably meet the range as described in «Optical substrate PP» from the same reason.

Further, from the viewpoint of applying the disturbances of the convex-portion bottom portion circumscribed circle diameter Φout to increases in light extraction efficiency LEE with increases in internal quantum efficiency IQE or electron injection efficiency EIE maintained by the above-mentioned mechanism, in the above-mentioned widest range (0.025~0.5), the (standard deviation/arithmetic mean) with respect to the convex-portion bottom portion circumscribed circle diameter Φout of the concavo-convex structure D that is the factor of the disturbances preferably ranges from 0.03 to 0.4. Particularly, by being 0.03 or more, a contribution to the light extraction efficiency LEE is excellent, and by being 0.4 or less, a contribution to maintenance of increases in internal quantum efficiency IQE or electron injection efficiency EIE is excellent. From the same viewpoints, the value is preferably 0.04 or more, more preferably 0.05 or more, and most preferably 0.06 or more. Further, the value is preferably 0.35 or less, more preferably 0.25 or less, and most preferably 0.15 or less.

Furthermore, from the viewpoint of applying the disturbances of the ratio (Φout/Φin) to increases in light extraction efficiency LEE with increases in internal quantum efficiency IQE or electron injection efficiency EIE maintained by the above-mentioned mechanism, in the above-mentioned widest range (0.025~0.5), the coefficient of variation with respect to the ratio (Φout/Φin) of the concavo-convex structure D that is the factor of the disturbances preferably ranges from 0.03 to 0.35. Particularly, by being 0.03 or more, a contribution to the light extraction efficiency LEE is excellent, and by being 0.35 or less, a contribution to maintenance of increases in internal quantum efficiency IQE or electron injection efficiency EIE is excellent. From the same viewpoints, the ratio is preferably 0.04 or more, more preferably 0.05 or more, and most preferably 0.06 or more. Further, the value is preferably 0.25 or less, more preferably 0.15 or less, and most preferably 0.10 or less.

In the case where the above-mentioned convex-portion bottom portion circumscribed circle diameter Φout, and convex-portion bottom portion circumscribed circle diameter Φout/convex-portion bottom portion inscribed circle diameter Φin meet the above-mentioned ranges, it is possible to increase the intensity of development of the new optical phenomenon (light diffraction or light scattering) based on the distribution of the concavo-convex structure D, and therefore, such a case is preferable. That is, it is possible to increase the light extraction efficiency LEE with increases in internal quantum efficiency IQE or electron injection efficiency EIE maintained. This is because the volume change of the concavo-convex structure D is important so as to strengthen optical scattering properties due to the disturbances of the concavo-convex structure D. By the element as described above having the disturbances, it is possible to increase the change in the volume of the concavo-convex structure D, and to increase the number of light diffraction modes or increase the contrast in a portion corresponding to the disturbances of effective refractive index Nema. That is, the optical scattering properties are increased, and it is made possible to increase the light extraction efficiency LEE.

Further, by the convex-portion bottom portion circumscribed circle diameter Φout and the height H as described below meeting the range of the above-mentioned equation (1), the volume change of the concavo-convex structure D as described is increased, the degree of increases in light extraction efficiency LEE is more increased, and therefore, such elements are preferable. From the same effect, it is preferable that the convex-portion bottom portion circumscribed circle diameter Φout, height H and pitch P' meet the above-mentioned equation (1), and it is more preferable that the convex-portion bottom portion circumscribed circle diameter Φout, height H, pitch P' and convex-portion bottom portion circumscribed circle diameter Φout/convex-portion bottom portion inscribed circle diameter Φin meet the above-mentioned equation (1). In addition, correlation between the convex-portion bottom portion circumscribed circle diameter Φout and the height H preferably has a positive correlation coefficient.

<Height H>

The definition of the height H of the concavo-convex structure is as described in «Optical substrate PP». The height H two or less times the average pitch P'ave is preferable from the viewpoints of the light extraction efficiency LEE, internal quantum efficiency IQE, the time requited for preparing of the concavo-convex structure D, and the semiconductor crystal amount to use. Further, by being two or less times the average pitch P'ave, it is possible to increase the light extraction efficiency LEE, and to increase the electron injection efficiency EIE excellently due to suppression of contact failures, and therefore, such a height H is preferable. Particularly, in the case where the height H is the average pitch P'ave or less, since the distribution of the refractive index of the concavo-convex structure D is appropriate from the viewpoint of the emitted light, and it is thereby possible to more increase the light extraction efficiency LEE. From this viewpoint, the height H of the concavo-convex structure D is more preferably 0.8 time or less the average pitch P'ave, and most preferably 0.6 time or less.
Further, from the viewpoint of applying the disturbances of the height H to increases in light extraction efficiency LEE with increases in internal quantum efficiency IQE or electron injection efficiency EIE maintained by the above-mentioned mechanism, in the above-mentioned widest range (0.025~0.5), the coefficient of variation on the height H of the concavo-convex structure D which is the factor of the disturbances preferably ranges from 0.03 to 0.40. Particularly, by being 0.03 or more, a contribution to the light extraction efficiency LEE is excellent, and by being 0.40 or less, a contribution to maintenance of increases in internal quantum efficiency IQE or electron injection efficiency EIE is excellent. From the same viewpoints, the coefficient is preferably 0.04 or more, more preferably 0.05 or more, and most preferably 0.12 or more. Further, the ratio is preferably 0.35 or less, more preferably 0.3 or less, and most preferably 0.25 or less.
In the case where the above-mentioned height H meets the above-mentioned range, it is possible to increase the development intensity of the new optical phenomenon (light diffraction or light scattering) based on the disturbances of the concavo-convex structure D, and therefore, such a case is preferable. That is, it is possible to increase the light extraction efficiency LEE with increases in internal quantum efficiency IQE or electron injection efficiency EIE maintained. This is because the volume change of the concavo-convex structure D is important so as to strengthen optical scattering properties due to the disturbances of the concavo-convex structure D. By the element as described above having the disturbances, it is possible to increase the change in the volume of the concavo-convex structure D, and to increase the number of light diffraction modes or increase the contrast in a portion corresponding to the disturbances of effective refractive index Nema. That is, the optical scattering properties are increased, and it is made possible to increase the light extraction efficiency LEE. Particularly, by the height H and pitch P' meeting the above-mentioned equation (1), the effect of the optical scattering properties is enhanced, the light extraction efficiency LEE is more increased, and therefore, such elements are preferable. In addition, in correlation between the height H and the pitch P', from the viewpoint of crack suppression, the correlation preferably has a negative correlation coefficient. On the other hand, from the viewpoint of the light extraction efficiency LEE, the correlation preferably has a positive correlation coefficient. From the same principles, it is preferable that the height H, pitch P' and convex-portion bottom portion circumscribed circle diameter Φout meet the above-mentioned equation (1), and it is more preferable that the height H, pitch P', convex-portion bottom portion circumscribed circle diameter Φout, and convex-portion bottom portion circumscribed circle diameter Φout/convex-portion bottom portion inscribed circle diameter Φin meet the above-mentioned equation (1).
In addition, the disturbances of the height H may have high regularity, or may be low in regularity. For example, when there is the concavo-convex structure D with center height H0, minimum height H1 and maximum height H2, in the case of the concavo-convex structure D including the specific structure in which the height H has the disturbances with low regularity in the above-mentioned range, regularity of the disturbances of the height H of the concavo-convex structure D is decreased, and it is possible to develop light scattering as the new optical phenomenon. On the other hand, in the case of the concavo-convex structure D including the specific structure in which the increase and decrease of the height H occur periodically, the disturbances of the height H has high regularity, and it is possible to develop light diffraction as the new optical phenomenon. Further, for example, in the case where the specific portions of the height H2 are locally arranged in the basic structure of an aggregation of the height H1, and the specific portions are scattered irregularly, regularity of the disturbances of the height H of the concavo-convex structure D is decreased, and it is possible to develop light scattering as the new optical phenomenon. On the other hand, in the case where the specific portions of the height H2 are locally arranged in the basic structure of an aggregation of the height H1, and the specific portions are arranged regularly, the disturbances of the height H has high regularity, and it is possible to develop light diffraction as the new optical phenomenon.

<Convex-portion side surface inclination angle Θ>

The inclination angle Θ of the convex-portion side surface is determined by the shape parameter of the concavo-convex structure D as described above. Particularly, it is preferable that the inclination angle changes in a multi-stage from the convex-portion vertex portion toward the convex-portion bottom portion. For example, when the inflection point that the convex-portion side surface is bulged upward draws a single curve, the number of inclination angles is 2. By having such multi-stage inclination angles, it is possible to more strengthen the effect of light scattering properties due to the disturbances of the concavo-convex structure D, and it is possible to increase the light extraction efficiency LEE. Further, corresponding to materials of the optical substrate and semiconductor crystal layer, it is also possible to select the inclination angle of the convex-portion side surface from the crystal surface appearing on the convex-portion side surface. In this case, it is conceivable that growth properties of the semiconductor crystal layer are made excellent, and that the internal quantum efficiency IQE is thereby increased.

Next, the disturbances of the concavo-convex structure D meeting the above-mentioned equation (1) will be described using specific examples. The elements of the concavo-convex structure D meeting the above-mentioned equation (1) are not limited particularly, and as the elements to be the factor of the disturbances of the concavo-convex structure D, examples thereof are pitch P', duty, aspect ratio, convex-portion vertex portion width lcvt, convex-portion bottom portion width lcvb, concave-portion opening width lcct, concave-portion bottom portion width lccb, inclination angle of the convex-portion side surface, the number of changes in the inclination angle of the convex-portion side surface, convex-portion bottom portion inscribed circle diameter Φin, convex-portion bottom portion circumscribed circle diameter Φout, convex-portion height, area of the convex-portion vertex portion, the number (density) of minute protrusions on the convex-portion surface, ratios thereof, and information (for example, shape of the concave portion and the like) on the analogy from the arrangement of the concavo-convex structure D.

Among such elements, the pitch P' means the disturbances in the arrangement of the concavo-convex structure D, and elements except the pitch P' mean the disturbances in the shape of the concavo-convex structure D. These disturbances may be the disturbances of only one of the elements as described above, or may be combined disturbances. This is due to the fact that the above-mentioned equation (1) was found out by the fact that it is possible to evaluate the disturbances of the concavo-convex structure D by the scattering component of the above-mentioned optical inspection. Particularly, from the viewpoints of exerting scattering properties more intensely, overcoming the waveguide mode effectively, and increasing the light extraction efficiency LEE, it is preferable that a plurality of elements concurrently meets the disturbances expressed by the above-mentioned equation (1). Among the elements, in the case where the pitch P', duty, height H, aspect ratio, convex-portion bottom portion circumscribed circle diameter Φout or the ratio (Φout/Φin) has the distribution, it is conceivable that scattering properties due to an increase in the number of diffraction modes, or scattering properties due to the distribution of effective refractive index Nema are increased, the effect of disturbing the waveguide mode is larger, and therefore, such a case is preferable. Among the elements, by concurrently including two or more distributions, it is possible to make increases in light extraction efficiency LEE more remarkable. Among the elements, in the case where one of the pitch P', height H, convex-portion bottom portion circumscribed circle diameter Φout, and convex-portion bottom portion circumscribed circle diameter Φout/convex-portion bottom portion inscribed circle diameter Φin has the disturbances meeting the above-mentioned equation (1), the optical scattering effect is more remarkable, such a case is thereby preferable, and combined disturbances of these elements are more preferable.

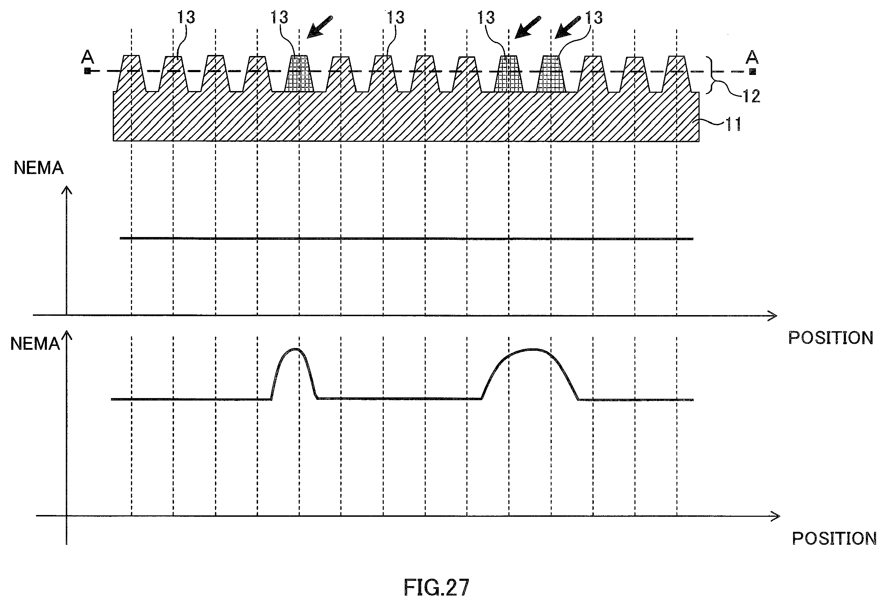

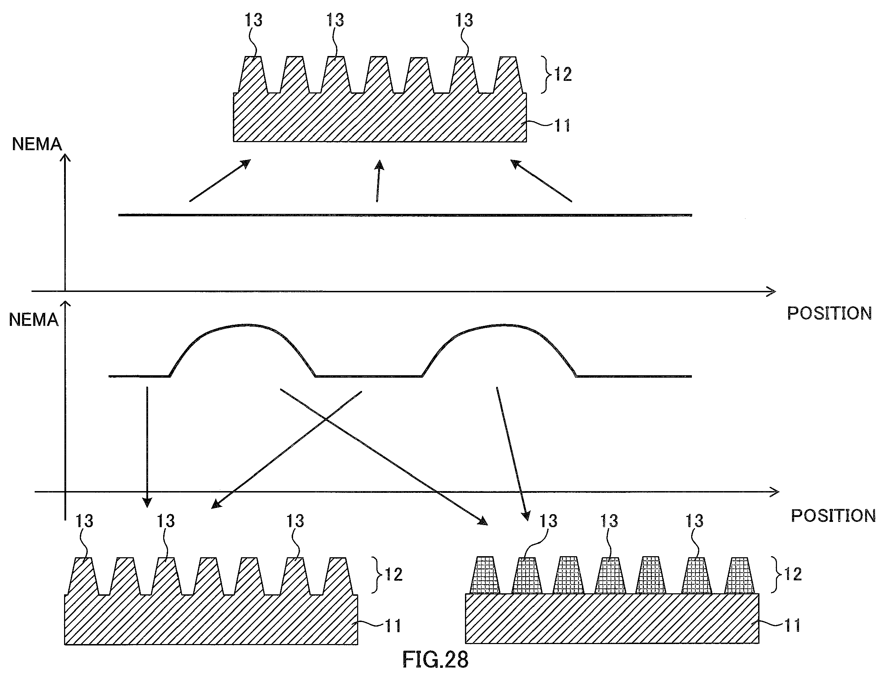

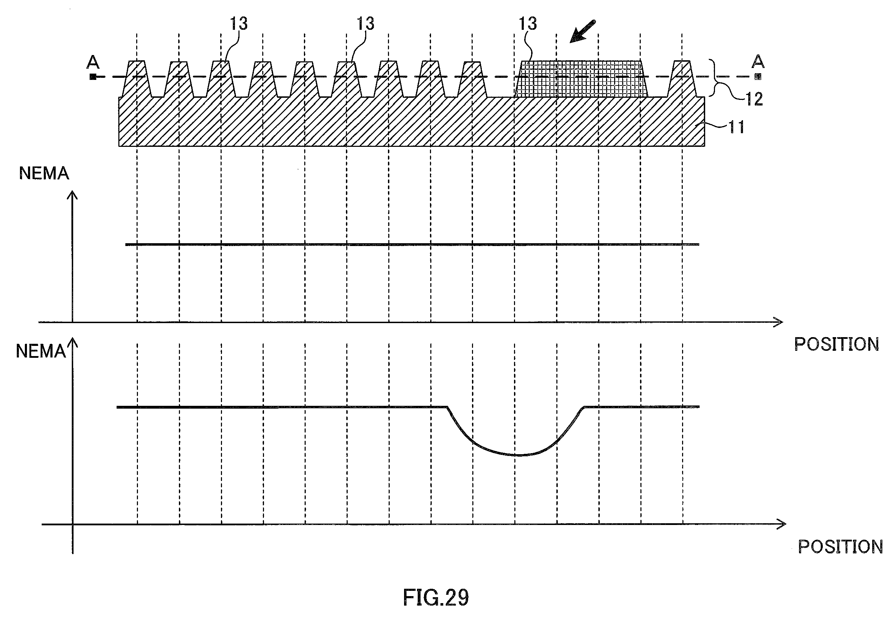

In the optical inspection under the effective medium approximation, it is conceivable that the state of meeting the above-mentioned equation (1) by the disturbances of the concavo-convex structure D12 and exhibiting scattering properties is classified into the case (see FIG. 27) of including local distributions of the refractive index in effective refractive index Nema, the case (see FIG. 28) of including distributions of the refractive index of a larger order than that of each concavo-convex structure D12 in the effective refractive index Nema, and the case (see FIG. 29) where a portion that does not reach the effective medium approximation exists. As described already, it is possible to extract the scattering component caused by the disturbances of the concavo-convex structure D12 by the optical inspection under effective medium approximation. This disturbance is the optical phenomenon (light diffraction or light scattering) that newly develops. Therefore, both in the case where the concavo-convex structure D12 is small from the viewpoint of the emitted light and in the case where the structure D12 is the size equal to or more, the emitted light of the semiconductor light emitting device is capable of developing scattering properties corresponding to the disturbances of the concavo-convex structure D12, and the light extraction efficiency LEE is increased. In addition, the effective refractive index Nema in the present description is not an actually measured value, and is a value obtained by calculation based on the optical phenomenon as a premise. Herein, the premise as the optical phenomenon is effective medium approximation. It is possible to express this effective medium approximation readily with a volume fraction of the distribution of dielectric constant. That is, the difference in the element of the concavo-convex structure D is calculated as the volume fraction of the distribution of dielectric constant, and the resultant is transformed into the refractive index to calculate. In addition, the dielectric constant is the square of the refractive index.

Each of FIGs. 27 to 29 is a schematic diagram illustrating a relationship between a cross-sectional schematic diagram showing an example of the optical substrate D according to this Embodiment and a graph showing a distribution of effective refractive index Nema. FIG. 27 is a schematic diagram illustrating the relationship between a cross-sectional schematic diagram of the optical substrate D11 and the graph showing a distribution of effective refractive index Nema, in the case where the effective refractive index Nema includes local distributions of the refractive index under effective medium approximation. In FIG. 27, portions indicated by the arrows are factors of the distribution of the concavo-convex structure D12 as described above, and correspond to the specific portion comprised of the convex portion 13 having a different shape or dimension from that of the convex portion 13 in the main portion of the concavo-convex structure D12. In addition, in the case where the portions indicated by the arrows occupy the majority of the convex portions 13 of FIG. 27, the concavo-convex structure D12 is in a state in which adjacent convex portions 13 are mutually different i.e. is the concavo-convex structure D12 including the specific structure.

In the graph in FIG. 27, the horizontal axis represents the position that corresponds to the position of each concavo-convex structure D12. The vertical axis represents the effective refractive index Nema in some cross-sectional position (position shown by A-A in FIG. 27) of the concavo-convex structure D12. Further, in FIG. 27, the graph in the upper stage illustrates the case where the disturbances of the concavo-convex structure D12 does substantially not exist, and the graph in the lower stage illustrates the case where disturbances (portions indicated by the arrows) exist in the concavo-convex structure D12. In the effective medium approximation, the concavo-convex structure D12 behaves as a medium having the average refractive index i.e. the effective refractive index Nema. Therefore, in the case where the disturbances does substantially not exist, the effective refractive index Nema takes an approximately constant value irrespective of the positions (plane direction) of the concavo-convex structure D12. That is, the scattering component in the optical inspection under the effective medium approximation is extremely small. On the other hand, in the case where the distribution exists in the concavo-convex structure D12, the effective refractive index Nema changes in the specific portion of the concavo-convex structure D12. On the other hand, when the portions indicated by the arrows occupy the majority of the convex portions 13 of FIG. 27, the effective refractive index Nema includes the refractive index that continuously changes. That is, by the concavo-convex structure D12 including the specific structure, the effective refractive index Nema has the distribution, and it is presumed that the light feels as if the medium corresponding to the distribution of the effective refractive index Nema exists. Therefore, scattering properties corresponding to the distribution of the effective refractive index Nema are exhibited, and the scattering component increases in the optical inspection under the effective medium approximation. Therefore, for example, the diffuse reflection intensity in reflection measurement or the haze value in transmission measurement increases. Accordingly, in the case where the specific portion indicated by the arrow in FIG. 27 is arranged periodically, the distribution of the effective refractive index Nema is considered also having periodicity, and scattering properties developed as the new optical phenomenon are observed as light diffraction. On the other hand, in the case where the specific portion indicated by the arrow in FIG. 27 is arranged non-periodically, the distribution of the effective refractive index Nema is considered also having non-periodicity, and scattering properties developed as the new optical phenomenon are observed as light scattering. Further, in the case where the portions indicated by the arrows in FIG. 27 occupy the majority of the convex portions 13 of FIG. 27 and the convex portions 13 have a periodical distribution, the distribution of the effective refractive index Nema is considered also having periodicity, and scattering properties developed as the new optical phenomenon are observed as light diffraction. On the other hand, even in the case where the portions indicated by the arrows in FIG. 27 occupy the majority of the convex portions 13 of FIG. 27, when the convex portions 13 has a non-periodical distribution, the distribution of the effective refractive index Nema is considered also having non-periodicity, and scattering properties developed as the new optical phenomenon are observed as light scattering.

The disturbances of the concavo-convex structure D12 will specifically be described later, and for example, the case due to the elements of the concavo-convex structure except the pitch P' described above corresponds to this case.

For example, in the case where convex portions 13 with the aspect ratio ranging from about 0 to 0.3 coexist in the base shape without the convex-portion vertex portion having a flat surface where the average pitch P'ave of the concavo-convex structure D12 is 300 nm, the convex-portion bottom portion width lcvb is 150 nm, and the aspect ratio is 1 i.e. the main portion, the portion with the low aspect ratio corresponds to the specific portion, and it is conceivable that the effective refractive index Nema has the distribution in the specific portion. Corresponding to the distribution of the effective refractive index Nema, in other words, corresponding to the distribution of the convex portion 13 having a low aspect ratio, scattering properties that are the new optical phenomenon are developed. Further, for example, in the case of the concavo-convex structure D including the specific structure where the average pitch P'ave of the concavo-convex structure D12 is 300 nm, an average value of the aspect ratio is 1, and the aspect ratio has a distribution in a range of 0.8 to 1.2 with low periodicity, the above-mentioned equation (1) is attained by the distribution of the aspect ratio, and it is conceivable that the effective refractive index Nema has the distribution corresponding to the distribution. Corresponding to the distribution of the effective refractive index Nema, in other words, corresponding to the distribution of the aspect ratio of the convex portion 13, scattering properties that are the new optical phenomenon are developed.

Such scattering properties corresponding to the distribution of the effective refractive index Nema are capable of being represented as the disturbances of the concavo-convex structure D12 shown in the above-mentioned equation (1). Therefore, by applying the optical substrate D11 having the concavo-convex structure D12 with the disturbances meeting the above-mentioned equation (1), the emitted light of the semiconductor light emitting device is capable of developing the new optical phenomenon corresponding to the disturbances of the concavo-convex structure D12, and it is possible to increase the light extraction efficiency LEE with increases in internal quantum efficiency IQE or electron injection efficiency EIE maintained.

FIG. 28 is a conceptual diagram illustrating the relationship between a cross-sectional schematic diagram of the optical substrate D11 and the graph showing a distribution of effective refractive index Nema, in the case of including the disturbances of the effective refractive index Nema of an order larger than that of each concavo-convex structure D12 under the effective medium approximation. In the graph in FIG. 28, the horizontal axis represents the position in the plane direction of the optical substrate D11. The vertical axis represents the effective refractive index Nema in some predetermined height position of the concavo-convex structure D12. Further, in FIG. 28, the graph in the upper stage illustrates the case where the disturbances of the concavo-convex structure D12 does substantially not exist, and the graph in the lower stage illustrates the case where disturbances exist in the concavo-convex structure D12. In the effective medium approximation, the concavo-convex structure D12 behaves as a medium having the average refractive index Nema. In the case where the specific portion shown in FIG. 28 is arranged periodically, the distribution of the effective refractive index Nema is considered also having large periodicity, and scattering properties developed as the new optical phenomenon are observed as light diffraction. On the other hand, in the case where the specific portion shown in FIG. 28 is arranged non-periodically, the distribution of the effective refractive index Nema is considered also having non-periodicity, and scattering properties developed as the new optical phenomenon are observed as light scattering. The disturbances of the concavo-convex structure D12 will specifically be described later, and for example, there is the case where a domain A with the average pitch P'ave of 250 nm and a domain B with the average pitch P'ave of 300 nm coexist. When the domain A and the domain B coexist at intervals of 1500 $\mu$m, it is presumed that the effective refractive index Nema also has the distribution at intervals of 1,500 $\mu$m. That is, scattering properties corresponding to the distribution (intervals of 1,500 $\mu$m) of the effective refractive index Nema are developed as the new optical phenomenon. Further, the case where specific portions of tetragonal arrangement are partially provided in the basic structure of orthohexagonal arrangement corresponds to this case. More specifically, there is the case where specific structures with the average pitch P'ave of 300 nm and the size of an aggregation ranging from 900 nm to 1,500 nm are distributed in the basic structure of hexagonal arrangement with the average pitch P'ave of 300 nm. In this case, when the specific structures are arranged regularly, since the effective refractive index Nema also has the distribution corresponding to the regular specific structure, and light diffraction occurs as the new optical phenomenon. When the specific structures are arranged irregularly, since the distribution of the effective refractive index Nema also has irregularity, and light scattering develops as the new optical phenomenon. Further, for example, the case where the concavo-convex structure D is comprised of specific structures including the hexagonal arrangement, quasi-hexagonal arrangement, quasi-tetragonal arrangement and tetragonal arrangement irregularly also corresponds to this case. In this case, since the distribution of the effective refractive index Nema has non-periodicity locally and macroscopically, light scattering is developed as the new optical phenomenon. Such a new optical phenomenon (scattering properties and diffraction properties) corresponding to the distribution of the effective refractive index Nema is capable of being represented as the disturbances of the concavo-convex structure D12 shown in the above-mentioned equation (1). Therefore, by applying the optical substrate D11 having the concavo-convex structure D12 with the disturbances meeting the above-mentioned equation (1), the emitted light of the semiconductor light emitting device is capable of developing the new optical phenomenon corresponding to the disturbances of the concavo-convex structure D12, and it is possible to increase the light extraction efficiency LEE with increases in internal quantum efficiency IQE or electron injection efficiency EIE maintained.

FIG. 29 is a conceptual diagram illustrating the relationship between a cross-sectional schematic diagram of the optical substrate D11 and the graph showing a distribution of effective refractive index Nema, in the case of including the concavo-convex structure D12 that is partially not included in the effective medium approximation. In FIG. 29, a portion indicated by the arrow illustrates the disturbances of the concavo-convex structure D12, and is the portion that is not included in the effective medium approximation. For example, since the average pitch P'ave of the concavo-convex structure D12 is 250 nm, in the case of using an optical measurement wavelength with a wavelength of 550 nm to apply effective medium approximation, this is the case where the convex portion (for example, the convex portion with a size of 500 nm) having the size equal to or more than the wavelength (550 nm) is arranged.

In the graph in FIG. 29, the horizontal axis represents the position that corresponds to the position of each concavo-convex structure D12. The vertical axis represents the effective refractive index Nema in some cross-sectional position (position shown by A-A in FIG. 29) of the concavo-convex structure D12. Further, in FIG. 29, the graph in the upper stage illustrates the case where the disturbances of the concavo-convex structure does substantially not exist, and the graph in the lower stage illustrates the case where the disturbances (portion indicated by the arrow) exists in the concavo-convex structure D12. In the effective medium approximation, the concavo-convex structure D12 behaves as a medium having the average refractive index i.e. the effective refractive index Nema. When the refractive index of the material constituting the concavo-convex structure D12 is described as Nact, in the effective refractive index Nema, the refractive index in the position that corresponds to the specific portion is Nact. That is, in the medium behaving as the effective refractive index Nema, a medium having the refractive index Nact different from the effective refractive index Nema functions as a state of being arranged corresponding to the distribution of the disturbances. That is, the light feels as a thin film as if the film is comprised of the medium having the effective refractive index Nema with the medium having the refractive index Nact dispersed, and therefore, exhibits scattering properties corresponding to the distribution of the refractive index Nact. In the case where the specific portion shown in FIG. 29 is arranged periodically, it is presumed that the distribution of the refractive index Nact also has a large periodicity. Therefore, scattering properties developed as the new optical phenomenon are observed as light diffraction. On the other hand, in the case where the specific portion of the concavo-convex structure D12 shown in FIG. 29 is arranged non-periodically, it is considered that the distribution of the refractive index Nact also has non-periodicity, and scattering properties developed as the new optical phenomenon are observed as light scattering. The disturbances of the concavo-convex structure D12 will specifically be described later, and for example, it is assumed that an optical measurement wavelength λ is set at 800 nm with the average pitch P'ave of 200 nm. At this point, it is assumed that convex portions with the convex-portion diameter (lcvt or lcvb) of 1,200 nm are partially included. In this case, the convex portion 13 having the large convex-portion diameter corresponds to the specific portion, the specific portion corresponds to a scattering point of the refractive index Nact, and the concavo-convex structure D12 exhibits scattering properties. Further, for example, it is assumed that an optical measurement wavelength λ is set at 800 nm with the average pitch P'ave of 300 nm. At this point, it is assumed that concave portions with the concave-portion diameter (concave-portion opening width lcct or concave-portion bottom portion width lccb) ranging from of 600 nm to 1,500 nm are partially included. In this case, the concave portion having the large concave-portion diameter corresponds to the specific portion, the specific portion corresponds to a scattering point, and the concavo-convex structure D12 exhibits scattering properties. In addition, the refractive index in the case where the concave portion having the large concave-portion diameter functions as the specific portion is the refractive index (for example, the refractive index of the semiconductor) of the medium surrounding the periphery of the concavo-convex structure D12. Such scattering properties corresponding to the distribution of the effective refractive index Nema are capable of being represented as the disturbances of the concavo-convex structure D12 shown in the above-mentioned equation (1). Therefore, by applying the optical substrate D11 having the concavo-convex structure D12 with the disturbances meeting the above-mentioned equation (1), the emitted light of the semiconductor light emitting device is capable of developing the new optical phenomenon corresponding to the disturbances of the concavo-convex structure D12, and it is possible to increase the light extraction efficiency LEE with increases in internal quantum efficiency IQE or electron injection efficiency EIE maintained.

When the disturbances of the concavo-convex structure D12 described using above-mentioned FIGs. 27 to 29 are combined, the distribution of the effective refractive index Nema is more increased, the scattering point increases, and the scattering intensity is strengthened. That is, by including a plurality of disturbances of the concavo-convex structure 12 as described above, the (standard deviation/arithmetic mean) of the distribution of the element that is a factor of the distribution of the concavo-convex structure D12 is also increased, and the effect of disturbing the waveguide mode is increased. Therefore, the degree of increases in light extraction efficiency LEE is increased.

The disturbances of the concavo-convex structure D12 will next be described more specifically. As described above, the disturbances of the concavo-convex structure D12 is sorted into the disturbances caused by the shape of the concavo-convex structure D12 and the disturbances caused by the arrangement as described above. The disturbances of the shape of the concavo-convex structure D12 will be described first.

<Disturbance caused by the shape>

As described already, the distribution of the element that is a factor of the disturbances of the concavo-convex structure D12 includes the pitch P', aspect ratio, duty, convex-portion vertex portion width lcvt, convex-portion bottom portion width lcvb, concave-portion opening width lcct, concave-portion bottom portion width lccb, inclination angle of the convex-portion side surface, the number of changes in the inclination angle of the convex-portion side surface, convex-portion bottom portion inscribed circle diameter Φin, convex-portion bottom portion circumscribed circle diameter Φout, convex-portion height, area of the convex-portion vertex portion, the number (density) of minute protrusions on the convex-portion surface and ratios thereof which are the terms as described above, and further includes distributions derived from those as well as these distributions.

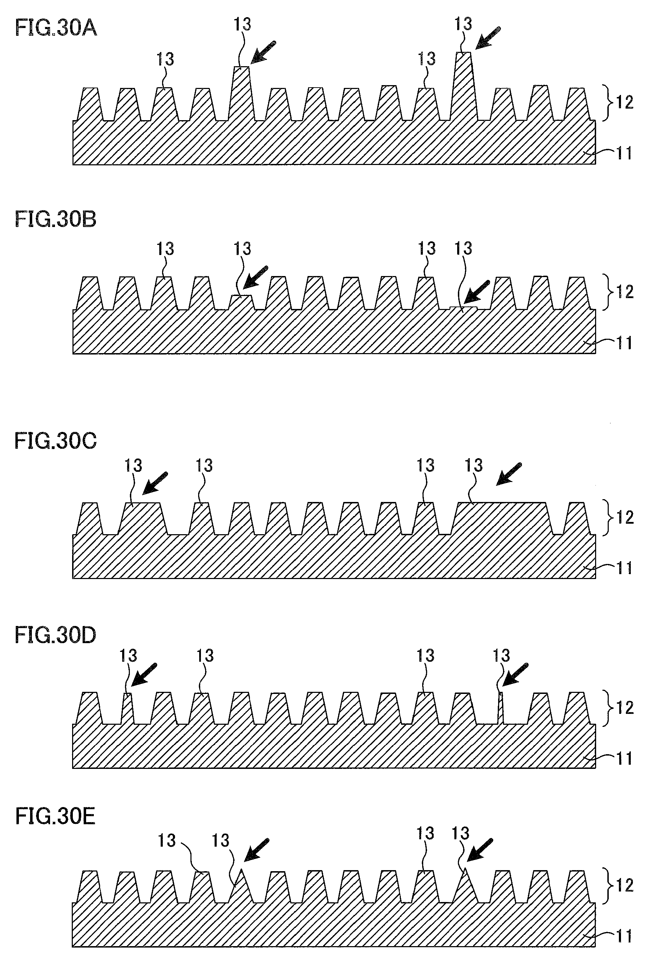

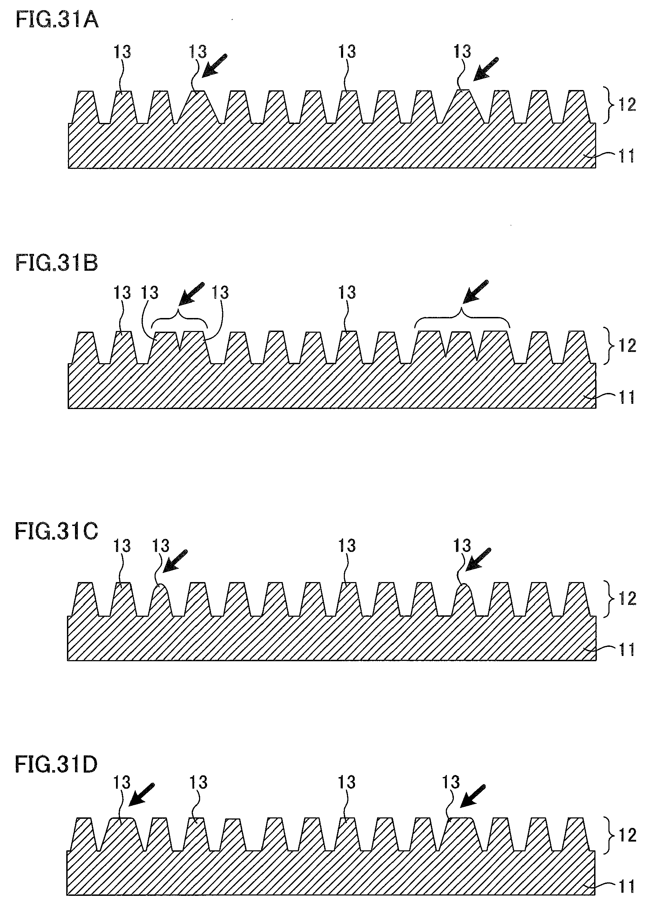

Examples of the disturbances of the shape of the concavo-convex structure D12 are described in FIGs. 30A to 30E and FIGs. 31A to 31D. FIGs. 30A to 30E and FIGs. 31A to 31D are cross-sectional schematic diagrams illustrating the optical substrate D according to this Embodiment, and portions indicated by the arrows in FIGs. 30A to 30E and FIGs. 31A to 31D show specific portions that are factors of variations in the shape of the concavo-convex structure D12. In addition, in FIGs. 30 and 31, in order to clarify the specific portion of the concavo-convex structure D12, the case is shown where the shape or dimension of a predetermined convex portion 13 is extremely different from that of the convex portion 13 in the other portions among the convex portions 13 constituting the concavo-convex structure D12. That is, in considering adjacent convex portion N and convex portion N+1, it is assumed to include a state in which the shape is slightly different between the convex portion N and the convex portion N+1, the shape is slightly different between the convex portion N+1 and the convex portion N+2, and the shape is also slightly different between the convex portion N+M and the convex portion N+M+1. In this case, when k<M is set, it is also possible to include convex portions having the same shape as that of the convex portion N+k in the convex portion N to convex portion N+M. That is, this is a state in which the rate of the specific portion provided independently of the main portion of the concavo-convex structure D12 is sufficiently higher than that of the main portion, and is the concavo-convex structure including the specific structure. For example, this is the state as shown in FIG. 11 used in «Optical substrate PP». The essence of the above-mentioned equation (1) is the average disturbance of the concavo-convex structure D12, and therefore, it is assumed to include a state in which a plurality of convex portions 13 constituting the concavo-convex structure D12 is slightly different from the average value respectively.

FIGs. 30A and 30 B are examples including the disturbances caused by at least the height H in the concavo-convex structure D12. In association with the disturbances of the concavo-convex structure D12 caused by the height H, the example includes disturbances of the concavo-convex structure D12 caused by the aspect ratio of the convex portion 13 and the inclination angle Θ of the convex-portion side surface of the concavo-convex structure D12. FIG. 30A is the case where the concavo-convex structure D12 includes the specific portions comprised of convex portions 13 with higher heights H than those of the convex portions 13 in the main portion, and FIG. 30B is the case where the concavo-convex structure D12 includes the specific portions comprised of convex portions 13 with lower heights H than those of the convex portions 13 in the main portion. For example, with respect to the concavo-convex structure D12 with the average height of 150 nm, the case (FIG. 30A) where the convex portion 13 of 180 nm locally exists or the case (FIG. 30B) where the convex portion 13 of 120 nm locally exists corresponds this case. Further, when the average height is 150 nm, this case also corresponds to the concavo-convex structure including the specific structure with the height H having the distribution in a range of 130 nm to 180 nm. Furthermore, from the same technical idea, this case corresponds to the case where the arithmetic mean of the aspect ratio is 0.67 and the aspect ratio has the distribution in a range of 0.6 to 0.1, and the like.

FIGs. 30C and 30 D are cases including the disturbances caused by the convex-portion diameter (convex-portion vertex portion width lcvt, convex-portion bottom portion width lcvb, convex-portion bottom portion circumscribed circle diameter Φout, convex-portion bottom portion inscribed circle diameter Φin) of the concavo-convex structure D12, and are cases including the specific portion with different concave-portion opening width lcct, concave-portion bottom portion width lccb, aspect ratio, duty and inclination angle Θ of the convex-portion side surface. FIG. 30C is the case of including the specific portions comprised of convex portions 13 with larger convex-portion diameters than those of convex portions 13 in the main portion, and FIG. 30D is the case of including the specific portions comprised of convex portions 13 with smaller convex-portion diameters than those of convex portions 13 in the main portion. For example, FIG. 30C corresponds to the case where the average value of the convex-portion bottom portion width lcvb is 150 nm, and the convex portions 13 having the convex-portion bottom portion width lcvb of 250 nm or more coexist partially. On the other hand, FIG. 30D corresponds to the case where the average value of the convex-portion bottom portion width lcvb is 150 nm, and the convex portions 13 having the convex-portion bottom portion width lcvb of 100 nm or less are partially included. From the same technical idea, this case corresponds to the case where the arithmetic mean of the convex-portion vertex portion width lcvt is 7.9 nm and the distribution in a range of 0 nm to 20 nm is included, the case where the arithmetic mean of the concave-portion bottom portion width lccb is 147 nm and the distribution in a range of 130 nm to 165 nm is included, and the like.

FIG. 30E is the case of having the disturbances of the concavo-convex structure 12 caused by the convex-portion vertex portion width lcvt, and in association therewith, the case includes specific portions where the inclination angle Θ of the convex-portion side surface is different.

FIG. 31A is the case of having the disturbances of the concavo-convex structure 12 caused by the convex-portion vertex portion width lcvt, and in association therewith, the case includes specific portions where the inclination angle Θ of the convex-portion side surface is different. For example, in assuming that the height direction of the concavo-convex structure D12 is the normal, this case corresponds to the case where the convex portion 13 having the side surface inclined 27 degrees coexists, with respect to the convex portion 13 having the side surface inclined 31 degrees on average from the normal, and the like.

FIG. 31B is the case of having the disturbances of the concavo-convex structure 12 caused by the convex-portion bottom portion width lcvb, and particularly, the case includes specific portions in a state in which adjacent convex portions 13 are partially coupled and form a larger convex portion 13.

FIG. 31C is the case of having the disturbances of the concavo-convex structure D12 caused by the shape of the convex-portion vertex portion, and illustrates specific portions in which the curvature of the convex-portion vertex portion is different.

FIG. 31D is the case of having the disturbances of the concavo-convex structure D12 caused by the shape of the convex-portion side surface, and the case includes specific portions in which the curvature of the convex-portion side surface is different.

In addition, although not shown, two or more distributions may be included which are caused by the shape of the concavo-convex structure D12 as described using FIGs. 30A to 30E and FIGs. 31A to 31D.

<Disturbance caused by the arrangement>

Described next is the disturbances caused by the arrangement of the concavo-convex structure D12. The disturbances caused by the arrangement is attained by a periodical disturbance of the concavo-convex structure D12, an arrangement of domains having different concavo-convex structure species, and the like.

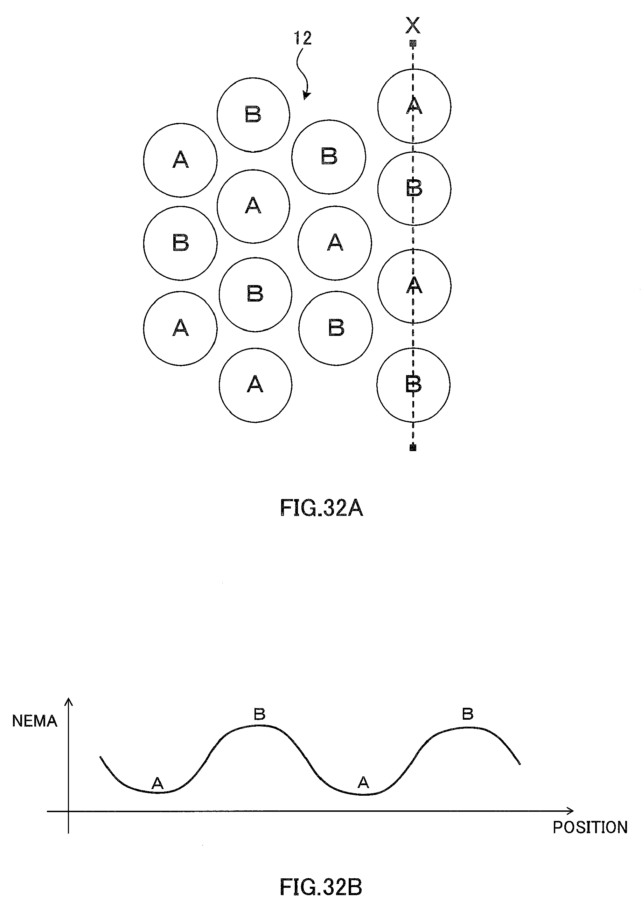

FIG. 32 contains a top diagram, viewed from the concavo-convex structure surface side, showing an example of the optical substrate D according to this Embodiment and a graph showing a distribution of effective refractive index Nema. For example, as shown in FIG. 32A, when domains A and domains B that are sets of the concavo-convex structure D12 are arranged, the effective refractive indexes Nema of the domains A and B take different values according to the concavo-convex structures D12 respectively constituting the domains A and B. Herein, the concavo-convex structures D12 respectively constituting the domains A and B being different means that the element of the concavo-convex structure D12 as described above is different between the concave-convex structures D12 constituting respective domains. More specifically, for example, it is the case where the average pitch P'ave of the domain A is 300 nm, and the average pitch P'ave of the domain A is 250 nm. The arrangement of such domains forms a macro (order sufficiently larger than the size of the concavo-convex structure D12) distribution of effective refractive index Nema. Accordingly, the light behaves as if the medium having the outside shape of the effective refractive index Nema as illustrated in the graph shown in FIG. 32B exists, and exhibits scattering properties. In addition, the arrangement of domains illustrated in FIG. 32A is the arrangement of two kinds, domains A and B. Further, for example, by preparing domains A, B and C, and regarding the domains A and B as one set, it is also possible to alternately arrange the set of the domains A and B, and the domain C. More specifically, there is the case where the average pitch P'ave of the domain A is 300 nm, the average pitch P'ave of the domain B is 600 nm, and the average pitch P'ave of the domain C is 1,000 nm.

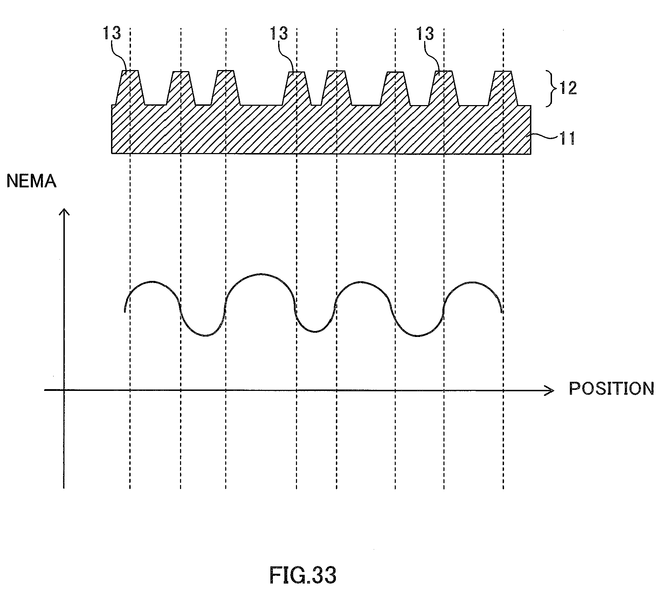

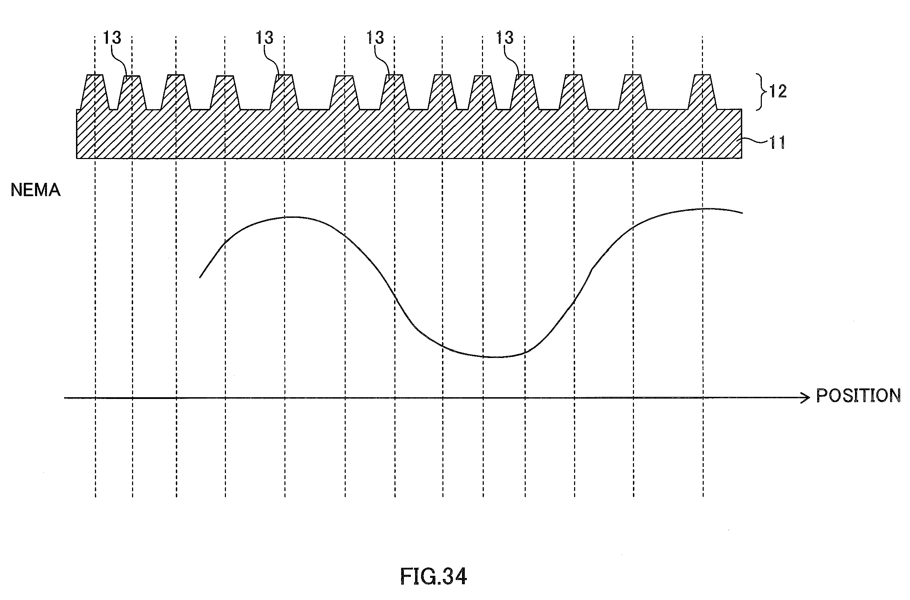

Each of FIGs. 33 and 34 contains a cross-sectional schematic diagram showing an example of the optical substrate D according to this Embodiment and a graph showing a distribution of effective refractive index Nema. Further, for example, FIG. 33 shows the case where the disturbances exist in the pitch P' that is a distance between convex portions 13. As shown in FIG. 33, when the disturbances exist in the period of the concavo-convex structure D12, the effective refractive index Nema forms a distribution corresponding to the period of the period of the concavo-convex structure D12. Thai is, scattering properties are exhibited which correspond to the disturbances of the effective refractive index Nema. Herein, when the disturbances of the pitch P' is non-periodical, the distribution of the effective refractive index Nema is also non-periodical. That is, the scattering properties that are the newly developed optical phenomenon are strongly dependent on light scattering. On the other hand, when the disturbances of the pitch P' is periodical, the distribution of the effective refractive index Nema is also periodical. That is, the scattering properties that are the newly developed optical phenomenon are strongly dependent on light diffraction. Particularly, in the case where at least the height H or the convex-portion bottom portion circumscribed circle diameter Φout has the disturbances corresponding to the disturbances of the period as described above, light scattering properties are improved, therefore such a case is preferable, and the case where the height H and the convex-portion bottom portion circumscribed circle diameter Φout have the disturbances at the same time is more preferable. Further, since the convex-portion volume change is increased, the case where convex-portion bottom portion circumscribed circle diameter Φout/convex-portion bottom portion inscribed circle diameter Φin also has the disturbances at the same is further preferable.

Moreover, for example, FIG. 34 shows the case where the pitch P' that is the distance between convex portions 13 continuously changes. As shown in FIG. 34, the effective refractive index Nema forms a distribution corresponding to the continuous change of the pitch P', and scattering properties corresponding to this distribution of the effective refractive index Nema are developed. Herein, in the case where the continuous change has periodicity, for example, when the average pitch P'ave is 300 nm, and the variation of the pitch of ±10% is repeatedly arranged with a period of 1,500 μm, the effective refractive index Nema has the distribution with a period of 1,500 μm, scattering properties corresponding to the period are developed, and the scattering properties due to the new optical phenomenon are strongly dependent on light diffraction. Particularly, in the case where at least the height H or the convex-portion bottom portion circumscribed circle diameter Φout has the disturbances corresponding to the continuous change of the period as described above, light diffraction is improved, therefore such a case is preferable, and the case where the height H and the convex-portion bottom portion circumscribed circle diameter Φout have the disturbances at the same time is more preferable. Further, since the convex-portion volume change is increased, the case where convex-portion bottom portion circumscribed circle diameter Φout/convex-portion bottom portion inscribed circle diameter Φin also has the disturbances at the same is further preferable.

A layer configuration of a semiconductor light emitting device in applying the optical substrate D according to this Embodiment to the semiconductor light emitting device is as described already with reference to FIGs. 24 to 26. Further, as materials applicable to each layer of the semiconductor light emitting device, it is possible to adopt the materials as described in «Optical substrate PP».

In addition, with respect to the disturbances of the concavo-convex structure D12 as described above, in the disturbances using expression of periodical or high regularity, the split phenomenon of laser beam is sometimes observed as described in above-mentioned «Optical substrate PP». Particularly, also in the optical substrate D, by the split of laser beam being observed, the degree of increases in light extraction efficiency LEE is more increased, and therefore, such a phenomenon is preferable. That is, the case of meeting the above-mentioned range of the average pitch P', the above-mentioned equation (1) and the split phenomenon of laser beam is the most preferable.

As described above, it is considered that the effective refractive index Nema forms the distribution due to the disturbances of the element of the concavo-convex structure D12, and that optical scattering properties are thereby developed, and it has been verified that the optical scattering properties are strengthened by regarding the element of the concavo-convex structure D12 as a parameter to change. Herein, since it is possible to consider that the occurrence of change in the effective refractive index Nema is the essence, it is possible to presume that the optical scattering properties are capable of being developed strongly due to kinds of materials constituting the concavo-convex structure D12, as well as the difference in the element of the concavo-convex structure D12 meeting the above-mentioned equation (1). That is, it is conceivable that it is possible to develop strong optical scattering properties also by regarding the disturbances of the element of the concavo-convex structure D12 as described above as a disturbance in materials forming the concavo-convex structure, particularly, a disturbance in the refractive index or extinction coefficient of materials forming the concavo-convex structure. Particularly, in considering that the optical substrate D is applied to a semiconductor light emitting device, it is conceivable that it is preferable to use the difference in the refractive index of materials forming the concave-convex structure D12, from the viewpoint of increasing the light extraction efficiency LEE. Further, it is not difficult to conceive that a difference of the extent of behavior of light due to the refractive index is important in strengthening the optical scattering properties due to the difference in the refractive index of the material. In calculating from this viewpoint, in the disturbances in the refractive index of materials forming the concavo-convex structure D12, the difference in the refractive index is preferably 0.07 or more, and more preferably 0.1 or more. This is because it is thereby possible to increase the reflectance of light. Particularly, from the viewpoints of more increasing the reflectance and strengthening the optical scattering properties, it is presumed that the difference in the refractive index is more preferably 0.5 or more. In addition, the difference in the refractive index is preferably larger, and most preferably 1.0 or more.

Described next is a method of manufacturing the optical substrate D according to this Embodiment.

As long as the optical substrate D according to this Embodiment is provided with the concavo-convex structure D meeting the above-mentioned conditions, the manufacturing method thereof is not limited, and it is possible to adopt the techniques as described in «Optical substrate PP», and particularly, it is preferable to adopt the transfer method. This is because by adopting the transfer method, processing accuracy and processing speed of the concavo-convex structure D is increased.

Herein, the transfer method is the technique defined in the same manner as described in «Optical substrate PP», and includes the case of using a transfer material that is transfer-added to a target product as a permanent material, the nanoimprint lithography method, and the nano-processing sheet method.

As described above, by adopting the transfer method, since it is possible to reflect the fine structure of the mold in the target product, it is possible to obtain the optical substrate D with excellence.

That is, an imprint mold according to this Embodiment is a mold provided with a fine structure on its surface, and is characterized in that the fine structure meets the average pitch P' as described above and the above-mentioned equation (1). In addition, the fine structure of the mold used in the transfer method is the structure opposite to the transfer-added concavo-convex structure. Therefore, the fine structure of the mold according to this Embodiment is the structure with the convexity and concavity described in the above-mentioned optical substrate D replaced with each other.

As materials of the imprint mold, it is possible to adopt the same materials as described in «Optical substrate PP».

Further, in the case of manufacturing a semiconductor light emitting device, it is preferable to include a step of preparing the optical substrate D according to this Embodiment, a step of performing an optical inspection on the optical substrate D, and a step of manufacturing a semiconductor light emitting device using the optical substrate D in this order.

As described already, it is possible to define the concavo-convex structure D according to this Embodiment by the optical scattering component. Therefore, by performing an optical inspection after preparing the optical substrate D, it is possible to beforehand grasp the accuracy of the concavo-convex structure D. For example, in the case of adding the concavo-convex structure D to a sapphire substrate so as to concurrently increase the internal quantum efficiency IQE and the light extraction efficiency LEE, by performing the optical inspection on the sapphire substrate (optical substrate D), and evaluating the optical scattering component, it is possible to grasp the accuracy of the concavo-convex structure D12. Therefore, it is possible to beforehand estimate the performance rank of a semiconductor light emitting device to manufacture. Further, since it is also possible to screen out optical substrates D that cannot be used, the yield is enhanced. Herein, the optical inspection is as described in «Optical substrate PP». In addition, in the optical inspection, by making the wavelength of the light source larger than the average pitch P'ave of the concavo-convex structure D12, it is possible to extract the effect of the disturbances of the concavo-convex structure D as shown in the above-mentioned equation (1). This means that the effect of the disturbances is evaluated purely, and therefore, means that it is possible to perform control with higher accuracy. Further, also in reflection measurement, in order to increase output, it is preferable to measure in oblique incident.

«Optical substrate PC»

The optical substrate PC according to this Embodiment will be described next.

The terms are in accordance with the definitions as described already in «Optical substrate PP», unless otherwise specified. As described in «Optical substrate PP» and «Optical substrate D», in order to concurrently improve the internal quantum efficiency IQE or electron injection efficiency EIE and the light extraction efficiency LEE in the mutually tradeoff relationship, it is considered the essence to increase the density of the concavo-convex structure existing as an entity, and newly add optical scattering properties based on the optical distribution of the effective refractive index Nema recognized by the emitted light of the semiconductor light emitting device. Herein, the multi-dimensional nano-structure body having a periodical structure of the refractive index is categorized as the field of academic study called the photonic crystal. According to the direction of periodical structure, the photonic crystal is classified into one-dimensional photonic crystal, two-dimensional photonic crystal and three-dimensional photonic crystal. By using an electron microscope or the like to observe, it is possible to observe the periodical structure comprised of the structure body of nano-order. The importance herein is that the degree of increases in internal quantum efficiency IQE is limited in the case of providing a large structure of micro-order in the thickness direction of the optical substrate so as to increase optical scattering properties. From this viewpoint, by using the photonic crystal, it is possible to provide a concavo-convex structure of nano-order on the optical substrate, and to develop strong optical scattering properties by the concavo-convex structure of nano-order. That is, it is possible to concurrently improve the internal quantum efficiency IQE and the light extraction efficiency LEE that have been mutually tradeoffs.

The optical substrate PC according to this Embodiment is a substrate for a semiconductor light emitting device applied to the semiconductor light emitting device comprised of an n-type semiconductor layer comprised of at least one or more layers, p-type semiconductor layer comprised of at least one or more layers, and a light emitting layer comprised of one or more layers. As specific materials of the optical substrate PC, it is possible to adopt the materials as described in «Optical substrate PP».

Further, as the semiconductor light emitting device using the optical substrate PC, it is possible to adopt the semiconductor light emitting device as described in «Optical substrate PP» with reference to FIGs. 2 to 6 with a photonic crystal layer PC (concavo-convex structure PC) substituted for the concavo-convex structure PP, or the semiconductor light emitting device as described in <<Optical substrate D» with reference to FIGs. 24 to 26 with a photonic crystal layer PC (concavo-convex structure PC) substituted for the concavo-convex structure D.

The photonic crystal layer is the multi-dimensional nano-structure body in which the refractive index (dielectric constant) periodically changes. The photonic crystal layer according to this Embodiment is comprised of a fine structure layer including dots comprised of a plurality of convex portions or concave portions extending in the out-of-plane direction on the main surface of a substrate for a semiconductor light emitting device. As the substrate for a semiconductor light emitting device, it is possible to use the substrate as described in «Optical substrate PP». Since the photonic crystal layer has the periodical structure of the refractive index (dielectric constant), the order of the fine structure layer observed with a scanning electron microscope is different from the order of an image observed with an optical microscope. Therefore, although only concavities and convexities of the fine structure layer are recognized in observing with a scanning electron microscope, the photonic crystal layer exists as a periodical structure larger than the concavo-convex period of the fine structure layer.

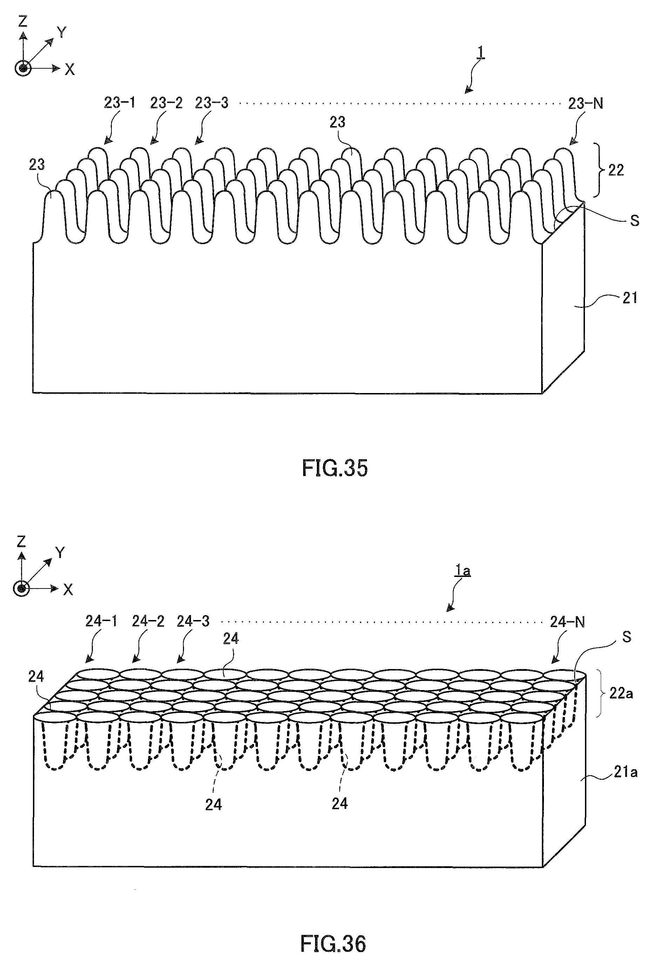

A configuration of the optical substrate PC according to this Embodiment will specifically be described next with reference to FIG. 35. FIG. 35 is a perspective schematic diagram showing an example of the optical substrate PC according to this Embodiment. As shown in FIG. 35, an optical substrate PC1 has the shape of a plate substantially, and is provided with a substrate body 21, and a fine structure layer 22 provided on one main surface of the substrate body 21. The fine structure layer 22 includes a plurality of convex portions 23 (convex-portion lines 23-1 to 23-N) protruding upward from the main surface of the substrate body 21. The convex portions 23 are arranged with respective particular intervals.

FIG. 36 is a perspective schematic diagram showing another example of the optical substrate PC according to this Embodiment. As shown in FIG. 36, an optical substrate PC1a has the shape of a plate substantially, and is provided with a substrate body 21 a, and a fine structure layer 22a provided on one main surface of the substrate body 21a. The fine structure layer 22a includes a plurality of concave portions 24 (concave-portion lines 24-1 to 24-N) dented from a surface S of the fine structure layer 22a toward the main surface side of the substrate body 21 a. The concave portions are arranged with respective predetermined intervals.

The fine structure layer 22, 22a may be separately formed on the main surface of the substrate body 21, 21a, or may be formed by directly processing the substrate body 21, 21a, respectively.

Hereinafter, the convex portions 23 or concave portions 24 constituting the fine structure of the fine structure layer 22 or 22a are referred to as "dots" in the optical substrate PC1 or PC1a according to this Embodiment, respectively. In this Embodiment, the above-mentioned dots are of nano-order.

According to this configuration, since the concavo-convex structure of nano-order is provided on the surface of each of the optical substrates PC1 and PC1a, the CVD growth mode of the semiconductor crystal layer is disturbed in providing the semiconductor layer on the surface of the optical substrate PC1 or PC1a, dislocation defects in association with layer growth collide and disappear, and it is possible develop the effect of reducing dislocation defects. Since dislocation defects inside the semiconductor crystal layer are decreased, it is possible to increase the internal quantum efficiency IQE of the semiconductor light emitting device.

Further, in the optical substrate PC1 or PC1a according to this Embodiment, the two-dimensional photonic crystal is formed which is controlled by one of the pitch between the above-mentioned dots, dot diameter and dot height. In this Embodiment, the photonic crystal is the multi-dimensional nano-structure body in which the refractive index periodically changes, and by the refractive index changing periodically, it is possible to control reflection, transmission and diffraction characteristics with respect to the propagated light inside the crystal.

In the optical substrates PC1 and PC1a according to this Embodiment, the above-mentioned dot is of nano-order, and is substantially equal to a wavelength of the propagated light. Therefore, in this Embodiment, the characteristics of the photonic crystal are determined by a periodical change in the effective refractive index Nema with refractive indexes caused by the structure averaged (effective medium approximation). Since the distribution of the effective refractive index Nema is repeated inside the main surface of the optical substrate PC1 or PC1a, the two-dimensional photonic crystal is formed.

Further, in the optical substrates PC1 and PC1a according to this Embodiment, it is necessary that the period of the above-mentioned two-dimensional crystal is two or more times the wavelength of the emitted light of the semiconductor light emitting device to apply. Since the two-dimensional crystal has the period two or more times the wavelength of the emitted light, light scattering properties are more strengthened than light diffraction properties. Therefore, in the optical substrates PC1 and PC1a according to this Embodiment, it is possible to strongly develop the light scattering properties with respect to the emitted light from the semiconductor crystal layer, and it is possible to resolve the waveguide mode due to the light scattering properties, and to increase the light extraction efficiency LEE.

Furthermore, at the same time, by strong light scattering properties, the angle dependence in the emission characteristics is weakened, and the emission characteristics get closer to Lambertian emission characteristics easy to apply to industrial uses.

The two-dimensional photonic crystal controlled by the pitch between dots, dot diameter or dot height will be described more specifically with drawings.

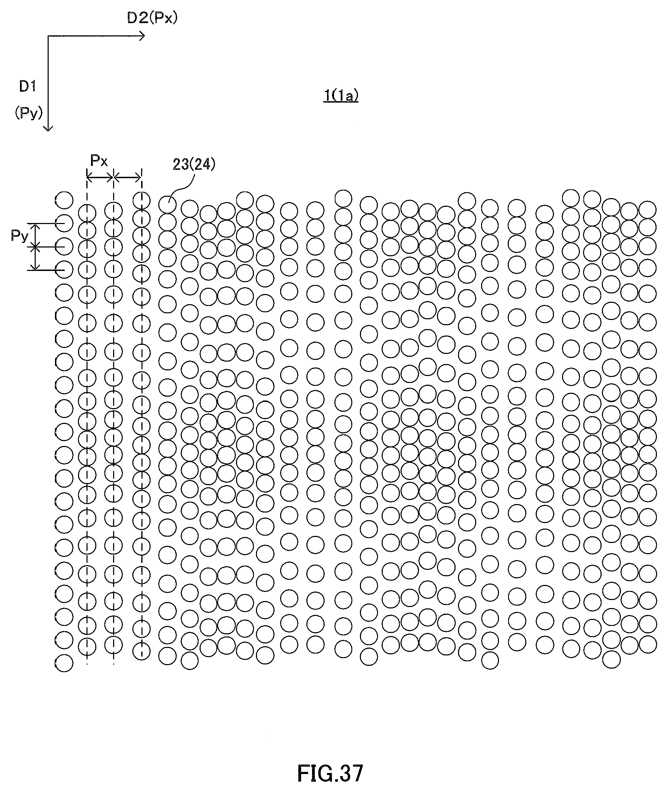

FIG. 37 is a plan schematic diagram illustrating the optical substrate PC according to this Embodiment. As shown in FIG. 37, the dots (convex portions 34 or concave portions 24) form a plurality of dot lines (convex-portion lines 23-1 to 23-N or concave-portion lines 24-1 to 24-N as shown in FIG. 35 or 36, respectively) in which a plurality of dots is arranged with pitches Py of inconstant intervals in a first direction D1 inside the main surface of the substrate body 21 or 21 a of the optical substrate PC1 or PC1a. Further, respective dot lines are arranged at inconstant intervals Px in a second direction D2 orthogonal to the first direction D1 inside the main surface of the substrate body 21 or 21a, respectively.

Further, the two-dimensional photonic crystal is made by one or both of periodical increase/decrease of the pitch Py of the inconstant interval between dots in the first direction D1 and periodical increase/decrease of the pitch Px that is an interval between dot lines at inconstant intervals in the second direction D2 orthogonal to the first direction D1. By increasing and decreasing the pitch Py that is the interval between dots or increasing and decreasing the pitch Px that is the interval between dot lines, it is possible to form the two-dimensional photonic crystal controlled by the pitch between dots. Because the size and pitch of each dot is equal to or less than the wavelength of the emitted light, the existence of each dot is optically substituted by the effective refractive index Nema due to effective medium approximation. In FIG. 37, since the pitch Py of the inconstant interval between dots periodically increases and decreases in the first direction D1, the light senses the period of periodical increase/decrease in the pitch Py of the inconstant interval due to the above-mentioned effective medium approximation, and exhibits the behavior equal to that as if a larger concavo-convex structure exists.

In other words, in FIG. 37, in the two-dimensional photonic crystal comprised of the nano-structure body due to concavities and convexities of nano-order, a two-dimensional photonic crystal having a period larger than the concavo-convex structure body is configured. In other words, in depositing the semiconductor crystal layer, by dispersing and decreasing dislocations due to the concavities and convexities of nano-order, it is possible to improve the internal quantum efficiency. Then, in using the semiconductor light emitting device, since the emitted light of the semiconductor light emitting device exhibits the optical behavior with respect to the two-dimensional photonic crystal, it is possible to effectively overcome the waveguide mode, and to increase the light extraction efficiency.

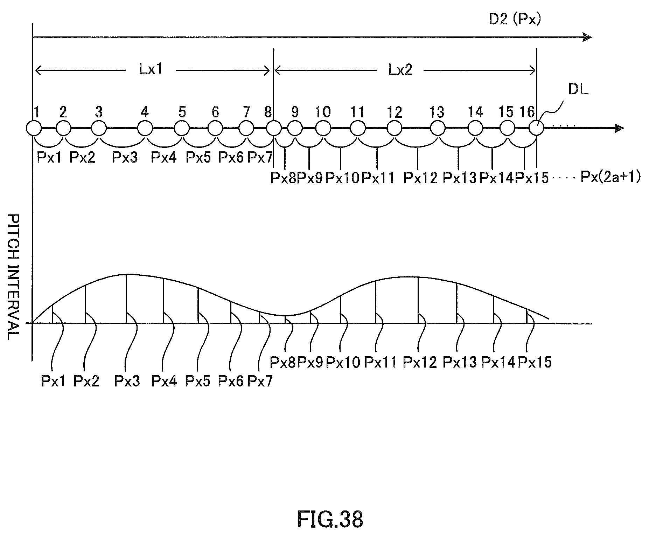

An arrangement example of dot lines arranged at inconstant intervals with mutually different pitches Px in the second direction D2 will be described more specifically. In addition, the pitch Px is an interval in the second direction D2 of dot lines arranged in the first direction D1 i.e. an interval between dot lines. FIG. 38 is a schematic diagram showing an arrangement example of dot lines in the second direction D2 of the optical substrate PC according to this Embodiment. As shown in FIG. 38, the dot lines (shown by DL in FIG. 38) in the second direction D2 are arranged at particular intervals (pitches Px) every eight lines, and the eight dot lines are repeatedly arranged. A unit comprised of the plurality (z) of dot lines is referred to as a long-term unit Lxz (in addition, z is a positive integer). In this Embodiment, it is necessary that the long-term unit Lxz is two or more times the light emission wavelength of the semiconductor light emitting device. In addition, also with respect to dots in the first direction D1 arranged at inconstant intervals with mutually different pitches Py, it is possible to arrange the dots as in the following description using a long-term unit Lyz. That is, it is possible to replace the pitch Px as described below with the pitch Py.

The pitch Px is a distance between adjacent dot lines. Herein, the relationship of the following equation (2) holds for pitches Pxn among at least adjacent four to m dot lines or less ($3 \leq n \leq 2a$ or $3 \leq n \leq 2a+1$. In addition, m and a are positive integers and n=m-1.) in the long-period unit Lxz.

$$Px1 < Px2 < Px3 < \cdots < Pxa > \cdots > Pxn \qquad (2)$$

In addition, the diameter of each dot is smaller than the pitch Pxn. The length of from the pitch Px1 to Pxn constitutes the long-period unit Lxz. In addition, the dot diameter is the convex-portion bottom portion circumscribed circle diameter Φout.

FIG. 38 shows the case where the long-period unit Lxz is comprised of eight dot lines e.g. the case of m=8. In this case, since n=7 and a=3, in the long period Lx1, the relationship of the following equation (3) holds for the pitches Pxn among dot lines.

$$Px1 < Px2 < Px3 > Px4 > Px5 > Px6 > Px7 \qquad (3)$$

Further, the pitches X in the long-period unit Lxz are set so that the maximum phase deviation δ expressed by a difference between the maximum value (Px(max)) and the minimum value (Px(min)) of the pitch Px meets (Px(min))x0.01<δ<(Px(min))x0.66, preferably (Px(min))x0.02<δ<(Px(min))x0.5, and more preferably (Px(min))x0.1<δ<(Px(min))x0.4.

For example, in the long period Lx1 as shown in FIG. 38, the pitch Pxn between respective dot lines is expressed as described below.

$$Px1 = Px(min)$$

$$Px2 = Px(min) + \delta a$$

$$Px3 = Px(min) + \delta b = Px(max)$$

$$Px4 = Px(min) + \delta c$$

$$Px5 = Px(min) + \delta d$$

$$Px6 = Px(min) + \delta e$$

$$Px7=Px(min)+\delta f$$

In addition, values of $\delta a$ to $\delta f$ meet $Px(min)\times0.01<(\delta a\sim sf)<Px(min)\times0.5$, and are the same as in an adjacent long period Lx2.

Further, the maximum value of z in the long-period unit Lxz or long-period unit Lyz is set so as to meet $4\leq z\leq1,000$, preferably $4\leq z\leq100$, and more preferably $4\leq z\leq20$.

In addition, the long-period units Lxz and Lyz in the first direction D1 and second direction D2 do not need to be the same as each other.

In the optical substrates PC1 and PC1a according to this Embodiment, it is preferable that at least one or more dot groups having the above-mentioned long-period unit Lyz are arranged in the first direction D1, and that at least one or more dot line groups having the above-mentioned long-period unit Lxz are arranged in the second direction D2.

The arrangement arranged at inconstant intervals with pitches Py is defined by replacing the dot lines with dots in the arrangement example of dot lines in the second direction D2 arranged at inconstant intervals with mutually different pitches Px as described above to read.

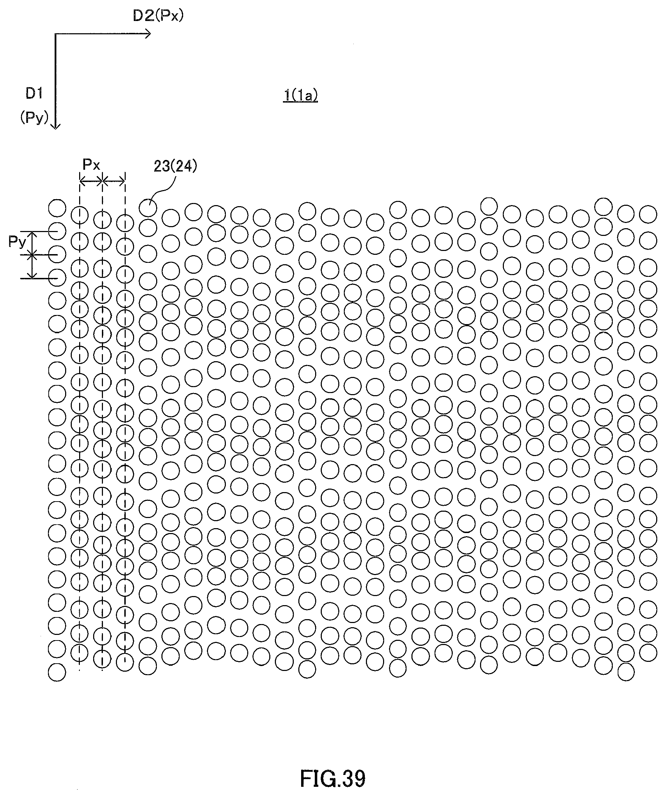

In the optical substrates PC1 and $PC1_A$ according to this Embodiment, the dots constituting the fine structure of the fine structure layer 22 (22a) can be arranged with pitches Px and Py of inconstant intervals as described above in both the first direction D1 and the second direction D2 (see FIG. 37), and can also be arranged with pitches of inconstant intervals as described above in one of the first direction D1 and the second direction D2, while being arranged with pitches of constant intervals in the other direction (see FIG. 39). In addition, in FIG. 39, the dots in the first direction D1 are arranged at inconstant intervals, and the dot lines in the second direction D2 are arranged at constant intervals. That is, FIG. 39 is the case where the pitch Py is the inconstant interval, and the pitch Px is the constant interval.

The two-dimensional photonic crystal as shown in FIGs. 37 to 39 is the two-dimensional photonic crystal formed of non-periodical dots, and in the optical substrates PC1 and PC1a according to this Embodiment, a pattern arrangement of dots constituting the two-dimensional photonic crystal may be periodical. Since the periodicity of each dot is cancelled by the effective medium approximation as described above, the long-term unit Lxz is necessary to develop the effects of the present invention. Therefore, the effect due to the long-term unit Lxz is higher than in periodicity/non-periodicity of each dot.

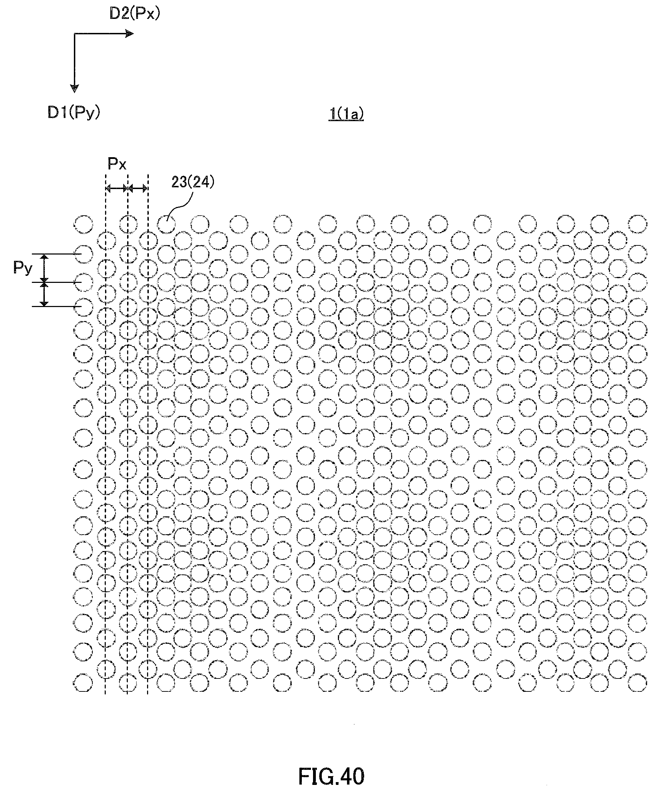

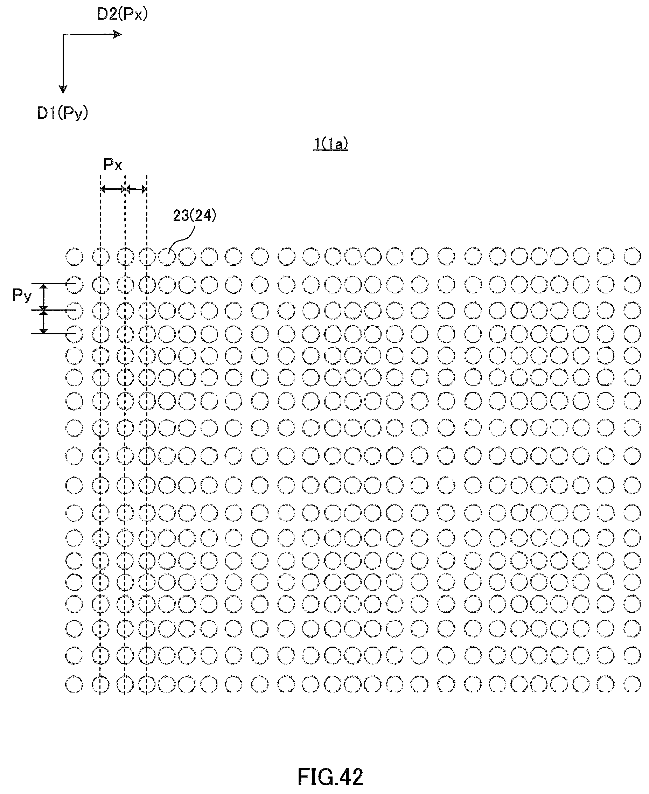

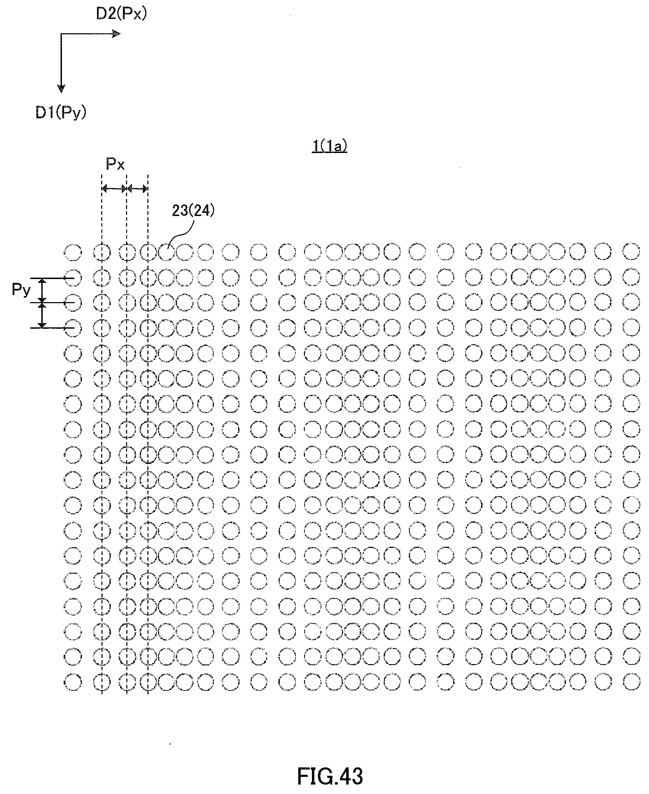

As an example of the periodical dot pattern, examples thereof are FIGs. 40 to 43. FIGs. 40 to 43 are plan schematic diagram showing another examples of the optical substrate PC according to this Embodiment. These arrangement examples are arrangements in which adjacent first and second dot lines or first and third dot lines are aligned, and the dot pattern is periodical.

Further, in the optical substrates PC1 and PC1a according to this Embodiment, the two-dimensional photonic crystal due to the dot pattern preferably has at least a period two or more times the emission center wavelength in the one-dimensional direction of the substrata main surface, and specifically, is the two-dimensional photonic crystals as shown in FIGs. 39, 41 and 43.

Furthermore, in the optical substrates PC1 and PC1a according to this Embodiment, the two-dimensional photonic crystal due to the dot pattern is preferably periodical at least in independent two axis directions, and specifically, is the two-dimensional photonic crystals as shown in FIGs. 37, 40 and 42.

The arrangements as shown in FIGs. 37, 40 and 42 are of the example in which the independent two axis directions are mutually orthogonal, but the directions do not need to be always orthogonal, and may be arranged at an optical angle. Further, a pattern arrangement in independent three axis directions may be adopted, and in this case, it is possible to make the two-dimensional photonic crystal formed of the density of dots a triangle lattice arrangement.

Further, in the case of an arrangement in which the dot interval in the first direction D1 or the dot line interval in the second direction D2 is a constant interval, the ratio of the pitches of inconstant intervals to the pitch of the constant interval is preferably in a particular range.

Herein, described is an example in which dots in the first direction D1 are arranged with a pitch Pyc of the constant interval and dot lines in the second direction D2 are arranged with Px of inconstant intervals. In this case, it is preferable that the ratio of the pitches Px of the inconstant intervals to the pitch Pyc of the constant interval is in a range of 85% to 100%. When the ratio of the pitches Px of inconstant intervals to the pitch Pyc of the constant interval is 85% or more, overlapping of adjacent dots is small, and therefore, such ratios are preferable. Further, when the ratio of the pitches Px of inconstant intervals to the pitch Pyc of the constant interval is 100% or less, the filling rate of the convex portions 23 constituting the dots improves, and therefore, such ratios are preferable. In addition, it is more preferable that the ratio of the pitches Px of inconstant intervals to the pitch Pyc of the constant interval is in a range of 90% to 95%.

Further, when one long-period unit Lxz or Lyz is comprised of five or more dots i.e. the number of pitches Px or Py belonging thereto is four or more, long-period variations in the effective refractive index Nema go away from nano-order, light scattering tends to occur, and therefore, such a case is preferable. On the other hand, in order to obtain sufficient light extraction efficiency LEE, it is preferable that the long-period unit Lxz or Lyz is comprised of 1,001 or less dots i.e. pitches Px or Py belonging thereto is 1,000 or less.

In the optical substrates PC1, PC1a according to this Embodiment, by the two-dimensional photonic crystal being formed which meets the relationship of the fine structure of fine structure layers 22, 22a as described above, the light scattering effect is sufficient, and since the interval between dots (convex portions 23 or concave portions 24) is decreased, the effect of reducing dislocation defects is produced. In other words, in manufacturing the semiconductor light emitting device, by the high-density concavo-convex structure of nano-order existing as an entity, the internal quantum efficiency IQE and electron injection efficiency EIE are improved. Further, in using the semiconductor light emitting device, light scattering properties are added which are strengthened due to the two-dimensional photonic crystal recognizable by light, and it is possible to improve the light extraction efficiency LEE.

Further, in spite of the photonic crystal, its light diffraction properties are suppressed, and get closer to Lambertian emission suitable for industrial uses.

Described next are dot shapes (concavo-convex structures) constituting the two-dimensional photonic crystal of the fine structure layers 22, 22a of optical substrates PC1, PC1a according to this Embodiment, respectively. The shapes of the convex portion 23 and concave portion 24 are not limited particularly within a range in which the effects of the present invention are obtained, and are capable of being modified as appropriate according to a use. As the shapes of the convex portion 23 and concave portion 24, it is possible to adopt the shapes described in «Optical substrate PP» or «Optical substrate D». Further, it is preferable to adopt the shapes described as being high in the effect of improving the internal quantum efficiency IQE from the same reason among the shapes in «Optical substrate PP» or «Optical substrate D».

The case as described above is the case where the two-dimensional photonic crystal in the present invention is configured by the intervals of dots, and the crystal may be configured by sizes of dot diameters. Specifically, in the dot shapes (concavo-convex structures) constituting the fine structures of the fine structure layers 22, 22a of the optical substrates PC1, PC1a according to this Embodiment, it is preferable that the diameter of each of dots increases/decreases corresponding to the pitch Py and/or the pitch Px. In addition, in consideration of correlation between the pitch and the dot diameter, the dot diameter increasing or decreasing corresponding to the pitch may be positive or negative in its correlation coefficient.

An example of the dot diameter increasing or decreasing corresponding to the pitch will specifically be described below. In addition, the dot diameter is the convex-portion bottom portion circumscribed circle diameter Φout as described in «Optical substrate PP». In the optical substrates PC1 and PC1a according to this Embodiment, it is preferable that when the pitch Py is the inconstant interval, dot diameters Dyn of at least adjacent four dots to m dots or less ($3 \leq n \leq 2a$ or $3 \leq n \leq 2a+1$. In addition, m and a are positive integers and n=m-1.) forming the pitch meet the relationship of the following equation (4) while dot groups formed with the dot diameters Dy1 to Dyn are repeatedly arranged in the long-period unit Lyz in the first direction D1, and that when the pitch Px is the inconstant interval, dot diameters Dxn of at least adjacent four dots to m dots or less ($3 \leq n \leq 2a$ or $3 \leq n \leq 2a+1$. In addition, m and a are positive integers and n=m-1.) forming the pitch meet the relationship of the following equation (5) while dot groups formed with the dot diameters Dx1 to Dxn are repeatedly arranged in the long-period unit Lxz in the second direction D2. In this Embodiment, the long-period units Lxz and Lyz need to be two or more times the emission center wavelength of the semiconductor light emitting device.

$$Dy1 < Dy2 < Dy3 < \cdots < Dya > \cdots > Dyn \qquad (4)$$

$$Dx1 < Dx2 < Dx3 < \cdots < Dxa > \cdots > Dxn \qquad (5)$$

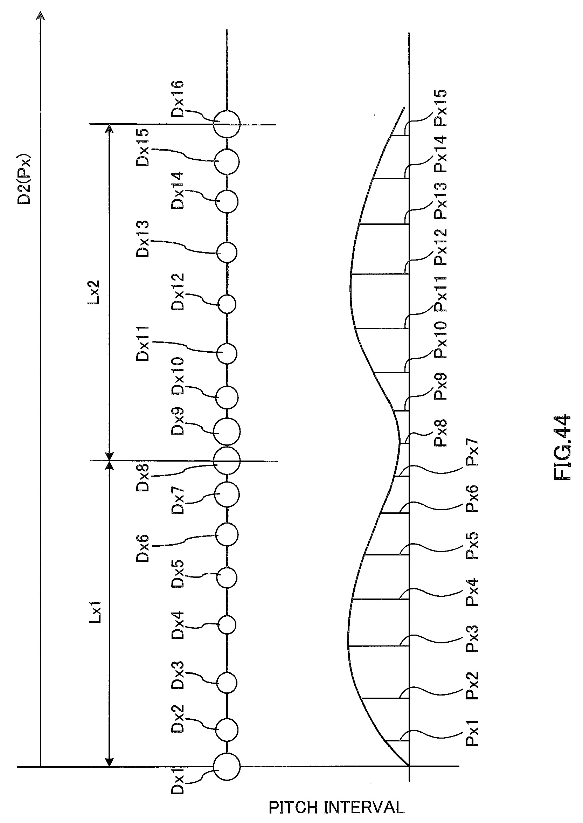

FIG. 44 shows the case where the long-period unit Lxz is comprised of eight dot lines i.e. the case of m=8. FIG. 44 is a schematic diagram showing an arrangement example of dot lines in the second direction D2 of the optical substrate PC according to this Embodiment. In this case, since n=7 and a=3, in the long period Lx1, the relationship of the above-mentioned equation (5) holds for the diameter Dxn of each of dots forming the dot line.

In FIG. 44, when the interval between adjacent dots widens, the dot diameter decreases, and when the dot interval narrows, the dot diameter increases. In the increase/decrease range in which the dot diameter increases and decreases, the upper limit value is determined from the viewpoint of growth properties of the semiconductor crystal layer, and the lower limit value is determined from the viewpoint of scattering properties with respect to light. In the case of within ±20% with respect to the average diameter of dots in the same long-period unit Lxz, light extraction efficiency increases, and such a case is preferable.

By the above-mentioned configuration, the volume of dots increases or decreases in the long-term unit Lxz, and the two-dimension photonic crystal is configured. This is because it is possible to represent the effective medium approximation simply by the volume fraction of the distribution of dielectric constant, and the dielectric constant is the square of the refractive index. In other words, by the volume of the medium changing in the long-period unit Lxz, the effective refractive index Nema changes in the long-period unit Lxz.

Since the two-dimensional photonic crystal is formed which has a period two or more times the emission center wavelength, light scattering properties are increased with respect to the emitted light, and the light extraction efficiency LEE is increased in the semiconductor light emitting device.

The period of the two-dimensional photonic crystal of the present invention preferably has a period two times or more the emission center wavelength of the obtained semiconductor light emitting device, the period of five times or more increases the light scattering properties with respect to the emitted light and therefore, is preferable, and in the case where the period is 10 times or more, since the angle dependence of the emission light distribution decreases and gets closer to the Lambertian type, and therefore, such a case is preferable.

Described next is an example in which the two-dimensional photonic crystal is controlled by the dot height in the optical substrates PC1 and PC1a according to this Embodiment.

In the optical substrates PC1 and PC1a according to this Embodiment, it is preferable that the height of each of dots in the dot shapes (concavo-convex structures) constituting the fine structures of the fine structure layers 22, 22a increases or decreases corresponding to the pitch Py and/or pitch Px in synchronization with the above-mentioned two-dimensional pattern. In addition, in consideration of correlation between the pitch and the dot height, the height of the dot which increases or decreases corresponding to the pitch may be positive or negative in its correlation coefficient.

An example of the dot height increasing or decreasing corresponding to the pitch will specifically be described below. In addition, the dot height is the height H as described in «Optical substrate PP».

In the optical substrates PC1 and PC1a according to this Embodiment, it is preferable that when the pitch Py is the inconstant interval, dot heights Hyn of at least adjacent four dots to m dots or less ($3 \leq n \leq 2a$ or $3 \leq n \leq 2a+1$. In addition, m and a are positive integers and n=m-1.) forming the pitch meet the relationship of the following equation (6) while dot groups formed with the dot heights Hy1 to Hyn are repeatedly arranged in the long-period unit Lyz in the first direction D1, and that when the pitch Px is the inconstant interval, dot heights Hxn of at least adjacent four dots to m dots or less ($3 \leq n \leq 2a$ or $3 \leq n \leq 2a+1$. In addition, m and a are positive integers and n=m-1.) forming the pitch meet the relationship of the following equation (7) while dot groups formed with the dot heights Hx1 to Hxn are repeatedly arranged in the long-period unit Lxz in the second direction D2. In this Embodiment, the long-period units Lxz and Lyz need to be two or more times the emission center wavelength of the semiconductor light emitting device.

$$Hy1 < Hy2 < Hy3 < \cdots < Hya \cdots > Hyn \quad (6)$$

$$Hx1 < Hx2 < Hx3 < \cdots < Hxa \cdots > Hxn \quad (7)$$

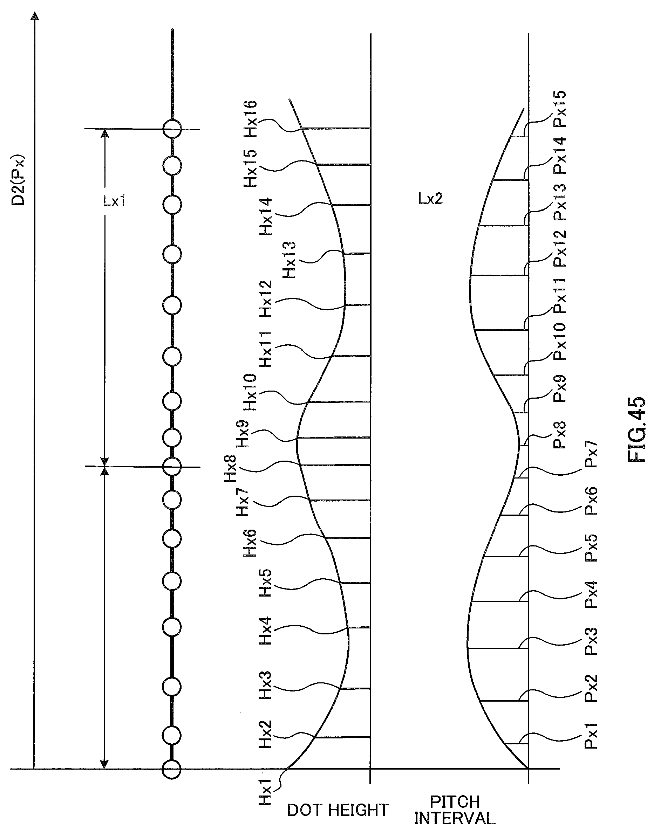

FIG. 45 shows the case where the long-period unit Lxz is comprised of eight dot lines i.e. the case of m=8. FIG. 45 is a schematic diagram showing an arrangement example of dot lines in the second direction D2 of the optical substrate PC according to this Embodiment. In this case, since n=7 and a=3, in the long period Lx1, the relationship of the above-mentioned equation (7) holds for the height Hxn of each of dots forming the dot line.

In FIG. 45, when the interval between adjacent dots widens, the dot height decreases, and when the dot interval narrows, the dot height increases. In the increase/decrease range in which the dot height increases and decreases, the upper limit value is determined from the viewpoint of fluctuations in the light extraction efficiency LEE, and the lower limit value is determined from the viewpoint of degree of increases in light extraction efficiency caused by increase/decrease of the dot height. In the case of within ±20% with respect to the average height of dots in the same long-period unit Lxz, light extraction efficiency increases without fluctuations, and therefore, such a case is preferable.

By the above-mentioned configuration, the volume of dots increases or decreases in the long-term unit Lxz, and the two-dimension photonic crystal is configured. This is because it is possible to represent the effective medium approximation simply by the volume fraction of the distribution of dielectric constant, and the dielectric constant is the square of the refractive index. In other words, by the volume of the medium changing in the long-period unit Lxz, the effective refractive index Nema changes in the long-period unit Lxz.

Since the two-dimensional photonic crystal is formed which has a period two or more times the emission center wavelength, light scattering properties are increased with respect to the emitted light, and the light extraction efficiency LEE is increased in the semiconductor light emitting device.

In the examples described using FIGs. 44 and 45 as described above, the case is described where the dot interval and the dot diameter or dot interval and dot height change at the same time. Herein, the essence to form the two-dimensional photonic crystal is the distribution of effective refractive index Nema. From this viewpoint, the element of the fine structure of the fine structure layer 22 or 22a to form the two-dimensional photonic crystal is capable of being selected from among elements of the concavo-convex structure plate PP or concavo-convex structure D as described in «Optical substrate PP» or «Optical substrate D». Among the elements, the two-dimensional photonic crystal is formed due to the difference in the dot interval, dot diameter or dot height as described already, the volume change of the dots thereby increases to strengthen optical scattering properties, and therefore, such elements are preferable. Particularly, in the case of forming the two-dimensional photonic crystal by the dot interval, dot diameter and dot height concurrently changing, the intensity of optical scattering properties is most increased.

In addition, with respect to the difference in the element of the fine structure of the fine structure layer 22 or 22a forming the two-dimensional photonic crystal as described above, in the difference using expression of periodical, the split phenomenon of laser beam is sometimes observed as described in above-mentioned «Optical substrate PP». Particularly, also in the optical substrate PC, by the split of laser beam being observed, the degree of increases in light extraction efficiency LEE is more increased, and therefore, such a phenomenon is preferable.

As described above, it has been considered that the effective refractive index Nema forms the distribution due to the difference in the element of the fine structure of the fine structure layer 22 or 22a forming the two-dimensional photonic crystal, the two-dimensional photonic crystal is thereby formed and that optical scattering properties are developed. Further, it has been verified that the optical scattering properties are strengthened by forming the two-dimensional photonic crystal by changing the element of the fine structure of the fine structure layer 22 or 22a. Herein, since it is possible to consider that the occurrence of change in the effective refractive index Nema is the essence, in order to form the two-dimensional photonic crystal, it is possible to presume that the optical scattering properties are capable of being developed strongly due to kinds of materials constituting the fine structure, as well as the shape, interval and the like of the fine structure of the fine structure layer 22 or 22a as described. That is, it is conceivable that it is possible to effectively form the two-dimension photonic crystal also by regarding the dot interval, dot diameter or dot height as described as a disturbance in materials forming the fine structure, particularly, the refractive index or extinction coefficient of materials forming the fine structure. Particularly, in considering that the optical substrate PC is applied to a semiconductor light emitting device, it is conceivable that it is preferable to use the difference in the refractive index of materials forming the fine structure, from the viewpoint of increasing the light extraction efficiency LEE. Further, it is not hard to conceive that a difference of the extent of behavior of light due to the refractive index is important in strengthening the optical scattering properties due to the difference in the refractive index of the material. In calculating from this viewpoint, in the difference in the refractive index of materials forming the fine structure of the fine structure layer 22 or 22a, the difference in the refractive index is preferably 0.07 or more, and more preferably 0.1 or more. This is because it is thereby possible to increase the difference as the substance recognizable by light, and to effectively form the two-dimensional photonic crystal. Particularly, from the viewpoint of more strengthening the optical scattering properties, it is presumed that the difference in the refractive index is more preferably 0.5 or more. In addition, the difference in the refractive index is preferably larger, and most preferably 1.0 or more.

Further, in the optical substrates PC1 and PC1a according to this Embodiment as described above, it is preferable that each of the pitch Px and the pitch Py ranges from 100 nm to 1,000 nm. When the pitches Px and Py are in this range, the concavities and convexities of nano-order are provided on the surface of each of the optical substrates PC1 and PC1a, and it is thereby possible to decrease the number of dislocation defects inside the semiconductor crystal layer in the case where the semiconductor crystal layer is provided on the surface of each of the optical substrates PC1 and PC1a. By the pitches Px and Py being 100 nm or more, the light extraction efficiency LEE of the semiconductor light emitting device increases, and the effect of reducing dislocation defects appears which contributes to improvements in luminous efficiency. Further, by the pitches Px and Py being 1,000 nm or less, the effect of decreasing the number of dislocation defects is maintained.

It is possible to verify the two-dimensional photonic crystals according to this Embodiment as shown in FIGs. 37 to 45 as described above by observing their surface structures with analysis equipment such as a scanning electron microscope and atomic force microscope having a resolution of nano-order. Particularly, use of the scanning electron microscope is desirable, in terms of clearly observing the change in the fine structure of the fine structure layer 22 or 22a. By observation using the scanning electron microscope, it is possible to clarify that dots of nano-order existing as an entity have the long-period unit, and to clarify the relationship between the long period and the emission center wavelength.

Described next are the principles in which the light extraction efficiency LEE is increased by the optical substrates PC1 or PC1a according to this Embodiment.

As described already, by providing the two-dimensional photonic crystal layer comprised of dots of nano-order on the optical substrate PC1 or PC1a, it is possible to obtain the effect of improving the light extraction efficiency LEE due to resolution of the waveguide mode by light scattering.

By repeatedly setting the long-period unit Lxz comprised of a plurality of dots, the refractive index changes for each long-period unit Lxz, and the same effect is exerted as in the case where a plurality of dots forming the long-period unit Lxz is repeated as a single unit. In other words, in the case of a plurality of dots of the same order as the wavelength, since it is possible to explain the behavior of light by the distribution of effective refractive index Nema, in calculating the distribution of spatial effective refractive index Nema, light acts as if a plurality of dots of the long-period unit Lxz is repeated as a single unit. A plurality of dots thus arranged in the long-period unit Lxz exhibits the light scattering effect.

Further, in the optical substrates PC1 and PC1a according to this Embodiment, the diameter of each of dots increases or decreases corresponding to the pitch. The distribution of spatial effective refractive index Nema changes, while depending on the volume fraction of the configuration unit. Therefore, in a plurality of dots of the long-period unit Lxz, the distribution of effective refractive index is changed corresponding to the change in the volume of each dot. In other words, as the volume change of each dot is increased, the light scattering effect is more increased even in the same long-period unit Lxz. This effect is remarkable by decreasing the dot diameter when the dot interval is narrow, or increasing the dot diameter when the dot interval is wide. In addition, by increasing the dot diameter when the dot interval is narrow, or decreasing the dot diameter when the dot interval is wide, since the degree of the volume change is decreased in the fine structure existing as an entity, the crack reducing effect is increased in depositing the semiconductor crystal layer.

Furthermore, in the optical substrates PC1 and PC1a according to this Embodiment, the height of the dot also increases or decreases corresponding to the pitch between dots. Also in this case, from the same reason as described above, by decreasing the dot height when the dot interval is narrow, or increasing the dot height when the dot interval is wide, the distribution of effective refractive index Nema inside the long-period unit Lxz is large, and the light scattering effect is increased. In addition, by increasing the dot height when the dot interval is narrow, or decreasing the dot height when the dot interval is wide, since the degree of the volume change is decreased in the fine structure existing as an entity, the crack reducing effect is increased in depositing the semiconductor crystal layer.

Still furthermore, in the arrangement in which the long-period unit Lxz comprised of a plurality of dots is repeatedly arranged, in the case of increasing or decreasing both the diameter of each of the dots and the height of the dot as described above corresponding to the pitch, the difference in the refractive index distribution described by effective medium approximation is further increased, and such a case is preferable. In this case, by decreasing the dot diameter and the dot height when the dot interval is narrow, or increasing the dot diameter and the dot height when the dot interval is wide, in the distribution of spatial effective refractive index Nema, the difference in the volume fraction of the configuration unit is large, the light scattering effect is further increased, and such a case is preferable. In addition, by increasing the dot diameter and the dot height when the dot interval is narrow, or decreasing the dot diameter and the dot height when the dot interval is wide, since the degree of the volume change is decreased in the fine structure existing as an entity, the crack reducing effect is increased in depositing the semiconductor crystal layer.

In the optical substrates PC1 and PC1a according to this Embodiment, as materials of the substrate bodies 21 and 21 a, it is possible to adopt the materials as described in <<Optical substrate PP».

In the semiconductor light emitting device according to this Embodiment, it is possible to adopt the semiconductor light emitting devices as described in «Optical substrate PP» and «Optical substrate D» with reference to FIGs. 2 to 6 and FIGs. 24 to 26. Herein, the optical substrate PP or the optical substrate D is replaced with the optical substrate PC to read.

Described next is a method of manufacturing the semiconductor light emitting device according to this Embodiment. In the method of manufacturing the semiconductor light emitting device according to this Embodiment, it is a feature to include at least a step of providing a semiconductor layer on the optical substrate PC1 or PC1a according to this Embodiment as described above.

As described above, an n-type semiconductor layer, light emitting semiconductor layer and p-type semiconductor layer are formed on the main surface side with the two-dimensional photonic crystal layer of the optical substrate PC1 or PC 1 a having the two-dimensional photonic crystal layer on the main surface. In the method of manufacturing the semiconductor light emitting device according to this Embodiment, it is essential to include the step of providing a semiconductor layer on the optical substrate PC1 or PC1a according to this Embodiment, and it is not necessary that the obtained semiconductor light emitting device includes the optical substrate PC1 or PC1a according to this Embodiment. More specifically, there is a method of removing the optical substrate PC1 or PC1a after providing the semiconductor crystal layer on the optical substrate PC1 or PC1a.

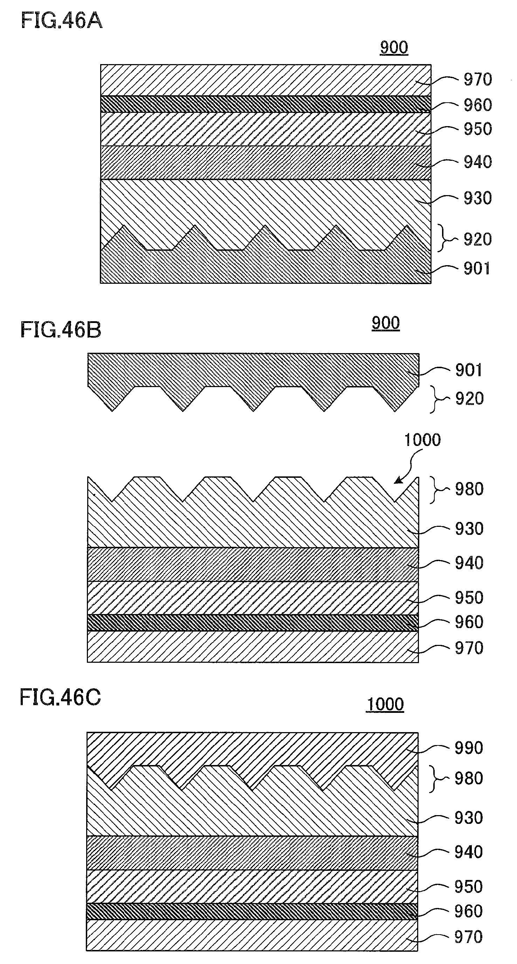

Each step of the method of manufacturing the semiconductor light emitting device according to this Embodiment will be described with reference to FIG. 46. In addition, the method of manufacturing the semiconductor light emitting device described with reference to FIG. 46 is applied also to «Optical substrate PP» and «Optical substrate D» as described above. That is, it is possible to replace the optical substrate PC described below with the optical substrate PP or optical substrate D to read. FIG. 46 contains cross-sectional schematic diagrams illustrating each step of the method of manufacturing the semiconductor light emitting device according to this Embodiment.

In an intermediate product 900 as shown in FIG. 46A, an n-type semiconductor layer 930, light emitting semiconductor layer 940 and p-type semiconductor layer 950 are sequentially layered on an optical substrate PC901 provided with a two-dimensional photonic crystal layer 920 on its surface according to this Embodiment. Further, a p electrode layer 960 and support product 970 are sequentially layered on the p-type semiconductor layer 950.

As the support product 970, it is possible to use a conductive substrate made of Si, Ge, GaAs, Fe, Ni, Co, Mo, Au, Cu, Cu-W or the like. Further, in FIG. 46A, the intermediate product 900 is a configuration to obtain conduction in the direction perpendicular to the device surface, and a parallel electrode type may be adopted. In this case, the support product 970 may be an insulating substrate. For junction between the support product 970 and the p-type semiconductor layer 950, it is possible to use metal eutectic such as Au-Sn, Au-Si, Ag-Sn-Cu, and Sn-Bi that is low-melting point metal, or also use an Au layer, Sn layer, Cu layer and the like that are not of low-melting point metal. In addition, a metal layer may directly be formed on the p electrode layer 960 as the support product by plating, sputtering, deposition or the like. Further, a backside electrode, not shown, may be provided on the surface that does not face the p electrode layer 960 of the support product 970.

From the intermediate product 900, as shown in FIG. 46B, by peeling (lift off) the optical substrate PC901, it is possible to obtain a semiconductor light emitting device 1000 in which a two-dimensional photonic crystal layer 980 that is inversion of the two-dimensional photonic crystal layer 920 is formed on the peeling surface of the n-type semiconductor layer 930. In this case, the structure of the two-dimensional photonic crystal layer 920 that is an inversion source is designed as appropriate so that the inverted two-dimensional photonic crystal layer 980 is suitable for the semiconductor light emitting device 1000 to obtain. In addition, the fine structure of the two-dimensional photonic crystal layer 920 that is the inversion source and the fine structure of the inverted two-dimensional photonic crystal layer 980 may match completely or may not match. Particularly, from the viewpoints of design versatility degree of the photonic crystal layer 980 and the external quantum efficiency EQE of the semiconductor light emitting device 1000, the transfer rate of the fine structure of the photonic crystal layer 980 to the fine structure of the photonic crystal layer 920 preferably ranges from 0% to 30%. In addition, in describing the height of the fine structure of the photonic crystal layer 920 as Hm and the height of the fine structure of the photonic crystal layer 980 as Ht, the transfer rate is defined as (Hm-Ht)/HmX100.

For peeling of the optical substrate PC901, for example, laser lift off, chemical lift off and the like is adopted. In the case of laser lift off, a laser to apply uses a wavelength that transmits the optical substrate PC901 and that does not transmit the n-type semiconductor layer 930. Further, in the case of chemical lift off, there is a method of layering a thin etching layer on the two-dimensional photonic crystal layer 920, and peeling off the optical substrate PC901 by chemical etching. In addition, in the case of adopting silicon as the optical substrate PC901, it is possible to dissolve the silicon easily to remove without layering the etching layer. Herein, by using the optical substrate PC, optical substrate PP or optical substrate D, it is possible to develop optical scattering properties due to the high-density concavo-convex structure PC, concavo-convex structure PP or concavo-convex structure D of nano-order. In other words, the concavo-convex structure PC, concavo-convex structure PP or concavo-convex structure D provided on the optical substrate PC, optical substrate PP or optical substrate D is sufficiently fine as compared with the concavo-convex structure of micro-order that is generally used. Therefore, it is possible to suppress physical damage on the n-type semiconductor layer 930 in lift off to remove the optical substrate PC901, optical substrate PP or optical substrate D. Further, increased is accuracy of the concavo-convex structure provided on the surface of the n-type semiconductor layer 930 after removing the optical substrate PC901, optical substrate PP or optical substrate D i.e. transfer accuracy of the concavo-convex structure of the optical substrate PC901, optical substrate PP or optical substrate D.

Next, in the semiconductor light emitting device 1000, as shown in FIG. 46C, an n electrode layer 990 is provided on the surface of the n-type semiconductor layer 930 including the two-dimensional photonic crystal layer 980.

A device process is further performed after the step of sequentially layering the semiconductor layers on the optical substrate PC901 according to this Embodiment or the step of lifting off the optical substrate 901 from the intermediate product 900 obtained as described above, and the electrode and the like are formed as appropriate to make the semiconductor light emitting device 1000.

Described next is a method of manufacturing the optical substrate PC901 according to this Embodiment. In addition, the manufacturing method as shown below is an example, and the method of manufacturing the optical substrate PC901 is not limited thereto.

For example, the optical substrate PC is manufactured by a transfer method. Herein, the transfer method is defined as the transfer method as described in «Optical substrate PP». At this point, as a mold, as well as using a cylindrical master mold as described below without change, it is possible to use a resin mold prepared by using the cylindrical master mold, mold made of nickel prepared from the resin mold, and the like.

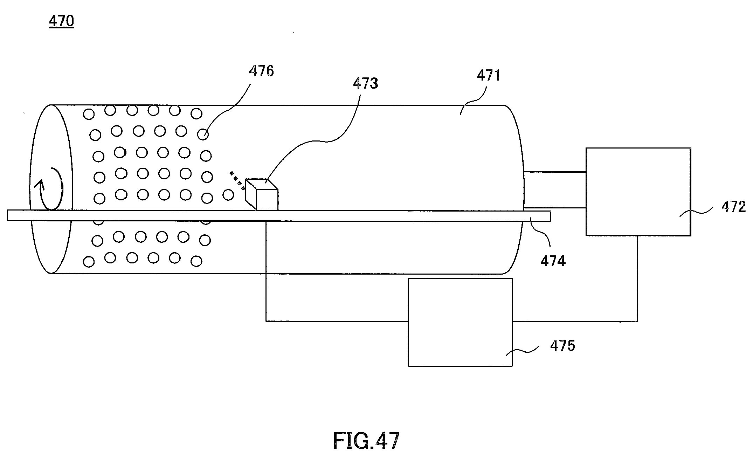

FIG. 47 is a schematic explanatory diagram showing an example of the method of manufacturing the optical substrate PC according to this Embodiment. As shown in FIG. 47, an exposure apparatus 470 grasps a roll-shaped member 471 coated with a resist layer with a roll grasp portion not shown, and is provided with a rotation control section 472, processing head portion 473, shift mechanism section 474, and exposure control section 475. The rotation control section 472 rotates the roll-shaped member 471 on the center of the roll-shaped member 471 as the axis. The processing head portion 473 applies laser light to expose the resist layer of the roll-shaped member 471. The shift mechanism section 474 shifts the processing head portion 473 at a control velocity along the long-axis direction of the roll-shaped member 471. The exposure control section 475 controls pulse signals of laser exposure by the processing head portion 473, based on a reference signal synchronized with rotation of the roll-shaped member 471 by the rotation control section 472.

Processing of the roll-shaped member 471 with the exposure apparatus 470 is performed by applying a pulse laser from the processing head portion 473, while rotating the roll-shaped member 471. The processing head portion 473 shifts along the long-axis direction of the roll-shaped member 471 by the shift mechanism 474, while applying the pulse laser. A pattern 476 is recorded at arbitrary pitches on the resist layer of the outer periphery of the roll-shaped member 471 in the rotation direction, from the number of revolutions of the roll-shaped member 471 and the frequency of the pulse laser. This is the pitch Py in the first direction D1 in a cylindrical master mold.

Further, since the scan is made along the long-axis direction of the roll-shaped member 471, when the roll-shaped member 471 rotates 360° once from an arbitrary position, the processing head portion 473 is shifted in the long-axis direction. This is the pitch Px in the second direction D2 in the cylindrical master mold. As compared with the circumference length of the roll-shaped member 471, the pitches Py and Px of the pattern 476 are of the order of nanometers and are thus extremely small, and therefore, it is possible to form the line-shaped pattern with the shift amount in the first direction D1 differing viewed in the long-axis direction, while maintaining the pitch Py in the first direction D1. Furthermore, as described above, since the pitches Py and Px of the pattern 476 are extremely small as compared with the circumference length of the roll-shaped member 471, the first direction D1 and the second direction D2 are substantially orthogonal.

The roll-shaped member 471 is obtained by providing the member formed in the shape of a cylinder with the rotating axis, and as the materials, it is possible to apply metal, carbon core, glass, quartz and the like. The roll-shaped member 471 needs processing precision permitting high rotation, and therefore, preferred as the materials are metal, carbon core and the like. Further, it is possible to coat only the cylindrical surface portion undergoing laser exposure with a different material. Particularly, when a heat-reactive resist is used, in order to enhance the heat insulation effect, it is preferable to apply materials with lower thermal conductivity than that of metal, and examples thereof are glass, quartz, oxide, nitride and the like. It is also possible to use the layer with which the cylindrical surface is coated as an etching layer to etch with a resist layer described later as a mask.

The resist to coat the roll-shaped member 471 is not limited particularly, as long as the resist is exposed to laser light, and it is possible to apply photocurable resists, light-amplification type resists, heat-reactive resists and the like. Particularly, heat-reactive resists allow pattern formation with wavelengths smaller than the wavelength of laser light, and are preferable.

As heat-reactive resists, organic resists or inorganic resists are preferable. The resist layer formed from these resists may be a single-layer structure, or may be multi-layer structure obtained by combining a plurality of resist layers. In addition, it is possible to change which resist to select as appropriate according to the process, required processing precision and the like. For example, organic resists allow coating with a roll coater or the like in forming a resist layer to coat the roll-shaped member 471, and the process is thereby easy. In addition, the viscosity of the resist is limited because of coating onto a sleeve, and it is difficult to obtain coating thickness accuracy and control or multi-layer coating.

As organic resists, as described in "Latest Resist Material Handbook" published by Johokiko Co., Ltd. and "Photo-polymer Handbook", Kogyo Chosakai Publishing Co., Ltd., examples thereof are novolac resins, mixtures of novolac resins and diazonaphthoquinone, methacrylate-based resins, polystyrene-based resins, polyethylene-based resins, phenol-based resins, polyimide-based resins, polyamide-based resins, silicone resins, polyester-based resins, epoxy-based resins, melamine-based resins, and vinyl-based resins.

On the other hand, inorganic resists are suitable for providing the resist layer to coat the roll-shaped member 471 by the resistance heating evaporation method, electron-beam sputtering method, vapor-phase method such as the CVD method or the like. Since these methods are basically of vacuum process, although the number of steps is required to form on the sleeve, it is possible to control the film thickness with accuracy, and it is easy to layer in multi-layer.

It is possible to select various inorganic resist materials corresponding to the reaction temperature. For example, among the inorganic resist materials are Al, Si, P, Ni, Cu, Zn, Ga, Ge, As, Se, In, Sn, Sb, Te, Pb, Bi, Ag, Au and their alloys. Further, as the inorganic resist materials, oxides, nitrides, nitrogen oxides, carbides, sulfides, sulfates, fluorides, and chlorides of Mg, Al, Si, Ca, Ti, V, Cr, Mn, Fe, Co, Ni, Cu, Zn, Ga, Ge, As, Se, Sr, Y, Zr, Nb, Mo, Pd, Ag, In, Sn, Sb, Te, Ba, Hf, Ta, W, Pt, Au, Pb, Bi, La, Ce, Sm, Gd, Tb and Dy, and mixtures of such compounds may be applied.

When a heat-reactive resist material is used as the resist to coat the roll-shaped member 471, before exposure to form the following pattern, preliminary heating may be performed on the resist to process the resist at a temperature lower than that in pattern formation. By applying preliminary heating, it is possible to improve the resolution in forming the pattern. Although details of the mechanism that the resolution is improved by preliminary heating are uncertain, in the case where a change in the material forming the resist layer by heat energy of the heat-reactive resist material is based on a plurality of reactions, it is presumed that the pattern formation reaction is made simple by beforehand finishing reactions except the reaction in pattern formation by preliminary heating, and that the pattern resolution is enhanced.

A method of preliminarily heating the resist to coat the roll-shaped member 471 is not limited particularly, and among the methods are a method of heating the entire roll-shaped member, a method of scanning the entire roll surface with lower output than in performing patterning on the roll-shaped member 471 with the laser to apply heat energy to the resist, and the like.

When a heat-reactive resist is used as the resist to coat the roll-shaped member 471, in the case of exposing with a pulse signal that is phase-modulated based on a reference signal synchronized with rotation described later, the diameter of each of dots forming the pattern increases or decreases corresponding to the pitch Py and/or pitch Px, and the heat-reactive resin is thus preferable. In the case of using the heat-reactive resist, although an explicit mechanism that the diameter of the dot increases/decreases corresponding to the pitch is uncertain, the mechanism is assumed as described below. In addition, when the dot is a convex-shaped body, the dot diameter is the convex-portion bottom portion circumscribed circle diameter Φout, and when the dot is a concave-shaped body, is an opening diameter of the concave-shaped body.

In the case of a heat-reactive resist, a change occurs in the material forming the resist layer by heat energy of a laser applied to an application portion, and a pattern is formed by etching characteristics changing. At this point, all of applied heat is not used in the change of the resist layer, and a part thereof is stored and transferred to an adjacent area. Therefore, heat energy in the adjacent area is provided with heat-transfer energy from the adjacent area in addition to application energy. In pattern formation of nano-order, a contribution of this heat-transfer energy is not neglected, the contribution of heat-transfer is inversely proportional to the distance between dots forming the pattern, and as a result, the obtained pattern diameter undergoes the effect of the interval between adjacent dots.

Herein, when the dot interval changes by phase modulation, the contribution of heat-transfer energy as described above varies for each dot. When the dot interval is wide, the contribution of heat-transfer energy is small, and the dot diameter decreases. When the dot interval is narrow, the contribution of heat-transfer energy is large, and the dot diameter thereby increases.

Further, in the case of using a heat-reactive resist as the resist to coat the roll-shaped member 471, providing the etching layer described later, and controlling the processing depth of the pattern, as in the same manner as described previously, when exposure is performed with a pulse signal that is phase-modulated based on a reference signal synchronized with rotation, the height of each of dots forming the pattern increases or decreases corresponding to the pitch Py and/or pitch Px, and therefore, such as case preferable. In the case of using the heat-reactive resist and etching layer together, although a mechanism that the height of the dot increases/decreases corresponding to the pitch Px is uncertain, it is possible to explain from the fact that the dot diameter increases/decreases corresponding to dot interval as described above.

That is, in patterning of nano-order, the etching depth increases or decreases corresponding to the dot diameter, and there is a tendency that the etching depth is deep when the dot diameter is wide, and that the etching depth is shallow when the dot diameter is narrow. Particularly, this tendency is remarkable when the etching technique is dry etching. It is conceivable this is because exchange of an etchant or removal of etching products is not carried out promptly.

As described previously, in using the heat-reactive resist, the dot diameter is small when the dot interval is wide, while the dot diameter is large when the dot interval is narrow. Since there is the tendency that the etching depth increases or decreases corresponding to the dot diameter, as a result, the dot depth is shallow when the dot interval is large, while the dot depth is deep when the dot interval is narrow.

The effects of increases/decreases in the dot interval, dot diameter and dot depth as described above are remarkable when the average pitch is small. It is presumed this is because the above-mentioned effect of heat-transfer energy is larger.

In this Embodiment, it is possible to apply as the cylindrical master mold without modification by using the resist layer to coat the roll-shaped member 471, or it is possible to form a pattern by etching the surface substrate of the roll-shaped member 471 using the resist layer as a mask.

By providing the etching layer on the roll-shaped member 471, it is possible to control the processing depth of the pattern freely, and to select a film thickness the most suitable for processing as the thickness of the heat-reactive resist. That is, by controlling the thickness of the etching layer, it is possible to control the processing depth freely. Further, it is possible to control the processing depth with the etching layer, and therefore, a film thickness easy to expose and develop may be selected for the heat-reactive resist layer.

The wavelength of a laser used in the processing head portion 473 to perform exposure preferably ranges from 150 nm to 550 nm. Further, in terms of miniaturization of wavelength and easiness of availability, it is preferable to use a semiconductor laser. The wavelength of the semiconductor laser preferably ranges from 150 nm to 550 nm. This is because when the wavelength is shorter than 150 nm, output of the laser is small, and it is difficult to expose the resist layer with which the roll-shaped member 471 is coated. On the other hand, this is because when the wavelength is longer than 550 nm, it is not possible to make the spot diameter of the laser 500 nm or less, and it is difficult to form a small exposed portion.

On the other hand, to form an exposed portion with a small spot size, it is preferable to use a gas laser as the laser used in the processing head portion 473. Particularly, in gas lasers of XeF, XeCl, KrF, ArF, and F2, the wavelengths are 351 nm, 308 nm, 248 nm, 193 nm and 157 nm and thus short, it is thereby possible to focus light on an extremely small spot size, and therefore, such lasers are preferable.

Further, as the laser used in the processing head portion 473, it is possible to use a second harmonic, third harmonic and fourth harmonic of a Nd:YAG laser. The wavelengths of the second harmonic, third harmonic and fourth harmonic of the Nd:YAG laser are respectively 532 nm, 355 nm, and 266 nm, and allow to obtain a small spot size.

In the case of forming a fine pattern in the resist layer provided on the surface of the roll-shaped member 471 by exposure, rotation position accuracy of the roll-shaped member 471 is significantly high, and manufacturing is made ease by first adjusting the optical system of the laser so that the member surface is in the focus depth. However, it is very difficult to hold roll dimension accuracy and rotation accuracy adapted to nanoimprint. Therefore, it is preferable that the laser used in exposure is concentrated with an objective lens and is set for autofocus so that the surface of the roll-shaped member 471 always exists in the focus depth.

The rotation control section 472 is not limited particularly, as long as the section is an apparatus having the function of rotating the roll-shaped member 471 on the center of the roll as the axis, and for example, a spindle motor or the like is suitable.

As the shift mechanism section 474 that shifts the processing head portion 473 in the long-axis direction of the roll-shaped member 471, the section 474 is not limited particularly, as long as the section is able to shift the processing head portion 473 at a controlled velocity, and suitable examples are a linear servo motor and the like.

In the exposure apparatus 470 as shown in FIG. 47, the exposure control section 475 controls the position of an exposed portion, using a pulse signal phase-modulated based on a reference signal such that the exposure pattern formed on the surface of the roll-shaped member 471 is synchronized with rotation (for example, rotation of a spindle motor) of the rotation control section 472. As the reference signal, it is possible to use an output pulse from an encoder synchronized with rotation of the spindle motor.

By the techniques as described above, it is possible to manufacture the cylindrical master mold. By controlling the pattern prepared on the surface of this cylindrical master mold, it is possible to manufacture the mold to manufacture the optical substrate PC of this Embodiment by the transfer method. Further, by applying the above-mentioned techniques, since it is also possible to easily manufacture the cylindrical master mold to manufacture the mold in manufacturing «Optical substrate PP» and «Optical substrate D» by the transfer method. Furthermore, by directly applying the above-mentioned techniques to the substrate body of the optical substrate PC, it is also possible to manufacture the optical substrate PC. Similarly, by directly applying to the substrate body of the optical substrate PP or the optical substrate D, it is also possible to manufacture the optical substrate PP or the optical substrate D.

As described above, by using the heat-reactive resist, it is possible to manufacture the cylindrical master mold provided with the dot diameter and dot height meeting negative correlation coefficients relative to a change in the pitch. Further, also in the case of transfer-forming a resin mold from the cylindrical master mold, these relationships are maintained.

Herein, in the case of processing the substrate body by applying the method of using the transfer material transfer-added to the target product described in «Optical substrate PP» using the prepared resin mold as a permanent material, or the nanoimprint lithography method, it is possible to make negative correlation between the pitch and the dot diameter (convex-portion bottom portion circumscribed circle diameter Φout) of the concavo-convex structure PC, concavo-convex structure PP or concavo-convex structure D provided on the substrate body.

On the other hand, in the case of preparing the sheet for nano-processing described in <<Optical substrate PP» using the prepared resin mold, and processing the substrate body using the sheet, it is possible to make positive correlation between the pitch and the dot diameter (convex-portion bottom portion circumscribed circle diameter Φout) of the concavo-convex structure PC, concavo-convex structure PP or concavo-convex structure D provided on the substrate body. This is because the mask layer spontaneously gathers in a small portion of the dot opening diameter with a large pitch in the mask layer forming step in preparing the sheet for nano-processing.

That is, in the optical substrate PC, optical substrate PP or optical substrate D, it is possible to control the relationship between the pitch and the convex-portion bottom portion circumscribed circle diameter Φout or between the pitch and the height to positive correlation or negative correlation to prepare. Which correlation is adopted is as described already.

For example, it is possible to control the pulse signal that is phase-modulated based on the reference signal synchronized with rotation as described below.

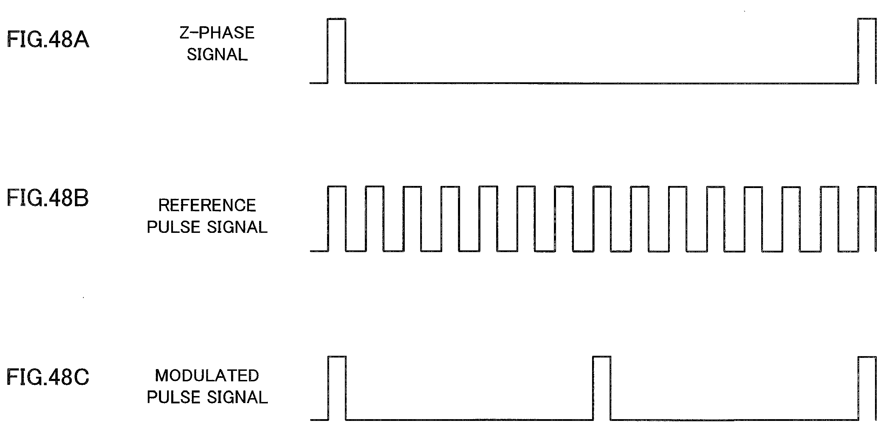

The relationship among a Z-phase signal of the spindle motor, reference pulse signal and modulated pulse signal will be described with reference to FIGs. 48A to 48C. FIG. 48 contains explanatory diagrams to explain an example of setting the reference pulse signal and modulated pulse signal using the Z-phase signal of the spindle motor as a reference signal in the exposure apparatus for forming the optical substrate PC according to this Embodiment. Using the Z-phase signal as the reference, a pulse signal with the frequency m times (integer of m>2) that of the signal is a reference pulse signal, and a pulse signal with the frequency n times (integer of m/n>k and k>1) that of the signal is a modulated pulse signal. Each of the reference pulse signal and the modulated pulse signal is an integral multiple of the frequency of the Z-phase signal, and therefore, the integral pulse signal exists during the time the roll-shaped member 471 rotates 360° once on the center axis.

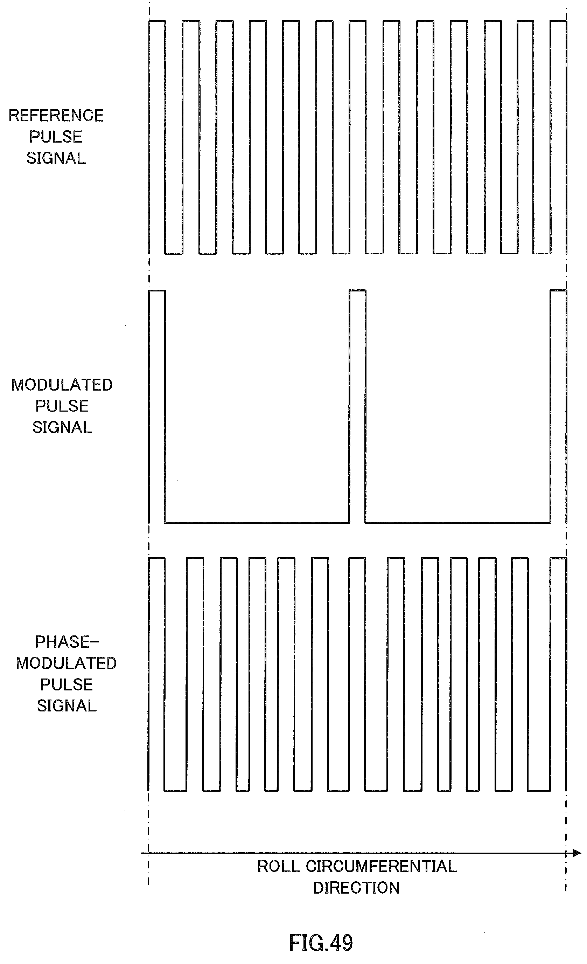

Subsequently, the relationship among the reference pulse signal, modulated pulse signal and phase-modulated pulse signal will be described with reference to FIG. 49. FIG. 49 is an explanatory diagram to explain an example of setting a phase-modulated pulse signal from the reference pulse signal and modulated pulse signal in the exposure apparatus for forming the optical substrate PC according to this Embodiment.

When the phase of the reference pulse signal is increased or decreased periodically with the wavelength of the modulated pulse signal, the signal is the phase-modulated pulse signal. For example, when a reference pulse frequency fY0 is expressed by the following equation (8) and a modulation frequency fYL is expressed by the following equation (9), the frequency-modulated modulated pulse signal fY is expressed by the following equation (10).

$$fY0 = A\sin(\omega 0 t + \Phi 0) \qquad (8)$$

$$fYL = B\sin(\omega 1 t + \Phi 1) \qquad (9)$$

$$fY = A\sin(\omega 0 t + \Phi 0 + C\sin(\omega 1 t)) \qquad (10)$$

Further, as expressed by the following equation (11), it is also possible to obtain a phase-modulated pulse signal fY' by adding a sine curve obtained from the modulated pulse signal to the reference pulse frequency fY0.

$$fY' = fY0 + C'\sin(t \cdot fYL/fY0 \times 2\pi) \qquad (11)$$

Furthermore, by adding a sine curve obtained from the wavelength LYL of the modulated pulse signal to the pulse wavelength LY0 of the reference pulse, it is possible to obtain the wavelength LY of the phase-modulated pulse signal.

As shown in FIG. 49, the obtained phase-modulated pulse signal is a signal such that the pulse interval of the reference pulse signal increases and decreases periodically corresponding to the signal interval of the modulated pulse signal.

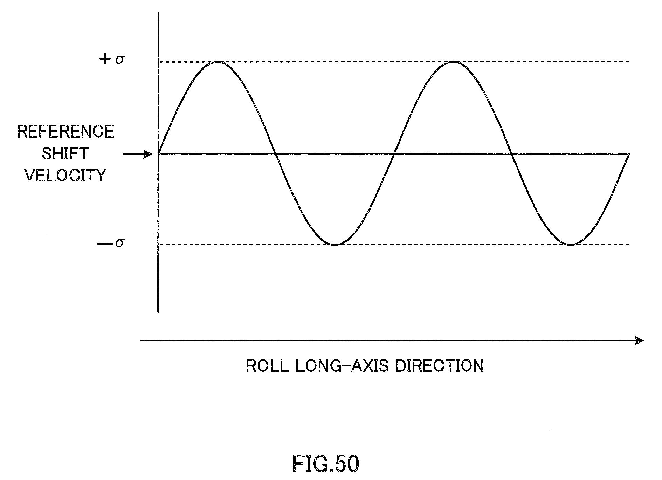

Further, in the exposure apparatus 470, it may be configured to control a pulse signal of laser exposure by the processing head portion 473 using a reference pulse signal with a certain frequency instead of the phase-modulated pulse signal, and to increase or decrease periodically the shift velocity of the processing head portion 473 by the shift mechanism section 474. In this case, for example, as shown in FIG. 50, the shift velocity of the processing head portion 473 is periodically increased or decreased. FIG. 50 is an explanatory diagram to explain an example of the shift velocity of the processing head portion that applies laser light in the exposure apparatus for forming the optical substrate PC according to this Embodiment. The shift velocity as shown in FIG. 50 is an example of the shift velocity of reference shift velocity ± σ. The shift velocity is preferably synchronized with rotation of the roll-shaped member 471, and for example, is controlled so that the velocity in the Z-phase signal is the velocity as shown in FIG. 50.

The above-mentioned description is of the case where the pattern 476 is controlled by periodical phase modulation, and it is also possible to form the pattern 476 by random phase modulation that is not periodical. For example, in the first direction D1, the pitch Py is inversely proportional to the pulse frequency. Therefore, when random frequency modulation is performed on the pulse frequency so that the maximum phase deviation is 1/10, the pitch Py has a maximum variable width δ1 that is 1/10 the pitch Py, and it is possible to obtain a pattern in which the pitch Py increases and decreases randomly.

For the control frequency of the reference signal synchronized with rotation, the modulated pulse signal may be controlled by the reference signal with a frequency of a plurality of times such as each one roll rotation, or may be controlled only by the initial reference signal set at the exposure initial time. In the case of controlling only by the initial reference signal, when modulation occurs in the number of revolutions of the rotation control section 472, phase modulation occurs in the exposure pulse signal. This is because of rotation control of nano-order, and therefore, even in a minute potential variation of the rotation control section 472, a pitch variation of nano-order occurs and is accumulated. In the case of a pattern pitch with a pitch of 500 nm, when the roll outer circumferential length is 250 mm, laser exposure is performed 500,000 times, and only a deviation of 1 nm every 10,000 times results in a deviation of 50 nm.

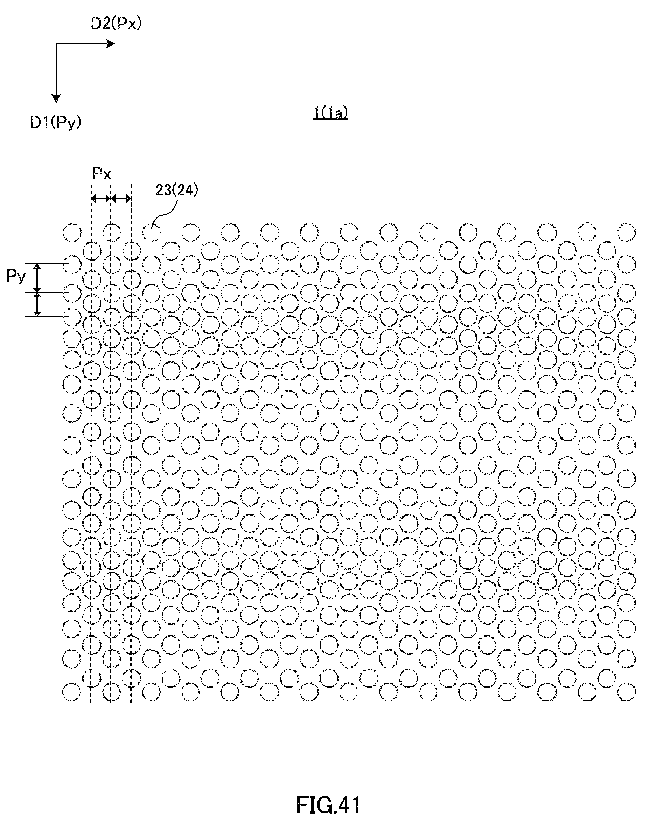

Also in the same pitch and same long period, by adjusting the control frequency of the reference signal, it is possible to prepare the fine structure with the arrangement as shown in FIG. 37 or 40. In the case of forming the fine structure with the arrangement as shown in FIG. 37, the control frequency of the reference signal is decreased. Meanwhile, in the case of forming the fine structure with the arrangement as shown in FIG. 40, the control frequency of the reference signal is increased. Therefore, in the arrangement as shown in FIG. 40, the phases (positions) in the second direction D2 of corresponding dots are matched, and in the arrangement as shown in FIG. 37, deviations occur in the phases (positions) in the second direction D2 of corresponding dots. The relationship between the arrangements as shown in FIGs. 39 and 41 is the same.

The roll-shaped member 471 with the resist layer provided on the surface exposed by the exposure apparatus 470 is developed, and the etching layer is etched by dry etching using the developed resist layer as a mask. After etching, by removing the residual resist layer, it is possible to obtain a cylindrical master mold.

As a method of transferring the pattern 476 obtained as described above to a predetermined substrate and obtaining the optical substrate according to this Embodiment, the method is not limited particularly, and it is possible to adopt the transfer method as described in «Optical substrate PP». The cylindrical master mold, specifically the pattern 476 of the cylindrical master mold (roll-shaped member 471) is once transferred to a film to form a resin mold, and the transfer method as described already is performed.

The method of transferring the pattern 476 from the cylindrical master mold to the resin mold is not limited particularly, and for example, it is possible to apply a direct nanoimprint method. As the direct nanoimprint method, there are a thermal nanoimprint method of filling the pattern 406 of the cylindrical master mold with a thermosetting resin while heating at a predetermined temperature, cooling the cylindrical master mold, and then, releasing the cured thermosetting resin to transfer, and a photo-nanoimprint method of irradiating a photocurable resin filled in the pattern 476 of the cylindrical master mold with light of a predetermined wavelength, curing the photocurable resin, and then, releasing the cured photocurable resin from the cylindrical master mold to transfer.

The cylindrical master mold (roll-shaped member 471) is a seamless cylindrical mold, and therefore, is particularly suitable for successively transferring to resin molds by roll-to-roll nanoimprint.

Further, it is also possible to perform the transfer method by preparing an electrocast mold from a resin mold with the pattern 476 transferred thereto by electrocasting and using the electrocast mold. In the case of forming an electrocast mold, such a case is preferable in terms of extending life of the cylindrical master mold that is an original mold, and also in a scheme of once forming an electrocast mold, since it is possible to absorb evenness of the substrate, a method of further forming a resin mold is preferable.

Furthermore, in the resin mold method, repetition transfer is easy, and the method is preferable. Herein, "repetition transfer" means either or both of (1) of manufacturing a plurality of concavo-convex pattern transfer materials inversely transferred from the resin mold (+) having the concavo-convex pattern shape, and (2) of, in the case of particularly using a curable resin composition as a transfer agent, obtaining a transfer material (-) inverted from the resin mold (+), next using the transfer material (-) as a resin mold (-) to obtain an inversely transferred transfer material (+) and performing repetition pattern inversion transfer of 凸凹 / 凹凸 / 凸凹 /凹凸 /…/.

In addition, the mold used in the above-mentioned transfer method is also applied similarly to «Optical substrate PP» and «Optical substrate D».

«Semiconductor light emitting device»

Described next are more preferable states of the semiconductor light emitting device described with reference to FIGs. 2 to 6 in «Optical substrate PP», «Optical substrate D» and «Optical substrate D» as described above.

In the following description, the height of the concavo-convex structure PP, concavo-convex structure D or concavo-convex structure PC (hereinafter, simply described as the concavo-convex structure) is defined as an average height of the concavo-convex structure. That is, the arithmetic mean value of the height H defined in the concavo-convex structure PP is adopted, and is described as the average height h. Further, the average concave-portion bottom portion position and convex-portion vertex portion position of the concavo-convex structure are determined with cross-sectional observation images using a scanning electron microscope. Alternatively, when it is possible to scan a probe to the concave-portion bottom portion of the concavo-convex structure, it is also possible to determine with an atomic force microscope on the concavo-convex structure.

<Distance Hbun>

As the semiconductor light emitting device according to this Embodiment, with respect to the semiconductor light emitting device as described in «Optical substrate PP» with reference to FIGs. 2 to 6, it is possible to adopt the device with the optical substrate PP, optical substrate D or optical substrate PC as a substitute for the optical substrate PP and the concavo-convex structure PP, concavo-convex structure D or concavo-convex structure PC as a substitute for the concavo-convex structure PP. A distance Hbun is defined by a distance between the surface on the light emitting semiconductor layer 40 side of the optical substrate PP 10 and the surface on the light emitting semiconductor layer 40 side of the first semiconductor layer 30. Herein, the surface on the light emitting semiconductor layer 40 side of the optical substrate PP 10 is defined as an average concave-portion bottom portion position of the concavo-convex structure 20. Further, the surface on the light emitting semiconductor layer 40 side of the first semiconductor layer 30 is defined as an average surface. The average is arithmetic mean, and the number of average points is 10 or more. That is, the distance Hbun is an average thickness of the first semiconductor layer 30 with the average concave-portion bottom portion position of the concavo-convex structure 20 as a reference.

<Distance Hbu>

A distance Hbu is defined by a distance between the surface on the light emitting semiconductor layer 40 side of the optical substrate PP 10 and the surface on the light emitting semiconductor layer 40 side of the undoped first semiconductor layer 31. Herein, the surface on the light emitting semiconductor layer 40 side of the optical substrate PP 10 is defined as an average concave-portion bottom portion position of the concavo-convex structure 20. Further, the surface on the light emitting semiconductor layer 40 side of the undoped first semiconductor layer 31 is defined as an average surface. The average is arithmetic mean, and the number of average points is 10 or more. That is, the distance Hbu is an average thickness of the undoped first semiconductor layer 31 with the average concave-portion bottom portion position of the concavo-convex structure 20 as a reference.
Subsequently, each of elements constituting the semiconductor light emitting device 100 (including 200, 300, 400 and 500. The same in the following description) will be described in detail.

The ratio (Hbun/h) of the distance Hbun to the average height h

The ratio (Hbun/h) of the distance Hbun to the average height h meets the following equation (12).

$$8 \leq Hbun/h \leq 300 \qquad (12)$$

The ratio (Hbun/h) means the ratio between the average height (h) of the concavo-convex structure 20 and the average thickness Hbun of the first semiconductor layer 30, and as the ratio (Hbun/h) increases, the average thickness Hbun of the first semiconductor layer 30 increases. In the case where the ratio (Hbun/h) is 8 or more, flatness is excellent on the surface on the light emitting semiconductor layer 40 side of the first semiconductor layer 30, and therefore, such a case is preferable. Particularly, from the viewpoint of improving the design versatility degree of the concavo-convex structure 20, the ratio (Hbun/h) is preferably 10 or more, and more preferably 12 or more. Further, from the viewpoints of suppressing the effect of the concavo-convex structure 20 and making the flatness of the surface on the light emitting semiconductor layer 40 side of the first semiconductor layer 30 more excellent, the ratio (Hbun/h) is preferably 14 or more, and more preferably 16 or more. Furthermore, from the viewpoints of increasing the collision probability of dislocations between the average convex-portion vertex portion position of the concavo-convex structure 20 of the first semiconductor layer 30 and the light emitting semiconductor layer 40, and more increasing the internal quantum efficiency IQE, the ratio (Hbun/h) is more preferably 20 or more, and most preferably 25 or more. On the other hand, when the ratio (Hbun/h) is 300 or less, it is possible to suppress warpage of the semiconductor light emitting device 100. From the viewpoint of shortening the time taken for manufacturing of the semiconductor light emitting device 100, the ratio (Hbun/h) is preferably 200 or less, and more preferably 150 or less. Further, from the viewpoint of effectively suppressing the warpage also in the case of manufacturing the semiconductor light emitting device 100 with a large area by decreasing distortion due to a difference in thermal expansion between the optical substrate PP 10 and the first semiconductor layer 30, and increasing the size of the optical substrate PP 10, the ratio (Hbun/h) is more preferably 100 or less, and most preferably 50 or less.

Ratio (Hbu/h) of the distance Hbu to the average height h

The ratio (Hbu/h) of the distance Hbu to the average height h meets the following equation (13).

$$3.5 \leq Hbu/h \leq 200 \qquad (13)$$

The ratio (Hbu/h) means the ratio between the average height (h) of the concavo-convex structure 20 and the average thickness Hbu of the undoped first semiconductor layer 31, and as the ratio (Hbu/h) increases, the average thickness Hbu of the non-doped first semiconductor layer 31 increases. In the case where the ratio (Hbu/h) is 3.5 or more, flatness is excellent on the surface on the light emitting semiconductor layer 40 side of the undoped first semiconductor layer 31, and therefore, such a case is preferable. Particularly, from the viewpoints of improving the design versatility degree of the concavo-convex structure 20, reflecting performance as a semiconductor of the undoped first semiconductor layer 31 in the doped first semiconductor layer 32, and shortening the manufacturing time of the first semiconductor layer 30, the ratio (Hbu/h) is preferably 4 or more, and more preferably 5 or more. Further, from the viewpoints of suppressing the effect of the concavo-convex structure 20 and making the flatness of the surface on the light emitting semiconductor layer 40 side of the undoped first semiconductor layer 31 more excellent, the ratio (Hbun/h) is preferably 8 or more, and more preferably 10 or more. Furthermore, from the viewpoints of increasing the collision probability of dislocations between the average convex-portion vertex portion position of the concavo-convex structure 20 of the undoped first semiconductor layer 31 and the light emitting semiconductor layer 40, and more increasing the internal quantum efficiency IQE, the ratio (Hbu/h) is most preferably 15 or more. On the other hand, when the ratio (Hbu/h) is 200 or less, it is possible to suppress warpage of the semiconductor light emitting device 100. From the viewpoint of shortening the time taken for manufacturing of the semiconductor light emitting device 100, the ratio (Hbu/h) is preferably 100 or less, and more preferably 50 or less. Further, from the viewpoint of effectively suppressing the warpage also in the case of manufacturing the semiconductor light emitting device 100 with a large area by decreasing distortion due to a difference in thermal expansion between the optical substrate PP 10 and the first semiconductor layer 30, and increasing the size of the optical substrate PP 10, the ratio (Hbu/h) is most preferably 30 or less.

First semiconductor layer

Materials of the first semiconductor layer 31 are as described already. The film thickness (Hbun) of the first semiconductor layer 30 is preferably 100 nm or more, from the viewpoints of flattening the concavo-convex structure 20, reducing dislocations inside the semiconductor layer 30, reflecting performance as a semiconductor in the light emitting semiconductor layer 40 and the second semiconductor layer 50 and thereby increasing the internal quantum efficiency IQE. Particularly, from the viewpoint of more exerting the effect of reducing dislocations due to the concavo-convex structure 20, the thickness (Hbun) is preferably 1,500 nm or more, and more preferably 2,000 nm or more. Further, from the viewpoint of reflecting the performance as a semiconductor in the light emitting semiconductor layer 40 and the second semiconductor layer 50 and effectively increasing the internal quantum efficiency IQE, the thickness (Hbun) is preferably 2,500 nm or more, more preferably 3,000 nm or more, and most preferably 4,000 nm or more. On the other hand, from the viewpoint of reducing warpage of the substrate, the upper limit value is preferably 100,000 nm or less, more preferably 7,500 nm or less, and most preferably 6,500 nm or less.

In addition, the doped first semiconductor layer 32 is not limited particularly, as long as the layer is capable of being used as an n-type semiconductor layer suitable for the semiconductor light emitting device (for example, LED). For example, it is possible to apply materials obtained by doping various elements to element semiconductors such as silicon and germanium, chemical semiconductors of group III-V, group II-VI, group VI-VI, and the like and others as appropriate. From the viewpoint of election injection properties in the light emitting semiconductor layer 40, the film thickness of the doped first semiconductor layer 32 is preferably 800 nm or more, more preferably 1,500 nm or more, and most preferably 2,000 nm or more. On the other hand, from the viewpoint of reducing warpage, the upper limit value is preferably 5,000 nm or less. From the viewpoint of reducing a used amount of the doped first semiconductor layer 32 and shortening the manufacturing time of the semiconductor light emitting device 100, the upper limit value is preferably 4,300 nm or less, more preferably 4,000 nm or less, and most preferably 3,500 nm or less.

The undoped first semiconductor layer 31 is capable of being selected as appropriate within a scope of not interfering with performance as the n-type semiconductor layer of the doped first semiconductor layer 32. For example, it is possible to apply element semiconductors such as silicon and germanium, chemical semiconductors of group III-V, group II-VI, group VI-VI and the like, and others. From the viewpoint of flattening the concavo-convex structure 20, the film thickness (Hbu) of the undoped first semiconductor layer 31 is preferably 1,000 nm or more. Particularly, from the viewpoint of effectively reducing dislocations inside the undoped first semiconductor layer 31, the thickness (Hbu) is preferably 1,500 nm or more, more preferably 2,000 nm or more, and most preferably 2,500 nm or more. On the other hand, from the viewpoint of reducing warpage of the semiconductor light emitting device 100, the upper limit value is preferably 6,000 nm or less. Particularly, from the viewpoint of shortening the manufacturing time of the semiconductor light emitting device 100, the value is preferably 5,000 nm or less, more preferably 4,000 nm or less, and most preferably 3,500 nm or less.

In addition, when at least the undoped first semiconductor layer 31 and doped first semiconductor layer 32 are sequentially layered on the concavo-convex structure 20 of the optical substrate PP 10, it is also possible to further provide another undoped semiconductor layer (2) on the doped first semiconductor layer 32, and provide the light emitting semiconductor layer 40 thereon. In this case, as another undoped semiconductor layer (2), it is possible to use the materials as described in the undoped first semiconductor layer 31 as described above. From the viewpoint of light emitting properties of the semiconductor light emitting device 100, a film thickness of the undoped semiconductor layer (2) is preferably 10 nm or more, more preferably 100 nm or more, and most preferably 200 nm or more. On the other hand, from the viewpoint of recombination of hole and electron inside the light emitting semiconductor layer 40, the upper limit value is preferably 500 nm or less, more preferably 400 nm or less, and most preferably 350 nm or less.

Relationship between the first semiconductor layer and the concavo-convex structure

The first semiconductor layer 30 and the concavo-convex structure 20 are capable of being combined as appropriate from the viewpoint of reducing dislocations inside the first semiconductor layer 30. When the flat surface (hereinafter, referred to as "flat surface B") of the concave-portion bottom portion of the concavo-convex structure 20 is parallel to a surface (hereinafter, referred to as "parallel stable growth surface") almost parallel to the stable growth surface of the first semiconductor layer 30, a disturbance of the growth mode of the first semiconductor layer 30 is increased in the vicinity of the concave portion of the concavo-convex structure 20, it is possible to effectively disperse dislocations inside the first semiconductor layer 30 corresponding to the concavo-convex structure 20, and the internal quantum efficiency IQE is thereby increased. The stable growth surface refers to a surface with the lowest growth rate in the material to grow. Generally, it is known that the stable growth surface appears as a facet surface during the growth. For example, in the case of gallium nitride-based chemical semiconductor, the plane parallel to the A-axis typified by the M-surface is the stable growth surface. The stable growth surface of the GaN-based semiconductor layer is M-surface (1-100), (01-10), (-1010) of hexagonal crystal, and is one of planes parallel to the A-axis. In addition, depending on the growth conditions, there is the case where the stable growth surface is another plane including the A-axis that is a plane except the M-surface of the GaN-based semiconductor.

By making the semiconductor light emitting device meeting the above-mentioned requirements, it is possible to efficiently manufacture semiconductor light emitting devices that effectively develop the effects of the optical substrate PP, optical substrate D and optical substrate PC. More specifically, the optical substrate is generally in the shape of a wafer. Problems of generation of cracks in the semiconductor crystal layer and warpage occur, in depositing the semiconductor crystal layer on the optical wafer. By meeting the above-mentioned ranges, even when the film thickness of the semiconductor crystal layer is thin, it is possible to manufacture semiconductor light emitting devices that efficiently emit light. In terms of this respect, cracks and warpage are reduced, and it is possible to many efficient semiconductor light emitting device chips from a single optical wafer.

[Examples]

Examples performed to confirm the effects of the present invention will be described below.

Symbols used in the following description represent the following meaning.

- DACHP···Fluorine-containing urethane (meth)acrylate (OPTOOL DAC HP (made by Daikin Industries, Ltd.))
- M350···Trimethylolpropane (EO-modified) triacrylate (made by TOAGOSEI Co., Ltd., Aronix M350)
- I.184···1-Hydroxy-cyclohexyl-phenyl-ketone (made by BASF Company, Irgacure (Registered Trademark) 184)
- I.369···2-Benzyl-2-dimethylamino-1-(4-morpholino phenyl)-butanone-1 (made by BASF Company Irgacure (Registered Trademark) 369)
- TTB···Titanium (IV) tetrabutoxide monomer (made by Wako Pure Chemical Industries, Ltd.)
- SH710···Phenyl-modified silicone (made by Dow Corning Toray Co., Ltd.)
- 3APTMS···3-Acryloxypropyl trimethoxysilane (KBM-5103 (made by Shin-Etsu silicone corporation))
- DIBK···Diisobutyl ketone
- MEK···Methyl ethyl ketone
- MIBK···Methyl isobutyl ketone
- DR833···Tricyclodecane dimethanol diacrylate (SR833 (made by SARTOMER company))
- SR368···Tris(2-hydroxyethyl) isocyanurate triacrylate (SR833 (made by SARTOMER company))

(Example 1)

<Optical substrate PP>

The optical substrate PP with the pattern X drawn on its surface was prepared, semiconductor light emitting devices (LEDs) were prepared using the substrate PP, and efficiency of LEDs was compared.

In the following study, first, (1) a cylindrical master mold was prepared, and (2) a resin mold was prepared by applying a light transfer method to the cylindrical master mold. (3) Then, the resin mold was processed to a sheet for nano-processing. Next, (4) using the sheet for nano-processing, a processing mask was formed on the optical substrate, and dry etching was performed through the obtained processing mask to prepare the optical substrate PP provided with the concavo-convex structure PP on its surface. Finally, (5) using the obtained optical substrate PP, a semiconductor light emitting device was prepared, and performance was evaluated.

(1) Preparation of cylindrical master molds

A fine structure was formed on a surface of cylindrical quartz glass by a direct-write lithography method using a semiconductor laser. First, a resist layer was formed on the cylindrical quartz glass surface by a sputtering method. The sputtering method was performed with power of RF 100W using CuO of 3-inch $\Phi$ (containing 8 atm% Si) as a target (resist layer) to form a resist layer of 20 nm. Next, while rotating the cylindrical quartz glass, the entire surface of the resist layer was once exposed using a semiconductor laser with a wavelength of 405 nm. Subsequently, pulse exposure was performed on the once exposed resist layer using the same semiconductor laser. Herein, predetermined regularity was added to the exposure pattern of laser pulses to control an arrangement of the fine structure. For example, for some cylindrical master, an exposure pulse width was constant in the circumferential direction of the cylindrical quartz glass, and a pulse interval in the axis direction was modulated by a sine curve to vary. Further, for another cylindrical master, both the exposure pulse interval in the circumferential direction and the exposure pulse interval in the axis direction of the cylindrical quartz glass were modulated by a sine curve to vary. Furthermore, for still another cylindrical master, both the exposure pulse interval in the circumferential direction and the exposure pulse interval in the axis direction of the cylindrical quartz glass were modulated by a sine curve to vary, and the rotation speed of the cylindrical master was increased and decreased. Next, the pulse-exposed resist layer was developed. Development of the resist layer was performed for 240 seconds using 0.03 wt% glycine aqueous solution. Next, using the developed resist layer as a mask, etching was performed on the etching layer (quartz glass) by dry etching. Dry etching was performed using $SF_6$ as an etching gas on the conditions that the processing gas pressure was 1 Pa, processing power was 300 W, and that the processing time was 5 minutes. Finally, only the resist layer residual was peeled off from the cylindrical quartz glass provided with the fine structure on the surface, using hydrochloric acid of pH1. The peeling time was 6 minutes.

The obtained cylindrical quartz glass was subjected to excimer cleaning, and next, the fine structure was coated with Durasurf HD-1101Z (made by Daikin Industries, Ltd.) that is a fluorine-based de-molding agent, heated at 60°C for 1 hour, and then, allowed to stand at room temperature for 24 hours to fix. Then, cleaning was performed three times using Durasurf HD-ZV (made by Daikin Industries, Ltd.) to obtain a cylindrical master mold.

(2) Preparation of resin molds

Resin molds G1 were prepared successively using the prepared cylindrical master mold as a mold by applying the photo nanoimprint method. Next, using the resin mold G1 as a template, resin molds G2 were obtained successively by applying the photo nanoimprint method.

The material 1 described below was applied onto an easy adhesion surface of a PET film: A-4100 (made by Toyobo Co., Ltd.: width 300 mm, thickness 100 $\mu$m) by Micro Gravure coating (made by Yasui Seiki Co., Ltd.) so that the coating film thickness was 2.5 $\mu$m. Next, the PET film coated with the material 1 was pressed against the cylindrical master mold with a nip roll, and was irradiated with ultraviolet rays at a temperature of 25°C and humidity of 60% under atmospheric pressure using a UV exposure apparatus (H bulb) made by Fusion UV Systems Japan Co., Ltd. so that the integral amount of exposure below the center of the lamp was 1,500 mJ/cm$^2$, photo-curing was performed successively, and obtained was a resin mold G1 (length 200 m, width 300 mm) with the fine structure transferred to the surface.

· Material 1··· DACHP: M350: I.184: I.369 = 17.5 g: 100 g: 5.5 g: 2.0 g

The fine structure surface of the prepared resin mold G1 was observed with an optical microscope to check the pattern. Further, by enlarging the pattern with a scanning electron microscope, the fine structure was observed. The results are summarized in Table 2. In addition, observation with the optical microscope was performed using Ultra-depth color 3D profile measuring microscope (VK-9500) made by Keyence Corporation using objective lenses made by Nikon Corporation, and KH-3000VD (objective lens: OL-700) made by HILOX Co., Ltd. Particularly, in the case of using VK-9500, the range of 10 times to 1,000 times was observed, and in the case of using KH-3000VD, the range of 700 times to 5,000 times was observed. In the case of using either of the microscopes, the same optical pattern was observed, and it was confirmed that the sharpness of the observed optical patterns was higher in the case of using the latter KH-3000VD. In addition, both of the above-mentioned two optical microscopes were used in optical microscope observation in the following Examples. Further, in any of the Examples, it was confirmed that the observation image was sharper in the case of using KH-3000VD.

Further, the fine structure surface of the resin mold G1 was observed using a scanning electron microscope. As the scanning electron microscope, Hitachi Ultra-High Resolution Field Emission Type Scanning Electron Microscope SU8010 (made by Hitachi High-Technologies Corporation) was used. Further, in any of the following Examples, unless otherwise specified, the above-mentioned SU8010 was used as the scanning electron microscope.

[Table 2]

| No. | A AVERAGE INTERVAL DAVE | ARRANGEMENT | B AVERAGE PITCH P' AVE | ARRANGEMENT |
|---|---|---|---|---|
| 2-1 | 1450nm | TETRAGONAL | 300nm | HEXAGONAL |
| 2-2 | 1650nm | LOW MAGNIFICATION: SHAPE OF LINE HIGH MAGNIFICATION: TETRAGONAL | 322nm | TETRAGONAL~ HEXAGONAL |
| 2-3 | 5060nm | SHAPE OF LINE | 460nm | HEXAGONAL |
| 2-4 | 1450nm | LOW MAGNIFICATION: SHAPE OF LINE HIGH MAGNIFICATION: TETRAGONAL | 300nm | HEXAGONAL |
| 2-5 | 1650nm | LOW MAGNIFICATION: SHAPE OF LINE HIGH MAGNIFICATION: TETRAGONAL | 330nm | TETRAGONAL~ HEXAGONAL |

In addition, in Table 2, the column A shows results of observing optical microscope images, and the column B shows results of observing scanning electron microscope images.

When the resin mold G1 of No. 2-1 was observed at magnifications of 500 times and 1,000 times with the optical microscope, the pattern X was observed in which first regions Xa lighter than the periphery as a change in light and dark were tetragonally arranged. In addition, the tetragonally arranged first regions Xa were circular patterns Xa with the average interval Dave of 1,450 nm, the contour of the pattern Xa was substantially circular and was provided with gradation, and portions were confirmed in which the luminance was different between some circular pattern Xa and another circular pattern Xa. Further, also in the case of further increasing the observation magnification to 1,400 times, 2,800 times and 4,900 times, the pattern X was observed. Furthermore, it was not changed that the first region Xa was the substantially circular pattern, and that the average interval Dave was 1,450 nm. That is, as described in FIG. 16, in taking some axis, the pattern in which light and dark changed continuously was observed. Still furthermore, in observing at magnifications of 5,000 times, 10,000 times and 50,000 times with the scanning electron microscope, it was confirmed that the pattern X observed with the optical microscope was formed of the finer fine structure. The contour of the convex portion of the fine structure was substantially circular, and the average pitch P'ave was 300 nm. Moreover, it was confirmed that the pitch P' of the fine structure continuously changed with 300 nm as the center, and that the average of a large period of the change was 1,450 nm and substantially matched with the average interval Dave of the pattern X observed by optical microscope observation. Further, when scanning electron microscope observation was performed from the light portion to the dark portion in the light and dark pattern observed with the optical microscope, it was confirmed that the fine structure was formed in all of the light portion, dark portion and their interface portion. Further, it was observed that the height H and convex-portion bottom portion circumscribed circle diameter Φout continuously changed also in association with the change of the pitch P' of the fine structure. Particularly, it was confirmed that the height H and convex-portion bottom portion circumscribed circle diameter Φout decreased as the pitch P' increased.

When the resin mold G1 of No. 2-2 was observed at magnifications of 500 times and 1,000 times with the optical microscope, the pattern X was observed in which first regions Xa lighter than the periphery as a change in light and dark were tetragonally arranged. The tetragonally arranged first regions Xa were circular patterns Xa with the average interval Dave of 1,650 nm, and the contour of the circular pattern Xa was provided with gradation. Further, it was confirmed that the tetragonally arranged circular patterns Xa formed groups in one axis direction, and were arranged larger in the direction perpendicular to the axis. That is, in the optical microscope image, tetragonally arranged circular patterns Xa were observed microscopically, and a pattern in the shape of lines with low regularity was observed macroscopically, independently of the circular patterns Xa. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer fine structure. Particularly, the fine structure was of the arrangement in which tetragonally arranged portions, hexagonally arranged portions, and portions with the intermediate arrangement between the tetragonal arrangement and the hexagonal arrangement were mixed with low regularity. When more detailed analysis was performed, the fine structure formed groups with the size of about 1,600 nm to 1,700 nm. That is, the size of the group of the fine structure observed with the scanning electron microscope substantially matched with the size of the circular pattern Xa observed with the optical microscope. Further, when 50 points were plotted with respect to the period with low regularity and width of the tetragonally arranged portion and hexagonally arranged portion in the scanning electron microscope image, further 50 points were plotted with respect to the interval and width of the line-shaped pattern observed with the optical microscope, and when their matching was checked, matching was confirmed in R2=0.86. Furthermore, when scanning electron microscope observation was performed from the light portion to the dark portion in the light and dark pattern observed with the optical microscope, it was confirmed that the fine structure was formed in all of the light portion, dark portion and their interface portion.

When the resin mold G1 of No. 2-3 was observed at magnifications of 500 times and 1,000 times with the optical microscope, the line-shaped pattern Xa was observed in which first regions Xa lighter than the periphery as a change in light and dark were arranged in the shape of line-and-space. The average interval Dave of the first regions Xa was 5,060 nm. Further, the contour of the first pattern Xa was provided with gradation. Furthermore, also in the case of further increasing the observation magnification to 1,400 times, 2,800 times and 4,900 times, the pattern X was observed. Still furthermore, it was not changed that the average interval Dave of the line-shaped patterns Xa was 5,060 nm. That is, as described in FIG. 16, in taking some axis (in addition, the direction perpendicular to the line-and-space), the pattern in which light and dark changed continuously was observed. Moreover, in observing at magnifications of 5,000 times, 10,000 times and 20,000 times with the scanning electron microscope, it was confirmed that the pattern X observed with the optical microscope was formed of the finer concavo-convex structure. The fine structure was observed as a hexagonal arrangement with the average pitch P'ave of 460 nm. Further, it was confirmed that the pitch P' of the fine structure continuously changed in a predetermined direction with 460 nm as the center, and that the average of a large period of the change was 5,060 nm and substantially matched with the average interval Dave of the pattern observed by optical microscope observation. Furthermore, when scanning electron microscope observation was performed from the light portion to the dark portion in the light and dark pattern observed with the optical microscope, it was confirmed that the fine structure was formed in all of the light portion, dark portion and their interface portion. Still furthermore, it was observed that the height H and convex-portion bottom portion circumscribed circle diameter Φout continuously changed also in association with the change of the pitch P' of the fine structure. Particularly, it was confirmed that the height H and convex-portion bottom portion circumscribed circle diameter Φout decreased as the pitch P' increased.

When the resin mold G1 of No. 2-4 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,450 nm, and the contour of the circular pattern Xa was provided with gradation. Further, when the magnification of the optical microscope was made 50 times, it was observed that the circular patterns Xa observed as a tetragonal arrangement formed a group in the shape of a line in one axis direction. That is, the circular patterns Xa (2) of the tetragonal arrangement with the average interval Dave of 1,450 nm were observed inside the line-shaped pattern Xa (1) in one direction with the average width of 15 μm. In addition, it was almost not possible to observe the circular pattern at magnifications at which the line-shaped pattern Xa (1) was capable of being observed. Further, portions were confirmed in which the luminance was different between some circular pattern Xa (2) and another circular pattern Xa. Furthermore, also in the case of further increasing the observation magnification to 1,400 times, 2,800 times and 4,900 times, the pattern X was observed. Still furthermore, it was not changed that the region was the substantially circular pattern, and that the average interval Dave was 1,450 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer fine structure. Particularly, it was confirmed that the fine structure was a hexagonal arrangement with the average pitch P'ave of 300 nm. Further, it was confirmed that the pitch P' of the fine structure continuously changed in a predetermined direction with 300 nm as the center, and that the average of a large period of the change was 1,450 nm and substantially matched with the average interval Dave of the pattern X observed by optical microscope observation. Furthermore, when the interface portion of the line-shaped pattern Xa(1) observed in observation at low magnifications of the optical microscope was observed with the scanning electron microscope, an image changing from the hexagonal arrangement to the tetragonal arrangement was observed. Still furthermore, when scanning electron microscope observation was performed from the light portion to the dark portion in the light and dark pattern observed with the optical microscope, it was confirmed that the fine structure was formed in all of the light portion, dark portion and their interface portion. Moreover, it was observed that the height H and convex-portion bottom portion circumscribed circle diameter Φout continuously changed also in association with the change of the pitch P' of the fine structure. Particularly, it was confirmed that the height H and convex-portion bottom portion circumscribed circle diameter Φout decreased as the pitch P' increased.

When the resin mold G1 of No. 2-5 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,650 nm, and the contour of the circular pattern Xa was provided with gradation. Further, when the magnification of the optical microscope was made 50 times, it was observed that the circular patterns Xa observed as a tetragonal arrangement formed a group in the shape of a line in one axis direction. That is, the circular patterns Xa of the tetragonal arrangement with the average interval Dave of 1,650 nm were observed inside the line-shaped pattern Xa in one direction with the average interval of 15 μm. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer fine structure. Particularly, in the fine structure, the average pitch P'ave was 330 nm. The arrangement included hexagonal arrangements and tetragonal arrangements with low regularity to skip among these arrangements.

Next, by regarding the resin mold G1 as a template, resin molds G2 were prepared successively by applying the photo nanoimprint method.

The material 1 was applied onto the easy adhesion surface of the PET film: A-4100 (made by Toyobo Co., Ltd.: width 300 mm, thickness 100 μm) by Micro Gravure coating (made by Yasui Seiki Co., Ltd.) so that the coating film thickness was 2 μm. Next, the PET film coated with the material 1 was pressed against the fine structure surface of the resin mold G1 with a nip roll (0.1 Mpa), and was irradiated with ultraviolet rays at a temperature of 25°C and humidity of 60% under atmospheric pressure using the UV exposure apparatus (H bulb) made by Fusion UV Systems Japan Co., Ltd. so that the integral amount of exposure below the center of the lamp was 1,200 mJ/cm$^2$, photo-curing was performed successively, and obtained was a plurality of resin molds G2 (length 200 m, width 300 mm) with the fine structure transferred to the surface.

· Material 1··· DACHP: M350: I.184: I.369 = 17.5 g: 100 g: 5.5 g: 2.0 g

The fine structure surface of the prepared resin mold G2 was observed with the optical microscope to check the pattern. Further, by enlarging the pattern with the scanning electron microscope, the fine structure was checked. The results are summarized in Table 3.

[Table 3]

| No. | A | | B | |
|-----|---|---|---|---|
| | AVERAGE INTERVAL DAVE | ARRANGEMENT | AVERAGE PITCH P'AVE | ARRANGEMENT |
| 3-1 | 1450nm | TETRAGONAL | 300nm | HEXAGONAL |
| 3-2 | 1650nm | LOW MAGNIFICATION: SHAPE OF LINE HIGH MAGNIFICATION: TETRAGONAL | 322nm | TETRAGONAL~ HEXAGONAL |
| 3-3 | 5060nm | SHAPE OF LINE | 460nm | HEXAGONAL |
| 3-4 | 1450nm | LOW MAGNIFICATION: SHAPE OF LINE HIGH MAGNIFICATION: TETRAGONAL | 300nm | HEXAGONAL |

(continued)

| No. | A | | B | |
| | AVERAGE INTERVAL DAVE | ARRANGEMENT | AVERAGE PITCH P'AVE | ARRANGEMENT |
| --- | --- | --- | --- | --- |
| 3-5 | 1650nm | LOW MAGNIFICATION: SHAPE OF LINE<br>HIGH MAGNIFICATION: TETRAGONAL | 330nm | TETRAGONAL~ HEXAGONAL |

In addition, in Table 3, the column A shows results of observing optical microscope images, and the column B shows results of observing scanning electron microscope images.

When the resin mold G2 of No. 3-1 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,450 nm, and the contour of the pattern Xa was relatively sharp. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,450 nm. That is, as described in FIG. 14, in taking some axis, a period of the pattern was observed in which a change in light and dark abruptly occurred, and subsequently gradually changed. Moreover, in observing at magnifications of 5,000 times, 10,000 times and 50,000 times with the scanning electron microscope, it was confirmed that the pattern X observed with the optical microscope was formed of the finer fine structure. The contour of the concave portion of the fine structure was substantially circular, and the average pitch P'ave was 300 nm. Further, it was confirmed that the pitch P' of the fine structure continuously changed with 300 nm as the center, and that the average of a large period of the change was 1,450 nm and substantially matched with the average interval Dave of the pattern X observed with the optical microscope. Furthermore, when scanning electron microscope observation was performed from the light portion to the dark portion in the light and dark pattern observed with the optical microscope, it was confirmed that the fine structure was formed in all of the light portion, dark portion and their interface portion. Still furthermore, it was observed that the height H and concave-portion opening portion diameter lcct continuously changed also in association with the change of the pitch P' of the fine structure. Particularly, it was confirmed that the height H and concave-portion opening portion diameter lcct decreased as the pitch P' increased.

When the resin mold G2 of No. 3-2 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,650 nm, and the contour of the circular pattern Xa was relatively sharp. Further, it was confirmed that the tetragonally arranged circular patterns Xa formed groups in one axis direction, and were arranged larger in the direction perpendicular to the axis. That is, in the optical microscope image, tetragonally arranged circular patterns Xa were observed microscopically, and a pattern in the shape of lines with low regularity was observed macroscopically, independently of the circular patterns Xa. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 14, in taking some axis, a period of the pattern was observed in which a change in light and dark abruptly occurred, and subsequently gradually changed. Moreover, in observing with the scanning electron microscope, it was confirmed that the pattern X observed with the optical microscope was formed of the finer fine structure (structure in which a plurality of concave portions was arranged). Particularly, the fine structure was of the arrangement in which tetragonally arranged portions, hexagonally arranged portion, and portions with the intermediate arrangement between the tetragonal arrangement and the hexagonal arrangement were mixed with low regularity. When more detailed analysis was performed, the fine structure formed groups with size of about 1,600 nm to 1,700 nm. That is, the size of the group of the fine structure observed with the scanning electron microscope substantially matched with the size of the circular pattern Xa observed with the optical microscope. Further, when 50 points were plotted with respect to the period with low regularity and width of the tetragonally arranged portion and hexagonally arranged portion in the scanning electron microscope image, further 50 points were plotted with respect to the interval and width of the line-shaped pattern observed with the optical microscope, and when their matching was checked, matching was confirmed in R2=0.89. Furthermore, when scanning electron microscope observation was performed from the light portion to the dark portion in the light and dark pattern observed with the optical microscope, it was confirmed that the fine structure was formed in all of the light portion, dark portion and their interface portion.

When the resin mold G2 of No. 3-3 was observed at magnifications of 500 times and 1,000 times with the optical microscope, the pattern X was observed in which first regions Xa lighter than the periphery as a change in light and dark were arranged in the shape of line-and-space. The average interval Dave of the first regions Xa was 5,060 nm. Further, the contour of the first pattern Xa was relatively sharp. Furthermore, also in the case of further increasing the observation magnification to 1,400 times, 2,800 times and 4,900 times, the pattern X was observed. Still furthermore, it was not changed that the first regions Xa were the line-shaped pattern, and that the average interval Dave was 5,060 nm. That is, as described in FIG. 14, in taking some axis (in addition, the direction perpendicular to the line-and-space), the regular pattern in which light and dark changed abruptly was observed. Moreover, in observing at magnifications of 5,000 times, 10,000 times and 20,000 times with the scanning electron microscope, it was confirmed that the pattern X observed with the optical microscope was formed of the finer fine structure. The fine structure was observed as a hexagonal arrangement of a plurality of concave portions with the average pitch P'ave of 460 nm. Further, it was confirmed that the pitch P' of the fine structure continuously changed in a predetermined direction with 460 nm as the center, and that the average of a large period of the change was 5,060 nm and substantially matched with the average interval Dave of the pattern X observed with the optical microscope. Furthermore, when scanning electron microscope observation was performed from the light portion to the dark portion in the light and dark pattern observed with the optical microscope, it was confirmed that the fine structure was formed in all of the light portion, dark portion and their interface portion. Still furthermore, it was observed that the height H and concave-portion opening portion diameter lcct continuously changed also in association with the change of the pitch P' of the fine structure. Particularly, it was confirmed that the height H and concave-portion opening portion diameter lcct decreased as the pitch P' increased.

When the resin mold G2 of No. 3-4 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,450 nm, and the contour of the circular pattern Xa was provided with gradation. Further, when the magnification of the optical microscope was made 50 times, it was observed that the circular patterns Xa observed as a tetragonal arrangement formed a group in the shape of a line in one axis direction. That is, the circular patterns Xa of the tetragonal arrangement with the average interval Dave of 1,450 nm were observed inside the line-shaped pattern Xa in one direction with the average width of 15 $\mu$m. In addition, it was almost not possible to observe the circular pattern at magnifications at which the line-shaped pattern was capable of being observed. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,450 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer fine structure. Particularly, it was confirmed that the fine structure was comprised of a plurality of concave portions of a hexagonal arrangement with the average pitch P'ave of 300 nm. Further, when the interface portion of the line-shaped pattern observed in observation at low magnifications of the optical microscope was observed with the scanning electron microscope, an image changing from the hexagonal arrangement to the tetragonal arrangement was observed. Furthermore, when scanning electron microscope observation was performed from the light portion to the dark portion in the light and dark pattern observed with the optical microscope, it was confirmed that the fine structure was formed in all of the light portion, dark portion and their interface portion. Still furthermore, it was observed that the height H and concave-portion opening portion diameter lcct continuously changed also in association with the change of the pitch P' of the fine structure. Particularly, it was confirmed that the height H and concave-portion opening portion diameter lcct decreased as the pitch P' increased.

When the resin mold G2 of No. 3-5 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,650 nm, and the contour of the circular pattern Xa was provided with gradation. Further, when the magnification of the optical microscope was made 50 times, it was observed that the circular patterns Xa formed a group in the shape of a line in one axis direction. That is, the circular patterns Xa of the tetragonal arrangement with the average interval Dave of 1,650 nm were observed inside the line-shaped pattern Xa in one axis direction with the average interval of 15 $\mu$m. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern observed with the optical microscope was formed of the finer fine structure. Particularly, the fine structure was comprised of a plurality of concave portions, and the average pitch P'ave was 330 nm. The arrangement included hexagonal arrangements and tetragonal arrangements with low regularity to skip among these arrangements.

In addition, in observing each of the fine structure surfaces of five cylindrical master molds used in manufacturing the film-shaped resin molds G2 as described above with the optical microscope and scanning electron microscope, the patterns and fine structures were observed which were almost the same as the observation results of the manufactured film-shaped resin molds G2 of No. 3-1 to No. 3-5.

(3) Preparation of sheets for nano-processing

The fine structure surface of the resin mold G2 was coated with a diluent (diluent of a mask layer) of the following material 2. Next, a diluent (diluent of a resist layer) of the following material 3 was applied onto the concavo-convex structure surface of the resin mold G2 with the material 2 included inside the concavo-convex structure, and a sheet for nano-processing was obtained.
Material 2···TTB: 3APTMS: SH710: I.184: I.369=65.2 g: 34.8 g: 5.0 g: 1.9 g: 0.7 g
Material 3···Binding polymer: SR833: SR368: I.184: I.369=77.1 g: 11.5 g: 11.5 g: 1.47 g: 0.53 g
Binding polymer···Methyl ethyl ketone solution of two-dimensional copolymer of benzyl methacrylate 80 mass% and methacrylic acid 20 mass% (solid 50%, weight average molecular weight 56,000, acid equivalent 430, degree of dispersion 2.7)

(2) The material 2 diluted with PGME was directly applied onto the fine structure surface of the resin mold G2 using the same apparatus as in preparation of the resin mold. Herein, the dilution concentration was set so that the solid amount included in the coating raw material (material 2 diluted with PGME) per unit area was smaller than the volume of the fine structure per unit area. More specifically, the inside of the concave portion of the resin mold G2 was filled with the material 2 of 80 nm. After coating, the resultant was passed inside an air-fan oven of 95°C for 5 minutes, and the resin mold G2 with the material 2 included inside the fine structure was wound and collected.

Next, while winding off the resin mold G2 with the material 2 included inside the fine structure, the material 3 diluted with PGME and MEK was directly applied onto the fine structure surface using a die coater. Setting was made so that the distance between the interface between the material 2 arranged inside the concavo-convex structure and the applied material 3 and the surface of the material 3 was 400 nm. After coating, the resultant was passed inside the air-fan oven of 95°C for 5 minutes, wound and collected.

(4) Nano-processing of an optical substrate

Using the prepared sheet for nano-processing, an optical substrate was processed. As the optical substrate, a c-surface sapphire substrate was used.
UV-$O_3$ treatment was performed on the sapphire substrate with 4-inch $\Phi$ to remove particles on the surface, and the surface was made hydrophilic. Next, the material 3 surface of the sheet for nano-processing was bonded to the sapphire substrate. At this point, bonding was performed in a state in which the sapphire substrate was heated to 105°C. Next, using a high-pressure mercury-vapor lamp, light was applied over the resin mold G2 so that the integral light amount was 1,200 mJ/cm$^2$. Subsequently, the resin mold G2 was peeled off.
Etching using oxygen gas was performed from the material 2 surface side of the obtained layered product (layered product comprised of material 2/material 3/substrate), nano-processing was performed on the material 3 by using the material 2 as the mask, and the sapphire substrate surface was partially exposed. The oxygen etching was performed on the conditions of processing pressure of 1Pa and power of 300W. Next, reactive ion etching using a mixed gas of BCl$_3$ gas and argon was performed from the material 2 surface side, and the sapphire was subjected to nano-processing. The etching was performed on the conditions that ICP: 150 W, BIAS: 100 W, and pressure 0.3 Pa, and a reactive ion etching apparatus (RIE-101iPH, made by SAMCO Inc.) was used.
Finally, the resultant was cleaned with a solution obtained by mixing sulfuric acid and hydrogen peroxide solution in a weight ratio of 2:1, and the sapphire substrate provided with the concavo-convex structure on its surface was obtained.
The fine structure surface side of the prepared optical substrate PP was observed with the optical microscope to check the pattern. Further, by enlarging the pattern with the scanning electron microscope, the concavo-convex structure was checked. The results are summarized in Table 4.

[Table 4]

| No. | A | | B | |
| --- | --- | --- | --- | --- |
| | AVERAGE INTERVAL DAVE | ARRANGEMENT | AVERAGE PITCH P'AVE | ARRANGEMENT |
| 4-1 | 1450nm | TETRAGONAL | 300nm | HEXAGONAL |
| 4-2 | 1650nm | LOW MAGNIFICATION: SHAPE OF LINE HIGH MAGNIFICATION: TETRAGONAL | 322nm | TETRAGONAL~ HEXAGONAL |
| 4-3 | 5060nm | SHAPE OF LINE | 460nm | HEXAGONAL |
| 4-4 | 1450nm | LOW MAGNIFICATION: SHAPE OF LINE HIGH MAGNIFICATION: TETRAGONAL | 300nm | HEXAGONAL |
| 4-5 | 1650nm | LOW MAGNIFICATION: SHAPE OF LINE HIGH MAGNIFICATION: TETRAGONAL | 330nm | TETRAGONAL~ HEXAGONAL |

In addition, in Table 4, the column A shows results of observing optical microscope images, and the column B shows results of observing scanning electron microscope images.

Further, observation using laser light was also performed on the optical substrate PP. As the laser light, a green laser with a wavelength of 532 nm was used. The laser light was perpendicularly input to the main surface of the optical substrate PP. Herein, a distance between the input surface and an output portion of the laser light was determined as 50 mm. Meanwhile, a screen was provided in a position that was parallel with the output surface of the optical substrate PP and that was spaced 150 mm apart from the output surface. A pattern of the laser light projected on the screen was observed. In addition, the observation was performed in a dark room. In the following Examples where the number of splits of the laser light is described, the same tests as described herein were carried out.

When the optical substrate of No. 4-1 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,450 nm, and the contour of the circular pattern Xa gradually changed. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,450 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer concavo-convex structure. The concavo-convex structure was formed of a plurality of independent convex portions, the contour of the convex-portion bottom portion was substantially circular, the average pitch P'ave was 300 nm, the arithmetic mean value of the height H was 160 nm, and the convex-portion bottom portion circumscribed circle diameter Φout was 210 nm. Further, it was confirmed that the pitch P' of the concave-convex structure continuously changed with 300 nm as the center, the height H continuously changed with 160 nm as the center, the convex-portion bottom portion diameter continuously changed with 210 nm as the center, and that the average of a large period of the change was 1,450 nm and substantially matched with the average interval Dave of the pattern X observed with the optical microscope. In addition, the maximum value of the height H was 310 nm, and the minimum value thereof was 200 nm. Furthermore, the convex portion was in the shape that the diameter thinned from the convex-portion bottom portion toward the convex-portion vertex portion. Still furthermore, the flat surface was formed in the concave-portion bottom portion. Moreover, it was observed that the height H and convex-portion bottom portion circumscribed circle diameter Φout continuously changed also in association with the change of the pitch P' of the concavo-convex structure. Particularly, it was confirmed that the height H and convex-portion bottom portion circumscribed circle diameter Φout increased as the pitch P' increased. Further, when scanning electron microscope observation was performed from the light portion to the dark portion in the pattern X observed with the optical microscope, it was confirmed that the fine structure was formed in all of the light portion, dark portion and their interface portion. On the other hand, when observation using the above-mentioned laser light was performed, the laser light split, and it was possible to easily confirm a laser output pattern that the light split in five.

When the optical substrate of No. 4-2 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,650 nm, and the contour of the circular pattern Xa changed gradually. Further, it was confirmed that the tetragonally arranged circular patterns Xa formed groups in one axis direction, and were arranged larger in the direction perpendicular to the axis. That is, in the optical microscope image, tetragonally arranged circular patterns Xa were observed microscopically, and a pattern in the shape of lines with low regularity was observed macroscopically, independently of the circular patterns Xa. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 16, in taking some axis, the pattern in which light and dark changed continuously was observed.

Moreover, in observing at magnifications of 5,000 times, 10,000 times and 50,000 times with the scanning electron microscope, it was confirmed that the pattern X observed with the optical microscope was formed of the finer concavo-convex structure (structure in which a plurality of convex portions is arranged). Particularly, the concavo-convex structure was of the arrangement in which the tetragonal arrangement and the hexagonal arrangement were mixed with low regularity. Further the convex portion was in the shape that the diameter thinned from the convex-portion bottom portion toward the convex-portion vertex portion. Furthermore, the flat surface was formed in the concave-portion bottom portion. In addition, the maximum value of the height H was 340 nm, and the minimum value thereof was 230 nm. When more detailed analysis was performed, the concavo-convex structure formed groups with the size of about 1,600 nm to 1,700 nm. That is, the size of the group of the fine structure observed with the scanning electron microscope substantially matched with the size of the circular pattern Xa observed with the optical microscope. Still furthermore, when 50 points were plotted with respect to the period with low regularity and width of the tetragonally arranged portion and hexagonally arranged portion in the scanning electron microscope image, further 50 points were plotted with respect to the interval and width of the line-shaped pattern observed with the optical microscope, and when their matching was checked, matching was confirmed in R2=0.81. Moreover, when scanning electron microscope observation was performed from the light portion to the dark portion in the pattern X observed with the optical microscope, it was confirmed that the fine structure was formed in all of the light portion, dark portion and their interface portion. On the other hand, when observation using the above-mentioned laser light was performed, the laser light split, and it was possible to easily confirm a laser output pattern that the light split in five.

When the optical substrate of No. 4-3 was observed at magnifications of 500 times and 1,000 times with the optical microscope, the pattern X was observed in which first regions Xa lighter than the periphery as a change in light and dark were arranged in the shape of line-and-space. The average interval Dave of the first regions Xa was 5,060 nm. Further, the contour of the first pattern Xa was relatively sharp. Furthermore, also in the case of further increasing the observation magnification to 1,400 times, 2,800 times and 4,900 times, the pattern X was observed. Still furthermore, it was not changed that the first regions Xa were the line-shaped pattern, and the average interval Dave was 5,060 nm. That is, as described in FIG. 14, in taking some axis (in addition, the direction perpendicular to the line-and-space), the regular pattern in which light and dark changed abruptly was observed. Moreover, in observing at magnifications of 5,000 times, 10,000 times and 20,000 times with the scanning electron microscope, it was confirmed that the pattern X observed with the optical microscope was formed of the finer concavo-convex structure. The concavo-convex structure was observed as a hexagonal arrangement of a plurality of convex portions with the average pitch P'ave of 460 nm. In addition, the convex portions were independent of one another. Further, it was confirmed that the pitch P' of the concavo-convex structure continuously changed in a predetermined direction with 460 nm as the center, the height of the concavo-convex structure continuously changed in a predetermined direction with 250 nm as the center, the convex-portion bottom portion diameter of the concavo-convex structure continuously changed in a predetermined direction with 310 nm as the center, and that the average of a large period of the change was 5,060 nm and substantially matched with the average interval Dave of the pattern X observed with the optical microscope. In addition, the maximum value of the height H was 440 nm, and the minimum value thereof was 240 nm. Further, it was observed that the height H and convex-portion bottom portion circumscribed circle diameter Φout continuously changed also in association with the change of the pitch P' of the concavo-convex structure. Particularly, it was confirmed that the height H and convex-portion bottom portion circumscribed circle diameter Φout increased as the pitch P' increased. Furthermore, the convex portion was in the shape that the diameter thinned from the convex-portion bottom portion toward the convex-portion vertex portion. Still furthermore, the flat surface was formed in the concave-portion bottom portion. Moreover, when scanning electron microscope observation was performed from the light portion to the dark portion in the pattern X observed with the optical microscope, it was confirmed that the fine structure was formed in all of the light portion, dark portion and their interface portion. On the other hand, when observation using the above-mentioned laser light was performed, the laser light split, and it was possible to easily confirm a laser output pattern that the light split in three.

When the optical substrate of No. 4-4 was observed at magnifications of 500 times and 1,000 times with the optical microscope, the pattern X was observed in which first regions Xa lighter than the periphery as a change in light and dark were tetragonally arranged. The first regions Xa were circular patterns Xa with the average interval Dave of 1,450 nm, and the contour of the circular pattern Xa was provided with gradation. Further, when the magnification of the optical microscope was made 50 times, it was observed that the circular patterns Xa observed as a tetragonal arrangement formed a group in the shape of a line in one axis direction. That is, the circular patterns Xa of the tetragonal arrangement with the average interval Dave of 1,450 nm were observed inside the line-shaped arrangement in one axis direction with the average interval of 15 $\mu$m. In addition, it was almost not possible to observe the circular pattern at magnifications at which the line-shaped pattern was capable of being observed. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,450 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer concavo-convex structure. Particularly, it was confirmed that the concavo-convex structure was formed of a plurality of convex portions, the average pitch P'ave was 300 nm, the convex-portion bottom portion circumscribed circle diameter Φout was 240 nm, the arithmetic mean value of the height H was 200 nm, and that the arrangement was the hexagonal arrangement. Further, the convex portion was in the shape that the diameter thinned from the convex-portion bottom portion toward the convex-portion vertex portion. Furthermore, the flat surface was formed in the concave-portion bottom portion. Still furthermore, when the interface portion of the line-shaped pattern observed in observation at low magnifications of the optical microscope was observed with the scanning electron microscope, an image changing from the hexagonal arrangement to the tetragonal arrangement was observed. Moreover, it was observed that the height H and convex-portion bottom portion circumscribed circle diameter Φout continuously changed also in association with the change of the pitch P' of the concavo-convex structure. Particularly, it was confirmed that the height H and convex-portion bottom portion circumscribed circle diameter Φout increased as the pitch P' increased. Moreover, when scanning electron microscope observation was performed from the light portion to the dark portion in the pattern X observed with the optical microscope, it was confirmed that the fine structure was formed in all of the light portion, dark portion and their interface portion. On the other hand, when observation using the above-mentioned laser light was performed, the laser light split, and it was possible to easily confirm a laser output pattern that the light split in nine.

When the optical substrate of No. 4-5 was observed at magnifications of 500 times and 1,000 times with the optical microscope, first regions Xa lighter than the periphery as a change in light and dark were observed. The first regions Xa were circular patterns Xa with the average interval Dave of 1,650 nm, and the contour of the circular pattern Xa was provided with gradation. Further, when the magnification of the optical microscope was made 50 times, it was observed that the circular patterns Xa observed as a tetragonal arrangement formed a group in the shape of a line in one axis direction. That is, the circular patterns Xa of the tetragonal arrangement with the average interval Dave of 1,650 nm were observed inside the line-shaped arrangement in one axis direction with the average interval of 15 $\mu$m. Further, portions were confirmed in which the luminance was different between some circular pattern Xa and another circular pattern Xa. Furthermore, also in the case of further increasing the observation magnification to 1,400 times, 2,800 times and 4,900 times, the pattern X was observed. Still furthermore, it was not changed that the first region Xa was the substantially circular pattern, and that the average interval Dave was 1,650 nm. That is, as described in FIG. 16, in taking some axis, the pattern in which light and dark changed continuously was observed. Moreover, in observing at magnifications of 5,000 times, 10,000 times and 50,000 times with the scanning electron microscope, it was confirmed that the pattern X observed with the optical microscope was formed of the finer concavo-convex structure. Particularly, the concavo-convex structure was formed of a plurality of convex portions, the average pitch P'ave was 330 nm, the convex-portion bottom portion circumscribed circle diameter Φout was 150 nm, and the arithmetic mean value of the height H was 150 nm. The arrangement included hexagonal arrangements and tetragonal arrangements with low regularity to skip among these arrangements. Further, the convex portion was in the shape that the diameter thinned from the convex-portion bottom portion toward the convex-portion vertex portion. Furthermore, the flat surface was formed in the concave-portion bottom portion. On the other hand, when observation using the above-mentioned laser light was performed, the laser light split, and it was possible to easily confirm a laser output pattern that the light split in five.

(5) Preparation of semiconductor light emitting devices

On the obtained sapphire substrate, by MOCVD, layered successively were (1) an AlGaN low-temperature buffer layer, (2) an n-type GaN layer, (3) an n-type AlGaN clad layer, (4) an InGaN light emitting semiconductor layer (MQW), (5) a p-type AlGaN clad layer, (6) a p-type GaN layer, and (7) an ITO layer. Concavities and convexities on the sapphire substrate were embedded in layering (2) the n-type GaN layer, and the flattened deposition condition was made. Further, etching processing was performed, and electrode pads were attached.

In this state, using a probe, a current of 20 mA was passed between the p electrode pad and the n electrode pad, and light emission output was measured.

[Comparative Examples 1 to 3]

As Comparative Examples, three types of optical substrate were prepared, and using the optical substrates, the semiconductor light emitting device was prepared as described above, and light emission output was measured. The optical substrates used in the Comparative Examples are summarized in Table 5.

[Table 5]

| No. | A | | B | |
|---|---|---|---|---|
| | AVERAGE INTERVAL DAVE | ARRANGEMENT | AVERAGE PITCH P'AVE | ARRANGEMENT |
| 5-1 | - | - | 300nm | HEXAGONAL |
| 5-2 | 1500nm | HEXAGONAL | 1500nm | HEXAGONAL |
| 5-3 | - | - | - | - |

In addition, in Table 5, the column A shows results of observing optical microscope images, and the column B shows results of observing scanning electron microscope images.

Comparative Example 1 is No. 5-1 of Table 5, and was a sapphire substrate where a plurality of convex portions was hexagonally arranged with the average pitch P'ave of 300 nm. The plurality of convex portions was mutually independent, and when 10 points were arbitrarily selected inside the sapphire surface and were observed at magnifications of 5,000 times, 10,000 times and 50,000 times with the scanning electron microscope, the arrangement of the concavo-convex structure with a substantially hexagonal arrangement was observed in any of portions. Further, in observing at magnifications of 50 times, 500 times and 1,000 times, the pattern was not observed, and images of almost the same color were projected. On the other hand, when observation using the above-mentioned laser beam was performed, split of the laser light was not observed, and only one light point was projected on the screen.

Comparative Example 2 is No. 5-2 of Table 5, and was a sapphire substrate where a plurality of convex portions was arranged with the average pitch P'ave of 1,500 nm. Further, the average intervals Dave observed at magnifications of 500 times and 1,000 times were also 1,500 nm. That is, any finer concave-convex structure was not observed even in enlarging the pattern observed with the optical microscope. On the other hand, when observation using the above-mentioned laser light was performed, the laser light split, and it was possible to easily confirm a laser output pattern that the light split in nine.

Comparative Example 3 was a sapphire substrate provided with neither the concavo-convex structure nor the pattern, and is No. 5-3 of Table 5. When observation using the above-mentioned laser light was performed, split of the laser light was not observed, and only one light point was projected on the screen.

Table 6 describes the internal quantum efficiency IQE and the intensity ratio that is a light emission output ratio. In addition, the intensity ratio was normalized with Comparative Example 3 (No. 5-3 in Table 5) as 1. Further, the internal quantum efficiency IQE was determined from PL intensity. The internal quantum efficiency IQE is defined as (the number of photons emitted from the light emitting semiconductor layer per unit time/the number of electrons injected into the semiconductor light emitting device per unit time). In the present description, as an indicator to evaluate the above-mentioned internal quantum efficiency IQE, (PL intensity measured at 300K/PL intensity measured at 10K) was adopted.

[Table 6]

| No. | IQE | INTENSITY RATIO |
|---|---|---|
| 4-1 | 91% | 1.38 |
| 4-2 | 89% | 1.41 |
| 4-3 | 82% | 1.42 |
| 4-4 | 92% | 1.36 |
| 4-5 | 87% | 1.42 |
| 5-1 | 90% | 1.32 |

(continued)

| No. | IQE | INTENSITY RATIO |
|-----|-----|-----------------|
| 5-2 | 67% | 1.27 |
| 5-3 | 52% | 1.00 |

The following description is understood from Table 6. First, from Comparative Example 2 (No. 5-2 of Table 5), the internal quantum efficiency IQE is increased by providing the concavo-convex structure of nano-order. The reason is presumed that growth of the first semiconductor layer was disturbed and that dislocations were dispersed, and the dislocation density actually measured with a transmission electron microscope was decreased by one digit or more as compared with Comparative Example 3 (No. 5-3 of Table 5). Next, from Comparative Example 1 (No. 5-1 of Table 5), it is understood that the light emission output ratio is not improved significantly due to only the concavo-convex structure of nano-order. The reason is presumed that in the case of the concavo-convex structure of nano-order, the effective medium approximation action works strongly, optical scattering properties are thereby weakened, and that increases in light extraction efficiency LEE is limited. On the other hand, in No. 4-1 to 4-5 of Table 4 of the Examples, it is understood that the internal quantum efficiency IQE increases and that the light emission output ratio also increases. The reason is conceivable that the internal quantum efficiency IQE is increased by the concavo-convex structure of nano-order, light scattering properties are also improved by the pattern X that is an optical pattern drawn by sets of the concavo-convex structure, and that the light extraction efficiency LEE is thereby improved. Further, in No. 4-1 to 4-5 of Table 4 of the Examples, the order of the observed pattern X is not reflected in the structure in the thickness direction of the optical substrate, the pattern X is a pattern that does not exist as an entity, and therefore, irrespective of the deposition conditions of the first semiconductor layer, it was possible to suppress cracks and decrease the thickness of the first semiconductor layer. On the other hand, in Comparative Example 2 (No. 5-2 of Table 5), depending on the decomposition conditions of the first semiconductor layer, cracks occurred, and it was difficult to manufacture an excellent LED. By comparing between Examples, it is understood that the light emission output ratio is large when larger arrangement and pattern made by the pattern X exit. This is because the fact that such observation is made means that optical scattering properties ware developed due to a plurality of modes. That is, it is presumed that the optical scattering properties are strengthened, and that the effect of disturbing the waveguide mode is increased.

From the above-mentioned Examples, it turned out that by the fact that the optical pattern is observed with the optical microscope and that the optical pattern is made of a finer fine concavo-convex structure, it is possible to concurrently improve the internal quantum efficiency IQE and the light extraction efficiency LEE, and it is also possible to reduce the occurrence of cracks in the semiconductor crystal layer, and to decrease the deposition amount (time) of the semiconductor crystal layer. Herein, the average pitch P'ave and height H of the concavo-convex structure were further examined.

(Effect of average pitch P'ave)

The laser pulse pattern was changed in manufacturing the cylindrical master mold, and the average pitch P'ave of the concavo-convex structure was set as a parameter. Herein, the pitch of a sine curve was set at 14 times the pitch P' of the concavo-convex structure and fixed, so that the pitch P' of the concavo-convex structure changed by multiplying by the sine curve.

From the prepared cylindrical master mold, as in the above-mentioned Example, the sheet for nano-processing was manufactured to process the optical substrate. Optical microscope observation and scanning electron microscope observation was performed on the manufactured optical substrate PP, and the following optical patterns were observed.

The magnification of the optical microscope varied with the average pitch P'ave of the concavo-convex structure, and there were sharply observed regions within a range of 500 times to 1,500 times. The observed optical pattern was the pattern X in which first regions Xa lighter than the periphery as a change in light and dark were tetragonally arranged. The average interval Dave of the first regions Xa was observed as the size 13.5 to 14.5 times the average pitch P'ave of the concavo-convex structure. Further, also in the case of increasing the magnification of the optical microscope to 2,800 times and 4,200 times, the similar pattern X was observed. The contour of the circular pattern Xa was provided with gradation. Furthermore, although the luminance was somewhat different between some circular pattern Xa and another circular pattern Xa, the patterns were observed as substantially uniform circular patterns. That is, as described in FIG. 15, in taking some axis, the pattern in which light and dark changed continuously was observed. Still furthermore, in observing at magnifications of 5,000 times, 10,000 times and 50,000 times with the scanning electron microscope, it was confirmed that the pattern X observed with the optical microscope was formed of the finer concavo-convex structure. In addition, it was confirmed that the arrangement of the concavo-convex structure was a hexagonal arrangement.

Further, the convex portion was in the shape that the diameter thinned from the convex-portion bottom portion toward the convex-portion vertex portion, and was of structure that the flat surface was formed in the concave-portion bottom portion without the flat surface being in the convex-portion vertex portion. Furthermore, when scanning electron microscope observation was performed from the light portion to the dark portion in the light and dark pattern X observed with the optical microscope, it was confirmed that the fine structure was formed in all of the light portion, dark portion and their interface portion. On the other hand, when observation using the above-mentioned laser beam was performed, the laser light split, and it was possible to confirm a laser output pattern that the light split in 5 to 13 that differed corresponding to the concavo-convex structure of the optical substrate.

LEDs were assembled as in the above-mentioned Example, and efficiency was compared. The results are described in Table 7.

First, it is understood that the internal quantum efficiency IQE increases when the average pitch P'ave of the concavo-convex structure decreases to nano-order. The reason is presumed that the density of the concavo-convex structure approaches the dislocation density of the semiconductor crystal layer when the average pitch P'ave is about 1,500 nm or less, and that it is thereby possible to disperse and reduce dislocations. Particularly, when the average pitch P'ave is 900 nm or less, since there is a tendency that the concavo-convex structure density is higher than the dislocation density of the semiconductor crystal layer, it is considered that the effect is promoted. This was judged also from cross-sectional observation of the optical substrate using the transmission electron microscope. More specifically, from transmission electron microscope observation, when the average pitch P'ave was 1,500 nm or less, about one to four dislocations occurred from a single concave portion. Meanwhile, when the average pitch P'ave was 900 nm or less, only one to two dislocations occurred from a single concave portion. Next, attention is directed toward the intensity ratio. In addition, the intensity ratio was normalized with No. 7-9 of the lowest efficiency as 1. It is understood that the intensity ratio significantly increases with the average pitch P'ave of 900 nm as the boundary. It is presumed to develop by combination of the light diffraction action of the concavo-convex structure itself and the light scattering action due to the optical pattern, in addition to increases in internal quantum efficiency IQE. From the foregoing, it is possible to judge that the average pitch P'ave of the concavo-convex structure of the optical substrate is more preferably 900 nm or less.

[Table 7]

|  | AVERAGE PITCH P' AVE/nm | IQE | INTENSITY RATIO |
|---|---|---|---|
| 7-1 | 200 | 92% | 1.38 |
| 7-2 | 300 | 91% | 1.59 |
| 7-3 | 500 | 88% | 1.41 |
| 7-4 | 700 | 85% | 1.42 |
| 7-5 | 900 | 81% | 1.38 |
| 7-6 | 1100 | 71% | 1.15 |
| 7-7 | 1300 | 69% | 1.14 |
| 7-8 | 1500 | 60% | 1.12 |
| 7-9 | 2000 | 56% | 1.00 |
| 7-10 | 3000 | 52% | 1.03 |

(Effect of height H)

The laser pulse intensity was changed in manufacturing the cylindrical master mold, and the depth (height) of the concavo-convex structure was set as a parameter. Herein, the pitch of a sine curve was set at 3,500 nm, so that the pitch P' of the concavo-convex structure changed by multiplying by the sine curve.

From the prepared cylindrical master mold, as in the above-mentioned Example, the sheet for nano-processing was manufactured to process the optical substrate. Optical microscope observation and scanning electron microscope observation was performed on the manufactured optical substrate, and the following optical patterns were observed.

The magnification of the optical microscope was varied in a range of 500 times, 1,400 times, 2,800 times and 4,900 times, and at any of the magnifications, the circular pattern Xa was observed. The average interval Dave of the circular pattern Xa was 3,500 nm. The observed optical pattern Xa was the pattern in which first regions Xa lighter than the periphery as a change in light and dark were tetragonally arranged. Further, the contour of the circular pattern Xa was provided with gradation. Furthermore, although the luminance was somewhat different between some circular pattern Xa and another circular pattern Xa, the patterns were observed as substantially uniform circular patterns. That is, as described in FIG. 15, in taking some axis, the pattern in which light and dark changed continuously was observed. Still furthermore, in observing at magnifications of 5,000 times, 10,000 times and 50,000 times with the scanning electron microscope, it was confirmed that the pattern X observed with the optical microscope was formed of the finer concavo-convex structure. In addition, it was confirmed that the arrangement of the concavo-convex structure was a hexagonal arrangement. Moreover, the convex portion was in the shape that the diameter thinned from the convex-portion bottom portion toward the convex-portion vertex portion, and was of structure that the flat surface was formed in the concave-portion bottom portion without the flat surface being in the convex-portion vertex portion. The average pitch P'ave of the convex portion was 700 nm. Further, when scanning electron microscope observation was performed from the light portion to the dark portion in the pattern X observed with the optical microscope, it was confirmed that the fine structure was formed in all of the light portion, dark portion and their interface portion. On the other hand, when observation using the above-mentioned laser beam was performed, the laser light split, and it was possible to confirm a laser output pattern that the light split in five.

LEDs were assembled as in the above-mentioned Example, and efficiency was compared. The results are described in Table 8.

First, it is understood that the internal quantum efficiency IQE increase as the height H of the concavo-convex structure decreases. The reason is conceivable that deposition properties of the semiconductor crystal layer are more stable as the height H of the concavo-convex structure decreases in comparison inside the region where the density of the concavo-convex structure is high. Particularly, the internal quantum efficiency IQE increases significantly with the height H of 1,000 nm as the boundary. When surface roughness was evaluated with the atomic force microscope after depositing the first semiconductor layer while fixing the deposition time of the semiconductor crystal layer, the surface roughness differed by two times between the case where the height H was 1,300 nm and the case where the height H was 1,000 nm, and was smoother in the case where the height H was 1,000 nm. It is presumed that the film quality of the light emitting semiconductor layer and the second semiconductor layer was made excellent caused by the excellent flatness and that the internal quantum efficiency IQE was improved. From the foregoing, it is possible to judge that the height H is more preferably 1,000 nm or less. Next, attention is directed toward the intensity ratio. In addition, the intensity ratio was normalized with No. 8-5 of the lowest efficiency as 1. As in the case of the internal quantum efficiency IQE, it is understood that the intensity ratio significantly increases with the height H of 1,000 nm as the boundary. This is mainly affected by increases in internal quantum efficiency IQE. On the other hand, it is understood that the intensity ratio further increases when the height is 500 nm. The reason is presumed that light diffraction is made moderate, a difference in light and dark of the pattern X drown by the concavo-convex structure increases, and that the extent of disturbing the waveguide mode is increased. From the foregoing, it is possible to judge that the height H is most preferably 500 nm or less.

[Table 8]

|  | HEIGHT H/nm | IQE | INTENSITY RATIO |
|---|---|---|---|
| 8-1 | 500 | 88% | 1.49 |
| 8-2 | 700 | 87% | 1.38 |
| 8-3 | 900 | 79% | 1.33 |
| 8-4 | 1000 | 71% | 1.31 |
| 8-5 | 1300 | 62% | 1.00 |

Next, the relationship between the optical pattern and the number of splits of laser beam was briefly examined. The split of laser beam is a phenomenon developed in the case where the effective refractive index Nema functions as a diffraction grating. Accordingly, the presence or absence of splits of laser beam was set as a parameter by controlling periodicity with respect to modulation of the pitch in manufacturing the cylindrical master mold. Sapphire substrates were processed by the same techniques as described above. The processed sapphires were the following three kinds.

Optical substrate 1. The average pitch P'ave of the concavo-convex structure observed with the scanning electron microscope was 300 nm. Circular patterns Xa were confirmed by optical microscope observation of 500 times and 1,400 times. The average interval Dave of the circular patterns Xa was 4,200 nm. The first regions Xa in the pattern X were almost circular in the outside shape and were tetragonally arranged. The number of splits of laser beam was 5.

Optical substrate 2. The average pitch P'ave of the concavo-convex structure observed with the scanning electron microscope was 300 nm. Substantially circular patterns Xa were confirmed by optical microscope observation of 500 times and 1,400 times. Regularity was not observed in the arrangement of first regions Xa in the pattern X, and the arrangement was random. Splits of laser beam were not observed.

Optical substrate 3. The average pitch P'ave of the concavo-convex structure observed with the scanning electron microscope was 4,200 nm. Substantially circular patterns Xa were confirmed by optical microscope observation of 500 times and 1,400 times. The size of the first region Xa in the pattern X was almost the same as the size of the convex portion of the concavo-convex structure observed with the scanning electron microscope. The number of splits of laser beam was 9.

Semiconductor light emitting devices were manufactured using the above-mentioned optical substrates 1. to 3. to compare their efficiency. First, for the internal quantum efficiency IQE, the optical substrate 1. and the optical substrate 2. were approximately 90%, and were the same. On the other hand, it was found out that the efficiency IQE was 60% in the optical substrate 3. and was extremely low. Next, in calculating the light extraction efficiency LEE from the light emission output and the internal quantum efficiency IQE to compare, it was understood that the efficiency LEE was higher in the order of the optical substrate 3., optical substrate 2. and optical substrate 1. Finally, the light emission output was more excellent in the order of the optical substrate 2, optical substrate 1. and optical substrate 3. That is, it was understood that the best efficiency is obtained in the case where the pattern x is observed with the optical microscope, and is made by a difference in the element of the concavo-convex structure observed with the scanning electron microscope, and splits of laser beam are observed. First, the concavo-convex structure observed with the scanning electron microscope is the physical structure existing as an entity. Then, the fact that the order of the pattern X observed with the optical microscope is larger than the order of the concavo-convex structure observed with the scanning electron microscope means that the optical pattern is drawn due to the difference in the element of the concavo-convex structure existing as an entity. That is, it means that the large pattern X exists from the viewpoint of light, and that such a large structure does not exist as an entity. Therefore, in the optical substrate 3., it is considered that deposition of the semiconductor crystal layer was not performed excellently due to the effect of the concavo-convex structure as large material substance, cracks occurred, and that the internal quantum efficiency IQE decreased. On the other hand, in the optical substrate 1., it is considered that the structure existing as an entity was the structure of nano-order, the dislocation reducing effect was thereby large in the semiconductor crystal layer, cracks were also suppressed in the semiconductor crystal layer, and that the internal quantum efficiency IQE increased. Then, the split of laser beam is a measure representing intensity of interaction between the light and the pattern X. More specifically, this is the measure of whether the pattern X functions as a random scattering component or diffraction grating with respect to the emitted lith. Particularly, in the diffraction grating made by the pattern X, the grating interface changes gently as compared with a diffraction grating as material substance, and therefore, such a diffraction grating leads to an optical phenomenon such that light diffraction and light scattering is mixed. Accordingly, it is presumed that the light extraction efficiency LEE increases in the case of the presence of splits with respect to the laser beam, as compared with the case of the absence. From the foregoing, it is considered that performance of the semiconductor light emitting devices was higher in the order of the optical substrate 2., optical substrate 1. and optical substrate 3.

(Example 2)

<Optical substrate D>

The optical substrate D provided with the concavo-convex structure D on its surface was prepared, a semiconductor light emitting device (LED) was prepared using the substrate D, and efficiency of LEDs was compared. At this point, the arrangement and shape of the concavo-convex structure were changed to control (standard deviation/arithmetic mean).

As in Example 1, (1) a cylindrical master mold was prepared, and (2) a resin mold was prepared. (3) Then, using the resin mold, a member for nano-processing (sheet for nano-processing) was prepared. Next, (4) using the sheet for nano-processing, a concavo-convex structure was prepared on the surface of the optical substrate. Finally, (5) using the obtained optical substrate D provided with the concavo-convex structure D, a semiconductor light emitting device was prepared, and performance was evaluated. In addition, (standard deviation/arithmetic mean) of the concavo-convex structure D was controlled by the concavo-convex structure of the cylindrical master mold prepared in (1), the light transfer method performed in (3), the sheet for nano-processing prepared in (4) and dry etching.

(1) Preparation of cylindrical master molds

The preparation was performed as in Example 1.

(2) Preparation of resin molds

Resin molds G1 were prepared successively using the prepared cylindrical master mold as a mold by applying the photo nanoimprint method. Next, using the resin mold G1 as a template, resin molds G2 were obtained successively by applying the photo nanoimprint method. The resin molds G1 were prepared as in Example 1 except that the coating film thickness of the material 1 was changed to 5 $\mu$m. The resin molds G2 were prepared as in Example 1 except that the coating film thickness of the material 1 was changed to 3 $\mu$m.

(3) Preparation of sheets for nano-processing

The concavo-convex structure surface of the resin mold G2 was coated with a diluent of the material 2 as described in Example 1. Next, a diluent of the above-mentioned material 3 was applied onto the concavo-convex structure surface of the resin mold G2 with the material 2 included inside the concavo-convex structure, and a sheet for nano-processing was obtained.

(2) The material 2 diluted with PGME was directly applied onto the concavo-convex structure surface of the resin mold G2 using the same apparatus as in preparation of the resin mold. Herein, the dilution concentration was set so that the solid amount included in the coating raw material (material 2 diluted with PGME) per unit area was smaller than the volume of the concavo-convex structure per unit area by 20% or more. After coating, the resultant was passed inside an air-fan oven of 80°C for 5 minutes, and the resin mold G2 with the material 2 included inside the concavo-convex structure was wound and collected.

Next, while winding off the resin mold G2 with the material 2 included inside the concavo-convex structure, the material 3 diluted with PGME and MEK was directly applied onto the concavo-convex structure surface using the same apparatus in (2) preparation of the resin mold. Herein, the dilution concentration was set so that the distance between the interface between the material 2 arranged inside the concavo-convex structure and the applied material 3 and the surface of the material 3 was 400 nm to 800 nm. After coating, the resultant was passed inside the air-fan oven of 80°C for 5 minutes, a cover film comprised of polypropylene was bonded to the surface of the material 3, and the resultant was wound and collected.

(4) Nano-processing of an optical substrate

Using the prepared sheet for nano-processing, an optical substrate was processed. As the optical substrate, a c-surface sapphire substrate was used.

UV-$O_3$ treatment was performed on the sapphire substrate with 2-inch $\Phi$ to remove particles on the surface, and the surface was made hydrophilic. Next, the material 3 surface of the sheet for nano-processing was bonded to the sapphire substrate. The bonding pressure was 0.3 MPa, and the bonding velocity was 50 mm/sec. At this point, bonding was performed in a state in which the sapphire substrate was heated to 80°C and the temperature of the bonding roller surface was 105°C. Next, using the high-pressure mercury-vapor lamp, light was applied over the resin mold G2 so that the integral light amount was 1,200 mJ/cm$^2$. Subsequently, the resin mold G2 was peeled off.

Etching using oxygen gas was performed from the material 2 surface side of the obtained layered product (layered product comprised of material 2/material 3/substrate), nano-processing was performed on the material 3 by using the material 2 as the mask, and the sapphire substrate surface was partially exposed. The oxygen etching was performed on the conditions of processing pressure of 1Pa and power of 300W. Next, reactive ion etching using $BCl_3$ gas was performed from the material 2 surface side, and the sapphire was subjected to nano-processing. The etching using $BCl_3$ was performed on the conditions that ICP: 150 W, BIAS: 500 W, and pressure 0.2 Pa, and the reactive ion etching apparatus (RIE-101iPH, made by SAMCO Inc.) was used.

Finally, the resultant was cleaned with a solution obtained by mixing sulfuric acid and hydrogen peroxide solution in a weight ratio of 2:1, and the sapphire substrate provided with the concavo-convex structure on its surface was obtained. In addition, the shape of the concavo-convex structure prepared on the sapphire substrate was mainly controlled by the filling rate of the material 2 and the film thickness of the material 3 of the sheet for nano-processing.

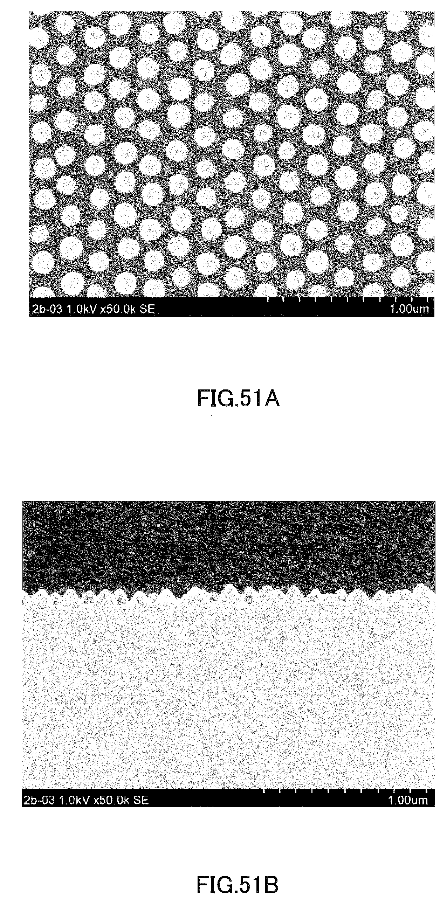

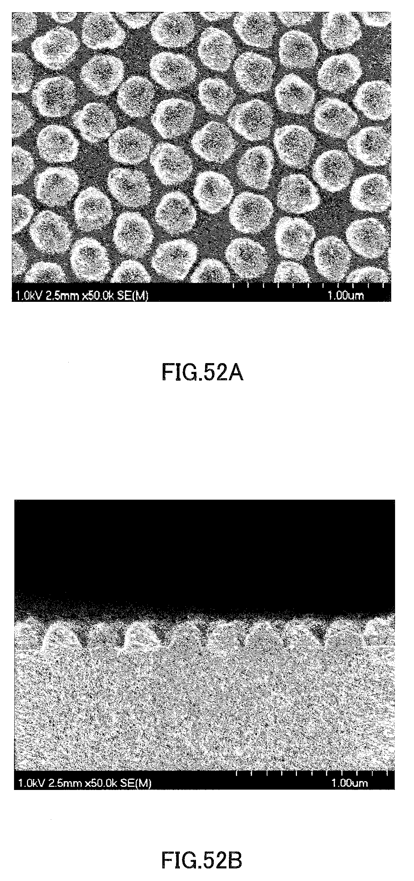

The shape of the concavo-convex structure prepared on the surface of the sapphire surface was controlled as appropriate by the shape of the concavo-convex structure prepared on the cylindrical master mold, the nip pressure condition in manufacturing the resin mold, and the processing condition of dry etching. FIGs. 51 and 52 are scanning electron microscope photographs showing the concavo-convex structure of the optical substrate D prepared in the Examples of the present invention. FIG. 51 shows the case where the average pitch P'ave is 200 nm, FIG. 51A shows a surface image, and FIG. 51B shows a cross-sectional image.

From FIG. 51, it is understood that a plurality of substantially cone-shaped convex portions is arranged while being spaced apart from one another on the sapphire substrate. From the surface image of FIG. 51A, it is understood that the main distributions are the convex-portion bottom portion circumscribed circle diameter $\Phi$out and the ratio between the convex-portion bottom portion circumscribed circle diameter $\Phi$out and the convex-portion bottom portion inscribed circle diameter $\Phi$in. Particularly, the shape of the convex-portion bottom portion circumscribed circle is substantially circular, and as shown in the following Table 9, the coefficient of variation with respect to convex-portion bottom portion circumscribed circle diameter Φout/convex-portion bottom portion inscribed circle diameter Φin was small. Further, from the cross-sectional image of FIG. 51B, it is understood that variations occur in the distributions of the height H of the convex portion and the inclination angle of the convex-portion side surface, i.e. specific portions are included which are comprised of convex portions having the height H of the convex portion and the inclination angle of the convex-portion side surface different from those of the other portions. Particularly, it was confirmed that the convex-portion bottom portion circumscribed circle diameter Φout was large when the height H was high, while being small when the height H was low. As a result of obtaining the coefficient of variation with respect to each element, it was understood that the distribution of the convex-portion bottom portion circumscribed circle diameter Φout was particularly large. In addition, it was also confirmed that the flat surface was prepared in the concave-portion bottom portion.

On the other hand, FIG. 52 shows the case where the average pitch P'ave is 300 nm, FIG. 52A shows a surface image, and FIG. 52B shows a cross-sectional image. From FIG. 52, it is understood that a plurality of substantially cone-shaped convex portions is arranged while being spaced apart from one another on the sapphire substrate, and that the inclination angle of each convex-portion side surface changes in two stages. From the surface image of FIG. 52A, it is understood that the contour shape of the convex-portion bottom portion is far from a perfect circle, and that the counter has a plurality of inflection points. Further, it is also understood that portions occur where the convex-portion height is partially low or the convex portion is not present partially. These portions are portions in which the portion prepared as the concavo-convex structure of the resin mold was transfer-formed by controlling the nip pressure in manufacturing the resin mold. Furthermore, from the cross-sectional image of FIG. 52B, it was also confirmed that there is the distribution in the position of the vertex portion of the convex portion. That is, with attention directed toward the contour of the convex-portion bottom portion circumscribed circle, there was the case where the vertex existed in the center, and another case also coexisted where the position of the vertex was not in the center of the contour of the convex-portion bottom portion circumscribed circle. This is because of exploiting the phenomenon that the resist layer thermally vibrates using heat generated in the dry etching step.

Table 9 shows a summary of results obtained by observing the obtained sapphire substrates with the scanning electron microscope as described above.

(5) Preparation of semiconductor light emitting devices

The preparation was performed as in Example 1. Light emission output was evaluated with output in the case of using the sapphire substrate without being provided with the concavo-convex structure of No. 9-7 of Table 9 as 1. In addition, in Table 9, No. 9-6 and No. 9-7 are Comparative Examples.

[Table 9]

| | AVERAGE PITCH P'AVE | STANDARD DEVIATION/ARITHMETICAL MEAN | | | | LIGHT EMISSION |
|---|---|---|---|---|---|---|
| | | PITCH P' | $\phi$ out | $\phi$ out/ $\phi$ in | HEIGHT H | |
| 9-1 | 200nm | 0.006 | 0.094 | 0.060 | 0.041 | 1.20 |
| 9-2 | 200nm | 0.071 | 0.102 | 0.054 | 0.068 | 1.40 |
| 9-3 | 300nm | 0.009 | 0.036 | 0.111 | 0.043 | 1.35 |
| 9-4 | 300nm | 0.009 | 0.047 | 0.064 | 0.285 | 1.50 |
| 9-5 | 300nm | 0.067 | 0.112 | 0.061 | 0.219 | 1.55 |
| 9-6 | 200nm | 0.010 | 0.011 | 0.025 | 0.020 | 1.10 |
| 9-7 | - | - | - | - | - | 1.00 |

As can be seen from Table 9, it is understood that the light emission output increases in the case (No. 9-6, Nos. 9-1 to 9-5) of using the sapphire substrate provided with the concavo-convex structure, as compared with the case (No. 9-7) of using the sapphire substrate without being provided with the concavo-convex structure. No. 9-6 that is the Comparative Example shows the sapphire substrate in which the average pitch P'ave is 200 nm and a plurality of convex portions is arranged in a hexagonal closest packing arrangement. In this case, it is understood that the light emission output hardly increases. The reason is conceivable that since the average pitch P'ave is 200 nm and minute, the dislocation density decreases to increase the internal quantum efficiency IQE, and that since the concavo-convex structure is too minute, the light extraction efficiency LEE hardly increases. In addition, it was observed that the dislocation density was significantly decreased by one digit or more by transmission electron microscope observation. Next, No.

9-1 and No. 9-6 are the case where the average pitch P'ave is the same and the distribution of the concavo-convex structure caused by the convex-portion shape is increased. In the case of No. 9-1, it is understood that the light emission output increases as compared with No. 9-6. As the reason, it is possible to consider that the effect of disturbing the waveguide mode is added due to the scattering component corresponding to the disturbances of the concavo-convex structure caused by the convex-portion shape. In addition, when the concavo-convex structures of No. 9-1 and No. 9-6 were transferred to films and the haze was measured, it was confirmed that the haze was larger by about 1.5 time in the concavo-convex structure of No. 9-1. Since No. 9-1 and No. 9-6 are the case where the average pitch P'ave is 200 nm and the arrangement is the hexagonal closest packing arrangement, it is possible to consider that this increase in the haze is the effect of scattering due to the disturbances. In No. 9-1 and No. 9-2, the average pitch P'ave is similarly 200 nm, and the distribution of the pitch is different. In No. 9-2, the pitch P' is changed between 180 nm and 220 nm by multiplying by a sine curve. The wavelength of the sine curve is 2,800 nm. The modulation of the pitch P' appears as the distribution of the pitch. In No. 9-1 and 9-2, since the average pitch P'ave is the same, it is possible to consider that the effect of the concavo-convex structure exerted on the internal quantum efficiency IQE is almost the same. Accordingly, it is conceivable that the increase in the light emission output is the effect of scattering developed by the distribution of the pitch. No. 9-3 is the case where the average pitch P'ave is 300 nm and the arrangement is made in hexagonal closest packing. In the concavo-convex structure of No. 9-3, Φout/Φin has a large value. This is due to the fact that the contour of the convex-portion bottom portion was significantly distorted, as illustrated in FIG. 52. As the reason why the light emission output of No. 9-3 is larger than that of No. 9-1, it is conceivable that light scattering properties were provided due to a large disturbance of the concavo-convex structure caused by the convex-portion shape, and that the average pitch P'ave was increased. In examining the effect on the internal quantum efficiency produced by the average pitch P'ave, it was confirmed that a decrease in internal quantum efficiency IQE was remarkable from the point at which the average pitch P'ave exceeded 350 nm. That is, it is possible to consider that the effect on the light extraction efficiency LEE due to an increase in the average pitch P'ave is large, as compared with the effect of the internal quantum efficiency IQE that decreases by the average pitch P'ave increasing from 200 nm to 300 nm. Further, as the reason why the light emission output is smaller in No. 9-3 than in No. 9-2, it is presumed that the effect of disturbing the waveguide mode is small because the disturbances of the concavo-convex structure is larger in No. 9-2. No. 9-4 is the case where the average pitch P'ave is 300 nm, and fluctuations in the distribution of the height of the convex portion are larger than in No. 9-3. This was achieved by preparing the structure with convex portions lost partially. It is conceivable that sine the concavo-convex structure of NO. 9-4 has a large disturbance in the height, the scattering component corresponding to the disturbances is large, and that the waveguide mode is thereby effectively disturbed. Further, in No. 9-5, the distribution is added to the pitch with respect to No. 9-4. The distribution of the pitch P'ave was set at the distribution between 270 nm and 330 nm, and was made by multiplying by a sine curve. The wavelength of the sine curve was 1,200 nm. As compared with No. 9-4, since the effect of the distribution of the pitch is added, it is understood that the light emission output is more increased. In addition, in No. 9-2 and No. 9-5, it was possible to obtain the pattern X by optical microscope observation as in Example 1. Further, in performing observation using the laser beam as in Example 1, it was observed that the laser light split in five. In addition, in the optical substrates used in the Examples and Comparative Examples except the above-mentioned two substrates, the optical pattern and split of the laser light was not observed.

(Example 3)

<Optical substrate PC>

(Preparation of a cylindrical master mold)

Used as a substrate of a cylindrical master was a cylindrical quartz glass roll with a diameter of 80 mm and a length of 50 mm. A fine structure (fine concavo-convex structure) was formed on the cylindrical quartz glass roll surface by a direct-write lithography method using a semiconductor pulse laser by the following method.

First, a resist layer is deposited on the fine structure on the quartz glass surface by a sputtering method. The sputtering method was carried out with power of RF 100 W using CuO (containing 8 atm% Si) as a target (resist layer). The film thickness of the resist layer after deposition was 20 nm. The cylindrical mold prepared as described above was exposed on the following conditions while rotating at linear speed s=1.0 m/sec.

Exposure semiconductor laser wavelength: 405 nm
Exposure laser power: 3.5 mV
X-axis direction pitch Px: 398 nm

Variable width $\delta 2$ with respect to the X-axis direction pitch Px: 80 nm
Long period PxL in the X-axis direction of the variable width $\delta 2$: 5 $\mu$m

Y-axis direction pitch Py: 460 nm

Variable width $\delta 1$ with respect to the Y-axis direction pitch Py: 100 nm
Long period PyL in the Y-axis direction of the variable width $\delta 1$: 5 $\mu$m

The Y-axis direction pitch Py is determined as described below.
Time T required for one circumference is measured using a Z-phase signal of a spindle motor as a reference, a circumferential length L is calculated from the linear speed s, and the following equation (14) is obtained.

$$L = T \times s \qquad (14)$$

Assuming a target pitch as Py, a value of 0.1% or less of the target pitch Py is added to adjust so that L/Py is an integer, and an effective pitch Py' is obtained by the following equation (15).

$$L/Py' = m \text{ (m is an integer)} \qquad (15)$$

With respect to the target pitch Py and effective pitch Py', although strictly Py$\neq$Py', since L/Py $\fallingdotseq$ 107, the equation of Py/Py' $\fallingdotseq$ 107 holds, and it is possible to handle so that Py and Py' are substantially equal. Similarly, with respect to the long period PyL, an effective long period PyL' is obtained by the following equation (16) so that L/PyL is an integer.

$$L/PyL' = n \text{ (n is an integer)} \qquad (16)$$

Also in this case, although strictly PyL$\neq$PyL', since L/PyL $\fallingdotseq$ 105, the equation of PyL/PyL' $\fallingdotseq$ 105 holds, and it is possible to handle so that PyL and PyL' are substantially equal.
Next, from the effective pitch Py', a reference pulse frequency fy0 and modulation frequency fyL are calculated by equations (17) and (18).

$$fy0 = s/Py' \qquad (17)$$

$$fyL = s/PyL' \qquad (18)$$

Finally, from the equations (17) and (18), a pulse frequency fy at elapsed time t from the Z-phase signal of the spindle motor is determined as in equation (19).

$$fy = fy0 + \delta 1 \times \sin(t \times (fyL/fy0) \times 2\pi) \qquad (19)$$

An axis feed velocity in the X-axis direction is determined as described below.
The time T required for one circumference is measured using the Z-phase signal of the spindle motor as a reference, and a reference feed velocity Vx0 in the axis direction is determined from the X-axis direction pitch Px as in the following equation (20).

$$Vx0 = Px/T \qquad (20)$$

The axis feed velocity Vx at time t is determined from the long period PxL in the X-axis direction by the following equation (21) and scanning is performed.

$$Vx = Vx0 + V\delta 2 \cdot \sin(Px/PxL \times t \times 2\pi) \qquad (21)$$

Herein, Vδ2 is a velocity variable width in the long period PxL in the X-axis direction, and is expressed with the pitch variable width δ2 of the long period PxL, Px and Vx0 by the following equation (22).

$$V\delta2 = \delta2 \times Vx0/Px \qquad (22)$$

Next, the resist layer was developed. Development of the resist layer was carried out using 0.03 wt% glycine aqueous solution on the condition of treatment time of 240 seconds. Next, using the developed resist layer as a mask, etching of the etching layer was performed by dry etching. Dry etching was carried out using $SF_6$ as an etching gas on the conditions of the treatment gas pressure of 1 Pa, treatment power of 300 W, and treatment time of 5 minutes. Next, only the residual resist layer was peeled off from the cylindrical master provided with the fine structure on the surface on the condition of 6 minutes using hydrochloric acid of pH1 to prepare a cylindrical master mold.

(Preparation of a resin mold)

The obtained cylindrical quartz glass roll surface (mold for transfer) was coated with Durasurf HD-1101Z (made by Daikin Industries, Ltd.), heated at 60°C for 1 hour, and then, allowed to stand at room temperature for 24 hours to fix. Then, cleaning was performed three times using Durasurf HD-ZV (made by Daikin Industries, Ltd.), and mold release treatment was performed.

Next, a resin mold was prepared from the obtained cylinder master mold. DACHP, M350 and I. 184 were mixed in a ratio of 10:100:5 in parts by weight to prepare a photocurable resin. Next, the photocurable resin was coated on the easy adhesion surface of the PET film (A4100, made by Toyobo Co., Ltd.: width 300 mm, thickness 100 $\mu$m) by Micro Gravure coating (made by Yasui Seiki Co., Ltd.) so that the coating film thickness was 6 $\mu$m.

Next, the PET film coated with the photocurable resin was pressed against the cylinder master mold with a nip roll (0.1 MPa), and was irradiated with ultraviolet rays at a temperature of 25°C and humidity of 60% under atmospheric pressure using the UV exposure apparatus (made by Fusion UV Systems Japan Co., Ltd., H bulb) so that the integral amount of exposure below the center of the lamp was 600 mJ/cm$^2$, photo-curing was carried out successively, and obtained was a reel-shaped transparent resin mold (length 200 m, width 300 mm) with the fine structure inversely transferred to the surface.

When the resin mold was observed with the scanning electron microscope, convex portions with the convex-portion bottom portion circumscribed circle diameter Φout of 400 nm and the height H of 800 nm were formed in periodical structure having the following long period structure. Further, it was confirmed that the convex-portion bottom portion circumscribed circle diameter Φout and the height H decreased as the pitch increased.

X-axis direction pitch Px: 398 nm

Variable width δ2 with respect to the X-axis direction pitch Px: 80 nm
Long period PxL in the X-axis direction of the variable width δ2: 5 $\mu$m

Y-axis direction pitch Py: 460 nm

Variable width δ1 with respect to the Y-axis direction pitch Py: 100 nm
Long period PyL in the Y-axis direction of the variable width δ1: 5 $\mu$m

(Electron microscope)
Apparatus; HITACHI S-5500
Acceleration voltage; 10 kV
MODE; Normal

(Preparation of an inversed resin mold)

Next, DACHP, M350 and I.184 were mixed in a ratio of 10:100:5 in parts by weight to prepare a photocurable resin. The photocurable resin was coated on the easy adhesion surface of the PET film (A4100, made by Toyobo Co., Ltd.: width 300 mm, thickness 100 $\mu$m) by Micro Gravure coating (made by Yasui Seiki Co., Ltd.) so that the coating film thickness was 2 $\mu$m.

Next, the PET film coated with the photocurable resin was pressed against the above-mentioned resin mold with the nip roll (0.1 MPa), and was irradiated with ultraviolet rays at a temperature of 25°C and humidity of 60% under atmospheric pressure using the UV exposure apparatus (made by Fusion UV Systems Japan Co., Ltd., H bulb) so that the integral amount of exposure below the center of the lamp was 600 mJ/cm$^2$, photo-curing was carried out successively, and obtained was a transparent resin mold sheet (length 200 mm, width 300 mm) with the fine structure inversely transferred to the surface.

(Nanoimprint lithography)

A mask material was applied onto a C-surface sapphire substrate with Φ2" and a thickness of 0.33 mm by a spin coating method (2,000 rpm, 20 seconds) to form a resist layer. Prepared as the mask material was a coating solution obtained by diluting with propylene glycol monomethyl ether so that the solid content of a photosensitive resin composition was 5 weight%.

(Photosensitive resin composition)

As the photosensitive resin composition, mixed and used were 20 parts by weight of 3-ethyl-3-{[3-ethyloxetane-3-yl)methoxy]methyl} oxetane (OXT-221, made by TOAGOSEI Co., Ltd.), 80 parts by weigh of 3',4'-epoxycyclohexane carboxylic acid 3,4-epoxycyclohexylmethyl (made by Wako Pure Chemical Industries Co., Ltd.), 50 parts by weight of phenoxy diethylene glycol acrylate (Aronix (Registered Trademark) M-101A, made by Toagosei Co., Ltd.), 50 parts by weight of ethylene oxide-modified bisphenol A diacrylate (Aronix (Registered Trademark) M-211B, made by Toagosei Co., Ltd.), 8 parts by weight of DTS-102 (made by Midori Kagaku Co., Ltd.), 1 part by weight of 1,9- dibutoxy anthracene (Anthracure (Registered Trademark) UVS-1331, made by Kawasaki Kasei Chemicals), 5 parts by weight of Irgacure 184 (Registered Trademark) 184 (made by Ciba), and 4 parts by weight of CACHP (solid content of 20%, made by Daikin Industries, Ltd.).

The transparent resin mold sheet was cut in 70 mm x 70 mm (□ 70 mm) and was bonded onto the sapphire substrate with the resist layer formed. For bonding, used was a sheet lamination machine (TMS-S2) made by Sun-Tec Co., Ltd. and lamination was performed with lamination nip force of 90 N and lamination velocity of 1.5 m/s. Next, laminated integrated transparent resin mold/resist layer/sapphire substrate was sandwiched between two transparent silicone plates (hardness 20) of □ 70 mm x t 10 mm. In this state, using a nanoimprint apparatus (EUN-4200) made by Engineering System Co., Ltd., the resultant was pressed with a pressure of 0.05 MPa. In the pressed state, ultraviolet rays were applied from the transparent resin mold side with 2,500 mJ/cm$^2$ to cure the resist layer. After curing, the transparent silicone plates and transparent resin mold were removed to obtain a resist/sapphire layered product with the pattern formed on the C-surface.

(Etching)

Using the reactive ion etching apparatus (RIE-101iPH, made by SAMCO Inc.), the sapphire was etched on the following etching conditions.

Etching gas: $Cl_2/(Cl_2+BCl_3)=0.1$
Gas flow rate: 10 sccm
Etching pressure: 0.1 Pa
Antenna: 50 w
Bias: 50 w

After etching, when the cross section and surface structure of the sapphire substrate were observed with the electron microscope, a two-dimensional photonic crystal having a period of 5 μm comprised of a nano-structure body was obtained in which convex portions with the convex-portion bottom portion circumscribed circle diameter Φout of 400 nm and the height H of 250 nm were in periodical structure including the same long period structure as in the reel-shaped transparent resin mold used in nanoimprint. Further, it was confirmed that the convex-portion bottom portion circumscribed circle diameter Φout and the height H decreased as the pitch increased.

(Formation of a semiconductor light emitting device)

On the obtained sapphire substrate, by MOCVD, layered successively were (1) an AlGaN low-temperature buffer layer, (2) an n-type GaN layer, (3) an n-type AlGaN clad layer, (4) an InGaN light emitting semiconductor layer (MQW), (5) a p-type AlGaN clad layer, (6) a p-type GaN layer, and (7) an ITO layer. Concavities and convexities on the sapphire substrate were embedded in layering (2) the n-type GaN layer, and the flattened deposition condition was made. Further, etching processing was performed, and electrode pads were attached.

In this state, using the probe, a current of 20 mA was passed between the p electrode pad and the n electrode pad, and light emission output was measured. The emission center wavelength of the obtained semiconductor light emitting device was 450 nm. Table 10 shows a light emission output ratio to Comparative Example 4. As compared with Comparative Example 4 as described later, the glare specific to diffraction was not observed in the emitted light from the light emitting device, and there was little emission angle dependence.

(Example 4)

A cylindrical master prepared as in Example 3 was exposed on the following conditions while rotating at linear speed s=1.0 m/sec.

Exposure semiconductor laser wavelength: 405 nm
Exposure laser power: 3.5 mV
X-axis direction pitch Px: 260 nm

Variable width $\delta 2$ with respect to the X-axis direction pitch Px: 26 nm
Long period PxL in the X-axis direction of the variable width $\delta 2$: 3.64 $\mu$m

Y-axis direction pitch Py: 300 nm

Variable width $\delta 1$ with respect to the Y-axis direction pitch Py: 30 nm
Long period PyL in the Y-axis direction of the variable width $\delta 1$: 4.2 $\mu$m

Next, as in Example 3, obtained was a reel-shaped transparent resin mold (length 200 m, width 300 mm) with the surface structure inversely transferred.
Next, the surface of the prepared reel-shaped transparent resin mold was observed with the scanning electron microscope. In the observed fine structure, convex portions of nano-order were arranged at inconstant intervals both in the Y-axis direction (vertical direction) and X-axis direction (horizontal direction), and in each pitch, the above-mentioned pitches were repeated with the long period.
Further, by the same method as in Example 3, the concavo-convex structure of nano-order was transferred to the surface of the sapphire substrate. When the cross section and surface structure of the sapphire substrate were observed with the electron microscope, obtained was a two-dimensional photonic crystal having a long period of 3.64 $\mu$m in the vertical direction and a long period of 4.2 $\mu$m in the horizontal direction. Further, it was confirmed that the convex-portion bottom portion circumscribed circle diameter $\Phi$out and the height H decreased as the pitch increased.
Then, a semiconductor light emitting device was prepared as in Example 3, and light emission output was measured. Table 10 shows a light emission output ratio. As in Example 3, the emission center wavelength of the obtained semiconductor light emitting device was 450 nm, emitted light with the glare specific to diffraction was not observed, and there was little emission angle dependence.

(Example 5)

A cylindrical master prepared as in Example 3 was exposed on the following conditions while rotating at linear speed s=1.0 m/sec.

Exposure semiconductor laser wavelength: 405 nm
Exposure laser power: 3.5 mV
X-axis direction pitch Px: 700 nm

Variable width $\delta 2$ with respect to the X-axis direction pitch Px: 70 nm
Long period PxL in the X-axis direction of the variable width $\delta 2$: 4.90 $\mu$m

Y-axis direction pitch Py: 606 nm

Variable width $\delta 1$ with respect to the Y-axis direction pitch Py: 61 nm
Long period PyL in the Y-axis direction of the variable width $\delta 1$: 4.8 $\mu$m

Next, as in Example 3, obtained was a reel-shaped transparent resin mold (length 200 m, width 300 mm) with the surface structure inversely transferred.

Further, by the same method as in Example 3, the concavo-convex structure of nano-order was transferred to the surface of the sapphire substrate. When the cross section and surface structure of the sapphire substrate were observed with the electron microscope, obtained was a two-dimensional photonic crystal having a long period of 4.90 $\mu$m in the vertical direction and a long period of 4.8 $\mu$m in the horizontal direction. Further, it was confirmed that the convex-portion bottom portion circumscribed circle diameter $\Phi$out and the height H decreased as the pitch increased.

Then, a semiconductor light emitting device was prepared as in Example 3, and light emission output was measured. Table 10 shows a light emission output ratio. As in Example 3, the emission center wavelength of the obtained semiconductor light emitting device was 450 nm, emitted light with the glare specific to diffraction was not observed, and there was little emission angle dependence.

(Example 6)

As in Example 4, obtained was a transparent resin mold sheet (length 200 m, width 300 mm) with the fine structure inversely transferred to the surface.

(Formation of an intermediate product)

On the obtained sapphire substrate, by MOCVD, layered successively were (1) an AlGaN low-temperature buffer layer, (2) an n-type GaN layer, (3) an n-type AlGaN clad layer, (4) an InGaN light emitting semiconductor layer (MQW), (5) a p-type AlGaN clad layer, and (6) a p-type GaN layer. Concavities and convexities on the sapphire substrate were embedded in layering (2) the n-type GaN layer, and the flattened deposition condition was made.

Subsequently, after preparing a p electrode layer by sputtering, a Si wafer support product and the p electrode layer were joined via solder. Then, laser light was applied from the sapphire substrate backside (side opposite to the surface facing the n-type GaN layer), the sapphire substrate was separated and removed by laser lift off, and the n-type GaN layer surface exposed by removing the sapphire substrate was cleaned with hydrochloric acid. On the obtained n-type GaN layer surface was formed the inverted fine structure of the sapphire substrate surface.

When the n-type GaN layer surface was observed with the electron microscope, the concavo-convex structure of nano-order was transferred, and obtained was a two-dimensional photonic crystal having a long period of 4.90 $\mu$m in the vertical direction and a long period of 4.8 $\mu$m in the horizontal direction. Further, an n electrode was formed on the n-type GaN layer surface to make a semiconductor light emitting device. Furthermore, it was confirmed that the convex-portion bottom portion circumscribed circle diameter $\Phi$out and the height H decreased as the pitch increased.

In this state, using the probe, a current of 20 mA was passed between the p electrode pad and the n electrode pad, and light emission output was measured.

Table 10 shows a light emission output ratio of this Example 6 to Comparative Example B as described later. In the emitted light from the light emitting device of Example 6, the emission center wavelength of the obtained semiconductor light emitting device was 450 nm, emitted light with the glare specific to diffraction was not observed, and there was little emission angle dependence.

(Example 7)

A cylindrical mold prepared as in Example 3 was exposed on the following conditions while rotating at linear speed s=1.0 m/sec.

Exposure semiconductor laser wavelength: 405 nm
Exposure laser power: 3.5 mV
X-axis direction pitch Px: 260 nm

Variable width $\delta$2 with respect to the X-axis direction pitch Px: 26 nm
Long period PxL in the X-axis direction of the variable width $\delta$2: 1.04 $\mu$m

Y-axis direction pitch Py: 300 nm

Variable width $\delta$1 with respect to the Y-axis direction pitch Py: 30 nm
Long period PyL in the Y-axis direction of the variable width $\delta$1: 1.2 $\mu$m

Next, as in Example 3, obtained was a reel-shaped transparent resin mold (length 200 m, width 300 mm) with the surface structure inversely transferred.

Further, by the same method as in Example 3, the concavo-convex structure of nano-order was transferred to the surface of the sapphire substrate. When the cross section and surface structure were observed with the electron microscope, obtained was a two-dimensional photonic crystal having a long period of 1.04 μm in the vertical direction and a long period of 1.2 μm in the horizontal direction. Further, it was confirmed that the convex-portion bottom portion circumscribed circle diameter Φout and the height H decreased as the pitch increased.

Then, a semiconductor light emitting device was prepared as in Example 3, and light emission output was measured. Table 10 shows a light emission output ratio. As in Example 3, the emission center wavelength of the obtained semiconductor light emitting device was 450 nm, emitted light with the glare specific to diffraction was not observed, and there was little emission angle dependence.

[Comparative Example 4]

A light emitting semiconductor layer was formed on a normal flat sapphire substrate on the same conditions as in Example 3, and light emission output was measured by the same method.

[Comparative Example 5]

By the same method as in Example 3, a fine structure (fine concavo-convex structure) of a nano-pattern was formed on a quartz glass surface by the direct-write lithography method using a semiconductor laser. The pitches in the X-axis direction and Y-axis directions were the same, and a hexagonal arrangement without pitch variations was made.

X-axis direction pitch Px: 398 nm
Y-axis direction pitch Py: 460 nm

Further, by the same method as in Example 3, the concavo-convex structure of nano-order was transferred to the surface of the sapphire substrate. When the cross section and surface structure were observed with the electron microscope, obtained was a two-dimensional photonic crystal having a long period of 460 nm

Subsequently, by the same method as in Example 3, a light emitting semiconductor layer was formed, and light emission output was measured. In the emitted light from the obtained semiconductor light emitting device, the emission center wavelength of the obtained semiconductor light emitting device was 450 nm, diffracted light specific to the diffraction structure was strongly observed, and the emission angle distribution was large.

[Comparative Example 6]

Except that the pattern provided on the sapphire substrate was the same as in Comparative Example B, via the lift off step of the same method as in Example 6, a semiconductor light emitting device was prepared, and light emission output was measured. In the emitted light from the obtained semiconductor light emitting device, the emission center wavelength of the obtained semiconductor light emitting device was 450 nm, diffracted light specific to the diffraction structure was strongly observed, and the emission angle distribution was large.

The light emission output was measured as in Example 3 except the above-mentioned respect. The results are shown in Table 10.

Table 10 shows light emission output ratios with the output of Comparative Example A as 1. From Table 10, according to the optical substrates (Examples 3 to 7) according to this Embodiment, it was understood that it is possible to decrease the number of dislocation defects in the semiconductor layer deposited on the sapphire substrate as compared with the conventional flat sapphire substrate (Comparative Example 4) and sapphire substrates (Comparative Examples 5 and 6) having the conventional two-dimensional photonic crystal without having the period two or more times the wavelength, it is further possible to resolve the waveguide mode and increase the light extraction efficiency due to light scattering caused by the concavo-convex pattern with the periodicity disturbed, and that it is thereby possible to obtain semiconductor light emitting devices with high light efficiency. Further, it is understood that there is little angle dependence in light emission characteristics from the light emitting device, and the light emitting devices are suitable light emitting devices in industrial practical use. In addition, observation using the optical microscope was performed on the optical substrates manufactured in above-mentioned Examples 3 to 7 as in Example 1, and it was possible to observe the optical pattern corresponding to the long period as a difference in light and dark on any of the optical substrates. Further, observation using laser light was performed as in Example 1, and it was observed that the laser light split in five or nine. In addition, in the cases of Comparative Examples 4 and 5, neither pattern with the optical microscope nor the split of laser was observed.

[Table 10]

|  | LIGHT EMISSION OUTPUT RATIO | ANGLE DEPENDENCE |
|---|---|---|
| EXAMPLE 3 | 1.80 | ○ |
| EXAMPLE 4 | 2.90 | ○ |
| EXAMPLE 5 | 2.95 | ○ |
| EXAMPLE 6 | 2.95 | ○ |
| EXAMPLE 7 | 2.92 | ○ |
| COMPARATIVE EXAMPLE 4 | 1.00 | ○ |
| COMPARATIVE EXAMPLE 5 | 1.35 | × |
| COMPARATIVE EXAMPLE 6 | 2.50 | × |

(Example 8)

<Semiconductor light emitting device>

An optical substrate provided with the concavo-convex structure on its surface was prepared, a semiconductor light emitting device (LED) was prepared using the optical substrate, and warpage was evaluated. Subsequently, chips were made to compare efficiency of LEDs.

In the following study, as in Example 1, (1) a cylindrical master mold was prepared, and (2) a resin mold was prepared. (3) Using the resin mold, a member for nano-processing (sheet for nano-processing) was prepared. Next, (4) using the sheet for nano-processing, a substrate provided with the concavo-convex structure on its surface was prepared. Finally, (5) using the obtained substrate provided with the concavo-convex structure, a semiconductor light emitting device was prepared, and performance was evaluated. In addition, the concavo-convex structure was controlled by the concavo-convex structure of the cylindrical master mold prepared in (1), the light transfer method performed in (3), the sheet for nano-processing prepared in (4) and dry etching.

(1) Preparation of cylindrical master molds

The preparation was performed as in Example 1.

(2) Preparation of resin molds

As in Example 2, resin molds G1 were prepared successively using the prepared cylindrical master mold as a mold by applying the photo nanoimprint method. Next, as in Example 2, using the resin mold G1 as a template, resin molds G2 were obtained successively by applying the photo nanoimprint method.

(3) Preparation of sheets for nano-processing

As in Example 2, sheets for nano-processing were prepared.

Nano-processing of an optical substrate Using the prepared sheet for nano-processing, processing of an optical substrate was attempted. Used as the optical substrate was a C-surface (0001) sapphire substrate with orientation flat on the A-surface (11-20).

As in Example 2, using the sheet for nano-processing, a layered product (layered product comprised of material 2/material 3/substrate) was obtained. Subsequently, as in Example 2, the substrate was subjected to etching processing.

Finally, cleaning was performed as in Example 2 to obtain a plurality of sapphire substrates each provided with the concavo-convex structure 20 on its surface. In addition, the shape of the concavo-convex structure prepared on the sapphire substrate was mainly controlled by the filling rate of the material 2 and the film thickness of the material 3 of the sheet for nano-processing.

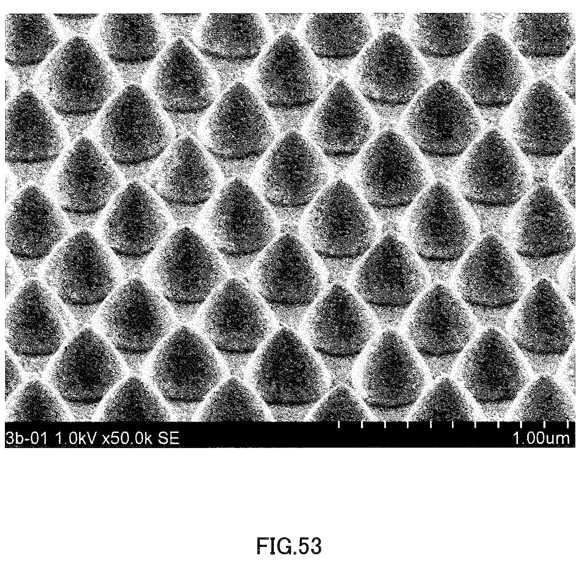

The shape of the concavo-convex structure prepared on the surface of the sapphire surface was controlled as appropriate by the shape of the concavo-convex structure prepared on the cylindrical master mold, the nip pressure condition in manufacturing the resin mold, and the processing condition of dry etching. FIGs. 53 to 56 are scanning microscope photographs showing the concavo-convex structures D of the sapphire substrates prepared in the Examples of the present invention.

FIG. 53 shows the result of observing the concavo-convex structure from a slanting upward direction, and the average pitch (P'ave) of the concavo-convex structure is 460 nm. Further, it is understood that the concavo-convex structure is comprised of a plurality of substantially cone-shaped convex portions, and the convex portions are in an orthohexagonal arrangement. This arrangement was controlled by the semiconductor laser pulse pattern in manufacturing the cylindrical master mold. Furthermore, it is understood that the convex-portion vertex portion and the convex-portion side surface are continuously connected smoothly, and that a flat surface is formed in the concave-portion bottom portion. Still furthermore, it is understood that the convex-portion side surface has a slight upward convex bulge. Such a shape of the convex portion was controlled by the filling rate of the material 2 of the sheet for nano-processing, the film thickness of the material 3, the etching rate ratio between the material 2 and the material 3, and dry etching conditions.

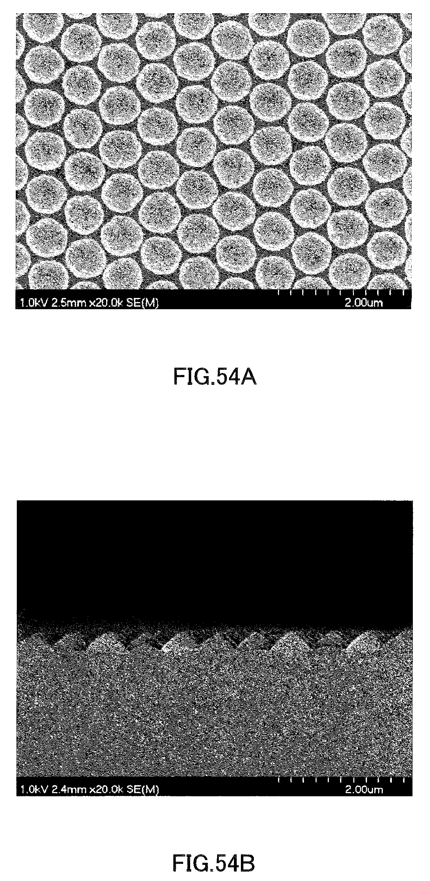

FIG. 54 is the case where the average pitch (P'ave) of the concavo-convex structure is 700 nm, FIG. 54A shows the top surface, and FIG. 54B shows the cross section. From FIG. 54A, it is understood that a plurality of substantially cone-shaped convex portions is in an orthohexagonal arrangement. This arrangement was controlled by the semiconductor laser pulse pattern in manufacturing the cylindrical master mold. Particularly, an interval (P'-lcvb) between bottom-portion contours of adjacent convex portions was extremely narrow, and was 50 nm in the narrowest portion. In addition, the arithmetic mean value of 10 points of the interval (P-lcvb) was 83 nm. Further, it is understood that the outside shape of each convex-portion bottom portion is slightly distorted from a perfect circle. The deviation from a perfect circle was controlled by the material 1 of the sheet for nano-processing. Furthermore, it is understood that the flat surface does not exist in the convex-portion vertex portion, while existing in the concave-portion bottom portion. This was mainly controlled by the dry etching conditions.

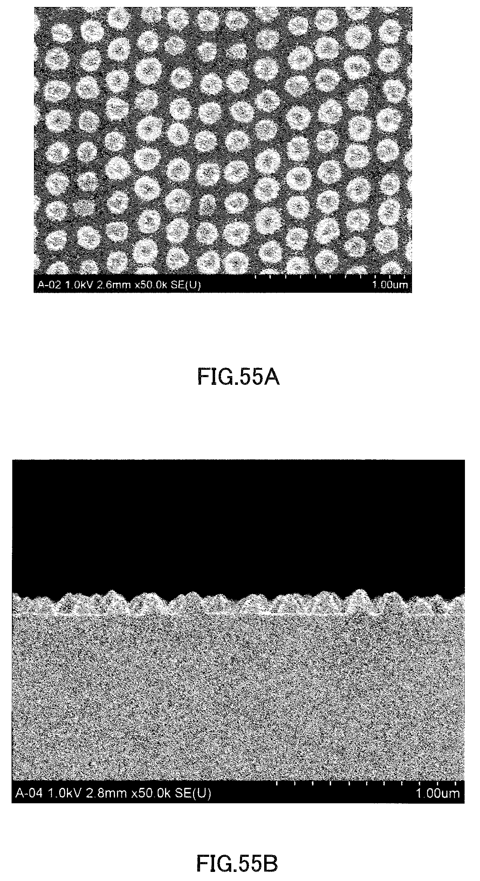

FIG. 55 is the case where the average pitch (P'ave) is 200 nm, FIG. 55A shows the top surface, and FIG. 55B shows the cross section. From FIG. 55A, in the SEM observation image, it is understood that the arrangement of a plurality of convex portions includes the hexagonal arrangement to tetragonal arrangement irregularly. That is, when some convex portion was selected arbitrarily, corresponding to the selected convex portion, there was a state of the case where the arrangement including the selected convex portion was a hexagonal arrangement, the case where such an arrangement was a tetragonal arrangement, or the case where such an arrangement was an arrangement between the hexagonal arrangement and the tetragonal arrangement. This disturbance of arrangement regularity was controlled by eliminating a reference point of the semiconductor pulse laser in manufacturing the cylindrical master mold. Further, it is understood that each convex-portion vertex portion and convex-portion side surface are connected smoothly, and that a flat surface exists in the concave-portion bottom portion. Furthermore, it is understood that the outside shape of each convex-portion bottom portion is not the same, and that there is a slight difference between convex portions. More specifically, in the case of selecting a convex portion arbitrarily, there was the case where the cross-sectional shape of the convex portion was the shape of a bombshell, or there was the case where such a shape was the shape of a cone. Such convex-portion shapes and its distribution were controlled by the filling rate of the material 2 of the sheet for nano-processing, the film thickness of the material 3, the etching rate ratio between the material 2 and the material 3, and dry etching conditions.

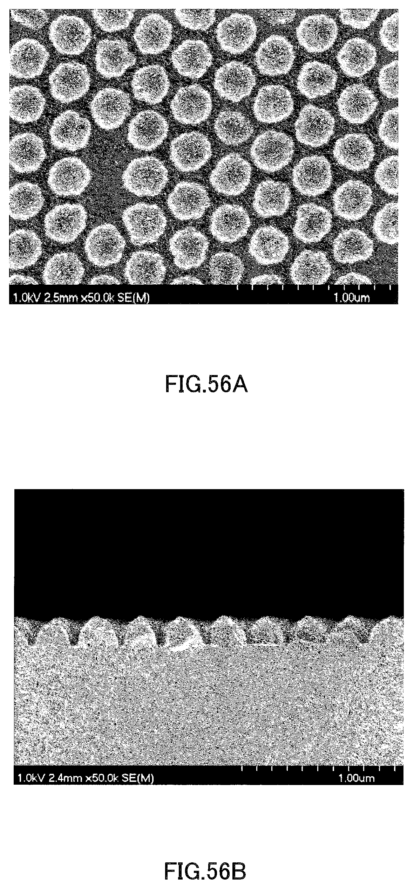

FIG. 56 is the case where the average pitch (P'ave) is 300 nm, FIG. 56A shows the top surface, and FIG. 56B shows the cross section. From FIG. 56, it is understood that a plurality of convex portions is in an orthohexagonal arrangement, and that portions where the convex portion height is 0 nm or low coexist partially. That is, there was the arrangement such that convex portions were thinned randomly from the convex portions in the orthohexagonal arrangement. The thinning rate was about 5.5%. This was controlled by the nip pressure in manufacturing the resin mold G1. More specifically, by performing nip with a pressure band almost equal to the pressure required for filling the inside of the concave portion of the cylindrical master mold with the material 1, the control was performed by forming portions in which a part of convex portions were not filled with the material 1 in the concavo-convex structure of the cylindrical master mold. Further, the vertex portion and side surface portion of each convex portion are smoothly continued, and a flat surface is formed in the concave-portion bottom portion. Furthermore, it is understood that the outside shape of the convex-portion bottom portion is not a perfect circle, and that a plurality of inflection points exists. Such a structure was mainly controlled by the material 2 of the sheet for nano-processing.

The sapphire substrates with different concavo-convex structures were manufactured as exemplified above.

(5) Preparation of semiconductor light emitting devices

On the obtained sapphire substrate, as a buffer layer, a low-temperature growth buffer layer of $Al_xGa_{1-x}N$ $(0 \leq x \leq 1)$ was deposited in 100 Å. Next, as an undoped first semiconductor layer, undoped GaN was deposited, and as a doped first semiconductor layer, Si-doped GaN was deposited. Next, a distortion absorption layer was provided, and then, as a light emitting semiconductor layer, an active layer of multi-quantum well (well layer, barrier layer=undoped InGaS, Si-doped GaN) with a respective film thickness of 60Å or 250Å was alternately layered so that the number of well layers was 6 and that the number of barrier layers was 7. On the light emitting semiconductor layer, as a second semiconductor layer, Mg-doped AlGaN, undoped GaN and Mg-doped GaN were layered so as to include an electro-blocking layer. Subsequently, ITO was deposited, and electrode pads were attached after etching processing. In this state, using the probe, a current of 20 mA was passed between the p electrode pad and the n electrode pad, and light emission output was measured. The evaluation was made with output, in the case of using the sapphire without being provided with the concavo-convex structure as described in Comparative Example 7 of Table 12, as 1.

Evaluations of the semiconductor light emitting devices were made by the above-mentioned operation. The internal quantum efficiency IQE and warpage of the semiconductor light emitting device were evaluated, using, as parameters, the film thickness (Hbu) of the undoped first semiconductor layer, the film thickness (Hbun) of the doped first semiconductor layer, and the average pitch (P'ave) and height H of the concavo-convex structure in (5) preparation of the semiconductor light emitting devices as described above.

The internal quantum efficiency IQE was determined from PL intensity. The internal quantum efficiency IQE is defined as (the number of photons emitted from the light emitting semiconductor layer per unit time/the number of electrons injected into the semiconductor light emitting device per unit time). In this Embodiment, as an indicator to evaluate the above-mentioned internal quantum efficiency IQE, (PL intensity measured at 300K/PL intensity measured at 10K) was adopted.

The studied results are summarized in Table 11. In addition, the meaning of terms as described in Table 11 is as described below.

- No.: Control number of the sample;
- P'ave: The average pitch (P'ave) of the concavo-convex structure with the dimension of "nm"
- h: The average height (h) of the concavo-convex structure with the dimension of "nm"
- Hbun: The film thickness of the first semiconductor layer with the dimension of "nm"
- Hbu: The film thickness of the undoped first semiconductor layer with the dimension of "nm"
- Hbun/h: The ratio of the film thickness of the first semiconductor layer to the average height (h) of the concavo-convex structure of a dimensionless value
- Hbu/h: The ratio of the film thickness of the undoped first semiconductor layer to the average height (h) of the concavo-convex structure of a dimensionless value
- IQE: Internal Quantum Efficiency with the dimension of "%"
- Warpage: Evaluation made by regarding the case of interfering with chip formation of the semiconductor light emitting device 100 as "×", and the case with no problem as "○"
- Total: Total evaluation with the IQE and warpage considered

[Table 11]

| | No. | P' ave | H | Hbun | Hbu | Hbun/h | Hbu/h | IQE | WARPAGE | TOTAL |
|---|---|---|---|---|---|---|---|---|---|---|
| EXAMPLE 8 | 1 | 300 | 150 | 46000 | 23000 | 306.7 | 213.3 | 80 | x | × |
| | 2 | 200 | 80 | 5900 | 3500 | 73.8 | 43.8 | 86 | ○ | ○ |
| | 3 | 200 | 80 | 3500 | 2500 | 43.8 | 31.3 | 73 | ○ | ○ |
| | 4 | 200 | 150 | 5900 | 3500 | 39.3 | 23.3 | 89 | ○ | ○ |
| | 5 | 300 | 150 | 5900 | 3500 | 39.3 | 23.3 | 85 | ○ | ○ |
| | 6 | 200 | 150 | 4500 | 2500 | 30.0 | 16.7 | 88 | ○ | ○ |
| | 7 | 300 | 150 | 4500 | 2500 | 30.0 | 16.7 | 84 | ○ | ○ |
| | 8 | 200 | 150 | 3500 | 2500 | 23.3 | 16.7 | 74 | ○ | ○ |
| | 9 | 460 | 250 | 5900 | 3500 | 23.6 | 14.0 | 79 | ○ | ○ |
| | 10 | 700 | 300 | 5900 | 3500 | 19.7 | 11.7 | 74 | ○ | ○ |
| | 11 | 460 | 250 | 4500 | 2500 | 18.0 | 10.0 | 76 | ○ | ○ |
| | 12 | 300 | 150 | 1000 | 500 | 6.7 | 3.3 | 51 | ○ | x |
| | 13 | 3000 | 1500 | 3500 | 1500 | 2.3 | 1.0 | 30 | ○ | × |
| COMPARATIVE EXAMPLE 7 | 0 | 0 | 0 | 4500 | 2500 | - | - | 52 | ○ | × |

In addition, Comparative Example 7 as described in Table 11 is the case of using the flat sapphire substrate without being provided with the concavo-convex structure.

Further, the relationship between the used substrate and No. in Table 11 is as described below.

No. 9 and No. 11···Substrate shown in FIG. 53
No. 10···Substrate shown in FIG. 54
No. 4, No. 6 and No. 8···Substrate shown in FIG. 55
No. 1, No. 5, No. 7 and No. 12···Substrate shown in FIG. 56

In No. 2 and No. 3, such a substrate was used that the average pitch (P'ave) was 200 nm and that a plurality of convex portions was in an orthohexagonal lattice arrangement. The average diameter of the convex-portion bottom portion was 100 nm, and the average height of the convex portion was 80 nm. Further, any flat surface did not exist on the convex-portion vertex portion, and the convex-portion vertex portion and the convex-portion side surface portions were continuously connected.

In No. 13, such a substrate was used that the average pitch (P'ave) was 3,000 nm and that a plurality of convex portions was in an orthohexagonal lattice arrangement. The average width of the convex-portion bottom portion was 1,500 nm, and the average height of the convex portion was 1,500 nm. In addition, only the substrate as descried in No. 13 was prepared by the following manufacturing method. An $SiO_2$ film as an etching mask was deposited on the C-surface (0001) of the sapphire substrate, and patterning was performed by the photolithography method. Next, the concavo-convex structure was prepared by using the mask comprised of $SiO_2$ and etching the sapphire substrate. In addition, the etching was performed by wet etching, and a mixed acid of phosphoric acid and sulfuric acid was used as an etchant. The solution temperature was substantially 295°C.

From Table 11, the following description is understood. In a range of Hbun/h of 18.0 to 73.8, as compared with the case where the concavo-convex structure is not provided, the internal quantum efficiency increases by 1.46 time to 1.7 time, and the warpage of the semiconductor light emitting device is also suppressed. Hbu/h at this point ranges from 10.0 to 43.8. The reason is conceivable that since the Hbun/h meets a range of the predetermined value or more, dislocations inside the first semiconductor layer are dispersed and reduced by the concavo-convex structure, and that since the Hbun/h meets a range of the predetermined value or less, it is possible to thin the film thickness of the first semiconductor layer and to reduce the warpage. On the other hand, in No. 12, Hbun/h is 6.7, Hbu/h is 3.3, both are small values, and as compared with the case (No. 0 of Comparative Example 7) without the concavo-convex structure, the internal quantum efficiency IQE is not increased. As the reason, it is possible to consider that the dislocation reducing effect is low inside the first semiconductor layer, and that performance as a semiconductor is thereby reduced in the light emitting semiconductor layer and the second semiconductor layer. Further, in No. 1, Hbun/h is 306.7, Hbu/h is 213.3, both are large values, and it is understood that the warpage of the semiconductor light emitting deice affects chip formation. From the foregoing, it is understood that by Hbun/h being in the predetermined range, it is possible to improve the internal quantum efficiency IQE and to reduce the warpage of the semiconductor light emitting device 100.

(Example 9)

A predetermined disturbance was added to the concavo-convex structure in which the average pitch (P'ave) was 300 nm and a plurality of convex portions was arranged in a hexagonal lattice shape, and it was examined whether to enable the external quantum efficiency EQE to be more increased. The results are summarized in Table 12. In addition, the meaning of terms as described Table 12 is as described below.

- No.: Control number of the sample
- P'ave: The average pitch (P'ave) of the concavo-convex
- Coefficient of variation: Value obtained by dividing a stranded deviation of some element constituting the concavo-convex structure by arithmetic mean of the element. Dimensionless value.
- Light emission output ratio: Light emission intensity ratio with Comparative Example 7 as a reference (1.00)

[Table 12]

| | No. | AVERAGE PITCH P'AVE | COEFFICIENT OF VARIATION | | | | LIGHT EMISSION OUTPUT RATIO |
|---|---|---|---|---|---|---|---|
| | | | PITCH P' | $\phi$ out | $\phi$ out/ $\phi$ in | HEIGHT H | |
| COMPARATIVE EXAMPLE 7 | 0 | 0 | - | - | - | - | 1.00 |
| EXAMPLE 9 | 14 | 300 | 0.008 | 0.007 | 0.009 | 0.008 | 1.21 |
| | 15 | 300 | 0.009 | 0.037 | 0.112 | 0.041 | 1.35 |
| | 16 | 300 | 0.009 | 0.048 | 0.061 | 0.286 | 1.50 |
| | 17 | 300 | 0.070 | - | - | 0.220 | 1.55 |

In the semiconductors light emitting devices of Example 9 listed in Table 12, it was confirmed that the internal quantum efficiency IQW exceeds 80% in each device, and that the warpage of the semiconductor light emitting is also suppressed. As can be seen from Table 12, as compared with the case (No. 0 of Comparative Example 7) of using the sapphire substrate without the concavo-convex structure, it is understood that the light emission output in the case (Example 9) of using the sapphire substrate provided with the concavo-convex structure is increased. First, No. 14 is the case where a plurality of convex portions is in an orthohexagonal arrangement, and respective shapes of the convex portions are almost the same. By using the substrate provided with the concavo-convex structure of such an arrangement with high shape regularity, the light emission output is increased by 1.21 time. The reason is presumed that the light extraction efficiency LEE increases by disturbing the waveguide mode using light diffraction corresponding to the average pitch (P'ave), and the results substantially coincide with simulation results using FDTD.

No. 15 is the case where a plurality of convex portions is in an orthohexagonal arrangement, and a disturbance is provided in the shape of each convex portion. More specifically, the convex-portion bottom portion circumscribed circle diameter Φout is provided with the disturbances. This means that there is a distribution in the size of the bottom portion of the convex portion, and since the arrangement is the orthohexagonal arrangement, further means that the area of the concave-portion bottom portion of the concavo-convex structure has the distribution at the same time. Further, a disturbance is in Φout/Φin. This means that the shape is not a perfect circle in the case of observing the convex portion from above, and further means that the convex-portion vertex position relative to the convex-portion bottom portion circumscribed circle varies with each convex portion. Further, the height H of each convex portion also has the distribution. It is understood that by using such a concavo-convex structure with high arrangement regularity and large shape disturbance, the light emission intensity is increased to 1.35 time. The reason is presumed that the number of diffraction modes to disturb the waveguide mode is high due to the disturbances of the concavo-convex structure, and that the light extraction efficiency LEE is increased.

In No. 16, the disturbances of the convex-portion height H is increased as compared with No. 15. This is the concavo-convex structure without having convex portions partially. In this case, it is understood that the light emission output is increased to 1.50 time. The reason is presumed that the concavo-convex structure in which some convex portions are lost and do not exist includes a large volume change of the convex portion therein, optical scattering properties are increased, and that the effect of disturbing the waveguide mode is increased.

Finally, No. 17 is the case of adding a disturbance to the arrangement to No. 16. The disturbances of the arrangement is not random, and is a controlled disturbance. More specifically, the arrangement was designed so that the pitch P' was changed by multiplying by a sine curve. In this case, the light emission output is increased to 1.55 time. Further, when optical microscope observation was performed on No. 17 as in Example 1, it was observed that substantially circular patterns were tetragonally arranged as a difference in light and dark. Furthermore, when observation using laser light was performed as in Example 1, it was confirmed that the laser light split in five. In addition, in No. 14 to No. 16, neither the optical pattern nor the split of laser light was observed. The reason is presumed that the number of diffraction modes to disturb the waveguide mode is increased due to the disturbances of the arrangement, optical scattering properties are enhanced, and that the light extraction efficiency LEE is thereby increased.

In addition, the present invention is not limited to the above-mentioned Embodiment, and is capable of being carried into practice with various modifications thereof. In the above-mentioned Embodiment, the size, shape and the like shown in the accompanying drawings are not limited thereto, and are capable of being modified as appropriate within the scope of exhibiting the effects of the invention.

Industrial Applicability

For example, the present invention is suitably applicable to semiconductor light emitting devices such as OLED, fluorescent material and light emitting diode (LED).

The present application is based on Japanese Patent Application No.2012-227299 filed on October 12, 2012, Japanese Patent Application No.2012-230000 filed on October 17, 2012, Japanese Patent Application No.2012-231861 filed on October 19, 2012, Japanese Patent Application No.2012-280240 filed on December 21, 2012, Japanese Patent Application No.2013-022576 filed on February 7, 2013 and Japanese Patent Application No.2013-111091 filed on May 27, 2013, entire contents of which are expressly incorporated by reference herein.

1. An optical substrate comprising:

a substrate body; and
a concavo-convex structure comprised of a plurality of convex portions or concave portions provided on a main surface of the substrate body,
wherein at least one pattern observable at any magnification within a range of 10 times to 5,000 times with an optical microscope is drawn on the main surface;
an interval of the pattern is larger than a pitch of the concavo-convex structure; and
in an optical microscope image of the pattern, the pattern is capable of being distinguished to a first region and a second region by a difference in light and dark, a plurality of first regions is arranged apart from one another at intervals, and the second region connects between the first regions.

2. The optical substrate according to 1, wherein the pattern is observable at any magnification within a range of 10 times to 1,500 times with the optical microscope.

3. The optical substrate according to 1, wherein the pattern is observable at any magnification within a range of 500 times to 1,500 times with the optical microscope.

4. The optical substrate according to 1, wherein the pattern is observable at any magnification within a range of 500 times to 5,000 times with the optical microscope.

5. The optical substrate according to any one of 1 to 4, wherein the pattern is drawn by a difference in at least one element constituting the plurality of convex portions or concave portions constituting the concavo-convex structure.

6. The optical substrate according to any one of 1 to 5, wherein an average pitch of the concavo-convex structure ranges from 10 nm to 1,500 nm.

7. The optical substrate according to 6, wherein an average pitch of the concavo-convex structure ranges from 10 nm to 900 nm, and a height of the concavo-convex structure ranges from 10 nm to 500 nm.

8. The optical substrate according to 1 or 5, wherein when each of three types of laser beams respectively with wavelengths of 640 nm to 660 nm, 525 nm to 535 nm and 460 nm to 480 nm is applied perpendicularly to the main surface of the optical substrate from a first surface side on which the concavo-convex structure exists of the optical substrate, with respect to at least one laser beam or more, the laser beam output from a second surface on the side opposite to the first surface splits in two or more.

9. The optical substrate according to any one of 1 to 8, wherein an average pitch of the concavo-convex structure ranges from 50 nm to 1,500 nm,
the concavo-convex structure includes at least one disturbance, and a standard deviation and arithmetic mean of elements of the concavo-convex structure that is at least one factor of the disturbance meet a relationship of following equation (1).

$$0.025 \leq (\text{standard deviation/arithmetic mean}) \leq 0.5 \quad (1)$$

10. The optical substrate according to any one of 1 to 8, wherein the optical substrate is applied to a semiconductor light emitting device comprised of at least an n-type semiconductor layer, a light emitting semiconductor layer, and a p-type semiconductor layer, the concavo-convex structure includes dots comprised of the plurality of convex portions or concave portions, and forms a two-dimensional photonic crystal controlled by at least one of a pitch between the dots, a dot diameter and a dot height, and
a period of the two-dimensional photonic crystal is two or more times an emission center wavelength of the semiconductor light emitting device.

11. An optical substrate provided with a concavo-convex structure on a surface thereof,
wherein an average pitch of the concavo-convex structure ranges from 50 nm to 1,500 nm,

the concavo-convex structure includes at least one disturbance, and a standard deviation and arithmetic mean of elements of the concavo-convex structure that is at least one factor of the disturbance meet a relationship of following equation (1).

$$0.025 \leq (\text{standard deviation/arithmetic mean}) \leq 0.5 \ (1)$$

12. The optical substrate according to 11, wherein a concave-portion bottom portion of the concavo-convex structure has a flat surface.

13. The optical substrate according to 11 or 12, wherein the element of the concavo-convex structure is at least one selected from the group consisting of a height of a convex portion of the concavo-convex structure, an outside diameter of a convex-portion bottom portion of the concavo-convex structure, an aspect ratio of the concavo-convex structure, a diameter of a circumscribed circle with respect to a contour of the convex-portion bottom portion, a diameter of an inscribed circle with respect to the contour of the convex-portion bottom portion, a ratio between the diameter of the circumscribed circle with respect to the contour of the convex-portion bottom portion and the diameter of the inscribed circle with respect to the contour of the convex-portion bottom portion, a pitch of the concavo-convex structure, a duty of the concavo-convex structure, an inclination angle of a side surface of the convex portion, and an area of a flat surface of a vertex portion of the convex portion.

14. An optical substrate applied to a semiconductor light emitting device comprised of at least an n-type semiconductor layer, a light emitting semiconductor layer, and a p-type semiconductor layer, wherein a concavo-convex structure including dots comprised of a plurality of convex portions or concave portions is provided on a main surface of the optical substrate, the concavo-convex structure forms a two-dimensional photonic crystal controlled by at least one of a pitch between the dots, a dot diameter and a dot height, and a period of the two-dimensional photonic crystal is two or more times an emission center wavelength of the semiconductor light emitting device.

15. The optical substrate according to 14, wherein the period of the two-dimensional photonic crystal has a period at least in one axis direction of the main surface.

16. The optical substrate according to 14, wherein the period of the two-dimensional photonic crystal has periods at least in two mutually independent axis directions of the main surface.

17. A semiconductor light emitting device, wherein at least a first semiconductor layer, a light emitting semiconductor layer and a second semiconductor layer are layered on the main surface of the optical substrate according to any one of 1 to 16.

18. The semiconductor light emitting device according to 17, wherein a ratio (Hbun/h) of a distance (Hbun) between a surface on the light emitting semiconductor layer side and a surface on the first semiconductor layer side of the light emitting semiconductor layer to an average height (h) of the concavo-convex structure provided on the surface on the light emitting semiconductor layer side of the optical substrate meets following equation (12).

$$8 \leq Hbun/h \leq 300 \qquad (12)$$

19. The semiconductor light emitting device according to 18, wherein the first semiconductor layer is comprised of an undoped first semiconductor layer and a doped first semiconductor layer in this order from the optical substrate side, and a ratio (Hbu/h) of a distance (Hbu) between a surface on the light emitting semiconductor layer side of the optical substrate and a surface on the doped first semiconductor layer side of the undoped first semiconductor layer to an average height (h) of the concavo-convex structure meets following equation (13).

$$3.5 \leq Hbu/h \leq 200 \qquad (13)$$

20. A method of manufacturing a semiconductor light emitting device, comprising:

performing an optical inspection on the optical substrate according to any one of 1 to 16; and manufacturing a semiconductor light emitting device using the optical substrate subjected to the optical inspection.

21. A semiconductor light emitting device obtained by separating the optical substrate according to any one of 1 to 16 from an intermediate product provided with the optical substrate, a first semiconductor layer, a light emitting semiconductor layer and a second semiconductor layer sequentially layered on the surface having the concavo-convex structure, and a support product joined to the second semiconductor layer.

22. A method of manufacturing a semiconductor light emitting device, comprising:

layering a first semiconductor layer, a light emitting semiconductor layer and a second semiconductor layer in this order on the surface having the concavo-convex structure of the optical substrate according to any one of claims 1 to 16;

bonding a support product to a surface of the second semiconductor layer to obtain an intermediate product; and

separating the optical substrate from the intermediate product to obtain a semiconductor light emitting device comprised of the first semiconductor layer, the light emitting semiconductor layer, the second semiconductor layer and the support product.

## Claims

1. An optical substrate applied to a semiconductor light emitting device comprised of at least an n-type semiconductor layer, a light emitting semiconductor layer, and a p-type semiconductor layer,

wherein a concavo-convex structure including dots comprised of a plurality of convex portions or concave portions is provided on a main surface of the optical substrate,

the concavo-convex structure forms a two-dimensional photonic crystal controlled by at least one of a pitch between the dots, a dot diameter and a dot height, and

a period of the two-dimensional photonic crystal is two or more times an emission center wavelength of the semiconductor light emitting device.

2. The optical substrate according to claim 1, wherein the period of the two-dimensional photonic crystal has a period at least in one axis direction of the main surface.

3. The optical substrate according to claim 1, wherein the period of the two-dimensional photonic crystal has periods at least in two mutually independent axis directions of the main surface.

4. A semiconductor light emitting device, wherein at least a first semiconductor layer, a light emitting semiconductor layer and a second semiconductor layer are layered on the main surface of the optical substrate according to any one of claims 1 to 3.

5. The semiconductor light emitting device according to claim 4, wherein a ratio (Hbun/h) of a distance (Hbun) between a surface on the light emitting semiconductor layer side and a surface on the first semiconductor layer side of the light emitting semiconductor layer to an average height (h) of the concavo-convex structure provided on the surface on the light emitting semiconductor layer side of the optical substrate meets following equation (12).

$$8 \leq Hbun/h \leq 300 \qquad (12)$$

6. The semiconductor light emitting device according to claim 5, wherein the first semiconductor layer is comprised of an undoped first semiconductor layer and a doped first semiconductor layer in this order from the optical substrate side, and

a ratio (Hbu/h) of a distance (Hbu) between a surface on the light emitting semiconductor layer side of the optical substrate and a surface on the doped first semiconductor layer side of the undoped first semiconductor layer to an average height (h) of the concavo-convex structure meets following equation (13).

$$3.5 \leq Hbu/h \leq 200 \qquad (13)$$

7. A method of manufacturing a semiconductor light emitting device, comprising:

performing an optical inspection on the optical substrate according to any one of claims 1 to 3; and

manufacturing a semiconductor light emitting device using the optical substrate subjected to the optical inspection.

8. A semiconductor light emitting device obtained by separating the optical substrate according to any one of claims 1 to 3 from an intermediate product provided with the optical substrate, a first semiconductor layer, a light emitting semiconductor layer and a second semiconductor layer sequentially layered on the surface having the concavo-convex structure, and a support product joined to the second semiconductor layer.

9. A method of manufacturing a semiconductor light emitting device, comprising:

layering a first semiconductor layer, a light emitting semiconductor layer and a second semiconductor layer in this order on the surface having the concavo-convex structure of the optical substrate according to any one of claims 1 to 3;
bonding a support product to a surface of the second semiconductor layer to obtain an intermediate product; and
separating the optical substrate from the intermediate product to obtain a semiconductor light emitting device comprised of the first semiconductor layer, the light emitting semiconductor layer, the second semiconductor layer and the support product.

10

10a

Xa

Xa
Xb } X

Xa

FIG.1

100

FIG.2

200

FIG.3

FIG.4

FIG.5

FIG.6

FIG.7A

FIG.7B

FIG.8A

FIG.8B

FIG.8C

FIG.8D

EP 3 043 392 A1

FIG.9

FIG.10

FIG.11A

FIG.11B

FIG.11C

FIG.12

EP 3 043 392 A1

LIGHT AND DARK

Y — — — — — — — a    b    c    d    e    f — — — — Y'

FIG.13

FIG.14

EP 3 043 392 A1

LIGHT AND DARK

A

B

C

a   b   c   d   e   f

Y ————————————————————— Y'

**FIG.15**

LIGHT AND DARK

FIG.16

EP 3 043 392 A1

FIG.17

FIG.18

FIG.19

FIG.20A

FIG.20B

FIG.21

FIG.22A

FIG.22B

FIG.23A

FIG.23D

FIG.23B

FIG.23E

FIG.23C

600

608

606

605
610 { 604
603

602

601

FIG.24

700

708

706

} 705

704

703

702

707

701

FIG.25

800

807

804
803
802

} 805

801

806

FIG.26

FIG.27

EP 3 043 392 A1

FIG.28

FIG.29

EP 3 043 392 A1

FIG.30A

FIG.30B

FIG.30C

FIG.30D

FIG.30E

FIG.31A

FIG.31B

FIG.31C

FIG.31D

FIG.32A

FIG.32B

FIG.33

FIG.34

EP 3 043 392 A1

FIG.35

FIG.36

FIG.37

D2 (Px)

Lx1      Lx2

DL

1 2 3 4 5 6 7 8 9 10 11 12 13 14 15 16

Px1 Px2 Px3 Px4 Px5 Px6 Px7

Px8 Px9 Px10 Px11 Px12 Px13 Px14 Px15 · · · · Px(2a+1)

PITCH INTERVAL

Px8 Px9 Px10 Px11 Px12 Px13 Px14 Px15

Px1 Px2 Px3 Px4 Px5 Px6 Px7

FIG.38

FIG.39

FIG.40

FIG.41

FIG.42

FIG.43

FIG.44

FIG.45

FIG.46A

900

~ 970
~ 960
~ 950
~ 940
~ 930
} ~ 920
~ 901

FIG.46B

900

~ 901
} ~ 920

1000

} ~ 980
~ 930
~ 940
~ 950
~ 960
~ 970

FIG.46C

1000

~ 990
} ~ 980
~ 930
~ 940
~ 950
~ 960
~ 970

FIG.47

FIG.48A    Z-PHASE
SIGNAL

FIG.48B    REFERENCE
PULSE SIGNAL

FIG.48C    MODULATED
PULSE SIGNAL

REFERENCE
PULSE
SIGNAL

MODULATED
PULSE
SIGNAL

PHASE-
MODULATED
PULSE
SIGNAL

ROLL CIRCUMFERENTIAL
DIRECTION

FIG.49

FIG.50

FIG.51A

FIG.51B

FIG.52A

FIG.52B

3b-01 1.0kV x50.0k SE            1.00um

FIG.53

1.0kV 2.5mm x20.0k SE(M)                    2.00um

FIG.54A

1.0kV 2.4mm x20.0k SE(M)                    2.00um

FIG.54B

FIG.55A

FIG.55B

FIG.56A

FIG.56B

Europäisches
Patentamt

European
Patent Office

Office européen
des brevets

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YI-TA HSIEH ET AL: "Fabrication of sub-micrometer surface structures on sapphire substrate for GaN-based light-emitting diodes by metal contact printing method", NANO/MICRO ENGINEERED AND MOLECULAR SYSTEMS (NEMS), 2011 IEEE INTERNATIONAL CONFERENCE ON, IEEE, 20 February 2011 (2011-02-20), pages 703-706, XP031966005, DOI: 10.1109/NEMS.2011.6017451 ISBN: 978-1-61284-775-7 * page 705 - page 708; figures 2-4 * | 1,4,6-9 | INV. H01L33/22 |
| X | GAO H. ET AL.: "Improvement of the performance of GaN-based LEDs grown on sapphire substrates patterned bywet and ICP etching.", SOLID-STATE ELECTRONICS, vol. 52, 14 February 2008 (2008-02-14), pages 962-967, XP002757974, DOI: 10.1016/j.sse.2007.12.013 * pages 962-965; figures 1-5 * | 1-5 | |
| A | HYOUNGWON PARK ET AL: "Enhancement of photo- and electro-luminescence of GaN-based LED structure grown on a nanometer-scaled patterned sapphire substrate", MICROELECTRONIC ENGINEERING, ELSEVIER PUBLISHERS BV., AMSTERDAM, NL, vol. 88, no. 11, 29 July 2011 (2011-07-29) , pages 3207-3213, XP028109505, ISSN: 0167-9317, DOI: 10.1016/J.MEE.2011.07.014 [retrieved on 2011-08-22] * page 3207 - page 3212; figures 1,3-4 * | 1,5,6 | TECHNICAL FIELDS SEARCHED (IPC)<br><br>H01L |

-/--

The present search report has been drawn up for all claims

| Place of search | Date of completion of the search | Examiner |
|---|---|---|
| The Hague | 27 May 2016 | Chin, Patrick |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 16 15 7412

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MIKE MILLER ET AL: "<title>Step and flash imprint process integration techniques for photonic crystal patterning: template replication through wafer patterning irrespective of tone</title>", PROCEEDINGS OF SPIE, vol. 6883, 7 February 2008 (2008-02-07), pages 68830D-68830D-9, XP055211145, ISSN: 0277-786X, DOI: 10.1117/12.771302 * page 68830D1 - page 68830d5; figures 5,6 * | 1,7 | |

TECHNICAL FIELDS
SEARCHED      (IPC)

The present search report has been drawn up for all claims

| Place of search | Date of completion of the search | Examiner |
|---|---|---|
| The Hague | 27 May 2016 | Chin, Patrick |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................

& : member of the same patent family, corresponding
    document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003318441 A
- JP 2007294972 A
- JP 2005259970 A
- JP 2012227299 A
- JP 2012230000 A
- JP 2012231861 A
- JP 2012280240 A
- JP 2013022576 A
- JP 2013111091 A

**Non-patent literature cited in the description**

- *IEEE photo. Tech. Lett.,* 2008, vol. 20, 13
- *J. Appl. Phys.,* 2008, vol. 103, 014314